(19) Europäisches Patentamt
European Patent Office
Office européen des brevets

(11) EP 2 827 361 A1

(12) EUROPEAN PATENT APPLICATION
published in accordance with Art. 153(4) EPC

(43) Date of publication:
**21.01.2015 Bulletin 2015/04**

(21) Application number: **13761076.2**

(22) Date of filing: **11.03.2013**

(51) Int Cl.:
***H01L 21/027*** *(2006.01)* ***B29C 33/38*** *(2006.01)*
***B29C 33/42*** *(2006.01)* ***B29C 59/02*** *(2006.01)*
***B32B 3/26*** *(2006.01)*

(86) International application number:
**PCT/JP2013/056598**

(87) International publication number:
**WO 2013/137176 (19.09.2013 Gazette 2013/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.03.2012 JP 2012054943**
**12.03.2012 JP 2012054944**
**12.03.2012 JP 2012054945**
**27.08.2012 JP 2012186551**

(71) Applicant: **Asahi Kasei E-materials Corporation
Tokyo 101-8101 (JP)**

(72) Inventor: **KOIKE, Jun
Tokyo 101-8101 (JP)**

(74) Representative: **Von Kreisler Selting Werner - Partnerschaft
von Patentanwälten und Rechtsanwälten mbB
Deichmannhaus am Dom
Bahnhofsvorplatz 1
50667 Köln (DE)**

# (54) MOLD, RESIST LAMINATE AND MANUFACTURING PROCESS THEREFOR, AND MICRORELIEF STRUCTURE

(57) A resist layered product (30) is provided with an inorganic substrate (21), first resist layer (22) provided on one main surface of the inorganic substrate (21), and second resist layer (23), provided on the first resist layer (22), provided with a concavo-convex structure (23a) on its surface. In the concavo-convex structure (23a), a thickness of a residual film after transfer is 50 nm or less, the ratio (lcv/lcc) of a top width of convex-portion (lcv) to an opening width of concave-portion (lcc) of a fine pattern of a mold is in a predetermined range, and the ratio (Vr2/Vcm) between a concave-portion volume (Vcm) of the fine pattern of the mold and a volume (Vr2) of the second resist layer (23) is in a predetermined range. It is possible to easily form a resist mask (25) having a thin and uniform residual film on the inorganic substrate (21).

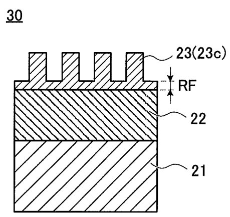


FIG.3A

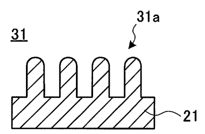


FIG.3E

EP 2 827 361 A1

## Description

Technical Field

The present invention relates to a mold, resist layered product, manufacturing method of the product, and concavo-convex structure product.

Background Art

Conventionally, a photolithography technique has often been used in the manufacturing process of a large scale integrated circuit (LSI) as a processing technique of concavo-convex structure. However, in the photolithography technique, there is the problem that it is difficult to form a concavo-convex structure of a size smaller than a wavelength of light used in exposure. Further, as another processing technique of concavo-convex structure, there is a mask pattern lithography technique with an electron beam lithography apparatus (EB method). However, since the EB method is to directly write a mask pattern on a surface of a workpiece with an electron beam, the writing time increases as the mask pattern to write increases, and there is the problem that throughput up to concavo-convex structure formation significantly decreases. Further, in an exposure apparatus for photolithography, it is necessary to control the mask positions with high accuracy, and in an exposure apparatus for the EB method, it is necessary to increase the size of the electron beam lithography apparatus. Therefore, in these methods, there has been the problem that apparatus costs are high.

A nanoimprint lithography technique has been known as the processing technique of concavo-convex structure to enable these problems to be solved. In the nanoimprint lithography technique, a mold with a fine pattern of nano-scale formed is pressed against a resist film formed on a surface of a workpiece, and the fine pattern formed on the mold is transferred to the surface of the resist film to form a concave-convex structure. Then, using the formed concavo-convex structure of the formed resist film as a mask, by performing dry etching on the workpiece, the concavo-convex structure is formed on the surface of the workpiece.

In addition, in the case of using the resist film with the concavo-convex structure transferred thereto as a mask of the workpiece, it is necessary to thin and uniform a film thickness of a thin film (hereinafter, referred to as "residual film") between the concave-portion bottom of the resist film and the workpiece. However, in a general nanoimprint method, it is difficult to thin the thickness of the residual film, while uniforming the thickness of the residual film.

Further, in the case of using a unworkable workpiece, since the dry etching time increases which is required to form a desired concavo-convex structure on the workpiece, it is necessary to increase the height of the convex portion of the concavo-convex structure and use a mask resisting long-time dry etching. However, when the height of the convex portion of the concavo-convex structure is increased, peeling stress on the concavo-convex structure is increased in peeling off the mold from the resist layer, and as a result, there is the problem that transfer accuracy of the concavo-convex structure significantly decreases.

Then, as shown in FIG. 1, such a method is known that to form a concavo-convex structure with a high height on a workpiece 101, a resist layer 102 is provided on the workpiece 101, and that a fine pattern of a mold 104 is transferred to a transfer target layer 103 provided on the resist layer 102. In this method, by performing dry etching on the resist layer 102 using the transfer target layer 103 with the fine pattern of the mold 104 transferred thereto as a mask, it is possible to form a concavo-convex structure with a high height formed from the resist layer 102 and transfer target layer 103. However, even in the case of using this method, as in the above-mentioned conventional nanoimprint method, it is difficult to thin the thickness of the residual film RF of the concavo-convex structure of the transfer target layer 103. Further, in the case of using this method, since it is necessary to apply a high pressure so as to thin the residual film of the concavo-convex structure, it is extremely difficult to process while maintaining thickness accuracy of the resist layer 102.

In such a situation, a fine mask formation method is proposed which enables a residual film to be thinned or enables a concavo-convex structure without a residual film to be obtained (for example, see Patent Document 1). In the fine mask formation method as described in Patent Document 1, a mask material film is directly formed on a fine pattern of a mold provided with the fine pattern on its surface, and etch back is applied to the formed mask material film. By this means, the film thickness of the mask material film disposed on the fine pattern of the mold is thinned, and it is thereby possible to thin the residual film or completely remove the residual film. Then, after laminating a substrate onto the mask material, by performing ashing processing on the mold side, it is possible to obtain a concavo-convex structure (fine mask pattern) with the fine pattern of the mold removed without the residual film.

Prior Art Document

Patent Document

[Patent Document 1] Japanese Unexamined Patent Publication No. 2011-66273

Disclosure of Invention

Problems to be Solved by the Invention

However, in the fine mask formation method as described in Patent Document 1, the number of total steps is high up to thinning the residual film, or obtaining the fine mask pattern without the residual film. Therefore, the steps to obtain the fine mask are complicated, and the drastic solution is not attained against the issues of enabling the residual film to be thinned and further enabling the residual film to be uniform.

The present invention was made in view of such a respect, and it is an object of the invention to provide a mold for enabling a resist having a thin and uniform residual film to be easily formed on a workpiece, a resist layered product for enabling a concavo-convex structure with a high aspect ratio to be easily formed on an inorganic substrate as the workpiece, manufacturing method of the product, and a concavo-convex structure product.

Means for Solving the Problem

A mold of the present invention is a mold provided with a fine pattern on a part or whole of a surface thereof, and is characterized in that in the fine pattern, a ratio (lcv/lcc) of a top width of convex-portion (lcv) to an opening width of concave-portion (lcc) and a ratio (Sh/Scm) of an opening portion area (Sh) existing under a region of a unit area (Scm) of the fine pattern to the unit area (Scm) meet following equation (1), the ratio (Sh/Scm) meets following equation (2), the ratio (lcv/lcc) meets following equation (3), and that a height (H) of the fine pattern meets following equation (4).
[Mathematical Expression 1]

Eq. (1)

$$\sqrt{0.5/(Sh/Scm)} - 1 \leqq lcv/lcc \leqq \sqrt{1.1/(Sh/Scm)} - 1$$

Eq. (2)

$$0.23 < (Sh/Scm) \leq 0.99$$

Eq. (3)

$$0.01 \leq (lcv/lcc) < 1.0$$

Eq.4

$$50\,nm \leq H \leq 1500\,nm$$

A resist layered product of the present invention is provided with an inorganic substrate, and a resist layer comprised of n layer (s) (n≥1) provided on one main surface of the inorganic substrate, and is characterized in that a surface of an nth resist layer that is an uppermost layer of the resist layer comprised of n layer(s) has a concavo-convex structure on a part or whole of the surface, the concavo-convex structure is provided by transfer of a fine pattern of a mold, a thickness of a residual film after the transfer is 50 nm or less, a ratio (lcv/lcc) of a top width of convex-portion (lcv) to an opening width of concave-portion (lcc) of the fine pattern of the mold meets following equation (3), and that a ratio (Vr2/Vcm) between a concave-portion volume (Vcm) of the fine pattern existing under a region of a unit area (Scm) of the surface with the fine pattern formed of the mold and a volume (Vr2) of the nth resist layer existing under a region of a unit area (Scr2) in the plane in the nth resist layer formed inside a surface parallel to the one main surface

of the inorganic substrate meets following equation (9).

Eq. (3)

$$0.01 \leq (lcv/lcc) < 1.0$$

Eq. (9)

$$0.1 \leq (Vr2/Vcm) \leq 1.5$$

A method of manufacturing a resist layered product of the present invention is a method of manufacturing the resist layered product as described above, and is characterized by including a pressing step of pressing a fine pattern of a mold against the surface of the nth resist layer in an atmosphere of low oxygen to obtain a mold layeredproduct, an energy ray irradiation step of irradiating the nth resist layer of the mold layered product with an energy ray from the mold side and/or inorganic substrate side, and transferring the fine pattern to the nth resist layer to provide the concavo-convex structure, and a mold release step of peeling off the mold from the nth resist layer with the concavo-convex structure transferred thereto to obtain the resist layered product, where the resist layered product meets following equation (16).

Eq. (16)

$$0.1 \leq (Vr2/Vcm) \leq 1$$

A concavo-convex structure product of the present invention is a concavo-convex structure product manufactured by using the resist layered product as described above, and is characterized by being manufactured by a manufacturing method including a first etching step of removing, by dry etching, a residual film of the nth resist layer existing between a bottom portion of a concave portion in the concavo-convex structure of the nth resist layer and an interface between an (n-1) th resist layer and the nth resist layer from the surface side with the nth resist layer provided, a second etching step of etching, by dry etching, a first to (n-1) th resist layers up to an interface between the first resist layer and the inorganic substrate after removing the residual film, and a third etching step of etching the inorganic substrate after the second etching step.

A method of manufacturing a resist layered product of the present invention is a method of manufacturing a resist layered product having a concavo-convex structure on a part or whole of a surface thereof, and is provided with a step of preparing an inorganic substrate provided with a resist layer on one main surface thereof, and a step of pressing the mold as described above against the resist layer.

Advantageous Effect of the Invention

According to the present invention, it is possible to provide a mold for enabling a resist having a thin and uniform residual film to be easily formed on a workpiece, a resist layered product for enabling a concavo-convex structure with a high aspect ratio to be easily formed on the workpiece, manufacturing method of the product, and a concavo-convex structure product.

Brief Description of Drawings

FIG. 1 is a cross-sectional schematic diagram illustrating a resist layered product using a conventional fine pattern transfer method;

FIG. 2 contains cross-sectional schematic diagrams illustrating each step of a method of manufacturing a resist layered product according to this Embodiment;

FIG. 3 contains cross-sectional schematic diagrams illustrating each step of a method of manufacturing a concavo-convex structure product according to this Embodiment;

FIG. 4 is an explanatory diagram illustrating a state in which a fine pattern of a mold is pressed against an nth resist in a pressing step of the method of manufacturing a concavo-convex structure product according to this Embodiment;

FIG. 5 contains explanatory diagrams illustrating a state in which the fine pattern of the mold is peeled off from a concavo-convex structure of the nth resist in a mold release step of the method of manufacturing a concavo-convex structure product according to this Embodiment;
FIG. 6 is a graph to explain the first to fourth conditions of the fine pattern of the mold according to this Embodiment;
FIG. 7 is another graph to explain the first to fourth conditions of the fine pattern of the mold according to this Embodiment;
FIG. 8 is still another graph to explain the first to fourth conditions of the fine pattern of the mold according to this Embodiment;
FIG. 9 is still another graph to explain the first to fourth conditions of the fine pattern of the mold according to this Embodiment;
FIG. 10 is still another graph to explain the first to fourth conditions of the fine pattern of the mold according to this Embodiment;
FIG. 11 is still another graph to explain the first to fourth conditions of the fine pattern of the mold according to this Embodiment;
FIG. 12 is a cross-sectional schematic diagram illustrating the mold according to this Embodiment;
FIG. 13 is still another graph to explain the first to fourth conditions of the fine pattern of the mold according to this Embodiment;
FIG. 14 contains schematic diagrams illustrating a relationship between a fine pattern G and a non-G area in the fine pattern of the mold according to this Embodiment;
FIG. 15 contains schematic diagrams illustrating contour shapes formed by the fine pattern G area and mold contour shapes in fine patterns of molds according to this Embodiment;
FIG. 16 contains plan schematic diagrams illustrating states obtained by observing, from a surface with the fine pattern formed, molds according to this Embodiment;
FIG. 17 contains plan schematic diagrams illustrating states obtained by observing, from the surface with the fine pattern formed, molds according to this Embodiment;
FIG. 18 contains schematic diagrams illustrating examples of the fine pattern of hole structure of the mold according to this Embodiment;
FIG. 19 is a schematic diagram illustrating a state obtained by observing, from the surface, the fine pattern of hole structure of the mold according to this Embodiment;
FIG. 20 contains schematic diagrams illustrating states obtained by observing, from the surface, the fine pattern of dot structure of the mold according to this Embodiment;
FIG. 21 is a schematic diagram illustrating a state obtained by observing, from the surface, the fine pattern of dot structure of the mold according to this Embodiment;
FIG. 22 is a schematic diagram illustrating a state obtained by observing, from the surface, the fine pattern of line-and-space structure of the mold according to this Embodiment;
FIG. 23 contains schematic diagrams illustrating fine patterns of hole structure of molds according to this Embodiment;
FIG. 24 contains schematic diagrams illustrating fine patterns of dot structure of molds according to this Embodiment;
FIG. 25 contains explanatory diagrams illustrating the relationship between the fine pattern and a unit area (Scm) in the mold according to this Embodiment;
FIG. 26 contains explanatory diagrams of an aperture ratio of the fine pattern in the mold according to this Embodiment;
FIG. 27 is an explanatory diagram of an aperture ratio of the concavo-convex structure in the mold according to this Embodiment;
FIG. 28 contains perspective schematic diagrams illustrating the fine patterns of the molds according to this Embodiment;
FIG. 29 is a schematic diagram illustrating a state obtained by observing, from the surface with the fine pattern formed, the mold according to this Embodiment;
FIG. 30 contains cross-sectional schematic diagrams illustrating fine patterns of dot structure of molds according to this Embodiment;
FIG. 31 is a top diagram illustrating the fine pattern of hole structure of the mold according to this Embodiment;
FIG. 32 is a top diagram of the mold illustrating the fine pattern of dot shape (hole shape) according to this Embodiment;
FIG. 33 is a top diagram illustrating the fine pattern of line-and-space structure of the mold according to this Embodiment;
FIG. 34 is a cross-sectional schematic diagram illustrating a resist layered product according to this Embodiment;
FIG. 35 contains explanatory diagrams illustrating the relationship between the unit area (Scm) and a concave-portion volume (Vcm) in the fine pattern of the resist layered product according to this Embodiment;
FIG. 36 contains explanatory diagrams illustrating the relationship between the unit area (Scm) and the concave-portion volume (Vcm) in the fine pattern of the resist layered product according to this Embodiment;

FIG. 37 contains explanatory diagrams illustrating the relationship between the nth resist layer and a unit area (Scr2) in the resist layered product according to this Embodiment;
FIG. 38 contains cross-sectional schematic diagrams illustrating arrangement examples of an elastic material in the pressing step of the resist layered product according to this Embodiment;
FIG. 39 contains cross-sectional schematic diagrams to explain a method of laminating the fine pattern and the nth resist layer in the resist layered product according to this Embodiment;
FIG. 40 contains cross-sectional schematic diagrams to explain a mold release method of the fine pattern from the nth resist layer in the resist layered product according to this Embodiment;
FIG. 41 is a cross-sectional schematic diagram to explain a peeling angle from the nth resist layer of the fine pattern in the resist layered product according to this Embodiment;
FIG. 42 is a cross-sectional schematic diagram illustrating a semiconductor light emitting device according to this Embodiment;
FIG. 43 is a graph showing results of Example 4;
FIG. 44 is a graph showing evaluation results of a resist layered product of Example 5;
FIG. 45 is a graph showing evaluation results of a concavo-convex structure product of Example 5; and
FIG. 46 is a graph showing evaluation results of a semiconductor light emitting device of Example 5.

Best Mode for Carrying Out the Invention

An Embodiment of the present invention will specifically be described below.
A mold according to this Embodiment is used to transfer a fine pattern of the mold to a transfer target material. The mold according to this Embodiment is provided with a fine pattern on its surface, and is characterized by having the fine pattern meeting the following four conditions at the same time on a part or whole of the surface of the mold.
First, a ratio (lcv/lcc) of a top width of convex-portion (lcv) to an opening width of concave-portion (lcc) of the fine pattern and a ratio (Sh/Scm) of an opening portion area (Sh) existing under a region of a unit area (Scm) of the surface (hereinafter, also referred to as fine pattern surface) with the fine pattern formed to the unit area (Scm) meet following equation (1). Second, the ratio (Sh/Scm) meets following equation (2). Third, the ratio (lcv/lcc) meets following equation (3). Finally, a height H of the fine pattern meets following equation (4).
[Mathematical Expression 2]

Eq. (1)

$$\sqrt{0.5/(Sh/Scm)} - 1 \leqq lcv/lcc \leqq \sqrt{1.1/(Sh/Scm)} - 1$$

Eq. (2)

$$0.23 < (Sh/Scm) \leq 0.99$$

Eq. (3)

$$0.01 \leq (lcv/lcc) < 1.0$$

Eq.4

$$50\,nm \leq H \leq 1500\,nm$$

According to the mold according to this Embodiment, (1) it is possible to fill inner portions of concave portions of the fine pattern with the transfer target material without extremely increasing the temperature and pressure in pressing the fine pattern of the mold against the transfer target material, it is also possible to improve flowability (outflow properties) of the transfer target material positioned below the convex portions of the fine pattern, and it is thereby possible to obtain a concavo-convex structure with a thin residual film thickness with ease. Then, (2) even when the residual film of the transfer target material with the concavo-convex structure transferred is thin, since it is possible to relax stress concentration on the residual film of the concavo-convex structure of the transfer target material in peeling off the mold, it

ispossible to prevent the residual film frombreaking, and since it is possible to suppress peeling stress on the concavo-convex structure, it is thereby possible to prevent the concavo-convex structure from breaking, and transfer accuracy of the transfer target material is improved. From these results, it is possible to provide the concavo-convex structure comprised of the transfer target material with the residual film thickness being thin and uniform on the workpiece. Accordingly, (3) since the residual film disposal is made ease on the concavo-convex structure, it is possible to improve processing accuracy in plane of the workpiece using the concave-convex structure as a mask.

A method of manufacturing a resist layered product of the present invention is a method of manufacturing the resist layered product as described above, and is characterized by including a pressing step of pressing a fine pattern of a mold against the surface of the nth resist layer in an atmosphere of low oxygen to obtain a mold layered product, an energy ray irradiation step of irradiating the nth resist layer of the mold layered product with an energy ray from the mold side and/or inorganic substrate side, and transferring the fine pattern to the nth resist layer to provide the concavo-convex structure, and a mold release step of peeling off the mold from the nth resist layer with the concavo-convex structure transferred thereto to obtain the resist layered product, where the resist layered product meets following equation (16).

Eq. (16)

$$0.1 \leq (Vr2/Vcm) \leq 1$$

A concavo-convex structure product of the present invention is a concavo-convex structure product manufactured by using the resist layered product as described above, and is characterized by being manufactured by a manufacturing method including a first etching step of removing, by dry etching, a residual film of the nth resist layer existing between a bottom portion of a concave portion in the concavo-convex structure of the nth resist layer and an interface between an (n-1) th resist layer and the nth resist layer from the surface side with the nth resist layer provided, a second etching step of etching, by dry etching, a first to (n-1) resist layers up to an interface between the first resist layer and the inorganic substrate after removing the residual film, and a third etching step of etching the inorganic substrate after the second etching step.

A method of manufacturing a resist layered product of the present invention is a method of manufacturing a resist layered product having a concavo-convex structure on a part or whole of its surface, and is provided with a step of preparing an inorganic substrate provided with a resist layer on its one main surface, and a step of pressing the mold as described above against the resist layer.

Further, the resist layered product according to this Embodiment is used in manufacturing of the concavo-convex structure product. The resist layered product is provided with an inorganic substrate, and a resist layer comprised of n layer (s) ($n \geq 1$) provided on one main surface of the inorganic substrate, and a surface of an nth resist layer that is an uppermost layer of the resist layer comprised of n layer (s) is provided with a concavo-convex structure. The concavo-convex structure is provided by transfer of a fine pattern of a mold, a thickness of a residual film after the transfer is 50 nm or less, and the ratio (lcv/lcc) of the top width of convex-portion (lcv) to the opening width of concave-portion (lcc) of the fine pattern of the mold is within a predetermined range. Further, the ratio (Vr2/Vcm) between the concave-portion volume (Vcm) of the fine pattern existing under a region of a unit area (Scm) of the fine pattern surface of the mold and the volume (Vr2) of the nth resist layer existing under a region of a unit area (Scr2) in the plane (hereinafter, also referred to as the nth resist layer plane) in the nth resist layer formed inside a surface parallel to one main surface of the inorganic substrate is within the predetermined range.

By such a configuration, since (1) the top width of convex-portion (lcv) and the opening width of concave-portion (lcc) of the fine pattern of the mold are within the predetermined ranges, it is possible to fill inner portions of concave portions of the fine pattern of the mold with the nth resist layer without extremely increasing the temperature and pressure in pressing, it is also possible to improve flowability (outflow properties) of the nth resist layer positioned below the convex portions of the fine pattern of the mold, and it is thereby possible to easily obtain a concavo-convex structure with a thin residual film thickness. Further, since the volume (Vcm) of the fine pattern of the mold and the unit volume (Vr2) of the nth resist layer are within the predetermined ranges, the volume (Vcm) of the fine pattern per unit volume (Vr2) of the nth resist layer 23 against which the mold is pressed is in a moderate range, the nth resist layer remaining between the convex portions of the fine pattern and the (n-1) th resist layer decreases, and it is possible to easily form a concavo-convex structure with a thin residual film with a thickness of 50 nm or less. Then, (2), even when the residual film of the concavo-convex structure is 50 nm or less, since the top width of convex-portion (lcv) and the opening width of concave-portion (lcc) of the fine pattern of the mold are within the predetermined ranges, it is possible to suppress stress concentration on the residual film of the concavo-convex structure of the nth resist layer in peeling off the mold, it is possible to prevent the concavo-convex structure from breaking, and transfer accuracy of the nth resist layer is improved. From these results, it is possible to actualize the resist layered product for enabling the concavo-convex structure with a high

height to be formed on the inorganic substrate as the workpiece with ease, and the concavo-convex structure product using the resist layered product. Accordingly, (3) since the residual film disposal is made ease on the concavo-convex structure, in the case where the layered number n of resists is one, it is possible to improve processing accuracy of the inorganic substrate in plane using the concave-convex structure as a mask. Further, (4) in the case where the layered number n of resists is two or more, since it ispossible to improveprocessabilityof the first to (n-1) resists using the concavo-convex structure as a mask, it is possible to improve processing accuracy of the inorganic substrate in plane using the nth resist layer as a mask.

An Embodiment of the present invention will specifically be described below with reference to accompanying drawings. A nanoimprint method according to this Embodiment will be described first. The nanoimprint method in the Description refers to a nanoimprint lithography method. In other words, the method is a method of transferring and adding a fine pattern of a mold to a resist to prepare a concavo-convex structure, processing (lithography) an inorganic substrate that is a workpiece using the concavo-convex structure, and obtaining the concavo-convex structure product. The concavo-convex structure product according to this Embodiment is obtained by any of the following manufacturing methods.

«The case where the layered number n of resist layers is one: Single layer»

First, prepared is a layered product formed by layering an inorganic substrate and a resist layer comprised of a single layer. A fine pattern of a mold provided with the fine pattern on its surface is transferred to the resist layer of the layered product to form a resist layered product having the concavo-convex structure on its surface. Then, concave portions of the concavo-convex structure of the resist layer are etched until the main surface of the inorganic substrate is exposed, and the fine mask pattern with the resist layer is formed on the inorganic substrate. Finally, the inorganic substrate as the workpiece is etched via the fine mask pattern to form the concavo-convex structure product. Such a case that the resist layer provided between the inorganic substrate and the mold is one layer is referred to as a single-layer resist. In addition, it is also possible to use a substrate with a hard mask beforehand provided on an inorganic substrate as the above-mentioned inorganic substrate. In this case, the hard mask is processed with the concavo-convex structure of the resist layer, and it is possible to process the inorganic substrate with the hard mask pattern.

« The case where the layered number n of resist layers is two or more: Multilayer»

First, prepared is a layered product formed by layering an inorganic substrate and resist layers comprised of n layers. A fine pattern of a mold provided with the fine pattern on its surface is transferred to the uppermost layer i.e. the nth resist layer of the layered product to form a resist layered product having the concavo-convex structure on its surface. Then, concave portions of the concavo-convex structure of the nth resist layer and a part of the first to (n-1) the resist layers are etched until the interface between the inorganic substrate and the first resist layer is exposed, and the fine mask pattern with the n layers is formed on the inorganic substrate. Finally, the inorganic substrate as the workpiece is etched via the fine mask pattern to form the concavo-convex structure product. Such a case that resist layers provided between the inorganic substrate and the mold are n layers ($n \geq 2$) is referred to as a multilayer resist. In addition, it is also possible to use a substrate with a hard mask beforehand provided on an inorganic substrate as the above-mentioned inorganic substrate. In this case, the hard mask is processed with the concavo-convex structure of the resist layer, and it is possible to process the inorganic substrate with the hard mask pattern.

As described above, in the resist layered product according to this Embodiment, the layered number n of resist layers is preferably two or more.

According to this configuration, it is possible to provide the concavo-convex structure with a residual film being uniform and thin on the (n-1)th resist layer. Therefore, by using the concavo-convex structure as a mask, it is possible to provide the concavo-convex structure with a high height comprised of the first to nth resist layers on the inorganic substrate. Accordingly, since the volume of the mask (concavo-convex structure comprised of the first to nth resist layers) increases in processing the inorganic substrate, it is possible to improve processability of the inorganic substrate.

Described next is a method of manufacturing a resist layered product according to this Embodiment.

The method of manufacturing a resist layered product according to this Embodiment uses a layered product provided with an inorganic substrate, and a resist layer comprised of n layer ($n \geq 1$) provided on one main surface of the inorganic substrate, and a mold having a fine pattern on its surface.

The method of manufacturing a resist layered product according to this Embodiment includes a pressing step of pressing a fine pattern of the mold against the nth resist layer plane to obtain a mold layered product, and a mold release step of peeling off the mold from the nth resist layer with the concavo-convex structure transferred to obtain a resist layered product. Particularly, when an energy ray curable substance is contained at least in the nth resist layer, it is preferable to include an energy ray irradiation step of irradiating the mold layered product with an energy ray from the mold side and/or inorganic substrate side between the pressing step and the mold release step. By these steps, it is possible to thin and uniform the thickness of the residual film of the concavo-convex structure transferred to the surface

of the nth resist layer. In addition, when the ratio (Vr2/Vcm) between the concave-portion volume (Vcm) of the fine pattern existing under a region of the unit area (Scm) of the fine pattern surface of the mold and the volume (Vr2) of the nth resist layer existing under a region of the unit area (Scr2) in the plane in the nth resist layer plane inside the surface parallel to one main surface of the inorganic substrate is 1 or less and the nth resist layer is the energy ray curable substance, the pressing step is performed in an atmosphere of low oxygen.

FIG. 2 contains cross-sectional schematic diagrams illustrating each step of the method of manufacturing a resist layered product according to one Embodiment of the present invention. As shown in FIGs. 2A to 2D, a resist layered product 30 is manufactured by a nanoimprint method using a mold 10. The mold 10 has a mold substrate 11, and a fine pattern 12 provided on the mold substrate 11. The surface of the fine pattern 12 is provided with a plurality of convex portions 12a and a plurality of concave portions 12b. For example, the mold 10 is a resin mold in the shape of a film or in the shape of sheet. In addition, as the mold 10, it is not always necessary to use a mold having the mold substrate 11, and a mold having only the fine pattern 12 may be used.

First, as shown in FIG. 2A, prepared is a layered product 20 provided with an inorganic substrate 21, first to (n-1) th resist layer 22 provided on the inorganic substrate 21, and the nth resist layer 23 provided on the first to (n-1)th resist layer 22. In addition, in the case of a single-layer resist, in other words, when the layered number n of resist layers is one, the first to (n-1) th resist layer 22 is the same as the nth resist layer 23 in FIG. 2A, and the interface does not exist between the first to (n-1) th resist layer 22 and the nth resist layer 23. On the other hand, in the case of a multilayer resist, in other words, when the layered number n of resist layers comprised of n layers is two or more, the resist layer 22 in FIG. 2A is comprised of layers of the first resist layer in contact with the inorganic substrate 21 to the (n-1) th resist layer in contact with the nth resist layer 23. Further, such a layered product may be used that the first to (n-1) th resist layer 22 and the nth resist layer 23 are comprised of multilayer structure with two or more layers. In addition, the following description expresses as a multilayer resist, and in the case of a single-layer resist, it is assumed to concurrently explain by substituting 1 for the layered number n in the following description.

Next, as shown in FIG. 2B, in the pressing step, the fine pattern 12 of the mold 10 is pressed against the nth resist layer 23 of the layered product 20 to obtain a mold layered product 24. Herein, when the ratio (Vr2/Vcm) is 1 or less and the nth resist layer contains an energy ray curable substance, pressing is performed in an atmosphere of low oxygen. Herein, a part of the surface portion of the nth resist layer 23 is filled into concave portions 12b of the fine pattern 12 of the mold 10, and the film thickness decreases in a region corresponding to the convex portions 12a of the fine pattern of the mold 10 in the nth resist layer 23. In the region with the film thickness decreased, a thin film (hereinafter, referred to as "residual film RF") with a predetermined thickness is formed between the bottoms of the concave portions 23b of the concavo-convex structure 23a and the interface S2 between the (n-1)th resist layer 22 and the nth resist layer 23 (see FIGs. 2C and 2D). Further, when the ratio (Vr2/Vcm) is 1 or less, predetermined gaps 24a are formed between the concave portions 12b of the fine pattern 12 of the mold 10 and the convex portions of the nth resist layer 23. Atmospheres in a pressing environment exist inside the gaps 24b. In other words, the inside of the gap 24a is the environment atmosphere used in pressing.

Next, as shown in FIG. 2C, in the energy ray irradiation step, energy rays (shown by arrows in the figure) are applied to the nth resist layer 23 of the mold layered product 24 from the mold 10 side and/or inorganic substrate side 21, and by applying the energy rays to a curable resin in a uncured state constituting the nth resist layer 23, the nth resist layer 23 is cured. By this means, the concavo-convex structure 23a associated with the fine pattern 12 of the mold 10 is transferred to the surface of the nth resist layer 23. In other words, the energy ray irradiation step is performed in the case where at least, the nth resist layer 23 contains an energy ray curable substance.

Next, as shown in FIG. 2D, in the mold release step, the fine pattern 12 of the mold 10 is peeled off from the nth resist layer 23 of the mold layered product 24. As a result, obtained is a resist layered product 30 provided with the inorganic substrate 21, first to (n-1)th resist layer 22 provided on the inorganic substrate 21, and the nth resist layer 23 with the concavo-convex structure 23a transferred to the surface provided on the first to (n-1)th resist layer 22. The resist layered product 30 is used in formation of the concavo-convex structure product 31 (see FIG. 3E). Herein, since the fine pattern 12 is peeled off in a state in which the concavo-convex structure 23a of the nth resist layer 23 is brought into intimate contact with the fine pattern 12 of the mold 10, when the opening width of the concave portion 12b of the fine pattern 12 is small and/or the depth of the concave portion 12b is deep, there is the case where stress arises in the outer edge portion of the convex portion 23c (see FIG. 3A) of the concavo-convex structure 23a in peeling off the mold 10 to cause a defect that the concavo-convex structure 23a breaks.

Described next is a method of manufacturing a concavo-convex structure product according to this Embodiment.

The method of manufacturing a concavo-convex structure product according to this Embodiment includes a first etching step of removing, by dry etching, a residual film RF of an nth resist layer to form a mask with a concavo-convex structure of the nth resist layer, a second etching step of etching the first to (n-1) resist layers up to an interface between the first resist layer and the inorganic substrate using the nth resist layer as a mask, and a third etching step of etching the inorganic substrate by dry etching or wet etching via the mask with the first to nth resist layers.

FIG. 3 contains cross-sectional schematic diagrams illustrating each step of the method of manufacturing a

concavo-convex structure product according to this Embodiment. In addition, the first to (n-1) th resist layer 22 and the nth resist layer 23 in FIG. 3 are also expressed as a multilayer resist as in FIG. 2, and it is assumed to concurrently explain the case of a single-layer resist by substituting 1 for the layered number n of resist layers in the following description. First, as shown in FIGs. 3A and 3B, in the first etching step, the residual film RF of the nth resist layer 23 of the resist layered product 30 is removed by dry etching. As a result, a mask comprised of the convex portions 23c of the nth resist layer 23 is formed. Herein, as the residual film RF formed by transfer of the fine pattern 12 of the mold 10 as described above is thinner and more uniform, the time required for removal of the residual film is shortened, changes in the shape of the convex portions 23c are suppressed, and the processing is made ease. In addition, when the residual film RF does not exist, it is not always necessary to perform the first etching step.

Next, as shown in FIG. 3C, in the second etching step, a part of the first to (n-1) th resist layer 22 is removed by dry etching via the mask comprised of the nth resist layer 23 until the inorganic substrate 21 is exposed. As a result, a fine mask pattern 25 comprised of the first to (n-1) th resist layer 22 and the nth resist layer 23 is formed. In addition, in the second etching step, for the purpose of controlling the shape of the fine mask pattern 25, it is possible to apply a plurality of dry etching conditions. Further, in the case of a single-layer resist, by performing only the first etching step, it is possible to form a fine mask pattern 25.

Next, the inorganic substrate 21 is subjected to dry etching via the fine mask pattern 25 to form a concavo-convex structure 31a on the surface of the inorganic substrate 21 (third etching step). In the case of a multilayer resist, as shown in FIG. 3D, the nth resist layer 23 is removed to form a fine mask pattern 25 comprised of the first to (n-1) th resist layer 22, and subsequently, dry etching may be performed on the inorganic substrate 21 via the fine mask pattern 25 to form the concavo-convex structure 31a on the surface of the inorganic substrate 21. Finally, as shown in FIG. 3E, the first to (n-1) thresist layer 22 is removedtomanufacture the concavo-convex structure product 31 provided with the concavo-convex structure 31a on the surface. In addition, removal of the first to (n-1) th resist layer 22 may be included in the third etching step.

In addition, in the method of manufacturing the resist layeredproduct 30 as described above, inpressing the mold 10 against the nth resist layer 23, there is the case that materials forming the nth resist layer 23 are not sufficiently filled into the concave portions 12b of the fine pattern 12 of the mold 10, depending on the composition of materials forming the nth resist layer 23, the shape of the opening of the concave portion 12b of the fine pattern 12 of the mold 10 and the shape of the concave portion 12b. In other words, there is the case that the residual film RF of the concavo-convex structure 23a of the nth resist has a large thickness. Further, when the film thickness of the nth resist layer 23 is thinned to thin the residual film RF, in pressing the mold 10 against the nth resist layer 23 , nano · micro bubbles or air voids may be enclosed. Herein, the nano · micro bubble is an air void on a scale of one to about several tens of concave portions of the fine pattern, and the air void is a phenomenon that an air void on a scale of millimeters is enclosed. Further, when the thickness of the residual film RF is 50 nm or less, in peeling off the mold 10 in intimate contact with the nth resist layer 23, there is the case that peeling stress concentrates on the residual film RF to break the concavo-convex structure 23a. Further, depending on the materials of the mold 10 and shape and arrangement of the fine pattern 12, in pressing the fine pattern 12 of the mold 10 against the nth resin layer 23 or peeling off from the nth resist layer 23, there is the case that the fine pattern 12 breaks. In these cases, pattern characteristics degrade in the concavo-convex structure 23a transferred to the surface of the nth resist layer 23, and there is the case that the aspect ratio and shape accuracy degrades in the concavo-convex structure 31a of the concavo-convex structure product 31 manufactured by using the resist layered product 30 or that the in-plane distribution of the concavo-convex structure 31a of the concavo-convex structure product 30 is large.

The inventor of the present invention found out that by setting the shape of the opening of the concave portion 12b of the fine pattern 12 of the mold 10 and the shape of the concave portion 12b withinpredetermined ranges, it is possible to make the thickness of the residual film RF 50 nm or less, and to resolve the above-mentioned defects, and arrived at completion of the present invention.

In other words, the mold according to this Embodiment is to resolve the above-mentioned issues by providing, on a part or whole of the surface of the mold, the fine pattern 12 such that the ratio (lcv/lcc) of the top width of convex-portion(lcv) to the opening width of concave-portion (lcc) of the fine pattern 12 and the ratio (Sh/Scm) of the opening portion area (Sh) existing under a region of the unit area (Scm) of the fine pattern 12 surface to the unit area (Scm) meet following equation (1), and that the ratio (Sh/Scm), the ratio (lcv/lcc) and the height H respectively meet following equation (2), following equation (3) and following equation (4).

[Mathematical Expression 3]

Eq. (1)

$$\sqrt{0.5/(Sh/Scm)} - 1 \leqq lcv/lcc \leqq \sqrt{1.1/(Sh/Scm)} - 1$$

Eq. (2)

$$0.23 < (Sh/Scm) \leq 0.99$$

Eq. (3)

$$0.01 \leq (lcv/lcc) < 1.0$$

Eq. 4

$$50nm \leq H \leq 1500nm$$

According to the mold 10, (1) it is possible to fill inner portions of concave portions 12b of the fine pattern 12 with the nth resist layer 23 without extremely increasing the temperature and pressure in pressing the fine pattern 12 of the mold 10 against the nth resist layer 23, it is also possible to improve flowability (outflow properties) of the nth resist layer 23 positioned below the convex portions 12a of the fine pattern 12, and it is thereby possible to obtain the concavo-convex structure 23a with a thickness of the residual film RF being thin with ease.

Then, (2) even when the residual film RF of the nth resist layer 23 with the concavo-convex structure 23a transferred is thin, since it is possible to relax stress concentration on the residual film RF of the concavo-convex structure 23a of the nth resist layer 23 in peeling off the mold 10, it is possible to prevent the concavo-convex structure 23a and the residual film RF from breaking, and transfer accuracy of the nth resist layer 23 is improved. Further, it is possible to suppress breakage of the fine pattern 12 of the mold 10 occurring in pressing the mold 10 and peeling. From these results, it is possible to enhance transfer accuracy of the concavo-convex structure 23a with a thickness of the residual film RF being thin.

Accordingly, (3) since the residual film disposal is made ease on the concavo-convex structure 23a, in the case of a single-layer resist, it is possible to improve processing accuracy of the inorganic substrate 21 in plane using the concave-convex structure 23a as a mask. Further, (4) in the case of a multilayer resist, since it is possible to improve processability of the first to (n-1) resists using the concavo-convex structure 23a as a mask, (3) it is possible to improve processing accuracy of the inorganic substrate 21 in plane using the fine mask pattern 25 of n layers as a mask.

Further, the resist layered product according to this Embodiment is to resolve the above-mentioned issues by the fact that (A) the ratio (lcv/lcc) of the top width of convex-portion (lcv) to the opening width of concave-portion (lcc) of the fine pattern 12 of the mold 10 meets following equation (3), (B) the ratio (Vr2/Vcm) between the concave-portion volume (Vcm) of the fine pattern 12 existing under a region of the unit area (Scm) of the surface with the fine pattern 12 formed of the mold 10 and the volume (Vr2) of the nth resist layer 23 existing under a region of the unit area (Scr2) in the plane in the nth resist layer 23 inside the surface parallel to one main surface of the inorganic substrate 21 meets following equation (9), and that (C) the thickness of the residual film DF in the resist layered product 30 as shown in FIG. 2C is 50 nm or less.

Eq. (3)

$$0.01 \leq (lcv/lcc) < 1.0$$

Eq. (9)

$$0.1 \leq (Vr2/Vcm) \leq 1.5$$

According to the resist layered product 30, since (A/1) the top width of convex-portion (lcv) and the opening width of concave-portion (lcc) of the fine pattern 12 of the mold 10 are within the predetermined ranges, it is possible to improve inflow properties of the nth resist layer 23 into the concave portions 12b of the fine pattern 12 of the mold 10 without extremely increasing the temperature and pressure in pressing, and it is also possible to improve outflow properties of the n resist layer disposed below the convex portions 12a of the fine pattern 12 of the mold 10.

Further, since (B/1) the volume (Vcm) of the fine pattern 12 of the mold 10 and the unit volume (Vr2) of the nth resist layer 23 are within the predetermined ranges, the volume (Vcm) of the fine pattern 12 per unit volume (Vr2) of the

nth resist layer 23 against which the mold 10 is pressed is in a moderate range, filling properties of the nth resist layer 23 into the concave portions 12b of the fine pattern 12 are improved, the nth resist layer 23 remaining between the convex portions 12a of the fine pattern 12 and the (n-1) th resist layer 22 decreases, and(C) it is possible to form the concavo-convex structure 23a with a thickness of the residual film RF of 50 nm or less.

Then, even when the thickness of the residual film RF of the concavo-convex structure 23a is made 50 nm or less, since (2/A) the top width of convex-portion (lcv) and the opening width of concave-portion (lcc) of the fine pattern 12 of the mold 10 are within the predetermined ranges, it is possible to suppress stress concentration on the concavo-convex structure 23a of the nth resist layer 23 in peeling off the mold 10, it is possible to prevent the concavo-convex structure 23a from breaking, and transfer accuracy of the nth resist layer 23 is improved. From these results, it is possible to actualize the resist layered product 30 for enabling the fine mask pattern 25 with a high aspect ratio to be easily formed on the inorganic substrate 21 as the workpiece, and the concavo-convex structure product 31 using the resist layered product.

Configurations of the mold 10, resist layered product 30 and concavo-convex structure product 31 as described above will specifically be described below.

<<Mold 10>>

The mold 10 is no limited particularly, as long as the mold 10 has the fine pattern 12 on a part or whole of the surface, the ratio (lcv/lcc) of the top width of convex-portion (lcv) to the opening width of concave-portion (lcc) of the fine pattern 12 and the ratio (Sh/Scm) of the opening portion area (Sh) existing under a region of the unit area (Scm) of the fine pattern 12 surface to the unit area (Scm) meet following equation (1), and the ratio (Sh/Scm), the ratio (lcv/lcc) and the height H concurrently meet following equation (2), following equation (3) and following equation (4), respectively.

[Mathematical Expression 4]

Eq. (1)

$$\sqrt{0.5/(Sh/Scm)}-1 \leqq lcv/lcc \leqq \sqrt{1.1/(Sh/Scm)}-1$$

Eq. (2)

$$0.23<(Sh/Scm)\leq 0.99$$

Eq. (3)

$$0.01\leq (lcv/lcc)<1.0$$

Eq.4

$$50\text{nm}\leq H\leq 1500\text{nm}$$

The meaning of above-mentioned equations (1) to (4) will be described respectively. In addition, in the following description, each equation will be described, and by meeting all the equations at the same time, it is possible to exert (1) filling properties, (2) transfer properties, and (3/4) processability with excellence.

Described first is the point of achieving a uniform and thin residual film RF in the pressing step of pressing the fine pattern 12 of the mold 10 against the nth resist layer 23. FIG. 4 is an explanatory diagram illustrating a state in which the fine pattern of the mold is pressed against the nth resist in the pressing step of the method of manufacturing a concavo-convex structure product according to this Embodiment.

In order to uniform and thin the residual film RF, it is necessary to concurrently meet mainly the following three requirements.

(A) As shown in FIG. 4, to improve outflowproperties, from apportion under the top of the convex portion 12a, of the nth resist layer 23 disposed under the top of the convex portion 12a of the fine pattern 12. When the outflow properties are low, a negative bias is applied to a decrease in the film thickness of the nth resist layer 23 disposed under the top of the convex portion 12a, it is difficult to achieve a thin residual film RF.

(B) As shown in FIG. 4, to suppress anchor and pinning effects of the flow of the resist materials forming the nth

resist layer 23 in the outer edge 12c of the top of the convex portion 12a of the fine pattern 12 when the nth resist layer 23 disposed under the top of the convex portion 12a of the fine pattern 12 flows out from the lower portion of the top of the convex portion 12a. In the case where the anchor and pinning effects occur with respect to the nth resist layer in the outer edge 12c, the flow of the resist materials forming the nth resist layer 23 is disturbed. In other words, uniformity of the residual film degrades.

(C) To improve inflow properties to the fine pattern 12 of the nth resist layer 23 disposed in a lower portion of the opening portion of the concave portion 12b of the fine pattern 12. When the inflow properties are low, since the outflow properties as described in above-mentioned (A) decrease, it is difficult to thin the residual film RF.

By taking the above-mentioned requirements (A) to (C) into consideration, it is possible to achieve a uniform thin residual film RF, and concurrently effectively suppress nano · micro bubbles in the pressing step.

Described next is the point of suppressing breakage of the residual film RF and crash of the concavo-convex structure 23a in the mold release step of peeling off the fine pattern 12 from the nth resist layer 23. FIG. 5 contains explanatory diagrams illustrating a state in which the fine pattern of the mold is peeled off from a concavo-convex structure of the nth resist in the mold release step of the method of manufacturing a concavo-convex structure product according to this Embodiment.

In order to suppress breakage of the thin residual film RF and crash of the concavo-convex structure 23a, it is necessary to concurrently meet mainly the following three requirements.

(D) As shown in FIG. 5A, to reduce moment energy applied to the convex portion 23c of the concavo-convex structure 23a. By the moment energy, the convex portion 23c becomes deformed as shown by alternate long and short dashed lines in FIG. 5A. When the moment energy is high, first, broken of the concave-convex structure 23a i.e. the crash of the concavo-convex structure 23a occurs. Further, when the moment energy is high, since concentration stress as described in (E) later is high, breakage of the residual film RF is promoted.

(E) As shown in FIG. 5A, to reduce concentration stress on the outer edge 23d of the bottom of the convex portion 23c of the concavo-convex structure 23a. When the concentration stress is high, since the moment energy of above-mentioned (D) is high, the crash of the concavo-convex structure 23a is promoted. Further, since moment energy to the residual film RF is high from the outer edge 23d of the bottom of the convex portion 23c as the starting point, as the residual film RF is thinner, resistance of the residual film RF to the moment energy decreases to promote the crash of the residual film RF.

(F) As shown in FIG. 5B, to reduce peeling energy 50 with respect to the residual film RF of the nth resist layer 23. When the peeling energy 50 is high, breakage of the RF occurs. More specifically, a cohesion failure of the residual film RF or peeling of the residual film RF in the interface between the nth resist layer 23 and the (n-1)th resist layer 22 occurs. Particularly, when the moment energy and concentration stress of above-mentioned (D) and (E) is high, the peeling energy 50 is also high.

By taking the above-mentioned requirements (D) to (F) into consideration, it is possible to suppress breakage of the residual film RF and crash of the concavo-convex structure 23a and to peel off the fine pattern 12 from the nth resist layer 23. In other words, by taking the above-mentioned requirements (A) to (F) into consideration, it is possible to obtain the concavo-convex structure 23a having a thin and uniform residual film.

By providing the fine pattern 12 concurrently meeting following equations (1) to (4) on a part or whole of the surface of the mold 10, since it is possible to set suitable values on (A) outflow properties of the nth resist layer in the pressing step as described above, (B) anchor and pinning effects with respect to the nth resist layer 23, (C) inflow properties of the nth resist layer 23, (D) moment energy with respect to the concave-convex structure 23a in the mold release step, (E) concentration stress on the concavo-convex structure 23a, and (F) peeling energy 50 with respect to the residual film RF, (1) filling properties of the nth resist layer 23 to the fine pattern 12 are improved, and (2) transfer accuracy of the concavo-convex structure 23a is improved. In other words, it is possible to obtain the concavo-convex structure 23a having a thin and uniform residual film.

[Mathematical Expression 5]

Eq. (1)

$$\sqrt{0.5/(Sh/Scm)}-1 \leqq lcv/lcc \leqq \sqrt{1.1/(Sh/Scm)}-1$$

Eq. (2)

$$0.23<(Sh/Scm)\leq 0.99$$

Eq. (3)

$$0.01\leq (lcv/lcc)<1.0$$

Eq.4

$$50nm\leq H\leq 1500nm$$

<<Relationship between (lcv/lcc) and (Sh/Scm)>>

When the ratio (lcv/lcc) is √(0.5/(Sh/Scm))-1 or less, or the ratio (lcv/lcc) is √(1.1/(Sh/Scm))-1 or more, disturbance of the flow of the resist materials forming the nth resist layer 23 is large in the outer edge 12c of the top of the convex portion 12a of the fine pattern 12. Therefore, it is presumed that residual stress inside the nth resist layer 23 is high. Further, the stress distribution is large to the outer edge 23d of the bottom of the convex portion 23c of the concavo-convex structure 23a of the nth resist layer 23 applied from the outer edge portion 12c of the top of the convex portion 12a of the fine pattern 12 in the mold release step. In other words, the site occurs at which stress extremely concentrates on the outer edge 23d of the bottom of the concave portion 23b of the concavo-convex structure 23a. In view of the forgoing, since it is conceivable that residual stress is high inside the concavo-convex structure 23a, mechanical strength of the concavo-convex structure 23a decreases. In addition, concentration stress is high on the outer edge 23d of the bottom of the concave portion 23b of the concavo-convex structure 23, therefore, the frequency is made high at which the crash of the concavo-convex structure 23a or breakage of the residual film RF arises. In addition, when the ratio (lcv/lcc) meets the range of above-mentioned equation (1), particularly, it is conceivable that since the disturbance of the flowof the nth resist layer is suppressed in the pressing step as described already, residual stress inside the nth resist layer 23 decreases, and that mechanical strength of the concavo-convex structure 23 is improved. Further, since it is possible to disperse stress applied to the outer edge 23d of the bottom of the concave portion 23b of the concavo-convex structure 23 in the mold release step, it is possible to suppress concentration stress applied to the outer edge 23d and to improve transfer accuracy.

Particularly, when the ratio (lcv/lcc) is √(0.5/(Sh/Scm))-1 or more, the ratio (Sh/Scm) exceeds 0.23, the ratio (lcv/lcc) is less than 1.0, and the height H is 1500 nm or less, since (1) improved are outflow properties of the nth resist layer 23 positioned in the portion under the convex portion 12a of the fine pattern 12 of the mold 10 and inflow properties into the concave portion 12b of the fine pattern 12 of the nth resist layer positioned in the lower portion of the concave portion 12b of the fine pattern 12, it is possible to uniformly thin the residual film RF of the nth resist layer irrespective of the layered number n of resists. Further, since (2) it is possible to relax concentration of peeling stress applied to the residual film RF of the concavo-convex structure 23a in peeling the mold 10 from the nth resist layer 23, transfer accuracy of the concavo-convex structure 23a is improved.

On the other hand, when the ratio (lcv/lcc) meets √(1.1/(Sh/Scm))-1 or less, the ratio (Sh/Scm) is 0. 99 or less, and the ratio (lcv/lcc) meets 0.01 or more, since it is possible to suppress breakage of the fine pattern 12 in pressing the mold 10 against the nth resist layer 23 or peeling, (1) improved is transfer accuracy of the concavo-convex structure 23a of the nth resist layer 23. Further, when the height H meets 50 nm or more, since it is possible to increase the volume of the convex portion 23c of the concave-convex structure 23a of the nth resist layer 23, in the case of a single-layer resist, processing accuracy of the inorganic substrate 21 is improved, and it is possible to obtain the concavo-convex structure product 31 with high accuracy in plane. (4) In the case of a multilayer resist, processing accuracy of the first to (n-1) th resist layer 22 is improved, and it is possible to improve physical stability of the fine mask pattern 25. Accordingly, (3) it is possible to improve processing accuracy in processing the inorganic substrate 21 using the fine mask pattern 25 as a mask.

In other words, by using the mold 10 including the fine pattern 12 meeting the area e shown by oblique lines in FIG. 6, (1) it is possible to uniformly thin the residual film RF of the nth resist layer 23, and (2) it is possible to transfer the concavo-convex structure 23a of the thin residual film RF without breaking. FIG. 6 is a graph to explain the first to fourth conditions of the fine pattern of the mold according to this Embodiment. In FIG. 6, the horizontal axis represents the ratio (Sh/Scm), and the vertical axis represents the ratio (lcv/lcc). The curve a shown in FIG. 6 represents (lcv/lcc)=√(1.1/(Sh/Scm))-1. The curve b represents (lcv/lcc)=√(0.5/(Sh/Scm))-1. Further, the straight line c represents

(Sh/Scm) =0.23, and the straight line d represents (Sh/Scm)=0.99. The straight line f represents (lcv/lcc)=1.0. Further, the straight line g represents (lcv/lcc)=0.01. In other words, the range of above-mentioned equation (1) is the area of the curve b or more while being the curve a or less in the vertical-axis direction. The range of above-mentioned equation (2) is the range exceeding the straight line c while being the straight line d or less in the horizontal-axis direction. The range of above-mentioned equation (3) is the range less than the straight line f while being the straight line g or more in the vertical-axis direction. Accordingly, the mold 10 according to the present invention is the mold 10 provided on a part or whole of the surface with the fine pattern 12 meeting the area shown by the oblique-line area e in FIG. 6 and above-mentioned equation (4). In addition, an area of the mold that does not meet the area e of the mold may be comprised of the fine pattern that does not meet the above-mentioned area e, or may be a flat portion without the fine pattern.

From the viewpoint of more exerting the above-mentioned effects, the ratio (lcv/lcc) is preferably $\sqrt{(0.6/(Sh/Scm))}$-1 or more, more preferably $\sqrt{(0.7/ (Sh/Scm))}$-1 or more, further preferably $\sqrt{(0.76/(Sh/Scm))}$-1 or more, and most preferably $\sqrt{(0.78/(Sh/Scm))}$-1 or more. In other words, curves b1, b2, b3, b4 and b5 or more as shown in FIG. 7 are more preferable in this order. In the graph in FIG. 7, the horizontal axis represents the ratio (Sh/Scm), and the vertical axis represents the ratio (lcv/lcc). When (lcv/lcc)=$\sqrt{(\alpha/(Sh/Scm))}$-1 is described, in FIG. 7, the curve b1 represents $\alpha$=0.5, the curve b2 represents $\alpha$=0.6, the curve b3 represents $\alpha$=0.7, the curve b4 represents $\alpha$=0.76, and the curve b5 represents $\alpha$=0.78.

Further, the curve a and straight lines c, d, f and g are the same as those in FIG. 6. In other words, the fine pattern 12 that is more preferable according to the present invention is areas of the curve a or less in the vertical-axis direction, and areas exceeding the straight line c while being the straight line d or less in the horizontal-axis direction, less than the straight line f while being the straight line g or more in the vertical-axis direction, and of the curve b1, b2, b3, b4 or b5 or more in the vertical-axis direction. Particularly, when (lcv/lcc) = $\sqrt{(\alpha/(Sh/Scm))}$-1 is described, as the $\alpha$ increases, in other words, as the curve b shifts upward from the b1 to b5 sequentially, the area of the curve a or less, exceeding the straight line c while being the straight line d or less, less than the straight line f while being the straight line g or more, and of the curve b or more is narrowed, and the fine pattern 12 meeting the narrower area is capable of (B) suppressing the anchor and pinning effects with respect to the flow of the resist materials forming the nth resist layer 23 in the pressing step, and thereby enables uniformity of the residual film RF to be improved. Further, it is possible to (E) reduce concentration stress applied to the outer edge 23d of the bottom of the convex portion 23c of the concavo-convex structure 23a in the mold release step, and in association therewith, to (F) reduce peeling energy applied to the residual film RF, and it is thereby possible to suppress the crash of the concavo-convex structure 23a and breakage of the residual film RF. In other words, it is possible to more excellently attain (1) uniformly thinning the residual film RF of the nth resist layer 23 and (2) transferring the concavo-convex structure 23a of the thinresidual filmRF without breaking as described above. In addition, a portion of the mold that does not meet the fine pattern according to the present invention as described above may be comprised of a fine pattern different from the fine pattern according to the invention as described above, or may be a flat portion without the fine pattern.

Furthermore, from the viewpoint of more exerting the above-mentioned effects, the ratio (lcv/lcc) preferably meets $\sqrt{(1.0/(Sh/Scm))}$-1 or less, preferably meets $\sqrt{(0.95/(Sh/Scm))}$-1 or less, more preferably meets $\sqrt{(0.93/(Sh/Scm))}$-1 or less, and most preferably meets $\sqrt{(0.91/(Sh/Scm))}$-1 or less. In other words, curves al, a2, a3, a4 and a5 or less as shown in FIG. 8 are more preferable in this order. In the graph in FIG. 8, the horizontal axis represents the ratio (Sh/Scm), and the vertical axis represents the ratio (lcv/lcc). When (lcv/lcc) = $\sqrt{(\alpha/(Sh/Scm))}$-1 is described, in FIG. 8, the curve a1 represents $\alpha$=1.1, the curve a2 represents $\alpha$=1. 0 , the curve a3 represents $\alpha$=0. 95 , the curve a4 represents $\alpha$=0.93, and the curve a5 represents $\alpha$=0.91.

Still furthermore, the curve b and straight lines c, d, f and g are the same as those in FIG. 6. In other words, the fine pattern 12 that is more preferable according to the present invention is areas of the curve b or more in the vertical-axis direction, and areas exceeding the straight line c while being the straight line d or less in the horizontal-axis direction, less than the straight line f while being the straight line g or more in the vertical-axis direction, and of the straight line a1, a2, a3, a4 or a5 or less in the vertical-axis direction. Particularly, when (lcv/lcc) = $\sqrt{(\alpha/(Sh/Scm))}$ -1 is described, as the $\alpha$ decreases, in other words, as the curve a shifts downward from the a1 to a5 sequentially, the area of the curve b or more, exceeding the straight line c while being the straight line d or less, less than the straight line f while being the straight line g or more, and of the curve a or more is narrowed, the fine pattern 12 meeting the narrower area is capable of (B) suppressing the anchor and pinning effects with respect to the flow of the resist materials forming the nth resist layer 23 in the pressing step, (A) improved are the outflow properties of the nth resist layer 23 disposed in under the top of the convex portion 12a, and it is possible to more improve thinning and uniformity of the residual film RF. Further, it is possible to (E) reduce concentration stress applied to the outer edge 23d of the bottom of the convex portion 23c of the concavo-convex structure 23a in the mold release step, and in association therewith, to (F) reduce peeling energy applied to the residual film RF, and it is thereby possible to suppress the crash of the concavo-convex structure 23a and breakage of the residual film RF. In other words, it is possible to more excellently attain (1) uniformly thinning the residual film RF of the nth resist layer 23 and (2) transferring the concavo-convex structure 23a of the thin residual film RF without

breaking as described above. It is possible to more excellently attain (1) uniformly thinning the residual film RF of the nth resist layer 23 and (2) transferring the concavo-convex structure 23a of the thin residual film RF without breaking as described above. In addition, a portion of the mold that does not meet the fine pattern according to the present invention as described above may be comprised of a fine pattern different from the fine pattern according to the invention as described above, or may be a flat portion without the fine pattern.

As described above, in the mold 10 according to this Embodiment, it is preferable that the fine pattern 12 meets following equation (5).

[Mathematical Expression 6]

Eq. (5)

$$\sqrt{0.76/(Sh/Scm)} - 1 \leqq lcv/lcc \leqq \sqrt{0.93/(Sh/Scm)} - 1$$

According to this configuration, it is possible to more suppress the anchor and pinning effects of the nth resist layer 23 in the vertex-portion outer edge portions of the convex portion 12a of the fine pattern 12 occurring in pressing the fine pattern 12 of the mold 10 against the transfer target material. Therefore, it is possible to (1) improve filling properties of the nth resist layer 23 into the fine pattern 12. Further, it is possible to relax concentration stress applied to the outer edge 23d of the bottom of the convex portion 23c of the concavo-convex structure 23 from the outer edge portion of the bottom of the convex portion 12a of the fine pattern 12 occurring in peeling off the mold 10 from the concavo-convex structure 23a, and it is thereby possible to (2) more suppress breakage of the residual film RF and breakage of the concavo-convex structure 23a.

Further, the mold 10 according to this Embodiment may meet following equation (6).

[Mathematical Expression 7]

Eq. (6)

$$\sqrt{0.78/(Sh/Scm)} - 1 \leqq lcv/lcc \leqq \sqrt{0.91/(Sh/Scm)} - 1$$

In this case, since it is possible to further exert the above-mentioned effects, (1) the filling properties of the nth resist layer 23 into the fine pattern 12 are excellent, and reductions in the residual film proceed. Further, (2) it is possible to relax the force (stress) relating to peeling on the concavo-convex structure 23a, and it is thereby possible to suppress breakage of the residual film RF and breakage of the concavo-convex structure 23a, and to improve transfer accuracy.

<<Ratio (Sh/Scm) >>

When the ratio (Sh/Scm) is 0.23 or less, it is conceivable that flowability of the nth resist layer 23 disposed in the lower portion of the convex portion of the fine pattern 12 decreases in the pressing step. The reason is presumed that such a phenomenon occurs at an early stage that the viscosity of the nth resist layer 23 apparently increases as the film thickness (RF) is thinner in the nth resist layer 23 disposed in the lower portion of the convex portion 12a of the fine pattern 12. On the other hand, when the ratio (Sh/Scm) exceeds 0.99, since the degree of deformation or breakage of the fine pattern 12 increases inpressing the fine pattern 12 against the nth resist layer 23, transfer accuracy degrades. Particularly, from the viewpoints of (A) promoting outflow properties of the nth resist layer 23 disposed in the portion under the convex portion 12a of the fine pattern 12 in the pressing step and improving inflow properties of the nth resist layer 23 disposed in the lower portion of the concave portion 12b of the fine pattern 12, the ratio is more preferably 0.4 or more, more preferably 0.45 or more, and most preferably 0.6 or more.

Particularly, when the ratio (Sh/Scm) meets the range of 0.4 or more and concurrently meets the relationship between the ratio (lcv/lcc) and the ratio (Sh/Scm) as described already, it is possible to (E) reduce concentration stress applied to the outer edge 23d of the bottom of the convex portion 23c of the nth resist layer 23, and transfer accuracy is improved in the nth resist layer 23. Further, when the ratio (Sh/Scm) meets the range of 0.45 or more and concurrently meets the relationship between the ratio (lcv/lcc) and the ratio (Sh/Scm) as described already, even in the case of low surface energy on the fine pattern 12 of the mold 10 as described below, the nth resist layer 23 is capable of recognizing the fine pattern 12 , and of being wet and spread into the fine pattern 12 so as to maximize a radius of the curvature of a virtual droplet of the nth resist layer 23 formed inside the concave portion 12b of the fine pattern 12. In other words, since it is possible to (B) suppress anchor and pinning effects on the nth resist layer 23 in the pressing step, flow

disturbance of the nth resist layer 23 is suppressed, and it is possible to thin the residual film and to improve uniformity. In addition, the virtual droplet means a droplet of the nth resist layer 23 assumed to exist inside the concave portion 12b of the fine pattern 12.

Further, when the ratio (Sh/Scm) meets the range of 0.6 or more, more preferably meets the range of 0.65 or more and concurrently meets the relationship between the ratio (lcv/lcc) and the ratio (Sh/Scm) as described already, in addition to the above-mentionedeffects, potential works in the direction from above the convex portion 12a of the fine pattern 12 to the inside of the concave portion 12b, stability of the nth resist layer 23 is improved in pressing the mold 10 against the nth resist layer 23, and such ranges are preferable. In other words, (C) improved are the inflow properties into the concave portion 12b of the nth resist layer 23 disposed in the lower portion of the concave portion 12b of the fine pattern 12 in the pressing step, and by the inflow properties, it is possible to (B) promote the outflow properties of the nth resist layer 23 disposed in the portion under the convex portion 12a of the fine pattern 12.

Furthermore, from the viewpoint of more exerting the above-mentioned effects, the ratio (Sh/Scm) is preferably 0.7 or more. (Sh/Scm) is more preferably 0.75 or more, and further preferably 0.8 or more. In other words, straight lines c1, c2, c3, c4, c5, c6 and C7 or more as shown in FIG. 9 are more preferable in this order. In the graph in FIG. 9, the horizontal axis represents the ratio (Sh/Scm), and the vertical axis represents the ratio (lcv/lcc). InFIG. 9, the straight line c1 represents (Sh/Scm) =0.23, the straight line c2 represents (Sh/Scm)=0.4, the straight line c3 represents (Sh/Scm)=0.45, the straight line c4 represents (Sh/Scm) = 0.6, the straight line c5 represents (Sh/Scm)=0.65, the straight line c6 represents (Sh/Scm)=0.7, and the straight line c7 represents (Sh/Scm)=0.8. Further, the curves a4 and b4 are the cases that $\alpha$=0.93 and $\alpha$=0.76, respectively, when (lcv/lcc)=$\sqrt{(\alpha/(Sh/Scm))}$-1 is described.

Still furthermore, the straight lines d, f and g are the same as those in FIG. 6. In other words, the fine pattern 12 that is more preferable according to the present invention is areas of the curve a4 or less while being the curve b4 or more in the vertical-axis direction, and areas of the straight line d or less in the horizontal-axis direction, less than the straight line f while being the straight line g or more in the vertical-axis direction, and exceeding straight lines c1, c2, c3, c4, c5, c6 or c7 or more in the horizontal-axis direction. Particularly, as the ratio (Sh/Scm) increases, in other words, as the straight line c shifts rightward from the c1 to c7 sequentially, the area is narrowed, the fine pattern 12 meeting the narrower area is capable of (E) reducing concentration stress applied to the outer edge 23d of the bottom of the convex portion 23c of the nth resist layer 23, and transfer accuracy is improved in the nth resist layer 23. In other words, since it is possible to (B) suppress the anchor and pinning effects with respect to the nth resist layer 23, flow disturbance of the nth resist layer is suppressed, and it is possible to thin the residual film and improve uniformity. Further, (C) improved are the inflow properties into the concave portion 12b of the resist layer 23 disposed in the lower portion of the concave portion 12b of the fine pattern 12 in the pressing step, and by the inflow properties, it is possible to (B) promote the outflow properties of the nth resist layer disposed in the portion under the convex portion 12a of the fine pattern 12. Therefore, thinning and uniformity of the residual film RF more proceed. At the same time, since it is possible to (F) reduce peeling energy applied to the residual film RF due to the outer edge 23d of the bottom of the convex portion 23c of the nth resist layer 23 in the mold release step, it is possible to suppress the crash of the concavo-convex structure 23a and breakage of the residual film RF, and transfer accuracy of the concavo-convex structure 23a is thereby improved. In addition, FIG. 9 shows the curves a4 and b4 with $\alpha$=0.93 and $\alpha$=0.76, respectively, when (lcv/lcc)=$\sqrt{(\alpha/(Sh/Scm))}$-1 is described, and these curves a and b are capable of adopting equation (1) as described above and the more preferable ranges within equation (1). In addition, a portion of the mold that does not meet the first to fourth conditions of the fine pattern 12 according to this Embodiment as described above may be comprised of a fine pattern different from the fine pattern according to the invention as described above, or may be a flat portion without the fine pattern.

Moreover, the ratio (Sh/Scm) is preferably 0.95 or less. When the ratio is 0.95 or less, it is possible to suppress breakage of the fine pattern 12 occurring in pressing the mold 10 against the nth resist layer 23. Particularly, when the ratio is 0.93 or less and more preferably 0.91 or less, it is possible to more exert the above-mentioned effects, and to (A) improve the outflow properties of the nth resist layer 23 into the concave portion 12b of the fine pattern 12, and it is thereby possible to thin and uniform the residual film while suppressing breakage of the mold 10.

As described above, the mold 10 according to this Embodiment may meet following equation (7).

Eq. (7)

$$0.4 \leq (Sh/Scm) \leq 0.95$$

In this case, particularly, the inflow properties into the concave portion 12b of the fine pattern 12 are improved in the resist materials forming the nth resist layer 23, and it is possible to further reduce peeling stress on the concavo-convex structure 23a.

Further, the mold 10 according to this Embodiment may meet following equation (8).

Eq. (8)

$$0.6 \leq (Sh/Scm) \leq 0.95$$

According to this configuration, it is possible to more suppress the anchor and pinning effects of the nth resist layer 23 in the vertex-portion outer edge portion of the convex portion 12a of the fine pattern 12 occurring in pressing the fine pattern 12 of the mold 10 against the n the resist layer 23. Therefore, it is possible to (1) improve the filling properties of the nth resist layer 23 into the fine pattern 12. Further, it is possible to relax concentration stress applied to the outer edge 23d of the bottom of the convex portion 23c of the concavo-convex structure 23 from the outer edge portion of the bottom of the convex portion 12a of the fine pattern 12 occurring in peeling off the mold 10 from the concavo-convex structure 23a, and it is thereby possible to (2) more suppress breakage of the residual film RF and breakage of the concavo-convex structure 23a.

<<Ratio (lcv/lcc)>>

When the ratio (lcv/lcc) of the top width of convex-portion (lcv) to the opening width of concave-portion (lcc) in the fine pattern 12 of the mold 10 is less than 1.0, (C) the inflow properties into the concave portion 12b are improved in the nth resist layer 23 disposed below the opening portion of the concave portion 12b of the fine pattern 12 of the mold 10, and (A) the outflow properties into the concave portion 12b of the fine pattern 12 of the mold 10 are also improved in the nth resist layer 23 below the top of the convex portion 12a of the fine pattern 12 of the mold 10. Therefore, it is possible to improve the filling properties of the nth resist layer 23 into the concave portions 12b of the fine pattern 12 of the mold 10, and to thin the thickness of the residual film RF. Further, it is possible to (E) reduce stress applied to the outer edge23d of the bottom of the convex portion 23c of the concave-convex structure 23a in peeling off the mold 10 from the nth resist layer 23. In other words, by setting (lcv/lcc)<1.0, it is possible to (1) improve the filling properties of the nth resist layer 23 into the fine pattern 12, and to (2) obtain the concave-convex structure 23a with a thin thickness of the residual film RF with high transfer accuracy. Further, by meeting 0.01≥(lcv/lcc), it is possible to (2) suppress the crash of the concave portion 12a of the fine pattern 12 in peeling off the mold 10 from the nth resist layer 23.

Particularly, when the ratio (lcv/lcc) meets 0.02 or more, since it is possible to (A) improve the outflow properties of the nth resist layer into the concave portion 12b of the fine pattern 12 in the pressing step, it is possible to thin and uniform the residual film while suppressing breakage of the mold 10.

Furthermore, when the ratio (lcv/lcc) meets 0.85 or less, particularly, since it is possible to (B) suppress the anchor and pinning effects with respect to the nth resist layer 23 in the pressing step, it is possible to (A) promote an outflow of the nth resist layer 23 from the lower portion of the convex portion 12a of the fine pattern 12. From the same effects, the ratio (lcv/lcc) more preferably meets 0.65 or less, and most preferably meets 0.50 or less. In addition, a portion of the mold that does not meet the first to fourth conditions of the fine pattern 12 according to this Embodiment as described above may be comprised of a fine pattern different from the fine pattern 12 according to this Embodiment as described above, or may be a flat portion without the fine pattern.

Herein, when surface free energy of the fine pattern 12 of the mold 10 is reduced so as to facilitate peeling of the mold 10 in the mold release step by decreasing the adhesion force between the nth resist layer 23 and the fine pattern 12 of the mold 10, it is possible to improve transfer accuracy of the concave-convex structure 23a, and on the other hand, there is the case that the filling properties into the fine pattern 12 of the mold 10 degrade in the nth resist layer 23 in the pressing step.

Even in such a case, in consideration of pressure in dislocation from the Cassie-Baxter mode to Wenzel mode of the droplet of the nth resist layer 23 in contact with the fine pattern 12 of the mold 10, inverse-dislocation from the Wenzel mode to Cassie-Baxter mode caused by potential applied to the convex portion 12a from the concave portion 12b of the fine pattern 12, the level relationship between the level for stabilizing the nth resist layer 23 and the fine pattern 12, and conditions such that the behavior of the nth resist layer 23 in contact with the convex portion 12a of the fine pattern 12 is absolutely made the Wenzel mode eventually, by the ratio (lcv/lcc) meeting the following ranges within the widest range (0.01≤(lcv/lcc)<1.0) as described above, it is possible to hold the filling properties of the nth resist layer 23 into the fine pattern 12 excellent.

In other words, by meeting (lcv/lcc)≤0.42, it is possible to (1) fill the fine pattern 12 of the mold 10 with the nth resist layer 23 with ease, and (2) suppress a fall of the concavo-convex structure 23a by peeling off the mold 10. Further, since it is possible to reduce energy, released in peeling, applied to the outer edge 23d of the bottom of the convex portion 23c of the concavo-convex structure 23a in peeling off the mold 10, it is possible to further improve transfer accuracy.

From the viewpoint of further exerting the above-mentioned effects, it is preferable that (lcv/lcc)≤0.35, and it is more preferable that (lcv/lcc)≤0.28. Further, from the viewpoints of increasing a material selection margin of the nth resist layer 23, decreasing the volume of the nth resist layer 23, in contact with the convex portion 12a of the fine pattern 12 of the mold 10, semi-stabilized by the pinning effect, and thinning the thickness of the residual film RF by a lower

pressing force, (lcv/lcc)≤0.18 is preferable, (lcv/lcc)≤0.14 is more preferable, and (lcv/lcc)≤0.10 is particularly preferable. Furthermore, when (lcv/lcc)≤0.06, it is possible to further decrease thickness unevenness of the film thickness of the nth resist layer 23 in the pressing step, and it is also possible to improve residual film thickness uniformity of the concavo-convex structure 23a.

By using the mold 10 including the fine pattern meeting the above-mentioned predetermined ranges, improved are (1) the filling properties of the nth resist layer 23 and (2) transfer accuracy of the concavo-convex structure 23a, and in association therewith, it is possible to more improve (3) processing accuracy of the inorganic substrate 21 and (4) physical stability of the fine mask pattern 25.

Particularly, when the fine pattern 12 meets the area e as shown in FIG. 10, even when the modulus of elasticity of the nth resist layer 23 is made higher than the modulus of elasticity of the bulk by thinning the film thickness of the nth resist layer 23, since it is possible to increase flowability of the nth resist layer 23, it is possible to thin and uniform the residual film RF with ease, and to improve transfer accuracy. In the graph in FIG. 10, the horizontal axis represents the ratio (Sh/Scm), and the vertical axis represents the ratio (lcv/lcc). The area e is the area concurrently meeting (lcv/lcc) ≥√(0.76/(Sh/Scm))-1 (curve b4 or more in FIG. 10), (lcv/lcc)≤√(0.93/(Sh/Scm))-1 (curve a4 or less in FIG. 10), (lcv/lcc) ≥0.01 (straight line g or more in FIG. 10), (lcv/lcc)≤0.50 (straight line f or less in FIG. 10), (Sh/Scm)≥0.40 (straight line c2 or more in the horizontal-axis direction in FIG. 10), and (Sh/Scm)≤0.95 (straight line d or less in the horizontal-axis direction in FIG. 10). In addition, a portion of the mold 10 that does not meet the first to fourth conditions of the fine pattern 12 according to this Embodiment as described above may be comprised of a fine pattern different from the fine pattern 12 according to this Embodiment as described above, or may be a flat portion without the fine pattern.

From the viewpoint of more exerting the above-mentioned effects, it is preferable that the fine pattern 12 of the mold 10 meets the area e as shown in FIG. 11. In the graph in FIG. 11, the horizontal axis represents the ratio (Sh/Scm), and the vertical axis represents the ratio (lcv/lcc). The area e is the area concurrently meeting (lcv/lcc)≥√(0.76/(Sh/Scm))-1 (curve b4 or more in FIG. 11), (lcv/lcc)≤√(0.93/(Sh/Scm))-1 (curve a4 or less in FIG. 11), (lcv/lcc)≥0.01 (straight line g or more in FIG. 11), (lcv/lcc)≤0.28 (straight line f or less in FIG. 11), (Sh/Scm) ≥0.60 (straight line c4 or more in the horizontal-axis direction in FIG. 11), and (Sh/Scm)≤0.95 (straight line d or less in the horizontal-axis direction in FIG. 11). In addition, a portion of the mold that does not meet the first to fourth conditions of the fine pattern 12 according to this Embodiment as described above may be comprised of a fine pattern different from the fine pattern 12 according to this Embodiment as described above, or may be a flat portion without the fine pattern.

<<Height H>>

While meeting the relationship between the ratio (lcv/lcc) and the ratio (Sh/Scm), the range of the ratio (lcv/lcc) and the range of the ratio (Sh/Scm), the height H of the fine pattern meets above-mentioned equation (4). FIG. 12 is cross-sectional schematic diagram illustrating the mold according to this Embodiment. The height (H) as shown in FIG. 12 means the height (or depth, the same in the following description) of the fine pattern 12. When there are fluctuations in the height (H), an arithmetical mean value of the convex-portion height (H) is obtained according to the following procedure, and is used as the convex-portion height (H) . First, the mold 10 is subjected to sampling to include an area of 10mm x 10mm square. In addition, this sample piece is also used in measuring lcv, lcc, Sh and Scm that are parameters constituting the first to fourth conditions of the fine pattern 12. In other words, the height (H), lcv, lcc, Sh and Scm are measured inside the area of 10mm x 10mm square. Next, the cross section of a sample piece of 10mm x 10mm square or more is observed with a scanning electron microscope. In scanning electron microscope observation, five points are selected arbitrarily from the sample piece with a length of 10 mm, and the height H is measured. Herein, it is assumed that sample points A, B, C, D and E are selected. First, the sample point A is enlarged until at least ten or more concave portion shapes of the fine pattern 12 are photographed. Next, the heights (H) are measured in the observed ten or more concave portions. It is assumed that the maximum height among measured heights (H) is hA. With respect to the sample points B, C, D and E, the same operation is performed to obtain hB, hC, hD, and hE. The arithmetical mean value of the convex-portion height (H) is given as (hA+hB+hC+hD+hE)/5. By the height (H) meeting this range, it is possible to (1) ensure the filling properties of the nth resist layer 23 into the fine pattern 12, and to (2) suppress a pattern crash of the concavo-convex structure 23a formed in the nth resist layer 23 in the mold release step. Particularly, from the viewpoints of (C) improving the inflow properties of the nth resist layer 23 into the concave portion 12b of the fine pattern 12 in the pressing step, while (D) reducing moment energy applied to the convex portion 23a of the concavo-convex structure 23c in the mold release step, the height (H) preferably ranges from 50 nm to 1000 nm, and more preferably ranges from 100 nm to 800 nm. Further, from the viewpoints of reducing the pressing environmental atmosphere included inside the fine pattern 12, and improving transfer accuracy of the concavo-convex structure 23a formed with the nth resist layer 23, the height (H) is more preferably 600 nm or less, and most preferably 400 nm or less. In addition, a portion of the mold 10 that does not meet the first to fourth conditions of the fine pattern 12 according to this Embodiment as described above may be comprised of a fine pattern different from the fine pattern 12 according to this Embodiment as described above, or may be a flat portion without the fine pattern.

By using the mold 10 including the fine pattern 12 as described above, it is possible to process inorganic substrates with ease. Particularly, by using the mold of the invention for processing of substrate surfaces for semiconductor light emitting devices, it is possible to manufacture semiconductor light emitting devices with high efficiency. For example, in the case of selecting a sapphire substrate, SiC substrate, Si substrate, spinel substrate or nitride semiconductor substrate to process as the inorganic substrate, when a light emitting semiconductor device (for example, LED) is manufactured using the processed inorganic substrate, it is possible to concurrently improve internal quantum efficiency and light extraction efficiency of the LED. In other words, by using, as the substrate for the semiconductor light emitting device, the concave-convex structure product 31 provided with the concavo-convex structure 31a on the surface comprised of the sapphire substrate, SiC substrate, Si substrate, spinel substrate or nitride semiconductor substrate to manufacture an LED, it is possible to manufacture the LED allowed to attain high external quantum efficacy.

By using the mold 10 including the fine pattern 12 meeting the area e shown by oblique lines in FIG. 6, it is possible to make a moderate ratio between the size of the convex portion of the concavo-convex structure 31a of the concavo-convex structure product 31 and the flat surface of the concave-portion bottom portion. Therefore, in forming the semiconductor crystal layer on the concavo-convex structure 31a, it is possible to disturb the growth mode of the semiconductor crystal layer, and it is possible to reduce the density of dislocation occurring inside the semiconductor crystal layer, and to improve internal quantum efficiency. In FIG. 6, as described previously, the curve a represents (lcv/lcc)=√(1.1/(Sh/Scm))-1. The curve b represents (lcv/lcc)=√(0.5/(Sh/Scm))-1. Further, the straight line c represents (Sh/Scm)=0.23, the straight line d represents (Sh/Scm)=0.99, the straight line f represents (lcv/lcc)=1.0, and the straight line g represents (lcv/lcc)=0.01.

Further, from the viewpoints of more improving light extraction efficiency while maintaining improvements in internal quantum efficiency of the LED, particularly, it is preferable to use the mold 10 including the fine pattern 12 meeting the area e as shown in FIG. 10. In this case, since it is possible to increase the size of the convex portion of the concave-convex structure product 31, it is possible to increase the number of modes of light diffraction with respect to emitted light of the LED, and light extraction efficiencyisimproved. In FIG. 10, as described already, the area e is the area concurrently meeting (lcv/lcc)(0.76/(Sh/Scm))-1 (curve b4 or more in FIG. 10), (lcv/lcc)≤√(0.93/(Sh/Scm))-1 (curve a4 or less in FIG. 10), (lcv/lcc)≥0.01 (straight line g or more in FIG. 10), (lcv/lcc)≤0.50 (straight line f or less in FIG. 10), (Sh/Scm)≥0.40 (straight line c2 or more in the horizontal-axis direction in FIG. 10), and (Sh/Scm)≤0.95 (straight line d or less in the horizontal-axis direction in FIG. 10).

From the viewpoint of more exerting the above-mentioned effects, it is preferable that the fine pattern 12 of the mold 10 includes the area e as shown in FIG. 11. In FIG. 11, as described previously, the area e is the area concurrently meeting (lcv/lcc)(0.76/(Sh/Scm))-1 (curve b4 or more in FIG. 11), (lcv/lcc)≤√(0.93/(Sh/Scm))-1 (curve a4 or less in FIG. 11), (lcv/lcc)≥0.01 (straight line g or more in FIG. 11), (lcv/lcc)≤0.28 (straight line f or less in FIG. 11), (Sh/Scm) ≥0.60 (straight line c4 or more in the horizontal-axis direction in FIG. 11), and (Sh/Scm)≤0.95 (straight line d or less in the horizontal-axis direction in FIG. 11).

Further, from the viewpoints of more improving internal quantum efficiency and light extraction efficiency i.e. setting the suitable range on the size of the convex portion of the concavo-convex structure 31a of the concavo-convex structure product 31 and the size of the flat surface of the concave-portion bottom portion, it is preferable to use the mold 10 including the fine pattern 12 meeting the area e as shown in FIG. 13. In the graph in FIG. 13, the horizontal axis represents the ratio (Sh/Scm), and the vertical axis represents the ratio (lcv/lcc). The area e is the area concurrently meeting (lcv/lcc)≥√(0.76/(Sh/Scm))-1 (curve b4 or more in FIG. 13), (lcv/lcc)≤√(0.93/(Sh/Scm))-1 (curve a4 or less in FIG. 13), (lcv/lcc)≥0.01 (straight line g or more in FIG. 13), (lcv/lcc)≤0.20 (straight line f or less in FIG. 13), (Sh/Scm)≥0.65 (straight line c5 or more in the horizontal-axis direction in FIG. 13), and (Sh/Scm)≤0.93 (straight line d or less in the horizontal-axis direction in FIG. 13).

The mold 10 according to this Embodiment is provided with the fine pattern 12 meeting the above-mentioned first to fourth conditions according to this Embodiment as described above on a part or whole of the surface of the mold 10. In other words, the entire surface of the mold 10 may be covered with the fine pattern 12 as described above, or a part of the surface of the mold 10 may be covered with the fine pattern 12 as described above. In the following description, the fine pattern 12 meeting the first to fourth conditions as described above is described as a fine pattern G, and a fine pattern that is not included in the fine pattern 12 as described above and that does not meet the first to fourth conditions is described as a fine pattern B. For example, in FIG. 6, the area e is the fine pattern G, and outside the area e is the finepatternB. In other words, with reference to FIG. 6, the surf ace of the mold 10 may be comprised of only the fine pattern G that is the area e, or the surface of the mold 10 may be comprised of the fine pattern B outside the area e and the fine pattern G.

The mold 10 has the fine pattern G at least in a part thereof. In other words, the entire surface of the mold 10 may be covered with the fine pattern G, or a part thereof may be covered with the fine pattern G. Herein, the area that is not covered with the fine pattern G is called the "non-G area". Herein, the non-G area is comprised of the fine pattern B and/or flat portion. Even in the case where a part of the surface of the mold 10 is provided with the non-G area, since it is possible to exert the effects as described already in the area covered with the fine pattern G, it is possible to obtain

the nth resist layer 23 with the residual film RF being thin and uniform.

($\alpha$) In using the average pitch (Pave) as described below, it is preferable that the fine pattern G provided on the surface of the mold 10 is provided at least inside a region having an area of 10Pave x 10Pave because of exhibiting the above-mentioned effects. In other words, for example, in the case of observing the surface of the mold 10 using a scanning electron microscope, it is essential only that the region having the area of 10Pave x 10Pave is formed of the fine pattern G. Particularly, it is preferable that the total sum of the fine pattern G occupying inside the region having the area of 10Pave x 10Pave meets the ratio or the size of the fine pattern G as described below. In other words, the inside of the range having the area of 10Pave x 10Pave is comprised of the fine pattern G, and it is possible to provide a plurality of such ranges. Particularly, by meeting 20Pave x 20Pave or more, more preferably, 25Pave x 25Pave or more, the effect of obtaining the concavo-convex structure 23a with a uniform and thin residual film in the region made of the fine pattern G is more remarkable, and therefore, such a range is preferable. Also in this case, it is preferable that the total sum of the fine pattern G meets the ratio or the size of the fine pattern G as described below. Further, in the case where the region having the area of 50Pave X 50Pave, more preferably 75Pave x 75Pave is comprised of the fine pattern G, transfer accuracy is also improved in the nth resist layer 23 in the non-G area adj acent to the area covered with the fine pattern G, and therefore, such a case is preferable. The effect is more exerted as the area increases to 100Pave x 100Pave or more, 150Pave x 150Pave or more, and 450Pave x 450Pave or more. Also in these cases, it is preferable that the total sum of the fine pattern G meets the ratio or the size of the fine pattern G as described below.

($\beta$) In the case of providing the non-G area in the area covered with the fine pattern G, it is preferable that the ratio of the non-G area is 1/5 or less relative to the fine pattern G. By this means, it is possible to exert the effects of the fine pattern G. From the viewpoint of more exerting the same effects, the ratio is more preferably 1/10 or less, more preferably 1/25 or less, and most preferably 1/50. In addition, by meeting 1/100 or less, it is possible to more improve uniformity of the residual film RF of the concavo-convex structure 23a of the nth resist layer 23. Particularly, by meeting 1/500 or less, more preferably 1/1,000 or less, uniformity of the residual film RF of the concave-convex structure 23a is more improved, and it is possible to further decrease an absolute value of the residual film RF. From the same viewpoint, the ratio is preferably 1/10,000 or less, preferably 1/100,000, and preferably 1/1,000,000 or less. In addition, the lower limit value is not limited, and as the value is lower i.e. approaches zero, the effects of the fine pattern G are more remarkable, and such a case is preferable.

($\gamma$) While being dependent on a use of the inorganic substrate 21 to process, when the ratio of the fine pattern G relative to the surface of the mold 10 is 0.002% or more, it is possible to exhibit the effects as described already in the fine pattern G, and such a ratio is preferable. Particularly, providing the mold 10 with the fine pattern G of 0.02% or more, more preferably 0.2% or more increases the ratio of the concavo-convex structure 23a of the nth resist layer 23 with the thin and uniform residual film to be transferred and added onto the inorganic substrate 21. In association therewith, the effects are enhanced of improving transfer accuracy of the concavo-convex structure of the non-G area, and particularly of suppressing the crash of the concavo-convex structure, being preferable. Further, by the mold 10 including the fine pattern G of 2.3% or more, more preferably 10% or more, it is possible to further exert the above-mentioned effects. Further, in the case of 20% or more, the effect is more remarkable of propagating the stress relaxation effect due to the fine pattern G in peeling off the mold 10 from the nth resist layer 23 to the non-G area. In other words, it is made ease improving transfer accuracy of the concave-convex structure of the non-G area by the fine pattern G. From the viewpoint of more exerting the effect, the fine pattern G is preferably included in a ratio of 30% or more, more preferably in a ratio of 40% or more, and most preferably in a ratio of 50% or more. Further, in the case of including the fine pattern G in a ratio of 60% or more, since alignment is made ease in pressing the mold 10 against the inorganic substrate 21, it is possible to improve the transfer velocity to the nth resist layer 23 while maintaining filling and transfer accuracy of the nth resist layer. From the viewpoint of more exerting the effect, the fine pattern G is preferably included in a ratio of 70% or more, more preferably in a ratio of 80% or more, and most preferably in a ratio of 90% or more. In addition, in the case where the fine pattern G is included in a ratio of 100% i.e. the case where the surface of the mold is filled with the fine pattern G, it is possible to thin and uniform the residual film of the nth resist layer 23 over the entire surface of the inorganic substrate 21.

($\delta$) Described is the case of using the mold 10 according to this Embodiment for the mold for processing the substrate for an LED. As described already, by using the mold 10 according to this Embodiment, it is possible to prepare the concavo-convex structure product 31 on the substrate surface for an LED. By using the substrate for an LED provided with the concavo-convex structure 31 and manufacturing the LED, it is possible to manufacture the LED with improvements in internal quantum efficiency and light extraction efficiency. Herein, the fine pattern G included in the surface of the mold 10 is preferably $0.0025 x 10^{-6}$ $m^2$ or more. By meeting this range, since it is possible to provide the concavo-convex structure product 31 with high efficiently inside the LED substrate, it is possible to obtain the LED with high efficiency. From the viewpoint of more exerting the above-mentioned effects, the fine pattern G included in the surface of the mold 10 is preferably $0.01 x 10^{-6}$ $m^2$ or more, and more preferably $0.04 x 10^{-6}$ $m^2$ or

more, and most preferably $0.09x10^{-6}$ $m^2$ or more. Further, the fine pattern G of $0.9x10^{-6}$ $m^2$ or more improves the effect of improving transfer accuracy of the non-G area by the fine pattern G, thereby sharply increases the ratio of the concavo-convex structure product 31 with high accuracy provided on the substrate for the LED, and is preferable. From the viewpoint of more exerting the above-mentioned effects, the fine pattern G is more preferably $9x10^{-6}m^2$ or more, and most preferably $90x10^{-6}m^2$ or more. Inaddition, when the area is $900x10^{-6}$ $m^2$ or more, and more preferably $1.8x10^{-3}$ $m^2$ or more, alignment is made ease in pressing the mold 10 against the substrate for the LED, and therefore, such areas are preferable. Particularly, when the area is $3.6x10^{-3}m^2$ or more, and more preferably $7.5x10^{-3}$ $m^2$ or more, manufacturing accuracy is also improved in the concave-convex structure product 31 with respect to the outer edge portion of the substrate for the LED, and therefore, such areas are preferable. When one or more fine patterns G meeting the size of the fine pattern G as described above are provided on the surface of the mold 10, it is possible to obtain the substrate for the LED allowed to manufacture the LED with high accuracy. In addition, it is possible to provide a plurality of fine patterns G meeting the size of the fine pattern G as described above. In this case, at least one fine pattern G meets the above-mentioned size. Particularly, it is preferable that 50% or more of the number of fine patterns G meets the above-mentioned range of the size, and it is most preferably that 100% meets the above-mentioned range of the size.

The arrangement relationship between the fine pattern G and non-G area is not limited particularly, as long as the above-mentioned details are satisfied, and for example, there are the following relationships. As the arrangement relationship between the fine pattern G and non-G area, in consideration of the fine pattern G and non-G area, it is possible to mention arrangements as described below. In addition, the fine pattern G is a set of fine patterns G meeting one or more of $\alpha$, $\beta$, $\gamma$ and $\delta$ as described above i.e. the fine pattern G area. Further, as shown in FIG. 14, in the case where non-G areas 202 are provided inside the fine pattern G area 201, as long as the non-G areas 202 meet the ratio described in above-mentioned $\beta$, the regularity or irregularity is not limited. FIG. 14 contains explanatory diagrams illustrating the relationship between the fine pattern G and the non-G area in the fine pattern of the mold according to this Embodiment. In FIGs. 14A and 14B, a plurality of non-G areas 202 with indefinite contours is arranged inside the fine pattern G area 201. In FIG. 14C, the non-G area 202 in the shape of a lattice is provided inside the fine pattern G area 201. Further, in FIG. 14D, a plurality of substantially circular non-G areas 202 is formed inside the fine pattern G area 201.

The contour shape made by the fine pattern G area 201 is not particularly limited. In other words, the interface shape between the fine pattern G area 201 and the non-G area 202 is not limited. Therefore, for example, as the interface shape between the fine pattern G area 201 and the non-G area 202, there are n-gon ($n\geq3$), non- n-gon ($n\geq3$), the shape of a lattice, the shape of a line and the like. The n-gon may be a regular n-gon or irregular n-gon.

FIG. 15 contains schematic diagrams illustrating contour shapes formed by the fine pattern G area and mold contour shapes in fine patterns of molds according to this Embodiment. For example, when a tetragon is represented, there are a regular tetragon (square), rectangle, parallelogram, trapezoid and shapes in which one or more sets of opposite sides of these tetragons are not parallel. Further, in the n-gon ($n\geq3$), the case where n is "4" or more includes the shapes as shown in FIGs.15A to 15D. FIG. 15A shows a tetragon, FIG. 15B shows a hexagon, FIG. 15C shows an octagon, and FIG. 15D shows a dodecagon. The non-n-gon is the n-gon ($n\geq3$) as described above including a structure without a corner, e.g. circle, ellipse, shape in which the corner of the above-mentioned n-gon as described above is rounded (shape in which a radius of curvature of the corner of the above-mentioned n-gon exceeds "0"), or rounded corner (portion with a radius of curvature exceeding "0".) Therefore, for example, the contour shapes include shapes exemplified in FIGs. 15E to 15H. In addition, the contour shapes of the non-G area 202 are capable of adopting the shapes described as the contour shapes of the fine pattern G area 201 as described above.

First, there is a state in which the fine pattern G area 201 is enclosed or sandwiched with/between the non-G area 202. FIG. 16 contains plan schematic diagrams illustrating states obtained by observing, from the surface with the fine pattern formed, molds according to this Embodiment. FIGs. 16A to 16F show states in which the fine pattern G area 201 is enclosed with the non-G area 202. As shown in FIG. 16A, the fine pattern G area 201 is provided on the surface of the mold 10, and the outer region may be comprised of the non-G area 202. It is preferable that the fine pattern G area 201 meets the above-mentioned ratio. Further, in the case of using the mold 10 for processing of the substrate for the LED, it is preferable that the fine pattern G area 201 meets the size as described already. In FIG. 16B, as in FIG. 16C, a plurality of fine pattern G areas 201 is arranged on the surface of the mold 10 while being mutually spaced, and regions between the fine pattern G areas 201 and outside the fine pattern G area 201 may be filled with the non-G area 202. In this case, it is preferable that the above-mentioned ratio is met relative to the total area of the fine pattern G. Further, in the case of using the mold 10 for processing of the substrate for the LED, it is preferable that at least one fine pattern G meets the size as described already, and it is more preferable that all fine patterns G meet the size as described already. Furthermore, when a plurality of fine patterns G is provided, the fine pattern G areas 201 may be arranged regularly as shown in FIG. 16C, or may be arranged irregularly as shown in FIG. 16D. As the regular arrangement, there are a tetragonal arrangement, hexagonal arrangement, arrangements in which these arrangements are

stretched in a uniaxial direction, arrangements in which these arrangements are stretched in a biaxial direction, and the like. Further, the contour shape of the fine pattern G area 201 is shown in the shape of a circle in FIGs. 16A to 16d, and as shown in FIG. 16E, it is also possible to adopt an indefinite shape. For example, as the outside shape of the fine pattern G area 201, it is possible to mention shapes such as an n-gon (n≥3), corner-rounded n-gon (n≥3), circle, ellipse, the shape of a line, the shape of a star, the shape of a lattice, and the like. Furthermore, as shown in FIG. 16F, it is possible to adopt the shape in which the fine pattern G area 201 is enclosed with the non-G area, the outer region is enclosed with the fine pattern G area 201, and further, the outer region is enclosed with the non-G area 202. In addition, in FIGs. 16A to 16D, circular shapes are described, and the contour shapes made by a set of the fine patterns G may adopt the shapes as described with reference to FIG. 15.

FIG. 17 contains plan schematic diagrams illustrating states obtained by observing, from the surface with the fine pattern formed, molds according to this Embodiment. FIG. 17 shows the case where the fine pattern G area 201 is sandwiched between non-G areas 202. As shown in FIGs. 17A to 17B, the fine pattern G area 201 is provided on the surface of the mold 10, and the outer regions may be comprised of the non-G areas 202. It is preferable that the fine pattern G meets the above-mentioned ratio. Further, in the case of using the mold 10 for processing of the substrate for the LED, it is preferable that the fine pattern G meets the size as described already. As shown in FIG. 17C, a plurality of fine pattern G areas 201 is arranged on the surface of the mold 10 while being mutually spaced, and regions between the fine pattern G areas 201 and outside the fine pattern G area 201 may be filled with the non-G areas 202. In this case, it is preferable that the above-mentioned ratio is met relative to the total area of the fine pattern G. Further, in the case of using the mold 10 for processing of the substrate for the LED, it is preferable that at least one fine pattern G meets the size as described already, and it is more preferable that all fine patterns G meet the size as described already. Furthermore, as shown in FIG. 17D, it is possible to make an arrangement in which the fine pattern G areas 201 include the non-G areas 202 and are continuously provided. In this case, it is preferable that the ratio as described is met relative to the area of the fine pattern G. Still furthermore, in the case of using the mold 10 for processing of the substrate for the LED, it is preferable that the finepatternGmeets the size as described already. Moreover, the interface shape between the fine pattern G area 201 and the non-G area 202 may be linear, or may be bowed as shown in FIG. 17E. As the shape of the fine pattern G area 201, there are the shape of a line, the shape of a lattice, the shape of a mesh and the like. Further, as shown in FIG. 17F, it is possible to adopt the arrangement in which the fine pattern G area 201 is sandwiched between the non-G areas 202, the outer regions are sandwiched between the fine pattern G areas 201, and further, the outer regions are sandwiched between the non-G areas 202. In addition, in FIG. 17, the contour line made by the fine pattern G area 201 is described as the shape of a line or substantially in the shape of a line, and it is also possible to adopt the shapes as described with reference to FIG. 15.

In the case where a plurality of fine pattern G areas 201 is provided as described above, the interface shape between each of the fine pattern G area 201 and the non-G area 202 may be a single, or may differ for each fine pattern G area 201.

Further, in the arrangement relationship between the fine pattern G area 201 and the non-G area 202 as described above, both cases may coexist i.e. the case where the fine pattern G area 201 is enclosed with the non-G area 202 and the case where the fine pattern G area 201 is sandwiched between the non-G areas 202 may coexist.

Furthermore, as shown in FIGs. 16F and 17F, when the non-G area 202 is provided outside the first fine pattern G area 201 (G1), the second fine pattern G area 201 (G2) is provided outside the area 202, and the non-G area 202 is further provided outside the area 201, the second fine pattern area 201 (G2) may be discontiguous.

The non-G area may be comprised of the fine pattern B, may be comprised of a flat portion, or may be comprised of the fine pattern B and flat portion.

Further, in the above-mentioned description, the outside shapes of the molds 10 are all described as rectangles, but the outside shape of the mold 10 is not limited thereto, and it is possible to adopt an n-gon (n≥3), non- n-gon (n≥3), the shape of a lattice, the shape of a line and the like. The n-gon may be a regular n-gon or irregular n-gon. For example, when a tetragon is represented, there are a regular tetragon (square), rectangle, parallelogram, trapezoid and shapes in which one or more sets of opposite sides of these tetragons are not parallel. Further, in the n-gon (n≥3), the case where n is "4" or more includes the shapes as shown in FIGs.15A to 15D. FIG. 15A shows a tetragon, FIG. 15B shows a hexagon,

FIG. 15C shows an octagon, and FIG. 15D shows a dodecagon. The non-n-gon is the n-gon (n≥3) as described above including a structure without a corner, e.g. circle, ellipse, shape in which the corner of the above-mentioned n-gon as described above is rounded (shape in which a radius of curvature of the corner of the above-mentioned n-gon exceeds "0"), or rounded corner (corner portion with a radius of curvature exceeding "0".) Therefore, for example, the shapes include shapes exemplified in FIGs. 15F to 15H. Among the shapes, it is preferable to adopt a line symmetrical shape, and it is more preferable to adopt a point symmetrical shape.

Described next are definitions of the top width of convex-portion (lcv), opening width of concave-portion (lcc), opening area (Sh) and unit area (Scm) that are terms used in the above-mentioned description.

<Opening width of concave-portion (lcc)>

The symbol (lcc) is defined by an opening width of the concave portion 12b of the fine pattern 12 in the mold 10.

Described first is the case where the fine pattern 12 of the mold 10 has a hole structure, i.e. the case where adj acent concave portions are separated by continuous convex portions. FIG. 18 contains schematic diagrams illustrating examples of the fine pattern of hole structure of the mold according to this Embodiment. In the case of hole structures as shown in FIGs. 18A and 18B where the shape of the opening portion of the fine pattern 12 is an n-gon (n≥3), the opening portion of the fine pattern is formed of n sides. In this case, the length of the longest side among n sides is defined as the opening width of concave-portion (lcc). In the case of FIG. 18A, the shape of the concave-portion opening portion of the concave portion 12b of the fine pattern 12 is a tetragon. In this case, the concave-portion opening portion is formed of four sides, a, b, c and d. In this case, the length of the longest segment among a, b, c and d is defined as the opening width of concave-portion (lcc). In the case of FIG. 18B, the shape of the concave-portion opening portion of the concave portion 12b of the fine pattern 12 is a hexagon. In this case, the concave-portion opening portion is formed of six sides, a, b, c, d, e and f. In this case, the length of the longest segment among a, b, c, d, e and f is defined as the opening width of concave-portion (lcc). In addition, the n-gon may be a regular n-gon or irregular n-gon. For example, when a tetragon is represented, there are a regular tetragon (square), rectangle, parallelogram, trapezoid and shapes in which one or more sets of opposite sides of these tetragons are not parallel. Further, in the n-gon (n≥3), the case where n is "4" or more includes the shapes as shown in FIGs.15A to 15D. FIG. 15A shows a tetragon, FIG. 15B shows a hexagon, FIG. 15C shows an octagon, and FIG. 15D shows a dodecagon.

On the other hand, in the case where the fine pattern 12 has the hole structure as shown in FIG. 18C or FIG. 18D and the opening portion of the concave portion 12b of the fine pattern 12 is a non-n-gon, the length of the longest distance between one predetermined point and another point in the opening portion outer edge portion of the fine pattern 12 is defined as the opening width of concave-portion (lcc). In the case of FIG. 18C, the shape of the concave-portion opening portion of the concave portion 12b of the fine pattern 12 is a circle. In this case, a maximum value of the distance (AB) from some point A to another point B in the opening outer edge portion of the concave portion 12b is defined as the opening width of concave-portion (lcc). In the case of FIG. 18D, the concave-portion opening portion of the concave portion 12b of the fine pattern 12 is in the shape having a plurality of curvatures. In this case, a maximum value of the distance (AB) from some point A to another point B in the opening outer edge portion of the concave portion 12b is defined as the opening width of concave-portion (lcc). Herein, the non-n-gon is the n-gon (n≥3) as described above including a structure without a corner, e.g. circle, ellipse, shape in which the corner of the above-mentioned n-gon as described above is rounded, or rounded corner. Therefore, examples thereof include the shapes exemplified in FIGs. 15E to 15H.

In addition, it is possible to provide a hole in the shape of an n-gon as the shape of a hole as described above and a hole in the shape of a non-n-gon to coexist.

In addition, when fluctuations exist in the opening width of concave-portion (lcc), ten concave portions 12b are selected arbitrarily, and the arithmetical mean value of the concave-convex opening widths (lcc) of the concave portions is defined as the opening width of concave-portion (lcc). In addition, for example, selection of concave portions 12b is made in a predetermined range in one image observed with a scanning electron microscope. Further, observation is performed on the sample piece including the area of 10mm x 10mm square used in obtaining the arithmetical mean value of the height (H) as described already. In other words, the height (H), opening width of concave-portion (lcc), and the top width of convex-portion (lcv) and the ratio (Sh/Scm) as described below are observed in different portions in the same sample piece. Further, the opening width of concave-portion (lcc), and the top width of convex-portion (lcv) and the ratio (Sh/Scm) as described below are observed in the same portion in the same sample piece. The arithmetical mean value of the opening width of concave-portion (lcc) is calculated by the following procedure. First, scanning electron microscope observation is performed on the surface (hereinafter, referred to as concavo-convex structure surface) with the concavo-convex structure formed of the sample piece of 10mm x 10mm square or more as described already. Herein, using the average pitch (Pave) as described below, an area of a square of 10Pave x 10Pave is set in the observation image, ten concave portions are selected arbitrarily from the area of the square of 10Pave x 10Pave, and obtained is the arithmetical mean value of opening width of concave-portions (lcc) measured respectively on selected ten concave portions. For example, in the case where different opening shapes of holes coexist or the like, the opening width of concave-portions (lcc) vary. FIG. 19 is a schematic diagram illustrating a state obtained by observing, from the surface, the fine pattern of hole structure of the mold according to this Embodiment. The fine pattern 12 as shown in FIG. 19 is comprised of a plurality of holes 301. The opening shapes of the holes 301 are almost circular, and among the holes, indefinite holes 302 and elliptical holes 303 coexist. In this case, ten holes are selected arbitrarily from the area of a square (shown by the dashed line in the figure) with the length ten times the average pitch (Pave) as one side, the opening width of concave-portions (lcc) are obtained on respective holes, and the arithmetical mean value of the widths is defined as the opening width of concave-portion (lcc).

Described next is the case where the fine pattern 12 of the mold 10 has a dot structure i.e. the case where

adjacent convex portions are separated by continuous concave portions. FIG. 20 contains schematic diagrams illustrating states obtained by observing, from the surface, the fine pattern of dot structure of the mold according to this Embodiment. In the case of dot structures as shown in FIGs. 20A to 20D, one dot (A) is selected arbitrarily from a plurality of dots 401, and the distance, which is the shortest distance between one point in the outer edge portion of the dot (A) and an outer edge portion of another dot (B) surrounding the periphery of the dot A, is defined as the concave-portion width (lcc). In addition, as the contour shapes of the dots 401 obtained by observing from the surface of the mold 10, it is possible to adopt shapes of holes in the case where the fine pattern 12 has the hole structure as described above.

In addition, when fluctuations exist in the opening width of concave-portion (lcc), ten convex portions are selected arbitrarily, and the arithmetical mean value of the opening width of concave-portions (lcc) of the convex portions is defined as the opening width of concave-portion (lcc). In addition,for example, selection of convex portions is made in a predetermined range in one image observed with a scanning electron microscope. Further, observation is performed on the sample piece including the area of 10mm x 10mm square used in obtaining the arithmetical mean value of the height (H) as described already. In other words, the height (H), opening width of concave-portion (lcc), and the top width of convex-portion (lcv) and the ratio (Sh/Scm) as described below are observed in different portions in the same sample piece. Further, the opening width of concave-portion (lcc), and the top width of convex-portion (lcv) and the ratio (Sh/Scm) as described below are observed in the same portion in the same sample piece. The arithmetical mean value of the opening width of concave-portion (lcc) is calculated by the following procedure. First, scanning electron microscope observation is performed on the concavo-convex structure surface of the sample piece of 10mm x 10mm square or more as described already. Herein, using the average pitch (Pave) as described below, an area of a square of 10Pave x 10Pave is set in the observation image, ten convex portions are selected arbitrarily from the area of the square of 10Pave x 10Pave, and obtained is the arithmetical mean value of opening width of concave-portions (lcc) measured respectively on selected ten convex portions. For example, in the case where contour shapes vary in observing the dots from the surface, pitches vary or the like, the opening width of concave-portions (lcc) vary. FIG. 21 is a schematic diagram illustrating a state obtained by observing, from the surface, the fine pattern of dot structure of the mold according to this Embodiment. The fine pattern 12 as shown in FIG. 21 is comprised of a plurality of dots 401. In the fine pattern 12 as shown in FIG. 21, pitches vary, and when there is a portion where dots 401 are partially lost, the bottom-portion contour shapes of the dots 401 also vary. The contour shapes of the dots 401 are almost circular, and among the dots, indefinite dots 402 and dots 403 with small diameters coexist. In this case, ten dots are selected arbitrarily from the area of a square (shown by the dashed line in the figure) with the length ten times the average pitch (Pave) as one side, the opening width of concave-portions (lcc) are obtained on respective dots, and the arithmetical mean value of the widths is defined as the opening width of concave-portion (lcc).

In the case of line-and-space structure as shown in FIG. 22, the shortest distance between adjacent concave-shaped lines is defined as the opening width of concave-portion (lcc). When fluctuations exist in the opening width of concave-portion (lcc), ten opening width of concave - portions (lcc) are arbitrarily measured, and the arithmetical mean value of the widths is defined as the opening width of concave-portion (lcc). In addition, when fluctuations exist in the opening width of concave-portion (lcc), ten convex lines are arbitrarily selected, and the arithmetical mean value of the opening width of concave-portions (lcc) of the convex lines is defined as the opening width of concave-portion (lcc).

In addition, for example, selection of convex lines is made in a predetermined range in one image observed with a scanning electron microscope. Further, observation is performed on the sample piece including the area of 10mm x 10mm square used in obtaining the arithmetical mean value of the height (H) as described already. In other words, the height (H), opening width of concave-portion (lcc) as described already, and the top width of convex-portion (lcv) and the ratio (Sh/Scm) as described below are observed in different portions in the same sample piece. Further, the opening width of concave-portion (lcc), and the top width of convex-portion (lcv) and the ratio (Sh/Scm) as described below are observed in the same portion in the same sample piece. The arithmetical mean value of the opening width of concave-portion (lcc) is calculated by the following procedure. First, scanning electron microscope observation is performed on the concavo-convex structure surface of the sample piece of 10mm x 10mm square or more as described already. Herein, using the average pitch (Pave) as described below, an area of a square of 10Pave x 10Pave is set in the observation image, ten convex-shaped lines are selected arbitrarily from the area of the square of 10Pave x 10Pave, and obtained is the arithmetical mean value of opening width of concave-portions (lcc) measured respectively on selected ten convex-shaped lines.

In addition, it is possible to provide the hole structure and line-and-space structure as described above or the dot structure and line-and-space structure as described above to coexist.

<Top of convex-portion width (lcv)>

The symbol (lcv) is defined by a top width of convex-portion of the fine pattern 12 in the mold 10.

Described is the case where the fine pattern 12 of the mold 10 has the hole structure, i.e. the case where adjacent concave portions are separated by continuous convex portions. FIG. 23 contains schematic diagrams illustrating

the fine patterns of hole structure of the mold according to this Embodiment. In the case of the fine patterns 12 of hole structure as shown in FIGs. 23A to 23D, one hole (A) is selected arbitrarily from a plurality of holes 301, and the distance, which is the shortest distance between one point in the outer edge portion of the hole (A) and an outer edge portion of another hole (B) surrounding the periphery of the hole A, is defined as the top width of convex-portion (lcv). In addition, as the shapes of the holes 301, it is possible to adopt shapes of holes as described already in <Opening width of concave-portion (lcc)>.

In addition, when fluctuations exist in the top width of convex-portion (lcv), ten holes (A) are selected arbitrarily, and the arithmetical mean value of the top width of convex-portions (lcv) of the holes (A) is defined as the top width of convex-portion (lcv). In addition, for example, selection of holes (A) is made in a predetermined range in one image observed with a scanning electron microscope. Further, observation is performed on the sample piece including the area of 10mmx 10mm square used in obtaining the arithmetical mean value of the height (H) as described already. In other words, the height (H), opening width of concave-portion (lcc) as described already, and the top width of convex-portion (lcv) and the ratio (Sh/Scm) as described below are observed in different portions in the same sample piece. Further, the opening width of concave-portion (lcc) as already described, and the top width of convex-portion (lcv) and the ratio (Sh/Scm) as described below are observed in the same portion in the same sample piece. The arithmetical mean value of the top width of convex-portion (lcv) is calculated by the following procedure. First, scanning electron microscope observation is performed on the concavo-convex structure surface of the sample piece of 10mm x 10mm square or more as described already. Herein, using the averagepitch (Pave) as describedbelow, an area of a square of 10Pave x 10Pave is set in the observation image, ten holes are selected arbitrarily from the area of the square of 10Pave x 10Pave, and obtained is the arithmetical mean value of top width of convex-portions (lcv) measured respectively on selected ten holes.

Described next is the case where the fine pattern 12 of the mold 10 has the dot structure, i.e. the case where adjacent convex portions are separated by continuous concave portions. FIG. 24 contains schematic diagrams illustrating the fine patterns of dot structure of the mold according to this Embodiment. FIGs. 24A and 24B show the case where the fine pattern 12 has the dot structure and the shape of the convex portion 12a of fine pattern 12 is an n-gon (n≥3). In this case, the convex portion 12a of the fine pattern is formed of n sides. In this case, the length of the longest side among n sides is defined as the top width of convex-portion (lcv). In the case of FIG. 24A, the shape of the top of the convex portion 12a is a tetragon. In this case, the top of the convex portion 12a is formed of four sides, a, b, c and d. In this case, the length of the longest segment among a, b, c and d is defined as the top width of convex-portion (lcv). In the case of FIG. 24B, the shape of the top of the convex portion 12a is a hexagon. In this case, the top of the convex portion 12a is formed of six sides, a, b, c, d, e and f. In this case, the length of the longest segment among a, b, c, d, e and f is defined as the top width of convex-portion (lcv). In addition, the n-gon may be a regular n-gon or irregular n-gon. For example, when a tetragon is represented, there are a regular tetragon (square), rectangle, parallelogram, trapezoid and shapes in which one or more sets of opposite sides of these tetragons are not parallel. Further, in the n-gon (n≥3), the case where n is "4" or more includes the shapes as shown in FIGs.15A to 15D. FIG. 15A shows a tetragon, FIG. 15B shows a hexagon, FIG. 15C shows an octagon, and FIG. 15D shows a dodecagon.

On the other hand, in the case where the fine pattern 12 has the dot structure as shown in FIG. 24C or FIG. 24D and the convex portion 12a of the fine pattern 12 is a non-n-gon, the length of the longest distance between one predetermined point A and another point B in the outer edge portion of the top of the convex portion 12a of the fine pattern 12 is defined as the top width of convex-portion (lcv). In the case of FIG. 24C, the shape of the top of the convex portion 12a is a circle. In this case, a maximum value of the distance (AB) from some point A to another point B in the outer edge portion of the top of the convex portion 12a is defined as the top width of convex-portion (lcv). In the case of FIG. 24D, the top of the convex portion 12a is in the shape having a plurality of curvatures. In this case, a maximum value of the distance (AB) from some point A to another point B in the outer edge portion of the top of the convex portion 12a is defined as the top width of convex-portion (lcv). Herein, the non-n-gon is the n-gon (n≥3) as described above including a structure without a corner, e.g. circle, ellipse, shape in which the corner of the above-mentioned n-gon as described above is rounded, or rounded corner. Therefore, examples thereof include the shapes exemplified in FIGs. 15E to 15H.

In addition, when fluctuations exist in the top width of convex-portion (lcv), ten dots are selected arbitrarily, and the arithmetical mean value of the top width of convex-portions (lcv) of the dots is defined as the top width of convex-portion (lcv). In addition, for example, selection of dots portions is made in a predetermined range in one image observed with a scanning electron microscope. Further, observation is performed on the sample piece including the area of 10mm x 10mm square used in obtaining the arithmetical mean value of the height (H) as described already. In other words, the height (H), opening width of concave-portion (lcc) as already described, the top width of convex-portion (lcv) and the ratio (Sh/Scm) as described below are observed in different portions in the same sample piece. Further, the opening width of concave-portion (lcc) as described already, and the top width of convex-portion (lcv) and the ratio (Sh/Scm) as described below are observed in the same portion in the same sample piece. The arithmetical mean value of the top width of convex-portion (lcv) is calculated by the following procedure. First, scanning electron microscope observation

is performed on the concavo-convex structure surface of the sample piece of 10mm x 10mm square or more as described already. Herein, using the average pitch (Pave) asdescribedbelow, an area of a square of 10Pave x 10Pave is set in the observation image, ten dots are selected arbitrarily from the area of the square of 10Pave x 10Pave, and obtained is the arithmetical mean value of top width of convex-portions (lcv) measured respectively on selected ten dots.

In the case of line-and-space structure as shown in FIG. 22 , the convex line width is defined as the top width of convex-portion (lcv). A point x is arbitrarily set on one side of the convex line, and a point y is set on opposite side, and the line width means a distance of the segment xy when the distance between the point x and point y is the shortest. When fluctuations exist in the top width of convex-portion (lcv), ten top width of convex-portions (lcv) are arbitrarily measured, and the arithmetical mean value of the widths is defined as the top width of convex-portion (lcv).

In addition, when fluctuations exist in the top width of convex-portion (lcv), ten convex lines are arbitrarily selected, and the arithmetical mean value of the top width of convex-portions (lcv) of the convex lines is defined as the topwidthof convex-portion (lcv). In addition, for example, selection of convex lines is made in a predetermined range in one image observed with a scanning electron microscope. Further, observation is performed on the sample piece including the area of 10mmx10mm square used in obtaining the arithmetical mean value of the height (H) as described already. In other words, the height (H), opening width of concave-portion (lcc) as described already, and the top width of convex-portion (lcv) and the ratio (Sh/Scm) as described below are observed in different portions in the same sample piece. Further, the opening width of concave-portion (lcc) as described already, and the top width of convex-portion (lcv) and the ratio (Sh/Scm) as described below are observed in the same portion in the same sample piece. The arithmetical mean value of the top width of convex-portion (lcv) is calculated by the following procedure. First, scanning electron microscope observation is performed on the concavo-convex structure surface of the sample piece of 10mm x 10mm square or more as described already. Herein, using the average pitch (Pave) asdescribedbelow, an area of a square of 10Pave x 10Pave is set in the observation image, ten convex lines are selected arbitrarily from the area of the square of 10Pave x 10Pave, and obtained is the arithmetical mean value of top width of convex-portions (lcv) measured respectively on selected ten convex lines.

<Unit area (Scm)>

FIG. 25 contains explanatory diagrams illustrating the relationship between the fine pattern and the unit area (Scm) in the mold according to this Embodiment. FIG. 25A schematically shows the top surface of the fine pattern 12, and FIG. 25B schematically shows the cross section of the fine pattern 12. As shown in FIGs. 25A and 25B, the unit area (Scm) is an area of a surface that is disposed on the top portion of the fine pattern 12 inside the surface parallel to one main surface of the fine pattern 12 and that is parallel to one main surface of the fine pattern 12. The size of the unit area (Scm) is defined as a region of 10Pave x 10Pave square using the average pitch (Pave) ad described below. Further, observation is performed on the sample piece including the area of 10mm x 10mm square used in obtaining the arithmetical mean value of the height (H) as described already. In other words, the height (H), opening width of concave-portion (lcc) as described already, the top width of convex-portion (lcv) as described already and the ratio (Sh/Scm) are observed in different portions in the same sample piece. Further, the opening width of concave-portion (lcc) as described already, the top width of convex-portion (lcv) as described already and the ratio (Sh/Scm) are observed in the same portion in the same sample piece.

<Ratio (Sh/Scm)>

FIG. 26 contains explanatory diagrams of an aperture ratio of the fine pattern in the mold according to this Embodiment. In the case where the fine pattern 12 of the mold 10 has the hole structure, as shown in FIG. 26A, the aperture ratio is the ratio of areas (Sh') of the concave portions 12b included in the unit area (Scm) on the fine pattern 12 inside the surface parallel to the main surface of the fine pattern 12. FIG. 26C is a schematic diagram of the extracted fine pattern 12 included in the unit area (Scm) as shown in FIG. 26A. In the sample as shown in FIG. 26C, 12 fine holes (concave portions 12b) are included in the unit area (Scm). The sum of opening portion areas (Sh' 1 to Sh' 12) of these 12 fine holes (concave potions 12b) is given as Sh', and by substituting Sh for Sh', the aperture ratio is gives as (Sh/Scm). On the other hand, when the fine pattern 12 has the dot shape, as shown in FIG. 26B, the aperture ratio is the ratio of areas (Scm-Sh') of concave portions 12b included in the unit area (Scm) on the fine pattern inside the surface parallel to the main surface of the fine pattern. FIG. 26C is a schematic diagram of the extracted fine pattern included in the unit area (Scm) as shown in FIG. 26B. In the example as shown in FIG. 26C, 12 fine dots (convex portions 12a) are included in the unit area (Scm). The sum of vertex-portion areas (Sh'1 to Sh'12) of these 12 fine dots (convex portions 12a) is given as Sh', and by substituting Sh for (Scm-Sh'), the aperture ratio is given as (Sh/Scm) . The value 100 times the aperture ratio is expressed as a percentage.

FIG. 27 is an explanatory diagram of an aperture ratio of the concavo-convex structure in the mold according to this Embodiment. For example, as shown in FIG. 27, in the case of the fine pattern where concave portions are

arranged in a hexagonal close-packed arrangement in which the opening shape is a circle, the opening diameter (Φ) is 430 nm, the pitch Px in the x-axis direction is 398 nm and the pitch Py in the y-axis direction is 460 nm, Sh/Scm is 0.79 (aperture ratio 79%). Inaddition, according to the above-mentioned definitions, the concave - portion width (lcc) is equal to the opening diameter (Φ).

Similarly, for example, in the fine pattern where concave portions are arranged in a hexagonal close-packed arrangement in which the opening shape is a circle, the opening diameter (Φ) is 180 nm, the pitch Px in the x-axis direction is 173 nm and the pitch Py in the y-axis direction is 200 nm, (Sh/Scm) is 0.73 (aperture ratio 73%).

Similarly, for example, in the fine pattern where concave portions are arranged in a hexagonal close-packed arrangement in which the opening shape is a circle, the opening diameter (Φ) is 680 nm, the pitch Px in the x-axis direction is 606 nm and the pitch Py in the y-axis direction is 700 nm, (Sh/Scm) is 0.86 (aperture ratio 86%).

For example, as shown in FIG. 27, in the case of the fine pattern where convex portions are arranged in a hexagonal close-packed arrangement in which the convex-portion shape is a circle, the top of convex-portion diameter is 80 nm, the pitch Px in the x-axis direction is 398 nm and the pitch Py in the y-axis direction is 460 nm, (Sh/Scm) is 0.97 (aperture ratio 97%). In addition, according to the above-mentioned definitions, the top width of convex-portion (lcv) is equal to the convex-portion vertex-portion diameter.

Similarly, for example, in the fine pattern where convex portions are arranged in a hexagonal close-packed arrangement in which the convex-portion shape is a circle, the top of convex-portion diameter is 30 nm, the pitch Px in the x-axis direction is 173 nm and the pitch Py in the y-axis direction is 200 nm, (Sh/Scm) is 0.98 (aperture ratio 98%).

Similarly, for example, in the fine pattern where convex portions are arranged in a hexagonal close-packed arrangement in which the convex-portion shape is a circle, the top of convex-portion diameter is 100 nm, the pitch Px in the x-axis direction is 606 nm and the pitch Py in the y-axis direction is 700 nm, (Sh/Scm) is 0.98 (aperture ratio 98%).

Described next are more preferable shapes of the concave portion 12b of the fine pattern 12.

It is preferable that the sum (lcc+lcv) of the concave-portion width (lcc) and the top width of convex-portion (1cv) is (lcc+lcv)≤3Pave using the average pitch (Pave) as described below. By meeting this range, it is possible to reduce disturbance of the flow (hereinafter, also referred to as the nth resist layer flow) of the resist materials forming the nth resist layer 23 in the vertex-portion outer edge portion of the convex portion 23c and the fine pattern 12. Therefore, it is presumed that residual stress inside the nth resist layer 23 is reduced. Further, stress distribution is reduced in the outer edge 23d of the bottom of the concave portion 23b of the concave-convex structure 23a of the resist layer 23 applied by the outer edge 12c of the top of the convex portion 12a of the fine pattern 12 in the mold release step. In other words, it is possible to suppress the site at which stress extremely concentrates on the outer edge 23d of the bottom of the convex portion 23b of the concave-convex structure 23a. In view of the foregoing, it is conceivable that the residual stress inside the concave-convex structure 23 is reduced, the mechanical strength of the concave-convex structure 23a improves, concentration stress on the outer edge 23d of the bottom of the concave portion 23b of the concave-convex portion 23 is reduced, and it is thereby possible to suppress the crash of the concavo-convex structure 23a or breakage of the residual film RF. From the viewpoint of more exerting the above-mentioned effects, it is preferable that (lcc+lcv)≤2√2 or less, it is more preferable that (lcc+lcv)≤1.2 or less, and it is the most preferable that (lcc+lcv)≤1.

When the diameter of the concave portion 23b increases from the bottom portion toward the opening portion, since it is possible to (B) suppress the pinning effect in the vertex-portion outer edge portion of the convexportion 23c of the nth resist layer 23 positioned in the lower portion of convex portion 12a of the fine pattern 12 of the mold 10 in the pressing step, (A) improved are the outflow properties from the portion under the convex-portion of the nth resist layer 23 disposed under the convex portion 12a of the fine pattern 12, and it is possible to thin the residual film RF with ease. Therefore, it is possible to uniform and thin the residual film RF of the nth resist layer irrespective of the layered number n of resists. Further, since it is possible to (C) suppress peeling energy applied to the residual film RF of the concavo-convex structure 23a in peeling off the mold 10 from the nth resist layer 23, it is possible to suppress breakage of the residual film of the concave-convex structure 23a, and transfer accuracy is improved. In other words, it is possible to obtain concavo-convex structure 23a having the uniform thin residual film RF with higher accuracy. From the effects, (3) in the case of a single-layer resist, processing accuracy of the inorganic substrate 21 is improved, and it is possible to obtain the concavo-convex structure product 31 with high accuracy in plane. (4) In the case of a multilayer resist, processing accuracy of the first to (n-1)th resist layer 22 is improved, and it is possible to improve physical stability of the fine mask pattern 25. Accordingly, (3) it is possible to improve processing accuracy in processing the inorganic substrate 21 using the fine mask pattern 25 as a mask.

Further, it is preferable that the flat surf ace of the bottom portion of the concave portion 12b of the fine pattern 12 is smaller, and it is more preferable that the flat portion does not exist in the bottom portion of the concave portion 12b. Furthermore, it is preferable that a corner portion does not exist in the bottom portion of the concave portion 12b. In other words, it is preferable that the bottom portion of the concave portion 12b is formed of a non-corner portion. Herein, the non-corner portion is a corner portion with a radius of curvature exceeding 0. In the case of meeting these conditions, by inclination of the side surface of the concave portion 12b connecting between the opening edge portion of the concave portion 12b and the concave-portion bottom portion, it is possible to (B) more effectively suppress the

pinning effect in the opening edge portion of the concave portion 23b on the nth resist layer 23, and it is thereby possible to improve the filling properties of the nth resist layer 23. Further, since it is possible to (E) suppress concentration stress occurring toward the nth resist layer 23 by the concave-portion opening edge portion, it is possible to (F) reduce peeling energy applied to the residual film RF, and transfer accuracy of the concavo-convex structure is improved.

Further, in the case where the opening edge portion and the concave-portion side surface of the concave portion 12b are smoothly connected, it is possible to more exert the above-mentioned effects, and such a case is preferable. In other words, the corner portion formed of the top of the convex portion 12a and the side surface portion of the concave portion 12b is preferably a non-corner portion. Herein, the non-corner portion is a corner portion with a radius of curvature exceeding 0.

A water contact angle on the fine pattern 12 is preferably smaller than 90 degrees, from the viewpoints of (A) the outflow properties of the nth resist layer 23 in the pressing step, (B) the anchor or pinning effect on the nth resist layer 23, and then (C) the inflow properties of the nth resist layer 23. Further, from the viewpoints of further exerting the effects, the angle is preferably 70 degrees or less. On the other hand, from the viewpoints of (D) moment energy applied to the concavo-convex structure23ainthemoldreleasestep, and (F) peeling energy applied to the residual film RF, the contact angle of a water droplet on the surface of the fine pattern 12 is preferably larger than 90 degrees, and more preferably 95 degrees or more. From the viewpoint of further exerting the effects more, the angle is most preferably 100 degrees or more. From the same effects, the falling angle of a water droplet on the surface of the fine pattern 12 is preferably less than 90 degrees, more preferably 65 degrees or less, and most preferably 35 degrees or less. In addition, it is essential only that surface energy of the fine pattern 12 is in the range in which the adhesion force between the fine pattern 12 and the nth resist layer 23 is lower than the adhesion force between the nth resist layer 23 and the (n-1)th resist layer.

In addition, surface energy of the fine pattern 12 is in correlation with the contact angle of water with respect to the fine pattern 12. As the contact angle increases, surface energy decreases. The fine pattern with low surface energy as described above is defined as a state in which the contact angle is 85 degrees or more. In addition, the contact angle is measured using the contact angle measurement method established in JISR3257 (1999) as "Wettability test method of substrate glass surface". In this case, it is assumed to use the surface with fine pattern 12 of the mold 10 according to this Embodiment formed, as a substrate targeted for contact angle measurement.

Even when the fine pattern 12 of the mold 10 has low surface energy, by the fine pattern 12 meeting the relationship between the ratio (lcc/lcv) and the ratio (Sh/Scm), the range of the ratio (lcv/lcc), the range of the ratio (Sh/Scm), and the range of the height H, the nth resist layer 23 is capable of recognizing the fine pattern 12, and of being wet and spread into the fine pattern 12 so as to maximize a radius of the curvature of a virtual droplet of the nth resist layer 23 formed inside the concave portion 12b of the fine pattern 12, and the residual film RF is thinned and made uniform. Further, potential works in the direction from above the convex portion 12a of the fine pattern 12 to the inside of the concave portion 12b, and stability of the nth resist layer 23 is improved in pressing the mold 10 against the nth resist layer 13. (C) The inflow properties into the concave portion 12b are accelerated in the resist layer 23 disposed in the lower portion of the concave portion 12b of the fine pattern 12 in the pressing process, while by acceleration, it is possible to (A) promote the outflow properties of the nth resist layer disposed in the portion under the convex portion 12a of the fine pattern 12 , and it is thereby possible to actualize thinning and uniformity of the residual film RF. In other words, even when the surf ace energy of the fine pattern 12 is low and peeling properties of the nth resist layer 23 are made excellent, it is possible to (1) easily fill inner portions of concave portions 12b of the fine pattern 12 with the nth resist layer 23, and it is possible to (2) improve transfer accuracy.

Further, from the viewpoints of improving (1) the filling properties and (2) transfer accuracy of the nth resist layer 23, the fine pattern 12 preferably contains at least one or more elements or group selected from the group consisting of a fluorine (F) element, methyl group ($-CH_3$), and silicon (Si) element. By containing these elements or group, it is possible to decrease the adhesion force between the nth resist layer 23 and the fine pattern 12, and (2) transfer accuracy is significantly improved. Further, since it is easy to meet the range of the bending modulus of elasticity, it is possible to (1) improve the filling properties of the nth resist layer 23.

When the bending modulus of elasticity of the mold 10 ranges from 5 MPa to 10 Gpa, it is possible to (A) more improve the outflow properties of the nth resist layer 23 disposed below the convex portion 12a of the fine pattern 12 in pressing the fine pattern against the nth resist layer 23. This is because deformation of the fine pattern 12 is applied to flow promotion of the nth resist layer 23 in pressing the fine pattern 12 against the nth resist layer 23 when the bending modulus of the elasticity is in the predetermined range.

In other words, when the bending modulus of elasticity ranges from 5 MPa to 10 Gpa, it is possible to (1) easily obtain the outflow properties of the nth resist layer 23 positioned in the portion under the convex portion 12a of the fine pattern 12 in pressing the fine pattern 12 of the mold 10 against the nth resist layer 23, and the inflow properties of the transfer target material positioned in the lower portion of the concave portion 12b of the fine pattern 12, and it is thereby possible to more easily obtain the concave-convex structure with a thin thickness of the residual film RF. Further, it is made ease to suppress inclusion of air voids in pressing the fine pattern 12 of the mold 10 against the nth resist layer

23. Further, since it is possible to (2) apply the force in peeling off the mold 10 as a line, the absolute value of the peeling force is decreased. Therefore, since it is possible to relax stress on the residual film RF of the concavo-convex structure 23a of the nth resist layer 23, it is possible to prevent the residual film RF from breaking, while it is possible to suppress peeling stress on the concave-convex structure 23a, it is thereby possible to prevent the concavo-convex structure 23a from breaking, and transfer accuracy of the nth resist layer 23 is improved.

Herein, the bending modulus of elasticity of the mold 10 is classified into the case where the mold 10 is comprised of the fine pattern 12 and mold substrate and the case where the mold 10 is comprised of only the fine pattern 12.

When the mold 10 is comprised of only the fine pattern 12, from the viewpoint of more exerting the above-mentioned effects, the bending modulus of elasticity of the mold 10 more preferably ranges from 100 Mpa to 5 Gpa, and most preferably ranges from 400 Mpa to 3.0 Gpa. Particularly, from the viewpoint of improving the filling properties of the nth resist layer 23 on the fine pattern 12, it is preferable to meet the range of 400 Mpa to 2 Gpa, and it is more preferable to meet the range of 450 Mpa to 1.5 Gpa. On the other hand, from the viewpoints of removing air voids in pressing the fine pattern 12 of the mold 10 against the nth resist layer 23 and (2) improving peeling accuracy to suppress breakage of the concave-convex structure comprised of the nth resist layer 23, it is more preferable to meet the range exceeding 2Gpa to 3 Gpa or less.

When the mold 10 is comprised of the fine pattern 12 and mold substrate 11, it is preferable to meet the range from 750 Mpa to 10 Gpa, it is more preferable to meet the range from 1.3 Gpa to 10 Gpa, and it is the most preferable to meet the range from 2.3 Gpa to 10 Gpa. Among the ranges , when the bending modulus ranges from 5 Gpa to 10 Gpa, the operability of the mold 10 is improved, it is possible to suppress inclusion of air voids in pressing the fine pattern 12 of the mold 10 against the nth resist layer 23, and such a range is preferable. From the same effects, the bending modulus more preferably ranges from 7.5 Gpa to 10 Gpa.

Further, the above-mentioned bending modulus of elasticity is a value measured in conformity with JIS K 7171, ISO 178.

Furthermore, when the mold 10 is comprised of only the fine pattern 12, the fine pattern 12 of the mold 10 is preferably formed of materials meeting values of the bending modulus of elasticity as described above. When the mold 10 is comprised of the fine pattern 12 and the mold substrate 11, the mold substrate 11 of the mold 10 is preferably formed of materials meeting values of the bending modulus of elasticity as described above.

<Shape of the fine pattern 12>

The arrangement and shape of the fine pattern 12 are not limited particularly, because it is possible to hold (1) the filling properties into the fine pattern 12 of the nth resist layer 23 and (2) transfer properties excellent in meeting the relationship between the ratio (lcv/lcc) and the ratio (Sh/Scm), the range of the ratio (lcv/lcc), the range of the ratio (Sh/Scm) and the range of height H that are the first to fourth conditions as described above. As the arrangement and shape of the fine pattern 12 , examples thereof are the line-and-space structure with a plurality of palisaded bodies arranged, the dot structure with a plurality of dot-shaped (convex portion, protrusion) structures arranged, and the hole structure with a plurality of hole (concave portion) - shaped structures arranged. As the dot structure and hole structure, examples thereof are a cone, cylinder, quadrangular pyramid, quadrangular prism, the shape of a ring, the shape of a double ring and the shape of a multi-ring.

When the shape of the fine pattern 12 is the shape of dots, since it is possible to cause a continuous gap between dots i.e. the concave portion 12b as a flow path of the nth resist layer 23, (1) filling accuracy to the fine pattern 12 is improved in the nth resist layer 23. Further, when the shape of the fine pattern 12 is the hole structure, since (4) shape stability is improved in the fine mask pattern 25 that is an intermediate state in processing the inorganic substrate 21 that is a workpiece, (3) processing accuracy is improved in the inorganic substrate 21.

Herein, "the shape of dots" is "a shape with a plurality of pillar-shaped bodies (cone-shaped bodies) arranged", and "the shape of holes" is "a shape with a plurality of pillar-shaped (cone-shaped) holes formed". In other words, as shown in FIG. 28A, the shape of dots is a shape in which a plurality of convex portions 12a (pillar-shaped bodies (cone-shaped bodies)) is arranged, and the concave portions 12b between convex potions 12a are in a continuous state. On the other hand, as shown in FIG. 28B, the shape of holes is a shape in which a plurality of concave portions 12b (pillar-shaped (cone-shaped) holes) is arranged, and adjacent concave portions 12b are in a state in which the concave portions 12b are isolated by convex portions 12a. In addition, the convex portion 12a indicates a portion higher than the average height of the fine pattern 12, and the concave portion 12b is indicates a portion lower than the average height of the fine pattern 12.

Further, as shown in FIG. 29, in the first direction D1 and the second direction D2 that are orthogonal inside the surface, the arrangement may have periodicity and non-periodicity in which the concave portions 12b are arranged with a pitch (P) in the first direction D1 and with a pitch (S) in the second direction D2, and further, regularity of shift amounts $\alpha$ is low in the first direction D1 of the concave portions 12b lined in the second direction D2. Since it is possible to design the pitch (P) and pitch (S) as appropriate corresponding to expected uses, the pitch (P) and pitch (S) may be

equal, while regularity of the shift amounts $\alpha$ may be high. In addition, the shift amount $\alpha$ is a position difference between adjacent (N) line and (N+1) line in the first direction D1.

Further, FIG. 29 shows a state in which the concave portions 12b do not overlap and are independent, and the concave portions 12b lined in the first direction D1 and/or the second direction D2 may overlap. In addition, the shift amount $\alpha$ is a distance between segments (second direction D2) passing through the centers of the most adjacent concave portions 12b in the adjacent lines (first direction D1). More specifically, for example, as shown in FIG. 29, the shift amount $\alpha$ means a distance between a segment in the second direction D2 passing through the center of a concave portion 12b in the (N) th line lined in the first direction D1 and a segment in the second direction D2 passing through the center of a concave portion 12b in the (N+1)th line existing at the shortest distance from the concave portion 12b.

In the case of the structure with low periodicity exemplified in FIG. 29, the distribution occurs in the density of the concave portions 12b. In such a case, when the surface energy of the fine pattern 12 of the mold 10 is reduced, particularly, an energy gradient of the nth resist layer 23 arises from a portion (rough portion) in which the density of the fine pattern 12 is low to another portion (dense portion) in which the density is high. In other words, from the viewpoint of a physical phenomenon such as filling into the fine pattern 12 of the mold 10 of the nth resist layer 23, the distribution occurs in the thickness of the residual film RF.

Thus, in the case where the density distribution exists in the fine pattern 12 of the mold 10, the distribution of the thickness of the residual film RF occurs, and therefore, it is preferable that the arrangement of the fine pattern 12 of the mold 10 is an arrangement with high regularity. Herein, for high regularity, it is preferable to arrange the concave portions 12b or convex portions 12a forming the fine pattern 12 in line symmetry. For example, there are arrangements with a point symmetrical arrangement such as an orthohexagonal arrangement, orthotetragonal arrangement, quasi-orthohexagonal arrangement and quasi-orthotetragonal arrangement stretched in a uniaxial direction. Particularly, a state arranged in point symmetry is more preferable. Examples thereof are an orthohexagonal arrangement, orthotetragonal arrangement, quasi-orthohexagonal arrangement and quasi-orthotetragonal.

However, even when the fine pattern 12 of the mold 10 has the density distribution, by meeting the relationship between the ratio (lcv/lcc) and the ratio (Sh/Scm), the range of the ratio (lcv/lcc), the range of the ratio (Sh/Scm) and the range of height H that are the first to fourth conditions as described already, the filling properties (flowability) of the nth resist layer 23 is improved, and it is thereby possible to obtain the effect of uniforming the thickness of the residual film RF.

In other words, in the case of meeting the relationship between the ratio (lcv/lcc) and the ratio (Sh/Scm), the range of the ratio (lcv/lcc), the range of the ratio (Sh/Scm) and the range of height H that are the first to fourth conditions as described previously, (1) the arrangement of the fine pattern 12 of the mold 10 is not limited, and it is possible to determine the arrangement of the fine pattern 12 of the mold 10 according to a use of the inorganic substrate 21 to process and use. In other words, meeting the relationship between the ratio (lcv/lcc) and the ratio (Sh/Scm), the range of the ratio (lcv/lcc), the range of the ratio (Sh/Scm) and the range of height H that are the first to fourth conditions as described already means the opening shape and arrangement of the fine pattern 12 of the mold 10 are limited so as to make (1) the filling properties of the nth resist layer 23 and (2) transfer accuracy of the concavo-convex portion 23 excellent.

From such viewpoints, as the arrangement of the fine pattern 12 of the mold 10 , it is possible to use anorthohexagonal arrangement, orthotetragonal arrangement, quasi-orthohexagonal arrangement quasi-orthotetragonal arrangement, arrangement described with reference to FIG. 29, arrangement in which a set X of average pitch (Px) and a set Y of average pitch (Py) are alternatively aligned, a set in which a set XY where a set X of average pitch (Px) and a set Y of average pitch (Py) are adjacent and a set XZ where the average pitch (Px) and a set Z of average pitch (Pz) are adjacent are alternatively aligned, arrangement in which a long period in which the average pitch (Pave) continuously increases and then decreases is set as one unit and this unit is repeated, and the like. In addition, the quasi-orthohexagonal arrangement is an arrangement obtained by stretching an orthohexagonally aligned arrangement in a uniaxial or biaxial direction, and the quasi-orthotetragonal arrangement is an arrangement obtained by stretching an orthotetragonally aligned arrangement in a uniaxial or biaxial direction.

For example, in the case of the mold 10 to perform processing of a sapphire substrate surface of an LED, for the efficiency improvement mechanism of the LED device, it is preferable that the fine pattern 12 of the mold meets the relationship between the ratio (lcv/lcc) and the ratio (Sh/Scm), the range of the ratio (lcv/lcc), the range of the ratio (Sh/Scm) and the range of height H as described above. Among the ranges, it is possible to determine the fine pattern 12 of the mold. Efficiency (external quantum efficiency) of an LED device is mainly determined by the product of current injection efficiency, light extraction efficiency and internal quantum efficiency, and particularly, in order to manufacture an LED device with high efficiency, it is important to improve light extraction efficiency and internal quantum efficiency. By manufacturing an LED device using the concavo-convex structure product 31 with the concavo-convex structure provided on the inorganic substrate 21, it is possible to control light extraction efficiency and internal quantum efficiency. In the case of reducing the time taken to manufacture the concavo-convex structure product 31 by nano-structure, decreasing a use amount of the semiconductor crystal layer, and improving light extraction efficiency, as the shape of the fine pattern, it is preferable that the pitch ranges from 200 nm to 1200 nm, and that the aspect ratio ranges from 0.3

to 1.5. Particularly, when the pitch ranges from 300 nm to 900 nm and the aspect ratio ranges from 0.5 to 1.3, it is possible to more exhibit the above-mentioned effects. From the viewpoints of actualizing improvements in light extraction efficiency by light diffraction, as the arrangement, it is possible to adopt the hexagonal arrangement and tetragonal arrangement. Herein, by adopting quasi-hexagonal arrangement and quasi-tetragonal arrangement with disorder added to the arrangement, arrangement changing from the hexagonal arrangement to tetragonal arrangement, or the like, it is possible to obtain both the effects of light diffraction properties and light scattering properties, and it is thereby possible to more improve light extraction efficiency. On the other hand, in the case of concurrently improving both internal quantum efficiency and light extraction ef f iciency, it is preferable that the pitch ranges from 200 nm to 350 nm, and that the aspect ratio ranges from 0.3 to 1.5. In this case, the density of the concavo-convex structure product 31 is increased, dislocations occurring inside the semiconductor crystal layer are dispersed, it is thereby possible to reduce local and macroscopic dislocation densities, and internal quantum efficiency is thereby improved. However, in the case of the concavo-convex structure with a high density, the degree of improvements in light extraction efficiency is sometimes low, but by adding disorder to the arrangement, it is possible to improve light extraction efficiency. The disorder of the arrangement is achieved by the quasi-hexagonal arrangement, quasi-tetragonal arrangement, arrangement changing from the hexagonal arrangement to tetragonal arrangement and the like. More specifically, preferable is the hole shape having the hexagonal arrangement with the pitch ranging from 150 nm to 350 nm, where the pitch has variations of ± 5% to ± 25% and the variations have a long period ranging from 1000 nm to 5000 nm.

FIG. 30 contains cross-sectional schematic diagrams illustrating fine patterns of dot structure of molds according to this Embodiment. As shown in FIG. 30, in the case where the concavo-convex shape of the fine pattern 12 is the dot shape, when the length (lx) of the longest segment on the surface to form the vertex portion of a single convex portion 12a is on a submicron scale, (1) improved are the filling properties into the fine pattern 12 of the nth resist layer 23, while increasing the degree of stress concentration on the concave portions 12a of the fine pattern 12, it is thereby possible to effectively decrease the residual film RF of the nth resist layer 23, and such a case is preferable. More specifically, since it is possible to (A) increase stress applied to the nth resist layer 23 disposed in the convex-portion lower portion of the fine pattern 12 from the top of the convex portion 12a of the fine pattern 12, the outflow properties are improved in the nth resist layer 23 disposed in the portion under the convex portion 12a of the fine pattern 12. In association therewith, (B) the influence of anchor and pinning effects is relatively reduced on the nth resist layer flow, and it is thereby possible to thin and uniform the residual film RF. Further, when (B) the length (lx) is on a submicron scale, it is possible to reduce concentration stress applied to the outer edge 23d of the bottom of the convex portion 23c of the nth resist layer 23 applied in peeling off the mold 10. In association therewith, since it is possible to (C) reduce peeling energy applied to the residual film RF, it is possible to suppress the crash of the concave-convex structure 23a and breakage of the residual film RF, and transfer accuracy is improved.

Particularly, in the case where the length (lx) of the longest segment is 500 nm or less, in addition to the above-mentioned effects, even when regularity of the fine pattern is low, it is possible to improve uniformity of the thickness of the residual film RF, and therefore, such a case is preferable. The length (lx) of the segment is more preferably 300 nm or less, and most preferably 150 nm or less. In addition, the surface to form the vertex portion of a single convex portion 12a means a surface on which the surface passing through the vertex-portion position of each convex portion 12a and the vertex-portion of a single convex portion 12 intersect.

As shown in FIG. 30A, when the convex portion 12a has a shape such that the area of the convex-portion bottom portion 12e is larger than the area of the top of convex-portion 12d i.e. a shape such that the convex portion 12a has an inclined surface 12f, the above-mentioned effects are more exerted, it is possible to (B) reduce the pinning effect in the outer edge portion of the convex portion 12a of the nth resist layer 23, and therefore, uniformity of the residual film RF is improved. Further, it is possible to apparently decrease a dynamic contact angle on the fine pattern 12 of the mold 10 of the nth resist layer 23 , (A) the outf lowproperties into the fine pattern 12 are thereby improved in the nth resist layer 23, and it is possible to thin the residual film thickness. Further, as shown in FIG. 30B, in the case where the outside surface of the top of convex-portion 12d and the inclined surface 12f are continuously connected smoothly, i.e. the corner portion formed of the top of convex-portion 12d and the inclined surface 12f has the curvature exceeding 0, it is possible to further exhibit the above-mentioned effects, and therefore, such a case is preferable.

FIG. 31 is a top diagram illustrating the fine pattern of hole structure of the mold according to this Embodiment. In the case where the concavo-convex structure shape of the fine pattern 12 is the hole shape as shown in FIG. 31, when in one hole (A) and hole (B) closest to the hole (A), the length of the shortest segment (ly) connecting between the opening edge portion of the hole (A) and the opening edge portion of the hole (B) is on a submicron scale, (1) improved are the filling properties into the fine pattern 12 of the nth resist layer 23, while increasing the degree of stress concentration on the convex portion 12a of the fine pattern 12, and it is thereby possible to effectively decrease the residual film RF of the nth resist layer 23, being preferable. More specifically, since it is possible to (A) increase stress applied to the nth resist layer 23 disposed in the convex-portion lower portion of the fine pattern 12 from the top of the convex portion 12a of the fine pattern 12, the outflow properties are improved in the nth resist layer 23 disposed in the portion under the convex-portion of the fine pattern. In association therewith, (B) the influence of anchor and pinning

effects are relatively reduced on the nth resist layer flow. Further, since (C) the inflow properties are increased in the nth resist layer 23 disposed in the concave-portion lower portion of the fine pattern 12 , the effects (A/B) as described above are further enhanced, and it is possible to thin the residual film RF while uniforming. Furthermore, when (2) the length (lx) is on a submicron scale, it is possible to reduce concentration stress applied to the outer edge portion of the convex-portion bottom portion 12e of the nth resist layer 23 applied in peeling off the mold 10. In association therewith, since it is possible to (C) reduce peeling energy applied to the residual film RF, it is possible to suppress the crash of the concave-convex structure 23a and breakage of the residual film RF, and transfer accuracy is improved.

Particularly, in the case where the length (lx) of the shortest segment is 500 nmor less, in addition to the above-mentioned effects, even when regularity of the fine pattern is low, it is possible to improve uniformity of the thickness of the residual film RF, and therefore, such a case is preferable. The length is more preferably 400 nm or less, and most preferably 300 nm or less. Among the lengths, from the viewpoints of more promoting (A) the outflow properties into the fine pattern 12 of the nth resist layer 23 disposed in the portion under the convex-portion of the fine pattern 12 and (B) the inflow properties into the fine pattern of the nth resist layer 23 disposed in the concave-portion lower portion of the fine pattern 12, and thinning the residual film RF, the length of the shortest segment is preferably 150 nm or less, more preferably 100 nm or less, and most preferably 0 nm. In addition, the length of the shortest segment of 0 nm means a state in which a part of the opening edge portion of the hole (A) overlaps a part of the opening edge portion of the hole (B).

In addition, although not shown in the figure, when the concave portion 12b has a shape such that the area of the opening portion is larger than the area of the concave-portionbottomportion i.e. a shape such that the concave portion 12b has an inclined surface, the above-mentioned effects are more exerted, it is possible to (B) suppress the pinning effect in the outer edge portion of the convex portion 12a of the nth resist layer 23, and therefore, uniformity of the residual film RF is improved. Further, it is possible to apparently decrease a dynamic contact angle on the fine pattern 12 of the mold 10 of the nth resist layer 23, (1) the filling properties into the fine pattern 12 are thereby improved in the nth resist layer 23, and it is possible to thin the thickness of the residual film RF, being preferable. Furthermore, in the case where the top of convex-portion and the inclined surface are continuously connected smoothly in the convex portion 12a separating the concave portion 12b, i.e. the corner portion formed of the top of convex-portion and the inclined surface has the curvature exceeding 0, it is possible to further exhibit the above-mentioned effects, and therefore, such a case is preferable. In other words, it is preferable that adjacent concave portions 12b are continuously connected.

<Average pitch (Pave)>

The pitch (P) as shown in FIG. 12 means a distance between adjacent convex portions 12a or a distance between adjacent concave portions 12b in the fine pattern 12. In the case where the fine pattern has the hole structure, as shown in FIG. 32, a hole B1 that is the closest to some hole A1 is selected, and a distance $P_{A1B1}$ between the center of the hole A1 and the center of the hole B1 is defined as the pitch (P).

FIG. 32 is a top diagram of the mold illustrating the fine pattern of dot shape (hole shape) of the mold according to this Embodiment. As shown in FIG. 32, when the pitch (P) varies with the selected hole, ten holes are selected arbitrarily, pitches (P) are respectively obtained for selected holes, and the arithmetical mean value of the pitches is defined as the average pitch (Pave) of the fine pattern 12. Further, observation is performed on the sample piece including the area of 10mmx10mm square used in obtaining the arithmetical mean value of the height (H) as described already. In other words, the height (H), opening width of concave-portion (lcc), the top width of convex-portion (lcv) and the ratio (Sh/Scm) as described already and the average pitch (Pave) are observed in different portions in the same sample piece. Further, the opening width of concave-portion (lcc), the top width of convex-portion (lcv) and the ratio (Sh/Scm) as described already and the average pitch (Pave) are observed in the same portion in the same sample piece. The average pitch (Pave) that is the arithmetical mean value of pitches (P) is calculated by the following procedure. First, scanning electron microscope observation is performed on the concavo-convex structure surface of the sample piece of 10mm x 10mm square or more as described already. Herein, the magnification of the scanning electron microscope is increased until at least 100 or more holes are sharply photographed. From the enlarged image are selected 100 holes, 10 holes are selected arbitrarily from among the 100 holes, and pitches (P) are calculated respectively on the holes. Although only 25 holes are drawn in FIG. 32, actually 10 holes are selected arbitrarily from 100 holes, and pitches (P) are calculated on the selected holes. Herein, in FIG. 32, the hole A1 is selected, and a pitch $P_{A1B1}$ is obtained. Similarly, $P_{A2B2}$ to $P_{ANBN}$ are obtained, and the arithmetical mean value of the pitches i.e. $(P_{A1B1}+P_{A2B2}+\cdots+P_{A10B10})/10=$Pave is defined. In addition, in the above-mentioned definition of the average pitch (Pave), in the case where the fine pattern 12 has the dot structure, it is possible to define by replacing the hole used in the description of the above-mentioned average pitch (Pave) with the dot to read.

Further, in the case where the fine pattern 12 has the line-and-space structure, as shown in FIG. 33, a convex line B1 that is the closest to some convex line A1 is selected, and a shortest distance $P_{A1B1}$ between the center line of the convex line A1 and the center line of the convex line B1 is defined as the pitch (P).

FIG. 33 is a top diagram illustrating the fine pattern of the line-and-space structure of the mold according to

this Embodiment. As shown in FIG. 33, when the pitch (P) varies with the selected convex line, ten convex lines are selected arbitrarily, pitches (P) are respectively obtained for selected convex lines, and the arithmetical mean value of the pitches is defined as the average pitch (Pave) of the fine pattern 12. Further, observation is performed on the sample piece including the area of 10mm x 10mm square used in obtaining the arithmetical mean value of the height (H) as described already. In other words, the height (H), opening width of concave-portion (lcc), the top width of convex-portion (lcv) and the ratio (Sh/Scm) as described already and the average pitch (Pave) are observed in different portions in the same sample piece. Further, the opening width of concave-portion (lcc), the top width of convex-portion (lcv) and the ratio (Sh/Scm) as described already and the average pitch (Pave) are observed in the same portion in the same sample piece. The average pitch (Pave) that is the arithmetical mean value of pitches (P) is calculated by the following procedure. First, scanning electron microscope observation is performed on the concavo-convex structure surface of the sample piece of 10mm x 10mm square or more as described already. Herein, the magnification of the scanning electron microscope is increased until at least 20 or more convex lines are sharply photographed. From the enlarged image are selected 20 convex lines, 10 convex lines are selected arbitrarily from among the 20 convex lines, and pitches (P) are calculated respectively on the convex lines. Although only 7 convex lines are drawn in FIG. 33, actually 10 convex lines are selected arbitrarily from 20 convex lines, and pitches (P) are calculated on the selected convex lines. Herein, in FIG. 33, the convex line A1 is selected, and a pitch $P_{A1B1}$ is obtained. Similarly, $P_{A2B2}$ to $P_{ANBN}$ are obtained, and the arithmetical mean value of the pitches i.e. $(P_{A1B1}+P_{A2B2}+\cdots+P_{A10B10})/10$=Pave is defined. In addition, the above-mentioned definition of the average pitch (Pave) is the same both in the case of concave lines and in the case of convex lines.

It is preferable that the average pitch (Pave) of the fine pattern 12 meets following equation (12). By meeting this range, it is possible to (1) ensure flowability of the nth resist layer 23 to the concave portion 12b of the fine pattern 12, and (2) suppress the crash of the fine pattern of the concave-convex structure 23a formed in the nth resist layer 23 in the mold release step. Particularly, when the average pitch (Pave) is 1500 nm or less, it is possible to (B) promote the inflow properties to the fine pattern 12 of the materials forming the nth resist layer 23 disposed in the concave-portion lower portion of the fine pattern 12, thin the residual film RF, (D) reduce moment energy applied to the convex portion 23c of the concave-convex structure 23a in the mold release step, and (E) reduce concentration stress applied to the outer edge 23dof the bottom of the convex portion 23c of the concavo-convex portion 23a, and it is thereby possible to improve transfer accuracy. On the other hand, when the average pitch (Pave) is 50 nm or less, since the average pitch (Pave) with respect to the residual film RF is relatively large, it is possible to improve uniformity of the residual film RF. From the viewpoints of further exerting these effect more, and improving flowability to the concave portion 12b of the fine pattern 12 of the nth resist layer 23 also in a state in which transfer accuracy is improved by using the mold with surface free energy reduced, the average pitch (Pave) more preferably ranges from 150 nm to 1300 nm, and further preferably ranges from 200 nm to 1200 nm. Further, from the viewpoints of (E) reducing concentration stress on the concave-convex structure 23a formed of the nth resist layer 23 applied in peeling the fine pattern 12 to improve transfer accuracy, the average pitch (Pave) more preferably ranges from 250 nm to 950 nm, and most preferably ranges from 300 nm to 750 nm.

Eq. (12)

$$50\ \text{nm} \leq \text{Pave} \leq 1500\ \text{nm}$$

<Aspect ratio (H/lcc)>

The aspect ratio (H/lcc) is a ratio between the opening width of concave-portion (lcc) and the height (H) of the fine pattern 12. The aspect ratio (H/lcc) is preferably 5.0 or less, from the viewpoints of the filling properties of the nth resist layer 23 in the pressing step and suppression of the pattern crash of the concave-convex structure 23a formed in the nth resist layer 23 in the mold release step. Particularly, from the viewpoints of (C) improving the inflow properties to the fine pattern 12 of the nth resist layer 23 disposed in the concave-portion lower portion of the fine pattern 12, and (D) reducing moment energy applied to the convex portion of the concave-convex structure 23a in the mold release step, the aspect ratio is more preferably 3.0 or less, and most preferably is 2.5 or less. Further, from the viewpoints of reducing friction energy in peeling off the fine pattern 12 in the mold release step, (E) reducing concentration stress applied to the concavo-convex 23a, and in association therewith, (F) reducing peeling energy applied to the residual film RF, the aspect ratio is more preferably 2.0 or less, and most preferably 1.5 or less. The lower limit value is preferably 0.1 or more, and more preferably 0.5 or more, from the viewpoint of forming the fine mask pattern 25 on the inorganic substrate 21 as the workpiece with high accuracy using the resist layered product 30. In addition, the aspect ratio is a value calculated with the height (H) and opening width of concave-portion (lcc) calculated according to the above-mentioned definitions.

Described next is a manufacturing method of the mold 10. The manufacturing method of the mold 10 is not

limited particularly. The fine pattern 12 of the mold 10 is preferably manufactured by transferring and forming a fine pattern of a master stamper by a transfer method. In addition, it is also possible to use a resin mold made of a resin, and a mold replicated by Ni electroforming as the master stamper. For example, it is possible to prepare the master stamper by a method of directly writing on a surface of an inorganic substrate typified by Si and $SiO_2$ by the photolithography method, interference exposure method, electron beam lithography method, thermal lithography method or the like, another method of transferring the fine patternpreparedby the above-mentioned method by the electroforming method typified by Ni, and the like. As a transfer material to transfer the fine pattern on the master stamper surface, examples thereof are thermoplastic resins, thermosetting resins and photocurable resins. Particularly, the case of using thermoplastic resins or thermosetting resins is generally referred to as thermal nanoimprint, and the case of using photocurable resins is generally referred to as photo nanoimprint. When the master stamper is in the shape of a plate, it is possible to transfer by a batch scheme. When the stamper is in the shape of a cylinder (cylindrical column), it is possible to transfer continuously.

The fine pattern 12 may be formed of polydimethylsiloxane (PDMS), inorganic substances typified by Si, Ni and $SiO_2$, fluorine resin, cycloolefin resin (COP), polyimide (PI), polyethylene terephthalate (PET), polyethylene (PE) and the like.

Particularly, from the viewpoints of reducing surface energy of the fine pattern 12 and improving transfer accuracy of the nth resist layer 23, the fine pattern 12 is preferably formed of any one among polyimide (PI), cycloolefin resin (COP), fluorine-containing resin, silicone-containing resin and polydimethylsiloxane (PDMS). The fine pattern 12 is particularly preferably formed of any one among fluorine-containing resin, silicone-containing resin and polydimethylsiloxane. Hereinafter, the mold formed of such a resin is referred to as a resin mold.

It is preferable that the fluorine concentration (Es) in the surface portion of the cured material of the photocurable resin in the fine pattern 12 is higher than the average fluorine concentration (Eb) in the fine pattern 12. By this means, the fine pattern 12 surface is excellent in mold release properties from the nth resist layer 23 and the first to (n-1)th resist layer 22 because of low free energy, free energy is kept high near the mold substrate 11, and it is thereby possible to improve adhesion directly connected to mold release properties between the mold substrate 11 and the fine pattern 12.

Further, from the viewpoint of more exerting the above-mentioned effects, it is preferable that the ratio between the average fluorine element concentration (Eb) in the resin forming the fine pattern 12 and the fluorine element concentration (Es) in the surface portion of the fine pattern 12 meets $1 \leq Es/Eb \leq 30000$. Particularly, the ranges of from $3 \leq Es/Eb \leq 1500$ to $10 \leq Es/Eb \leq 100$ further improve mold release properties, and are preferable.

In addition, when the ratio is in the range of $20 \leq Es/Eb \leq 200$ within the aforementioned widest range ($1 < Es/Eb \leq 30000$), the fluorine element concentration (Es) in the surface portion of the fine pattern 12 is sufficiently higher than the average fluorine element concentration (Eb) in the fine pattern 12, free energy on the surface of the fine pattern 12 decreases effectively, and mold release properties from the transfer material resin, the nth resist layer 23 and the first to (n-1)th resist layer 22 are thereby improved.

Further, by lowering the average fluorine element concentration (Eb) in fine pattern 12 relative to the fluorine element concentration (Es) in the surf ace portion of the fine pattern 12, the strength of the fine pattern 12 itself is improved, while free energy can be kept high near the mold substrate 11 in the fine pattern 12, and therefore, adhesion between the fine pattern 12 and the mold substrate 11 is improved. By this means, it is possible to obtain the fine pattern 12 which is excellent in adhesion to the mold substrate 11, excellent in mold release properties from the nth resist layer 23, and which enables the concave-convex shape of the nanometer size to be transferred repeatedly from resin to resin.

Further, in the range of $26 \leq (Es/Eb) \leq 189$, it is possible to further lower free energy on the fine pattern 12 surface, repetition transfer properties are excellent, and therefore, the range is preferable. Furthermore, in the range of $30 \leq (Es/Eb) \leq 160$, it is possible to maintain the strength of the fine pattern 12 while decreasing free energy on the fine pattern 12 surface, repetition transfer properties are further improved, the range is thereby preferable, and the range of $31 \leq (Es/Eb) \leq 155$ is more preferable. The range of $46 \leq (Es/Eb) \leq 155$ enables the aforementioned effects to be further exerted, and is preferable.

In order to set the abovementioned (Es/Eb) at the predetermined range and improve transfer accuracy on the second resist layer, the concentration gradient is important such that the fluorine element concentration decreases from the surface side of the fine pattern 12 of the mold 10 to the mold substrate 11 side. While being different depending on the shape of the fine pattern 12, when the thickness of the fine pattern 12, which is substantially the distance from the interface between the mold substrate 11 side and the fine pattern 12 to the top of convex-portion, is 1500 nm or more, since it is possible to stabilize the gradient of the fluorine element concentration thermodynamically, it is possible to meet the above-mentioned (Ex/Eb) and enhance transfer accuracy on the nth resist layer 23. From the same effects, the thickness of the fine pattern 12 is preferably 2000 nm or more, and more preferably 2500 nm or more. In addition, the upper limit value is preferably 10 $\mu$m or less, from the viewpoints of handling and throughput in manufacturing the resin mold, and amount of used raw materials. The value of 8 $\mu$m or less is more preferable, from the viewpoints of improving throughput characteristics while maintaining transfer accuracy continuously by the roll-to-roll method.

In addition, the above-mentioned repetition transfer properties mean that a resin mold is easily replicated from

a resin mold. In other words, it is possible to transfer and form a resin mold G2 with the concave-shaped concavo-convex structure using a resin mold G1 with the concavo-convex structure of the resin mold in the convex shape as a mold, and transfer and form a resin mold G3 with the convex-shaped concavo-convex structure using the resin mold G2 as a mold. Similarly, it is possible to transfer and form a resin mold GN+1 with the concave-shaped concavo-convex structure using a resin mold GN with the convex-shaped concave-convex structure. Further, it is also possible to obtain a plurality of resin molds G2 using a single resin mold G1 as a mold, and to also obtain a plurality of resin molds G3 using a single resin mold G2 as a mold. Similarly, it is also possible to obtain a plurality of resin molds GM+1 using a single resin mold GM as a mold. Further, it is possible to use the resin mold many timed. Thus, by using the resin mold meeting the above-mentioned (Es/Eb), environmental suitability is improved.

Herein, for example, the surf ace portion of the fine pattern 12 means an intrusion portion of approximately 1% to 10% in the thickness direction or an intrusion portion of 2 nm to 20 nm in the thickness direction, from the surface side with the nth resist layer 23 formed of the fine pattern 12 toward the mold substrate 11 side.

In addition, it is possible to quantify the fluorine element concentration (Es) in the surface portion of the fine pattern 12 by an XPS (X-ray Photoelectron Spectroscopy) method. The penetration length of X-rays of the XPS method is several nanometers, thus shallow, and therefore, is suitable for quantifying the Es value. As another analysis method, it is also possible to calculate (Es/Eb) using energy dispersive X-ray spectroscopy (TEM-EDX) using a transmission electron microscope.

Further, it is possible to calculate the average fluorine element concentration (Eb) in the resin constituting the fine pattern 12 from the amount of charge. Alternatively, it is also possible to identify the average fluorine element concentration (Eb) in the resin by decomposing a slice obtained by physically peeling off the fine pattern 12 by a flask combustion method, and then, applying ion chromatography analysis to the resultant.

Among resins constituting the fine pattern 12, as photopolymerizable radical polymerization system resins, it is preferable to use curable resin compositions (1) that are mixed materials of fluorine-non-containing (meth)acrylate, fluorine-containing (meth)acrylate, and photopolymerization initiator, curable resin compositions (2) that are mixed materials of fluorine-non-containing (meth) acrylate and photopolymerization initiator, curable resin compositions (3) that are mixed materials of fluorine-non-containing (meth)acrylate, silicone, and photopolymerization initiator, and the like. Further, it is also possible to use curable resin compositions (4) containing sol-gel materials typified by metal alkoxide.

The curable resin compositions (4) are only metal alkoxide containing a silane coupling agent, silane coupling agent provided with photopolymerizable functional groups, photopolymerization initiator and metal alkoxide, and mixed materials of metal alkoxide containing a silane coupling agent and the above-mentioned resin curable compositions (1) to (3), and the like. Particularly, by using the curable resin composition (1), when the curable resin composition (1) is cured in a state in which the curable resin composition (1) is brought into contact with a hydrophobic interface with low surface free energy, it is possible to make the fluorine element concentration (Es) in the resin layer surface portion constituting the resin mold higher than the average fluorine element concentration (Eb) in the resin constituting the resin layer constituting the resin mold, and further, to adjust the average fluorine element concentration (Eb) in the resin to be lower.

As the fluorine-containing meth(acrylate), it is preferably to have either or both of a polyfluoroalkylene chain andperfluoro (polyoxyalkylene) chain and polymerizable group, and further preferable is a linear perf luoro alkylene group or perf luoro oxyalkylene group having a trifluoromethyl group in the side chain with an ethereal oxygen atom inserted in between carbon atoms. Further, particularly preferable is either or both of a linear polyfluoroalkylene chain having a trifluoromethyl group in the molecular side chain or molecular structure terminal and a linear perfluoro (polyoxyalkylene) chain.

The polyfluoroalkylene chain is preferably a polyfluoroalkylene group with the carbon number of from 2 to 24. Further, the polyfluoroalkylene group may have a functional group.

The perfluoro (polyoxyalkylene) chain is preferably comprised of one kind of perfluoro (oxyalkylene) units or more selected from the group consisting of a ($CF_2CF_2O$) unit, ($CF_2CF(CF_3)O$) unit, ($CF_2CF_2CF_2O$) unit and ($CF_2O$) unit, and is more preferably comprised of ($CF_2CF_2O$) units, ($CF_2CF(CF_3)O$) units or ($CF_2CF_2CF_2O$) units. The perfluoro (polyoxyalkylene) chain is particularly preferablycomprisedof ($CF_2CF_2O$) units, becausephysicalproperties (heat resistance, acid resistance, etc.) of the fluorine-containing polymer are excellent. In terms of high mold release properties and hardness of the fluorine-containing polymer, the number of perfluoro (oxyalkylene) units is preferably an integer of from 2 to 200, and more preferably an integer of from 2 to 50.

As the polymerizable group, among preferable groups are a vinyl group, ally group, acryloyl group, methacryloyl group, epoxy group, dioxetane group, cyano group, isocyanate group and hydrolytic silyl group expressed by following chemical formula (A), and an acryloyl group or methacryloyl group is more preferable.

Chemical formula (A) $-(CH_2)\ aSi\ (M1)_{3-b}\ (M2)_b$

In the above-mentioned chemical formula (A), M1 is a substituent group that is converted into a hydroxyl group

by hydrolysis reaction. Examples of such substituent groups are a halogen atom, alkoxy group, and acyloxy group. As the halogen atom, a chlorine atom is preferable. As the alkoxy group, a methoxy group or ethoxy group is preferable, and a methoxy group is more preferable. As M1, an alkoxy group is preferable, and a methoxy group is more preferable.

M2 is a monovalent hydrocarbon group. Examples of M2 are an alkyl group, alkyl group substituted by one or more aryl groups, alkenyl group, alkynyl group, cycloalkyl group and aryl group, and an alkyl group or alkenyl group is preferable. When M 2 is an alkyl group, alkyl groups with the carbon number of from 1 to 4 are preferable, and a methyl group or ethyl group is more preferable. When M2 is an alkenyl group, alkenyl groups with the carbon of from 2 to 4 are preferable, and a vinyl group or allyl group is more preferable. a is an integer of from 1 to 3, and "3" is preferable. b is "0", or an integer of from 1 to 3, and "0" is preferable. As the hydrolytic silyl group, preferable is $(CH_3O)_3SiCH_2$-, $(CH_3CH_2O)_3Si(CH_2)_2$-, $(CH_3O)_3Si(CH_2)_3$ or $(CH_3CH_2O)_3Si(CH_2)_3$-.

As the number of polymerizable groups, in terms of excellence in polymerizable properties, integers of from 1 to 4 are preferable, and integers of from 1 to 3 are more preferable. When two kinds of compounds or more are used, the average number of polymerizable groups preferably ranges from 1 to 3.

The fluorine-containing (meth)acrylate having functional groups is excellent in adhesion to transparent substrates. Examples of the functional groups are a carboxyl group, sulfone group, functional groups having an ester bond, functional groups having an amide bond, hydroxyl group, amino group, cyano group, urethane group, isocyanate group and functional groups having derivatives of isocyanuric acid. Particularly, it is preferable to contain at least one functional group of a carboxyl group, urethane group, and functional groups having derivatives of isocyanuric acid. In addition, the derivatives of isocyanuric acid include structures having a skeleton of isocyanuric acid with at least one of hydrogen atoms bound to a nitrogen atom substituted by another group. As the fluorine-containing (meth)acrylate, it is possible to use fluoro(meth)acrylates, fluorodienes, etc.

Particularly, fluorine-containing (meth)acrylate is preferably fluorine-containing urethane (meth) acrylates expressed by following chemical formulas (B) to (D), from the viewpoints of effectively increasing the fluorine element concentration (Es) of the fine pattern 12 surface portion with the average fluorine element concentration (Eb) in the resin lowered, and more effectively developing adhesion to the mold substrate and mold release properties of the nth resist layer 23. As such an urethane (meta)acrylate, for example, it is possible to use ""OPTOOL DAC" made by Daikin Industries, Ltd.

[Chemistry 1]

Chemical formula (B)

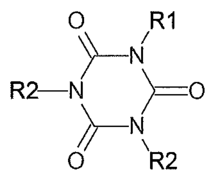

(In chemical formula (B), R1 represents following chemical formula (C), and R2 represents following chemical formula (D).)

[Chemistry 2]

(Chemical formula (C)

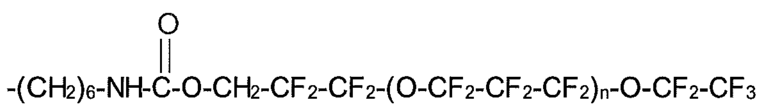

(In chemical formula (C), n is an integer of from 1 to 6.)

[Chemistry 3]

(Chemical formula (D)

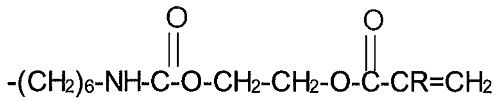

(In chemical formula (D), R is H or $CH_3$.)

By forming a demolding layer on the fine pattern 12, transfer accuracy of the nth resist layer 23 is improved. The demolding layer reduces surface energy of the fine pattern 12, and thereby enables the adhesion force between the nth resist layer 23 and the fine pattern 12 to be decreased. On the other hand, a reduction in surface energy of the fine pattern 12 causes inhibition of filling to the fine pattern 12 of the nth resist layer 23. However, by meeting the relationship between the ratio (lcv/lcc) and the ratio (Sh/Scm), the range of the ratio (lcv/lcc), the range of the ratio (Sh/Scm) and the range of the height (H) as described already, it is possible to excellently fill without degrading the filling properties of the nth resist layer 23, and to decrease the adhesion force between the nth resist layer and the fine pattern.

The thickness of the demolding layer is preferably 30 nm or less from the viewpoint of transfer accuracy, and a thickness of a single molecular layer or more is preferable. The thickness of the demolding layer is more preferably 2 nm or more from the viewpoint of mold release properties, and is more preferably 20 nm or less from the viewpoint of transfer accuracy.

A material forming the demolding layer is not limited particularly, as long as the contact angle with respect to water is 90 degrees or more, and from the viewpoint of mold release properties, among preferable materials are materials containing methyl groups, materials containing silicone, and materials containing fluorine. As the materials containing fluorine, for example, there are fluorine-based mold release agents. Particularly, materials containing a silane coupling agent or PDMS enable the film thickness of the demolding layer to be thinned with ease, further enable transfer accuracy to be held, and are preferable. As the material used in the demolding layer, a single kind may be used alone, or a plurality of kinds may be used at the same time. It is also possible to adopt diamond-like carbon (DLC) and a substance obtained by adding fluorine to diamond-like carbon.

Further, a metal layer formed of both or either of metal and metal oxide may be formed on the fine pattern 12. By providing such a metal layer, since surface hardness of the fine pattern 12 is improved, it is possible to (A) promote the outflow properties of the nth resist layer 23 disposed in the portion under the convex-portion of the fine pattern 12. In the case of laminating the fine pattern 12 of the mold 10 to the nth resist layer and thinning the residual film RF of the nth resist layer 23, as the residual film RF is thinner, the hardness and viscosity of a portion corresponding to the residual film RF of the nth resist layer 23 increase. In an extremely small area with the residual film RF of 50 nm or less, physical properties different from physical properties of the bulk are exerted, and particularly, in the nth resist layer 23, there is a tendency that the hardness and viscosity increase.

In other words, as the residual film RF is made smaller, flowability decreases in the nth resist layer 23 existing in the lower portion of the convex portion 12a of the fine pattern 12 of the mold 10. By meeting the relationship between the ratio (lcv/lcc) and the ratio (Sh/Scm), the range of the ratio (lcv/lcc), the range of the ratio (Sh/Scm) and the range of the height (H) as described already, it is possible to suppress the effect of thinning inhibitionof the residual filmRF due to a change inphysical properties of the nth resist layer 23, and to obtain the fine pattern 12 having an excellent residual film RF, and by beforehand providing the above-mentioned metal layer, since it is possible to suppress deformation of the fine pattern 12 in thinning the thickness of the residual film RF, it is possible to obtain the residual film RF having an excellent shape. From the viewpoint of transfer accuracy, the thickness of the metal layer is preferably 30 nm or less, more preferably 20 nm or less, and further preferably 15 nm or less. By forming the metal layer, the physical strength of the fine pattern 12 is increased. Further, transfer accuracy and transfer durability is improved in the case of forming the demolding layer on the metal layer.

The thickness of the demolding layer provided on the metal layer preferably ranges from a single molecular layer to 30 nm, from the viewpoint of transfer accuracy. The thickness of the demolding layer is more preferably 2 nm or more from the viewpoint of mold release properties, and is more preferably 20 nm or less from the viewpoint of transfer accuracy.

It is possible to select a material forming the metal layer as appropriate, in terms of adhesion to the fine pattern 12 and adhesion to the demolding layer. As the metal, examples thereof are chrome, aluminium, tungsten, molybdenum, nickel, gold and platinum. As the metal oxide, examples thereof are oxides of the above-mentioned metals, $SiO_2$, ZnO, $Al_2O_3$, $ZrO_2$, CaO, and $SnO_2$. Further, it is possible to use silicon carbide, diamond-like carbon, fluorine-containing diamond-like carbon and the like. Mixed materials thereof may be used. Further, as the material forming the metal layer, from the viewpoint of transfer accuracy, Cr is preferable as the metal, and $SiO_2$, $Al_2O_3$, $ZrO_2$, and ZnO are preferable

as the metal oxide. The metal layer may be a single layer or multilayer.

Particularly, in the case where adhesion between the metal layer formed on the uppermost surface and the fine pattern 12 of the mold 10 is poor, or the like, it is preferable to form a first metal layer on the fine pattern 12 of the mold 10, and further form a second metal layer on the first metal layer. Similarly, in order to improve adhesion and electrostatic property, it is possible to from an N+1th metal layer on an Nth metal layer. As the number of metal layers, from the viewpoint of transfer accuracy, N≤4 is preferable, N≤2 is more preferable, and N≤1 is further preferable. For example, in the case of N=2, it is possible to provide a first metal layer made of $SiO_2$ on the fine pattern 12 surface, and further provide a second metal layer made of Cr on the first metal layer.

As described above, it is possible to prepare the fine pattern 12 by various techniques, and particularly, from transfer accuracy of the fine pattern 12 and speed, it is preferable to form by continuous process using a photocurable resin.

A material constituting the mold substrate 11 is not limited particularly, and for example, it is possible to use both inorganic materials such as glass, ceramic and metal and organic materials such as plastic. Corresponding to a use of the formed product, it is possible to use a plate, sheet, film, thin film, cloth, nonwoven cloth, other optional shapes and composite materials thereof. Among the materials, it is particularly preferable to include a sheet, film, thin film, cloth, nonwoven cloth and the like which have flexibility and are excellent continuous productivity.

As the materials having flexibility, examples thereof are a glass film, amorphous thermoplastic resins such as methyl polymethacrylate resin, polycarbonate resin, polystyrene resin, cycloolefin resin (COP), cross-linked polyethylene resin, polyvinyl chloride resin, polyacrylate resin, polyphenylene ether resin, modified polyphenylene ether resin, polyether imide resin, polyether sulfone resin, polysulfone resin and polyether ketone resin, crystalline thermoplastic resins such as polyethylene terephthalate (PET) resin, polyethylene naphthalate resin, polyethylene resin, polypropylene resin, polybutylene terephthalate resin, aromatic polyester resin, polyacetal resin, and polyamide resin, ultraviolet (UV) curable resins of acrylic system, epoxy system, urethane system and the like, and thermosetting resins.

Further, it is possible to combine the UV-curable resin and thermosetting resin, inorganic substrate made of glass or the like, the above-mentioned thermoplastic resin and triacetate resin, or use alone to form the mold substrate 11.

A the mold substrate 11 of the mold 10, it is possible to use materials having the above-mentioned configuration, and by using the mold substrate 11 with consideration given to the refractive index, haze, and viewpoint of the resin layer containing fine particles, improved are shape stability of the nth resist layer 23 and transfer accuracy of the nth resist layer 23.

In the case of applying an energy ray from the mold substrate 11 surface side after forming a mold layered product including mold substrate 11/fine pattern 12/nth resist layer 23/first to (n-1) th resist layer 22/inorganic substrate 21, as reflection of the energy rays decreases in the interface between the mold substrate 11 and the fine pattern 12, transfer accuracy is more improved, and it is possible to decrease power of the energy ray source to use. Therefore, a difference (|n1-n2|) between the refractive index (n1) of the mold 11 and the refractive index (n2) of the fine pattern 12 with respect to the main wavelength (λ) required for the reaction with the nth resist layer 23 is preferably 0.3 or less, more preferably 0.2 or less, and further preferably 0.15 or less. In addition, from the viewpoint of the fact the energy ray is substantially hard to recognize the interface between the mold substrate 11 and the fine pattern 12, the refractive index difference (|n1-n2|) is preferably 0.1 or less.

The haze of the mold substrate 11 is preferably 30% or less. By this means, it is possible to ensure adhesion of the fine pattern 12 to the mold substrate 11. Further, it is possible to improve surface accuracy of the surface formed of the top of convex-portions of the fine pattern 12. Particularly, from the viewpoints of transfer accuracy and adhesion to the fine pattern 12, the haze is preferably 10% or less, more preferably 6% or less, and most preferably 1.5% or less.

Further, in the case of applying patterned energy rays, and forming a layered product (hereinafter, simply referred to as "layered product A") including patterned nth resist layer 23/first to (n-1)th resist layer 22/inorganic substrate 21, from the viewpoint of resolution, the haze of the mold substrate 11 is preferably 1. 5% or less. The haze is a value indicative of turbidity, is obtained from total transmittance T of light which is applied from a light source and passes through a sample and transmittance D of scattered light diffused in the sample, and is defined as haze value H=D/T x 100. These items are specified by JIS K 7105. It is possible to easily measure by using a commercially available haze meter (for example, NDH-1001DP, made by NIPPON DENSHOKU INDUSTRIES Co. , LTD. and the like). As the mold substrate 11 having the haze value of 1.5% or less, examples thereof are polyethylene terephthalate films such as high transparent film GS series made by TEIJIN LIMITED, M-310 series made by Hoechst Diafoil Company and Mylar D series made by Du Pont.

As the film-shaped mold substrate 11, such a product may be used that is obtained by laminating a resin layer containing fine particles on one surface of a biaxially oriented polyester film. The average particle diameter of fine particles is preferably 0.01 μm or more, from the viewpoints of workability in manufacturing the fine pattern 12 continuously by roll-to-roll process, improvement of workability in continuously laminating the mold to the inorganic substrate 21, and suppression of the occurrence of micro· nano bubbles and air voids on a millimeter scale occurring in the pressing step. From the viewpoint of improving resolution in applying patterned energy rays to form the patterned layered product 20, the average particle diameter of fine particles is preferably 5.0 μm or less. From the viewpoint of further exerting the

effect, the average particle diameter more preferably ranges from 0.02 μm to 4.0 μm, and particularly preferably ranges from 0.03 μm to 3.0 μm.

For example, it is possible to adjust the blending amount of fine particles as appropriate corresponding to the base resin forming the resin layer, kind and average particle diameter of fine particles, desired physical properties and the like. As the fine particles, examples thereof are inorganic particles of silica, kaolin, talc, alumina, calcium phosphate, titanium dioxide, calcium carbonate, barium sulfate, calcium fluoride, lithium fluoride, zeolite, molybdenum sulfide and the like, and organic particles such cross-linked polymer particles, calcium oxalate and the like. Particularly, from the viewpoint of transparency, particles of silica are preferable. In addition, fine particles include fillers. These fine particles may be used alone, or may be used in combination of two or more kinds together.

As a base resin constituting the resin layer containing fine particles, examples thereof are polyester-based resins, polyurethane-based resins, acryl-based resins, mixtures thereof, and copolymers thereof. From the viewpoints of improving workability in continuously manufacturing the fine pattern 12 by roll-to-roll process, and workability in continuously laminating the mold 10 to the inorganic substrate 21, and suppressing a defect of the concavo-convex structure and a macro defect on a millimeter or centimeter scale, the thickness of the resin layer is preferably 0.01 μm or more. From the viewpoint of improving resolution in applying patterned energy rays to form the patterned layered product 20, the thickness preferably ranges from 0.05 μm to 3.0 μm, more preferably ranges from 0.1 μm to 2.0 μm, and further preferably ranges from 0.1 μm to 1.0 μm.

The method of laminating a resin layer on one surface of the biaxially oriented polyester film is not limited particularly, and for example, there are coating and the like. As the polyester-based resin constituting the biaxially oriented polyester film, examples thereof are aromatic linear polyesters having aromatic dicarboxylic acids and diols as components such as polyethylene terephthalate, polybutylene terephthalate, and polyethylene naphthalate, aliphatic linear polyesters having aliphatic dicarboxylic acids and diols as components, and polyester-based resins mainly made of polyester such as these copolymers. These resins may be used alone, or two or more kinds may be used together.

Further, the biaxially oriented polyester film to laminate the resin layer may contain fine particles. As the fine particles, examples thereof are the same fine particles as those contained in the resin layer. From the viewpoint of maintaining transparence of the mold substrate 11, the content of the fine particles preferably ranges from 0 ppm to 80 ppm, more preferably ranges from 0 ppm to 60 ppm, and particularly preferably ranges from 0 ppm to 40 ppm.

A method of manufacturing the above-mentioned biaxially oriented polyester film is not limited particularly, and for example, it is possible to use a biaxial stretching method. Further, the mold substrate 11 may be obtained by forming the resin layer on one surface of a non-stretched film or uniaxially stretched film, and then, stretching. The thickness of the biaxially oriented polyester film preferably ranges from 1 μm to 100 μm, and more preferably ranges from 1 μm to 50 μm. As these mold substrates 11, examples thereof are A2100-16, A4100-25 and the like made by TOYOBO Co., Ltd.

In addition, in the case of using the mold substrate 11 obtained by laminating the resin layer containing fine particles on one surface of the above-mentioned biaxially oriented polyester film, from the viewpoints of adhesion and transfer durability, it is preferable to form the fine pattern 12 on the resin layer surface containing fine particles.

In order to improve adhesion between the mold substrate 11 and the fine pattern 12, one main surface of the mold substrate 11 to provide the fine pattern 12 may undergo easy adhesion coating, primer treatment, corona treatment, plasma treatment, UV/ozone treatment, high-energy irradiation treatment, surface roughening treatment, porous treatment for chemical bonds to the fine pattern 12 and physical bonds such as permeation.

From the viewpoints of improving the filling properties and transfer accuracy of the nth resist layer 23, the fine pattern 12 is preferably a cured material of fluorine-containing photocurable resin, cured material of methyl group-containing photocurable resin or fluorine and methyl group-containing photocurable resin.

<<Resist layered product 30>>

FIG. 34 is a cross-sectional schematic diagram illustrating a resist layered product 30 according to this Embodiment. As shown in FIG. 34, in the resist layered product 30, the inorganic substrate 21, the first to (n-1) th resist layer 22 and the nth resist layer 23 are layered in this order, and the concavo-convex structure 23a is provided on the surface of the nth resist layer 23. Herein, the case where the layered number n is "1" is called the single-layer resist, and the case where the layered number n is "2" or more is called the multilayer resist. The layered number n is not limited particularly, as long as the number is an integer of "1" or more. This is because by using the mold 10 provided with above-mentioned fine pattern 12, it is possible to thin and uniform the residual film RF of the concavo-convex structure 23a of the resist layered product 30. Particularly, when the layered number n is in the range of 2 to 10, since it is possible to cause the first to (n-1) th resist layer 22 to function as a buffer layer in pressing the fine pattern 12 against the resist layer 23, it is possible to more suitably develop (A) the outflow properties of the nth resist layer 23, (B) the anchor and pinning on the nth resist layer flow and (C) the inflow properties of the nth resist layer as described above, and therefore, such a range is preferable. Further, when the layered number n is in the range of 2 to 5 , it is possible to improve processing accuracy of the inorganic substrate 21. In addition, when the layered number n is 2 or 3, it is possible

to improve processability of the inorganic substrate 21, and to suppress excessive uses of the resist, and environmental suitability is thereby improved. The layered number n is most preferably "2".

<Concave-portion bottom position (S1)>

Reference symbol (S1) as shown in FIG. 34 denotes a position of the bottom of the concave portions 23b of the nth resist layer 23 i.e. concave-portionbottomportionposition. Inaddition, when fluctuations exist in the position of the bottom portion of the concave portion 23b of the concavo-convex structure 23a, the concave-portion bottom portion position (S1) means the in-plane average position of positions of bottom positions of respective concave portions 23b. As the average number, ten points are preferable.

<Interface position (S2)>

Reference symbol (S2) as shown in FIG. 34 denotes a position of the interface between the nth resist layer 23 and the (n-1) th resist layer 22 i.e. the interface position. When fluctuations exist in the position of the interface, the interface position (S2) means the in-plane average position of positions of respective interfaces. As the average number, ten points are preferable.

<Interface position (S3)>

Reference symbol (S3) as shown in FIG. 34 denotes a position of the interface between the first resist layer 22 and the inorganic substrate 21 i.e. the interface position. When fluctuations exist in the position of the interface, the interface position (S3) means the in-plane average position of positions of respective interfaces. As the average number, ten points are preferable.

In addition, it is possible to obtain the above-mentioned concave-portion bottom portion position (S1), interface position (S2), and interface position (S3) by cross section observation using a scanning electron microscope, transmission electron microscope or transmission electron microscope and energy dispersive X-ray spectroscopy. Particularly, the concave-portion bottom portion position (S1), interface position (S2), and interface position (S3) are obtained from the above-mentioned observation in the same portion in the same sample. The observation method is as described below. First, the resist layered product 30 is sampled. The above-mentioned observation is performed on the sampled sample piece. In the observation, an area of 100 μm is set in the surface direction of the resist layered product 30 i.e. in the direction perpendicular to the thickness direction of the resist layered product 30. Five points are arbitrarily selected from the area of 100 μm, and the concave-portion bottom portion position (S1), interface position (S2), and interface position (S3) are measured. Herein, it is assumed that sample points A, B, C, D and E are selected. First, at the sample point A, each of the concave-portion bottom portion position (S1), interface position (S2), and interface position (S3) is measured in ten points, and the arithmetical mean value of the values is obtained. The same operation is performed on the sample points B, C, D and E, and the arithmetical mean values are obtained. Finally, obtained is the average (arithmetical mean) of five arithmetical mean values obtained respectively from the sample points A to E. By these values, the concave-portion bottom portion position (S1), interface position (S2), and interface position (S3) are defined.

<Residual film thickness>

The thickness (residual film thickness) of the residual film RF in FIG. 34 means the shortest distance between the concave-portion bottom portion position (S1) and the interface position (S2).

The thickness of the residual film RF is preferably 1/3 the height H or less, from the viewpoint of shape stability of the concave-convex structure 23a in the first etching step as described later. Particularly, when the thickness is 1/5 or less, since a change in the shape of the concavo-convex structure 23a is small in the first etching step as described later, processing accuracy of the inorganic substrate 21 is improved. In addition, the thickness is most preferably 1/10 or less. Further, an absolute value of the thickness of the residual film RF is 100 nm or less, and more preferably 50 nm or less. In this case, irrespective of the average pitch Pave of the fine pattern 12 of the mold 10, it is possible to undergo an excellent first etching step. Particularly, the thickness is more preferably 30 nm or less, further preferably 10 nm or less, and most preferably 5 nm or less. By the thickness of the residual film RF meeting the above-mentioned range, it is possible to decrease a change in the shape of the convex portions 23c of the concavo-convex structure 23a in removing the residual film RF in the first etching step as described later. In the case of the single-layer resist, processing accuracy of the inorganic substrate 21 is determined by the shape of the convex portions 23c of the concavo-convex structure 23a left after the first etching step. In other words, by the thickness of the residual film RF meeting the above-mentioned range, shape accuracy is improved in the convex portions 23c subsequent to the first etching step, and it is thereby possible to improve processing accuracy of the inorganic substrate 21. On the other hand, in the case of the multilayer

resist, processing accuracy of the inorganic substrate 21 is determined by accuracy of the convex portions 23c of the nth resist layer 23 after removing the residual film. In other words, by the meeting the above-mentioned film thickness range of the residual film RF, it is possible to reflect accuracy of the fine pattern of the mold, and perform nano-processing on the inorganic substrate 21 as the workpiece.

<Film thickness (lr1)>

Reference symbol (lr1) as shown in FIG. 34 is the shortest distance between the interface position (S2) and the interface position (S3), and is defined as the film thickness of the first to (n-1)th resist layer 22.

<Ratio (lr1/Pave)>

In the case of the multilayer resist, it is preferable that the ratio (lr1/Pave) of the film thickness (lr1) of the first to (n-1) th resist layer 22 in the layered product to the average pitch (Pave) of the fine pattern 12 meets following equation (11). By meeting this range, it is possible to select the film thickness of the first to (n-1) th resist layer 22 corresponding to structure resolution of the fine pattern 12. By this means, it is possible to cause the first to (n-1) th resist layer 22 to function as a layer for stress concentration relaxation on the top of convex-portion of the fine pattern 12 in pressing the fine pattern 12 of the mold 10 against the nth resist layer 23, and it is possible to make the residual film thickness of the nth resist layer approximately equal. Further, (4) stability and processing accuracy is improved in the fine pattern mask 25 in processing the inorganic substrate 21 using the resist layered product 30 as described later, processing accuracy of the inorganic substrate 21 is also improved, and therefore, such a range is preferable.

Eq. (11)

$$0.01 \leq (lr1/Pave) \leq 5$$

From the viewpoint of more exerting these effects, the ratio (lr1/Pave) preferablymeets (lr1/Pave)≤4, and more preferably meets (lr1/Pave)≤2.5. On the other hand, from the viewpoint of sufficiently ensuring the processing depth of the inorganic substrate 21, it is preferable to meet 0.05≤ (lr1/Pave), it is more preferable to meet 0.25≤ (lr1/Pave), and it is the most preferable to meet 0.5≤(lr1/Pave).

In addition, when the hard mask layer is provided between the first resist layer and the inorganic substrate, in the case where the film thickness of the hard mask layer is made lhm, by (lhm/P) being 0.01 or more, processing accuracy is improved in the hard mask layer with the nth resist layer 23, and processing accuracy is thereby improved in the inorganic substrate 21. From the same viewpoints, when the first resist layer 23 is the hard mask, the ratio (lhm/P) preferably ranges from 0.01 to 1.0, more preferably ranges from 0.015 to 0.8, and most preferably ranges from 0.02 to 0.5.

In addition, the average pitch (Pave) of the fine pattern 12 is the same as the average pitch (Pave) of the concavo-convex structure 23a of the resist layered product 30. Therefore, for the above-mentioned (lr1/Pave), it is possible to apply the average pitch of the concavo-convex structure 23a of the resist layered product 30. The average pitch of the concave-convex structure 23a of the resist layered product 30 is obtained by observation in a slightly different portion of the same sample piece as that used in obtaining the above-mentioned concave-portion bottom portion position (S1), interface position (S2), and interface position (S3). A calculation method is as described below. Observation is performed on the sample piece used in obtaining the concave-portion bottom portion position (S1), interface position (S2), and interface position (S3) as described already. First, scanning electron microscope observation is performed on the concavo-convex structure surface of the sample piece as described already. Herein, the magnification of the scanningelectronmicroscope is increaseduntil at least 100 or more dots are sharply photographed. From the enlarged image are selected 100 dots, 10 dots are selected arbitrarily from among the 100 dots, and pitches (P) are calculated respectively on the dots. Herein, it is assumed that dots A1 to A10 are selected. The dot A1 is selected, and a pitch $P_{A1}$ is obtained. Similarly, $P_{A2}$ to $P_{A10}$ are obtained, and the arithmetical mean value i.e. $(P_{A1}+P_{A2}+\cdots+P_{A10})/10=Pave$ is defined. In addition, in the above-mentioned definition of the average pitch (Pave), in the case where the concave-convex structure 23a has the hole structure, it is possible to define by replacing the dot used in the description of the above-mentioned average pitch (Pave) with the hole to read.

The mold used to transfer and add the concave-convex structure 23a to the nth resist layer 23 of the resist layeredproduct 30 is the mold 10 described in «Mold 10» as described above. By using the mold 10 as described above, the filling properties to the fine pattern 12 of the mold 10 of the nth resist layer 23 are made excellent, and it is thereby possible to obtain the concavo-convex structure 23a with the residual film thickness being thin and uniform.

In a method of manufacturing the resist layered product 30 according to this Embodiment, by using the mold 10 provided with the fine pattern 12 described in <<Mold 10>> as described above, (1) flowability of the nth resist layer 23 is improved in filling the fine pattern 12 with the nth resist layer 23 in the pressing step to make the filling properties excellent, while stress concentration is further increased on the convex portion 12a of the fine pattern 12, flowability of the nth resist layer 23 is thereby improved, and it is possible to obtain the effect of thinning the residual film RF. Further, since it is possible to (2) reduce release energy in peeling applied to the outer edge of the bottom of the convex-portions of the concavo-convex structure 23a in peeling off the mold 10, it is possible to suppress breakage of the concavo-convex structure 23a due to a bend and fall.

Particularly, by meeting the relationship between the convex-portion volume (Vcm) of the fine pattern 12 of the mold 10 and the volume (Vr2) of the nth resist layer 23, it is possible to thin the residual film RF of the concavo-convex structure 23a, and more improve its uniformity.

<Concave-portion volume (Vcm)>

FIG. 35 contains explanatory diagrams illustrating the relationship between the unit area (Scm) and the concave-portion volume (Vcm) in the fine pattern of the resist layered product according to this Embodiment. FIG. 35A schematically illustrates the top surface of the fine pattern 12, and FIG, 35B schematically illustrates the cross section of the fine pattern 12. As shown in FIGs. 35A and 35B, the concave-portion volume (Vcm) is defined as the concave-portion volume of the fine pattern 12 existing below a region of the unit area (Scm). When the unit area (Scm) is moved down perpendicularly to the main surface direction of the fine pattern 12, the concave-portion volume (Vcm) is the concave-portion 12b volume of the fine pattern 12 such that the unit area (Scm) passes after crossing the vertex portion of the fine pattern 12 and finishing to cross the bottom portion. In addition, the arrangement and shape of the fine pattern in FIG. 35 do not affect the definition of the concave-portion volume (Vcm), and the arrangement and shape of the concave-convex structure are capable of adopting the shape as described later.

For example, as shown in FIGs. 36A and 36B, in the case of the fine pattern 12 where cylindrical concave portions with front ends rounded are arranged in a hexagonal arrangement in which the opening shape is a circle, the opening diameter (Φ) is 430 nm, the pitch (Px) in the x-axis direction is 398 nm, the pitch (Py) in the y-axis direction is 460 nm and the depth (height) is 460 nm, when the unit area (Scm) is set as a hexagonal unit cell as shown in FIGs. 36A and 36B, values of the unit area (Scm) and the concave-portion volume (Vcm) are independently determined respectively, and (Vcm/Scm)=364 is calculated. In addition, the volume of a single cylindrical concave portion with the front end rounded is defined as 80% of the volume of a single cylindrical concave portion.

Similarly, for example, also in the fine pattern 12 where cylindrical concave portions with front ends rounded are arranged in a hexagonal arrangement in which the opening shape is a circle, the opening diameter (Φ) is 180 nm, the pitch (Px) in the x-axis direction is 173 nm, the pitch (Py) in the y-axis direction is 200 nm and the depth (height) is 200 nm, values of the unit area (Scm) and the concave-portion volume (Vcm) are independently determined respectively, and (Vcm/Scm)=163 is calculated. In addition, the volume of a single cylindrical concave portion with the front end rounded is defined as 80% of the volume of a single cylindrical concave portion.

Similarly, for example, for the concavo-convex structure where cylindrical concave portions with front ends rounded are arranged in a hexagonal arrangement in which the opening shape is a circle, the opening diameter (Φ) is 680 nm, the pitch in the x-axis direction is 606 nm, the pitch in the y-axis direction is 700 nm and the depth (height) is 700 nm, values of the unit area (Scm) and the concave-portion volume (Vcm) are independently determined respectively, and (Vcm/Scm)=599 is calculated. In addition, the volume of a single cylindrical concave portion with the front end rounded is defined as 80% of the volume of a single cylindrical concave portion.

<Unit area (Scr2)>

FIG. 37 contains explanatory diagrams illustrating the relationship between the nth resist layer and the unit area (Scr2) in the resist layered product according to this Embodiment. FIG. 37A schematically illustrates the top surface of the nth resist layer 23, and FIG. 37B schematically illustrates the cross section of the nth resist layer 23. As shown in FIGs. 37A and 37B, the unit area (Scr2) is the same area as the unit area (Scm) in the surface that is disposed on the top portion of the nth resist layer 23 inside the surface parallel to one main surface of the inorganic substrate 21 in the resist layered product 30 and that is parallel to one main surface of the inorganic substrate 21. The unit area (Sr2) is disposed on the tope portion of the nth resist layer 23, and forms the surface parallel to one main surface of the inorganic substrate 21.

<Volume (Vr2)>

Further, as shown in FIGs. 37A and 37B, the volume (Vr2) is defined as the volume of the n the resist layer 23

existing below a region of the unit area (Scr2) of the resist layered product 30. When the unit area (Scr2) is moved down perpendicularly to the main surf ace of the inorganic substrate 21, the volume (Vr2) is the volume of a region such that the unit area (Scr2) passes after crossing the surface of the nth resist layer 23 and crossing the interface between the (n-1) th resist layer 22 and the nth resist layer 23.

<Ratio (Vr2/Vcm)>

The ratio (Vr2/Vcm) between the concave-portion volume (Vcm) in the fine pattern 12 of the mold 10 and the volume (Vr2) of the nth resist layer 23 preferably meets 0.1≤ (Vr2/Vcm)≤1.5. Bymeeting 0.1≤ (Vr2/Vcm), it is possible to suppress inclusion of micro· nano bubbles and macro air voids in laminating in the pressing step described specifically later, and therefore, such a range is preferable. Further, by meeting (Vr2/Vcm)≤1.5, improved are the filling properties of the nth resist layer 23 into the fine pattern 12 of the mold 10, and therefore, such a range is preferable.

In order to more exert these effects and decrease the residual film thickness of the concavo-convex structure 23a, it is preferable to meet following equation (14), and it is more preferable to meet 0.6≤ (Vr2/Vcm) ≤1.3, and it is the most preferable to meet 0.8≤(Vr2/Vcm)≤1.3.

Eq. (14)

$$0.5 \leq (Vr2/Vcm) \leq 1.4$$

Further, from the viewpoint of thinning the residual film thickness, it is preferable that the Young's modulus (longitudinal modulus) of the material forming the fine pattern 12 is higher than the Young' s modulus (longitudinal modulus) of the nth resist layer 23. Particularly, in the case of assuming that the Young' s modulus (longitudinal modulus) of the material forming the fine pattern 12 is $Y_{12}$, and that the Young's modulus (longitudinal modulus) of the nth resist layer 23 is $Y_{23}$, it is preferable that $Y_{12} \geq 1.1Y_{23}$, it is more preferable that $Y_{12} \geq 1.3Y_{23}$, and it is the most preferable that $Y_{12} \geq 1.5Y_{23}$.

In addition, in the case where the metal layer or demolding layer is provided on the fine pattern 12 as described already, the relationship between the above-mentioned $Y_{12}$ and $Y_{23}$ may meet $Y_{12} \geq 0{\cdot}8Y_{23}$. Particularly, it is more preferable that $Y_{12} \geq 1.0Y_{23}$, and it is the most preferable that $Y_{12} \geq 1.2Y_{23}$.

In addition, the Young's modulus of the material forming the fine pattern 12 is measured by one of the following methods. (1) Measurement is performed on stabilized fine pattern 12 raw material formed on quartz or SUS substrate. For example, when the fine pattern 12 raw material is photocurable (or heat-curable), the fine pattern 12 raw material is photo-cured (or, heat-cured), and measurement is performed on the thin film. In this case, measurement of the Young's modulus is capable of being measured by the Nano Indentation method or Surf ace Acoustic Wave (SAW) method on the thin film made of the cured material of the fine pattern 12 raw material. (2) A bulk thin film is prepared so that the stabilized raw material of the fine pattern 12 is capable of being self-support. It is possible to measure by applying the tensile test method (JIS G0567J) to the bulk thin film made of the obtained cured material of the raw material of the fine pattern 12.

Subsequently, described is the nanoimprint method to prepare the resist layered product 30. The nanoimprint method includes the pressing step and mold release step in this order.

<Pressing step>

The pressing step is to fill inner portions of the concave portions 12b with the nth resist layer 23 and to thin the resist film RF of the nth resist layer 23. By using the mold 10 provided with the fine pattern 12 described in <<Mold 10>> as described above, it is possible to actualize the filling properties of the nth resist layer 23 and thinning of the residual film RF from the already described effects. Therefore, the pressing step is not limited particularly, as long as it is possible to actualize the filling properties of the nth resist layer 23 and thinning of the residual film RF.

It is possible to select the pressing force in the pressing step as appropriate corresponding to materials of the first to (n-1) th resist layer 22, the nth resist layer 23 and fine pattern 12 and the like. From the viewpoint of thinning the thickness of the residual film RF, the pressing force in the pressing step is preferably approximately 0.01 MPa or more substantially, and more preferably 0.03 MPa or more. On the other hand, from the viewpoints of suppressing making of excessive facilities and enabling the mold 10 to be used repeatedly, the pressing force in the pressing step is preferably 20 MPa or less, and more preferably 10 MPa or less. Further, from the viewpoint of more exerting the above-mentioned effects, the pressing force in the pressing step is preferably 5 MPa or less, more preferably 1.5 MPa or less, and further preferably 1 MPa or less.

In addition, in the case of using the resin mold described in <<Mold 10>> as the mold 10, the pressing force in the pressing step may be a value that causes elastic deformation of the fine pattern 12 of the mold 10 within the above-mentioned range. In such a case, in the pressing step, the flow of the nth resist layer 23 occurs. With thinning of the residual film, since mobility of the nth resist layer 23 is limited, hardness (for example, Young's modulus) of the nth resist layer 23 is larger than the bulk, and flowability of the nth resist layer 23 decreases. When deformation resistance of the fine pattern 12 is smaller than that of the nth resist layer 23, the fine pattern 12 becomes deformed. By the fine pattern 12 becoming deformed, a new flow path of the nth resist layer 23 arises, while the stress concentration point on the nth resist layer 23 changes. From such principles, by using the resin mold as the mold 10 and utilizing elastic deformation of the resin mold, it is possible to easily thin the residual film RF. Further, in such a case, in the mold release step, since it is possible to utilize the restoring force of the fine pattern 12 of the mold 10 subjected to elastic deformation, and also utilize a gap occurring due to the fact that the fine pattern 12, which partially bulges in the surface direction of the resist layered product 30 by elastic deformation, restores, it is also possible to improve transfer accuracy of the concavo-convex structure of the nth resist layer 23.

Further, the pressing step may be performed in a state in which the nth resist layer 23 is heated. For example, in the case of using, as the nth resist layer 23 , materials of which the viscosity is substantially larger than 1000 mPa·s at 25°C, it is preferable to perform heating. The heating temperature in this case is preferably 200°C or less, from the viewpoint of extending the selection ranges of mold 10 and nth resist layer 23 materials. From the viewpoints of suppressing making of excessive facilities and improving throughput characteristics, the heating temperature is more preferably 150°C or less. The heating method may be a method of placing the resist layered product 30 on a hot plate, a method of irradiating the resist layered product 30 with a microwave or infrared rays (IR), a method of putting the entire system to perform the pressing step in a heating atmosphere, a method of heating only the mold 10, or a method of heating both the mold 10 and the inorganic substrate 21.

On the other hand, in the case of using, as the nth resist layer 23, materials of which the viscosity is substantially smaller than 1000 mPa·s at 25°C, pressing may be performed without heating. The temperature of this case is dependent on the environmental atmosphere, is thereby not limited, and substantially ranges from 10°C to 40°C.

Further, in the pressing step, a heating step may be added after laminating the fine pattern 12 of the mold 10 and the nth resist layer 23. Particularly, when the metalloxane bond portion contained in the nth resist layer 23 contains an unreacted condensation portion, by performing heating treatment while pressing, condensation is promoted to improve transfer accuracy, and therefore, such treatment is preferable. Heating in this case may be a method of placing on a hot plate, a method of applying a microwave or infrared rays (IR), a method of putting the entire system in a heating atmosphere, a method of heating only the mold 10 , or a method of heating both the mold 10 and the inorganic substrate 21. The heating temperature preferably ranges substantially from 25°C to 200°C, and more preferably ranges from 25°C to 150°C.

It is preferable to perform the heating step for a period during which the pressing force is applied to the nth resist layer 23 in the pressing step. More specifically, the fine pattern 12 of the mold is pressed against the nth resist layer 23 in the pressing step, the pressure ($P_{ress}$) is maintained, then the pressure ($P_{ress}$) is released, and the flow proceeds to the mold release step. It is preferable that the heating step includes heating at least in a state in which the pressure ($P_{ress}$) is maintained. The state in which the pressure ($P_{ress}$) is maintained includes pressure variations of ±50% relative to the pressure ($P_{ress}$)·Particularly, when the variations are controlled to within ±20%, uniformity of the residual film thickness is improved, and therefore, such variations are preferable. The variations are more preferably ±5%.

Further, in order to uniformly thin the thickness of the residual film RF, as shown in FIG. 38, an elastic material 27, 28 may be provided on the surface (see FIG. 38A) of the mold substrate 11 in the mold 10, or on the surface (see FIG. 38B) of the inorganic substrate 21 in the resist layered product 30. In addition, the elastic material 27 is provided on the surface opposite to the fine pattern 12, in the case where the mold 10 is formed of only the fine pattern 12. By providing these elastic materials 27, 28, stress applied to the top of convex-portions of the fine pattern 12 of the mold 10 are substantially equalized, and as a result, it is possible to approximately uniform the residual film RF. In addition, as shown in FIG. 38C, these elastic materials 27, 28 may be provided on both the surface of the substrate mold 11 in the mold 10 and the surface of the inorganic substrate 21 in the resist layered product 30.

As the elastic materials 27, 28, it is possible to use publicly-known commercially available rubber plate, resin plate, film or the like. Among the materials, from the viewpoint of enabling the residual film RF to be small and substantially uniform, the Young's modulus (longitudinal modulus) of the elastic material preferably ranges from 1 MPa to 100 MPa, and more preferably ranges from 4MPa to 50 MPa. Further, from the viewpoint of obtaining the same effects, the thickness of the elastic material 27, 28 preferably ranges from 0.5 mm to 10 cm, more preferably ranges from 1 mm to 8 cm, and most preferably ranges from 5 mm to 10 cm.

Further, it is also possible to use compressed air, compressed gas or the like as the elastic materials 27, 28. Particularly, in the case of using compressed air and compressed gas, as shown in FIG. 38A, it is preferable to press from above the surface of the mold substrate 11 in the mold 10.

Micro-inclusion of the environmental atmosphere into the concave portion 12b of the fine pattern 12 in laminating

is directly coupled to transfer failure of the nth resist layer 23. Herein, micro-inclusion is inclusion of air bubbles on a scale of one to about several tens of concave portions of the fine pattern 12, and is called the micro• nano bubble. Further, macro-inclusion on a millimeter scale formed between the fine pattern 12 and the nth resist layer 23 in the laminating is generally called the air void, and becomes a significant defect. Therefore, in laminating the fine pattern 12 of the mold 10 and the nth resist layer 23, it is preferable to use one of methods as described below or their composite method.

(1) There is a method of laminating the fine pattern 12 of the mold 10 and the nth resist layer 23 under a reducedpressure (including vacuum). By this reduced pressure, it is possible to improve transfer accuracy of the nth resist layer 23.
(2) There is a method of laminating the fine pattern 12 of the mold 10 and the nth resist layer 23 in an atmosphere of compressible gas. As the compressible gas, there are carbon dioxide, pentafluoropropane gas and the like. In this case, in laminating the mold 10, the whole of the mold 10 and layered product 20 may be placed under the compressible gas, or laminating may be performed while blowing the compressible gas on the surface of the nth resist layer 23. The compressible gas is a material that changes a state from gas to liquid corresponding to the applied compression force. In other words, by using the compressible gas, when the pressure applied in laminating exceeds a predetermined value, the compressible gas in a portion scheduled to form an air void is liquefied. The change from gas to liquid means abrupt volume contraction, and the air void apparently is lost. In view of the foregoing, in the case of using the compressible gas, it is preferable to laminate at a laminating pressure of the liquefaction pressure of the compressible gas or more.

FIG. 39 contains cross-sectional diagrams to explain a method of laminating the fine pattern and the nth resist layer in the resist layered product according to this Embodiment. In addition, FIG. 39 schematically illustrates only the fine pattern 12 with the mold 10 simplified. Further, it is assumed that the nth resist layer 23 is provided with the concavo-convex structure 23a on the surface on the mold 10 side, and that the first to (n-1) th resist layer 22 and inorganic substrate 21 are successively layered on the surface opposite to the concavo-convex structure 23a formation surface.
The laminating method as shown in FIG. 39A is a laminating method of bringing one end portion of the fine pattern 12 of the mold 10 into contact with the nth resist layer 23, and gradually increasing the contact area. In this case, as compared with the case of using the parallel plate-shaped mold 10, since an escape path of the environmental atmosphere is made, inclusion of the environmental atmosphere is reduced.
The laminating method as shown in FIG. 39B is a laminating method of deforming near the center of the mold 10 downward in the shape of a convexity, bringing the center of the convex portion into contact with the nth resist layer 23, and gradually restoring the deformation. In this case, as compared with the case of using the parallel plate-shaped mold 10, since an escape path of the environmental atmosphere is made, inclusion of the environmental atmosphere is reduced. Particularly, this method is effective in the case where the mold 10 is a flexible mold.
The laminating method as shown in FIG. 39C is a laminating method of curving the mold 10, while bringing one end portion of the mold 10 into press contact with the nth resist layer 23, and laminating in a lamination manner. In this case, as compared with the case of using the parallel plate-shaped mold 10, since an escape path of the environmental atmosphere is made, inclusion of the environmental atmosphere is reduced. Particularly, this method is effective in the case where the mold 10 is a flexible mold.
In the above-mentioned laminating methods, it is possible to use a laminator. Among laminators to use are a single-stage type laminator using a pair of laminate rolls above the surface on the side opposite to the fine pattern 12 of the mold 10, a multi-stage type laminator using two or more pairs of laminate rolls, a vacuum laminator for sealing a portion to laminate with a container and then reducing a pressure or evacuating using a vacuum pump, and the like.
Among the laminators, from the viewpoint of suppressing intrusion of air in lamination, it is preferable to use the vacuum laminator. The laminate velocity preferably ranges from 0.1[m/min] to 6[m/min]. As the pressure, the pressure per unit length of the laminate roll preferably ranges from 0.01[MPa/cm] to 1 [MPa/cm], preferably ranges from 0.1 [MPa/cm] to 1 [MPa/cm], and more preferably ranges from 0.2[MPa/cm] to 0.5[MPa/cm]. In addition, in the case of providing the laminator rolls with temperature, the temperature is preferably 200°C or less.
In the pressing step, by performing the energy ray irradiation step, described specifically later, with the fine pattern 12 of the mold 10 pressed against the nth resist layer 23, it is possible to thin the thickness of the residual film RF and ensure uniformity of the thickness of the residual film RF, being preferable. More specifically, in the pressing step, the fine pattern 12 of the mold 10 is pressed against the nth resist layer 23atapredeterminedpressure (Press) for predetermined time ($T_{press}$). Subsequently, the energy ray is applied with the pressure (Press) maintained. In addition, the state in which the pressure (Press) is maintained includes pressure variations of ±50% relative to the pressure (Press). Particularly, when the variations are controlled to within ±20%, uniformity of the residual film thickness is improved, and therefore, such variations are preferable. The variations are more preferably ±5%. Further, it is preferable that the time ($T_{press}$) substantially ranges from 20 seconds to 10 minutes.

Further, by performing the energy ray irradiation step while pressing in an atmosphere of low oxygen, it is possible to further exert the above-mentioned effects, and such conditions are preferable. As in the atmosphere of low oxygen of this case, examples thereof are on a reduced pressure (vacuum) condition, in an atmosphere of compressible gas, and in an atmosphere of inert gas typified by Ar and $N_2$.

As described above, in the resist layered product according to this Embodiment, it is preferable that transfer of the concavo-convex structure 23a to the nth resist layer 23 of the pattern 12 with the mold 10 is performed under a reduced pressure, in a vacuum, in an atmosphere of inert gas, or in an atmosphere of compressible gas, the temperature of the mold 10 or the inorganic temperature is 200°C or less in transfer, and that the pressing force is 5 MPa or less.

In this case, the filling properties of the nth resist layer 23 into the concave portions 12b of the fine pattern 12 of the mold 10 are made excellent, and it is thereby possible to improve throughput characteristics in the imprint method and to suppress making of excessive facilities. Further, since it is possible to (2) suppress deterioration of the fine pattern 12 of the mold 10, it is possible to improve transfer accuracy of the concavo-convex structure 23a of the nth resist layer 23, and it is also possible to use the mold 10 repeatedly.

<Mold release step>

In the mold release step, when the residual film RF is thinned, since stress in peeling concentrates on the residual film RF, there is the case where mold release failure occurs such as peeling of the nth resist layer 23 from the (n-1)th resist layer 22. It is possible to solve such a problem by using the fine pattern 12 described in <<Mold 10>> as described above, optimizing the compositions of the first to (n-1) resist layer 22 and the nth resist layer 23 and the like. Therefore, the mechanism of the mold release step is not limited particularly. It is possible to support also by mold release methods as described below, and to improve the peeling velocity of the mold.

In the mold release step, by utilizing a difference in the coefficient of thermal expansion between the fine pattern 12 and the nth resist layer 23, it is possible to reduce stress applied at the time of mold release. The environmental atmosphere to develop the difference in the coefficient of thermal expansion varies with the material of the fine pattern 12 and the composition of the nth resist layer 23 , and therefore, is not limited particularly. As the environmental atmosphere to develop the difference in the coefficient of thermal expansion in mold release, examples thereof are a state cooled with cooling water, refrigerant, liquid nitrogen or the like, and a state heated at temperatures between about 40°C to 200°C.

In addition, the cooled state and heated state are defined as cooling or heating at least the inorganic substrate 21. As methods of cooling and heating, for example, there is a method of attaching a cooling mechanism or heating mechanism to a base to place the inorganic substrate 21. In addition, cooling or heating may be performed on the entire layered product (hereinafter, also referred to as "mold layered product") comprised of mold 10/the nth resist layer 23/the first to (n-1)th resist layer 22/inorganic substrate 21. In this case, there is a manner of performing the mold release step itself in a cooled atmosphere or heated atmosphere. Further, the cooling also includes that the mold release step is performed after once immersing the mold layered product in liquid nitrogen or the like. Furthermore, the heating may use a method of applying infrared rays. Particularly, peeling on the heating condition is effective in the case where a fluorine component exists on the surface of the fine pattern 12.

Further, in the mold release step, by utilizing a difference in solubility between the mold 10, and the nth resist layer, the first to (n-1)th resist layer 22 and inorganic substrate 21, it is possible to decrease stress on the nth resist layer 23 applied in removing the mold 10. In other words, by causing a predetermined solution to act on the mold 10 of the mold layeredproduct to dissolve, it is possible to perform the mold release step. Herein, the dissolution is intended to include swelling peeling. By removing the mold 10 utilizing such dissolution (swelling) peeling, since it is possible to minimize mold release stress on the resist layer 23, it is possible to suppress defects occurring in mold release.

FIG. 40 contains cross-sectional diagrams to explain a mold release method of the fine pattern from the nth resist layer in the resist layered product according to this Embodiment. In addition, in FIG. 40, as in FIG. 39, the mold 10 is simplified, and the configuration of the nth resist layer 23 is also omitted to illustrate.

The mold release method as shown in FIG. 40A is a mold release method of starting peeling from one end portion of the fine pattern 12 of the mold 10 and gradually decreasing the contact area. In this case, as compared with the case of using the parallel plate-shaped mold, since the force on the interface between the (n-1) the resist layer 22 and the nth resist layer 23 decreases, mold release properties are improved.

The mold release method as shown in FIG. 40B is a mold release methodof starting peeling with near the center of the mold 10 deformed downward in the shape of a convexity, and increasing the deformation degree. In this case, as compared with the case of using the parallel plate-shaped mold, since the force on the interface between the (n-1) the resist layer 22 and the nth resist layer 23 decreases, mold release properties are improved.

The mold release method as shown in FIG. 40C is a mold release method of curving the mold 10, while starting peeling of the nth resist layer 23 from one end portion of the mold 10, and gradually decreasing the contact area. In this case, as compared with the case of using the parallel plate-shaped mold, since the force on the interface between the

(n-1) the resist layer 22 and the nth resist layer 23 decreases, mold release properties are improved. Particularly, this method is effective in the case where the mold 10 is a flexible mold.

In the peeling methods of the mold as shown in FIGs. 40A to 40C as described above, it is preferable that a peeling angle θ as shown in FIG. 41 is 90 degrees or less. FIG. 41 is a cross-sectional schematic diagram to explain a peeling angle form the nth resist layer of the fine pattern in the resist layeredproduct according to this Embodiment. The peeling angle θ is expressed as an angle between the surface on the side opposite to the fine pattern 12 of the mold 10 and the main surface of the inorganic substrate 21 in peeling. By setting the peeing angle θ at 90 degrees or less, it is possible to reduce peeling energy applied to the outer edge (positions shown by middle points P in FIG.41) of the bottom of the convex portions of the nth resist layer 23 applied in peeling off the mold 10.

In other words, it is possible to reduce loads on the convex-portion bottom of the nth resist layer 23 applied in peeling off the mold 10, and it is possible to transfer the concavo-convex structure 23a promptly with high transfer accuracy. From such viewpoints, the peeling angle θ is preferably 80 degrees or less, more preferably 60 degrees or less, and most preferably 45 degrees or less.

On the other hand, the peeling angle θ preferably exceeds 0 degree. The case where the peeling angle θ is 0 degree means that the mold 10 is peeled off while maintaining a state in which the main surface of the mold 10 is parallel to the main surface of the nth resist layer 23. In such a case, friction energy caused by the depth (H) of the fine pattern 12 of the mold 10 is applied to the nth resist layer 23 , and transfer accuracy degrades. Further, in the case where the peeling angle θ is 0 degree, peeling energy increases that is a value obtained by multiplying the plane area of the density of concave portions 12b on convex portions 12a of the fine pattern 12 of the mold 10 in contact with the nth resist layer 23 x the plane area of the nth resist layer 23 by friction energy caused by each fine pattern 12. In other words, the force associated with peeling increases. In the case of peeling with such an excessive peeling force, from the problem of unevenness of the peeling force, the large peeling force partially concentrates, and the convex portion of the concavo-convex structure 23a is broken and falls, resulting in breakage of the concavo-convex structure 23a. From such a viewpoint, the peeling angle θ is preferably 3 degrees or more, and more preferably 5 degrees or more.

In the case of reducing a pressure in the pressing step, the reduced pressure may be maintained in the mold release step, but it is preferable that the mold is released while releasing the pressure from the viewpoint of transfer accuracy.

Described specifically is a method of manufacturing the resist layered product 30 in which the nth resist layer 23 contains a photocurable substance.

In the present invention, in the nanoimprint method, the energy ray irradiation step may be added to between the above-mentioned pressing step and the mold release method.

<Energy ray irradiation step>

By applying an energy ray after laminating the nth resist layer 23 in the layered product 20 and the fine pattern 12 in the mold 10, it is possible to improve stability of the first to (n-1) th resist layer 22 and the nth resist layer 23, and it is possible to significantly improve the interface adhesion force between the (n-1) th resist layer 22 and the nth resist layer 23. The irradiation of the energy ray is effective in the case where the chemical bond based on the chemical reaction occurs in the interface between the (n-1)th resist layer 22 and the nth resist layer 23, and in the case where one layer among n resist layers contains an energy ray curable substance. Particularly, the application is effective in the case where the nth resist layer 23 contains an energy ray curable substance.

In order to peel off the nth resist layer 23 from the mold 10 to obtain the concavo-convex structure 23a with high transfer accuracy, importance are peeling properties between the fine pattern 12 of the mold 10 and the nth resist layer 23, adhesion between the nth resist layer 23 and the (n-1) th resist layer 22, and adhesion between the first resist layer 22 and the inorganic substrate 21. In order to thus improve adhesion to improve transfer accuracy, it is effective to form the chemical bond in the interface between the (n-1)th resist layer 22 and the nth resist layer 23.

It is possible to select the type of energy ray as appropriate corresponding to the compositions of the first to (n-1) th resist layer 22 and the nth resist layer 23, and therefore, the type is not limited particularly. As the type of energy ray, examples thereof are X-rays, ultraviolet rays, visible light rays and infrared rays. Among the rays, by using ultraviolet rays, it is easy to improve the adhesion force between the nth resist layer 23 and the (n-1)th resist layer 22. As the ultraviolet rays, particularly, ultraviolet rays with a wavelength region of 250 nm to 450 nm are preferable.

As a light source of the energy ray, for example, it is possible to use various kinds of discharge lamps, xenon lamp, low-pressure mercury lamp, high-pressure mercury-vapor lamp, metal halide lamp light emitting device and laser. As the laser, it is possible to use UV LED, Ar gas laser, excimer laser, semiconductor laser and the like.

Further, the integral light amount during the time of starting irradiation of the energy light and finishing the irradiation is preferably in the range of 500 $mJ/cm^2$ to 5000 $mJ/cm^2$. When the integral light amount is 500 $mJ/cm^2$ or more, the chemical reaction proceeding degree by energy ray irradiation is high, and it is possible to improve stabilization of the nth resist layer 23 and adhesion between the nth resist layer 23 and the (n-1)th resist layer 22. Further, when the

integral light amount is 5000 mJ/cm$^2$ or less, it is possible to reduce heating according to energy ray irradiation, deterioration of the mold 10 , and deterioration of the demolding layer (low surface energy layer) formed on the surface of the fine pattern 12 of the mold 10.

Particularly, from the viewpoint of obtaining excellent transfer accuracy even in the case where the average pitch (Pave) of the fine pattern 12 of the mold 10 is small and the aspect ratio is large, the integral light amount is preferably 800 mJ/cm$^2$ or more, more preferably 1000 mJ/cm$^2$ or more, and further preferably 1500 mJ/cm$^2$ or more. Further, from the viewpoint of aiming environmental suitability, and suppressing transfer failure caused by deterioration of the mold 10, the integral light amount is preferably 4000 mJ/cm$^2$ or less, more preferably 3000 mJ/cm$^2$ or less, and further preferably 2500 mJ/cm$^2$ or less.

Further, in irradiation of the energy ray, irradiation may be performed using a plurality of line sources. By this means, it is possible to meet the above-mentioned range of the integral light amount easier and to improve transfer accuracy. Further, by including light sources with different wavelength regions with two or more light sources, it is possible to further improve stabilization of the nth resist layer 23 and adhesion between the nth resist layer 23 and the (n-1)th resist layer 22. As an irradiation method using a plurality of line sources, examples thereof are a method of using two ultraviolet LEDs, setting the main wavelength of the first LED at $\lambda x$ and setting the main wavelength of the second LED at $\lambda y$ nm ($\lambda x \neq \lambda y$, $\lambda x$=365, 385, 395, 405 nm, etc. , $\lambda y$=365, 385, 395, 405 nm, etc.), and another method of using a ultraviolet LED with a sharp emission spectrum and metal halide light source or high-pressure mercury-vapor light source including wavelength components of a wide range.

Furthermore, it is preferable to apply the energy ray from both or either of the mold 10 side and the inorganic substrate 21 side. Particularly, when the mold 10 or inorganic substrate 21 is an energy ray absorption material, it is preferable to apply the energy ray from the medium side which the energy ray passes through.

In the method of manufacturing the resist layered product 30 as described above, in the case where the nth resist layer 23 contains a photocurable (radical polymerization system) substance in the range meeting $1.0<(Vr2/Vcm)\leq 1.5$, particularly, it is preferable to perform the energy ray irradiation step for the nth resist layer 23 of the mold layered product 24. In addition, it is possible to adopt the pressing laminating method in the pressing step, the type, light quantity and the like of the energy ray in the energy ray irradiation step, peeling method in the mold release step and the like as described above. Particularly, it is preferable to apply the energy ray while pressing in an atmosphere of low oxygen.

In other words, in the case where the nth resist layer 23 contains a photocurable substance in the range meeting $1.0< (Vr2/Vcm)\leq 1.5$, by performing the energy ray irradiation step, cure of the nth resist layer 23 is sufficient, and transfer accuracy of the nth resist layer 23 is improved. This is because shape stability is improved in the concavo-convex structure 23a of the nth resist layer 23, and it is possible to suppress peeling of the thin residual film RF from the (n-1)th resist layer 22. Particularly, when irradiation of the energy ray is performed in an atmosphere of low oxygen in a state in which the pressing state of the mold layered product 24 is maintained, the effects of more thinning and approximately uniforming the residual film RF are exhibited, and therefore, such irradiation is preferable.

Further, when the pressing step is performed in an atmosphere of low oxygen, transfer accuracy is more improved due to suppression of curing inhibition of the nth resist layer 23, being preferable. It is possible to select the atmosphere of low oxygen as described above as appropriate corresponding to the type of photocurable substance contained in the nth resist layer 23. Such an environmental atmosphere is preferable that the reaction rate of the photocurable groups is 50% or more in irradiating the photocurable substance with the energy ray.

Particularly, from the viewpoints of enabling the nth resist layer 23 to contain the high number of photocurable groups and improving transfer accuracy and transfer velocity, an environmental atmosphere such that the reaction rate of photocurable groups is 75% or more is preferable, an environmental atmosphere for making 80% or more is more preferable, and an environmental atmosphere with the rate of 90% or more is most preferable. For example, it is possible to prepare such a reaction atmosphere by evacuating (reduced pressure), introduction of inert gas typified by $N_2$ gas and Ar gas, introduction of compressible gas typified by pentafluoropropane and carbon dioxide, and the like. In this case, all of the mold and layered product may be disposed in an atmosphere of low oxygen to perform laminating and pressing, or such a scheme may be adopted that an atmosphere of low oxygen is blown on the surface of the nth resist layer 23 in the laminating stage.

In the case where the nth resist layer 23 contains a photocurable (radial polymerization system) substance in the range meeting $1.0<(Vr2/vcm)\leq 1.5$ as described above, from the viewpoint of actualizing an aspect ratio of the concavo-convex structure 23a of the nth resist layer 23 sufficiently high relative to the thickness of the residual film RF, $1.0<(Vr2/Vcm)\leq 1.4$ is preferable, and $1.0<(Vr2/Vcm)\leq 1.3$ is more preferable.

Further, in the method of manufacturing the resist layered product 30 as described above, in the case where the nth resist layer 23 contains a photocurable substance (radial polymerization system) in the range meeting $0.1\leq(Vr2/Vcm)\leq 1.5$, particularly, it is preferable to press the fine pattern 12 of the mold 10 against the nth resist layer 23 deposited on the surface of the first to (n-1) th resist layer 22 provided on the inorganic substrate 21 in an atmosphere of low oxygen. In addition, it is preferable to apply the energy ray in an atmosphere of low oxygen while the energy

irradiation method, light source, irradiation amount and the like meeting the above-mentioned ranges, and particularly, pressing.

In other words, in the case where the nth resist layer 23 contains a photocurable substance and meets 0.1≤(Vr2/Vcm)≤1, when the mold layered product 24 is obtained by pressing the fine pattern 12 of the mold 10 against the surface of the nth resist layer 23 in an atmosphere of low oxygen, cure of the nth resist layer 23 is sufficient, and transfer accuracy of the nth resist layer 23 is improved. This is because shape stability is improved in the concavo-convex structure 23a of the nth resist layer 23, and it is possible to suppress peeling of the thin residual film RF from the (n-1)th resist layer 22. Particularly, when irradiation of the energy ray is performed in an atmosphere of low oxygen in a state in which the pressing state of the mold layered product 24 is maintained, the effects of more thinning and uniforming the residual film RF are exhibited, and therefore, such irradiation is preferable.

In the case where the nth resist layer 23 contains a photocurable (radical polymerization system) substance in the range meeting 0.1≤ (Vr2/Vcm) ≤1 as described above, in order to more improve the filling properties of the nth resist layer 23 to the fine pattern 12 of the mold 10, and actualize a concave-convex structure height of the nth resist layer 23 sufficiently high relative to the thickness of the residual film RF, 0.5≤(Vr2/Vcm)≤1 is preferable, 0.6≤ (Vr2/Vcm) ≤1 is more preferable, and 0.8≤ (Vr2/Vcm) ≤1 is the most preferable.

In the present invention, in the nanoimprint method, in addition to inclusion of the above-mentioned pressing step, energy ray irradiation step, and mold release step in this order, the heating step may added to between the energy ray irradiation step and the mold release step. Further, a post-processing step may be added after the mole release step.

<Heating step>

By heating the entire mold layered product after irradiating with the energy ray, while being dependent on the compositions of the first to (n-1) th resist layer 22 and the nth resist layer 23, it is possible to obtain the effects of improving stability of the first to (n-1)th resist layer 22 and the nth resist layer 23 and reduce transfer failure in the mold release step. More specifically, it is possible to improve (D) moment energy applied to the convex portion of the concavo-convex structure 23a in the mold release step, (E) concentration stress applied to the outer edge 23d of the bottom of the convex portion 23c of the concavo-convex structure 23a, and (F) resistance to of the concavo-convex structure 23a to peeling energy applied to the residual film RF. The heating temperature is substantially in the range of 40°C to 200°C, and is preferably a temperature lower than the glass transition temperature (Tg) of the first to (n-1) th resist layer 22 and the nth resist layer 23. Further, the heating time preferably ranges from substantially 20 seconds to 20 minutes.

In addition, in the case of undergoing the heating step, the temperature in the subsequent mold release step is set at least with reference to the temperature of the mold 10. This is because of improving resistance of the concavo-convex structure 23a as described above. Used as the reference is the glass transition temperature (Tg) of the first to (n-1)th resist layer 22 and the nth resist layer 23. When one layer among n resist layers has a glass transition temperature (Tg), the glass transition temperature herein is set at the glass transition temperature (Tg). When two or more layers among n resist layers have glass transition temperatures (Tg), the lowest (Tg) is used. By setting 0.9Tg or less, it is possible to improve transfer accuracy. From the viewpoint of improving the velocity of the mold release step and keeping transfer accuracy excellent, 0.8Tg or less is preferable, 0.7Tg or less is more preferable, and 0.5Tg or less is further preferable.

<Post-processing step>

The post-processing step is performed by applying an energy ray from both side or either side of the surface with the concavo-convex structure 23a of the nth resist layer 23 formed or the surface provided with the inorganic substrate 21. Alternatively, the post-processing step is performed by heating the resist layered product 30 including the nth resist layer 23. Further, in the post-processing step, both energy ray irradiation and heating may be performed.

By applying the energy ray, since it is possible to promote reactions of unreacted portions existing in both or either of the first to (n-1) th resist layer 22 and the nth resist layer 23, stability is improved in the first to (n-1)th resist layer 22 and the nth resist layer 23, it is possible to perform first etching step to third etching step described later with excellence, and therefore, such irradiation is preferable. As the irradiation methods and irradiation conditions, it is possible to use the same conditions as the conditions in the energy ray irradiation step.

By performing heating, it is possible to promote reactions of unreacted portions existing in both or either of the first to (n-1) th resist layer 22 and the nth resist layer 23. Therefore, stability is improved in the first to (n-1) th resist layer 22 and the nth resist layer 23, it is possible to perform first etching step to third etching step described later with excellence, and therefore, heating is preferable. The heating temperature is substantially in the range of 60°C to 500°C, and is preferably a temperature lower than the glass transition temperature (Tg) or softening temperature of the first to (n-1) th resist layer 22 and the nth resist layer 23. Particular, the heating temperature preferably ranges from 60°C to 200°C. Further, the heating time preferably ranges from substantially 20 seconds to 20 minutes.

The arrangement of the fine pattern 12 of the mold 10 is the same as the arrangement of the concavo-convex structure 23a, and the shape of the opening portion of the concave portion 12b of the fine pattern 12 of the mold 10 is the same as the contour shape of the bottom portion of the convex portion 23c of the concavo-convex structure 23a.

By performing sequentially the first etching step of processing the residual film RF, the second etching step of etching the first to (n-1)th resist layer 22, and the third etching step of etching the inorganic substrate 21 on the resist layered product 30 obtained as described above, it is possible to obtain the concavo-convex structure product 31 with the concavo-convex structure 31a formed on the surface of the inorganic substrate 21.

<First etching step>

In the first etching step, the residual film RF of the nth resist layer 23 is removed by an etching method using the concavo-convex structure 23a formed in the nth resist layer 23 as a mask. As the etching method, either a dry etching method or a wet etching method may be used. By using the dry etching method, it is possible to remove the residual film RF with high accuracy. The dry etching conditions are capable of being selected as appropriate corresponding to the materials of the nth resist layer 23 and the residual film thickness of the nth resist layer 23, and therefore, are not limited particularly, and it is possible to use at least a dry etching method (oxygen ashing) using oxygen.

<Second etching step>

In the second etching step, the first to (n-1) th resist layer 22 is dry-etched up to the interface between the inorganic substrate 21 and the first resist layer 22 using the nth resist layer 23 as a mask. The dry etching conditions are capable of being selected as appropriate corresponding to the materials of nth resist layer 23 and the first to (n-1)th resist layer 22, and therefore, are not limited particularly, and for example, there are the following conditions.

As an etching gas, it is possible to select $O_2$ gas and $H_2$ gas, from the viewpoint of etching the first to (n-1) th resist layer 22 in a chemical reaction manner. Further, from the viewpoint of improving an etching rate in the longitudinal direction in the thickness direction of the first to (n-1)th resist layer 22 due to increases in the ion incident component, it is possible to select Ar gas and Xe gas. As the etching gas, it is preferable to use a mixed gas containing at least one of $O_2$ gas, $H_2$ gas and Ar gas, and particularly, it is preferable to use only $O_2$ gas.

The pressure in etching preferably ranges from 0.1 Pa to 5 Pa, and more preferably ranges from 0.1 Pa to 1 Pa, from the viewpoints of increasing ion incident energy contributing to reactive etching and more improving etching anisotropy. In addition, etching anisotropy is a ratio (etching rate in the thickness direction/etching rate in the plane direction) of the etching rate in the thickness direction of the first to (n-1)the resist layer 22 to the etching rate in the plane direction of the first to (n-1) the resist layer 22, and when the ratio is high, etching is preferentially performed in the thickness direction of the first to (n-1)the resist layer 22.

Further, as the mixed gas ratio of $O_2$ gas or $H_2$ gas and Ar gas or Xe gas, when the chemical reactive etching component and ion incident component are proper amounts, from the viewpoint of improving anisotropy, in the case of assuming that the total flow rate of gas flow rate is 100 sccm, the ratio of gas flow rates is preferably 99 sccm:1 sccm to 50 sccm:50 sccm, more preferably 95 sccm:5 sccm to 60 sccm:40 sccm, and further preferably 90 sccm:10 sccm to 70 sccm:30 sccm. When the total flow rate of gas is changed, the gas is a mixed gas according to the above-mentioned ratio of flow rates.

Plasma etching is performed using RIE using capacity coupling type RIE, inductive coupling type RIE or RIE using ion drawing-in bias. For example, there are etching method of using only $O_2$ gas or a gas obtained by mixing (total gas flow rate 100 sccm) $O_2$ gas and Ar in the ratio of flow rates of 90 sccm:10 sccm to 70 sccm:30 sccm, setting the processing pressure in the range of 0.1 Pa to 1 Pa, and using capacity coupling type RIE or RIE using ion drawing-in voltage, and the like. When the total flow rate of the mixed gas used in etching is changed, the gas is a mixed gas according to the above-mentioned ratio of flow rates.

Particularly, when the nth resist layer 23 contains a component (for example, metalloxane bondportion as described later) with low vapor pressure, in etching the first to (n-1)th resist layer 22, the nth resist layer 23 shifts to the side walls of the first to (n-1)th resist layer 22. By this means, the nth resist layer 23 acts as protecting the side walls of the first to (n-1) th resist layer 22, and therefore, etching anisotropy is increased. As a result, it is possible to easily etch the thick first to (n-1) th resist layer 22.

In addition, in the above-mentioned second etching step, in the process of performing dry etching on the first to (n-1)th resist layer 22, it is also possible to change the dry etching conditions as appropriate. In other words, the second etching step is capable of including a plurality of dry etching steps. For example, it is possible to change the dry etching gas species and/or change the pressure. By adopting such a dry etching method, it is possible to control the shape (height, width, taper angle and the like) of the fine mask pattern 25, and it is possible to obtain the shape of the fine mask pattern 25 that is the most suitable for performing nano-processing on the inorganic substrate 21.

Further, the same conditions may be adopted in dry etching in the first etching step as described above and

dry etching in the second dry etching step. In this case, it is possible to perform the first etching step and the second etching step at the same time inside a single chamber. For example, it is possible to perform continuously the first etching step and the second etching step by dry etching using the gas containing $O_2$ gas.

<Third etching step>

In the third etching step, the inorganic substrate 21 is processed by dry etching or wet etching to manufacture the concavo-convex layered product 31. In addition, the first to (n-1) th resist layer 22 may be removed by etching in the third etching step or may be removed by wet peeling treatment typified by alkali treatment and Piranha treatment after etching in the third etching step. In the third etching step, it is preferable to perform etching by dry etching until the first to (n-1) th resist layer 22 is lost to finish processing of the inorganic substrate 21. In addition, also in the case of performing such dry etching in the third etching step until the first to (n-1)th resist layer 22 disappear, it is preferable to perform alkali cleaning or acid cleaning on the obtained concavo-convex structure product 31 to remove a surface residual and particle or remove a portion in which the surface is modified by dry etching of the inorganic substrate 21. The dry etching conditions are capable of being selected as appropriate corresponding to the materials of the nth resist layer 23, the first to (n-1)th resist layer 22 or inorganic substrate 21, therefore, are not limited particularly, and for example, there are the following conditions.

In the third etching step, from the viewpoint of decreasing a ratio (etching rate of the first to (n-1) th resist layer 22/etching rate of the inorganic substrate 21) between etching rates of the inorganic substrate 21 and the first to (n-1)th resist layer 22, it is possible to use an etching gas such as chlorine-based gas and fluorocarbon-based gas. The oxygen gas, argon gas or a mixed gas of oxygen gas and argon gas may be added to the chlorine-based gas.

Among fluorocarbon-based gases (CxHzFy: x=1 to 4, y=1 to 8, and z=0 to 3 of integers in these ranges) easy to perform reactive etching on the inorganic substrate 21, a mixed gas containing at least one kind is used. As the fluorocarbon-based gases, examples thereof are $CF_4$, $CHF_3$, $C_2F_6$, $C_3F_8$, $C_4F_6$, $C_4F_8$, $CH_2F_2$, and $CH_3F$.

Further, in order to improve the etching rate of the inorganic substrate 21, used is a mixed gas obtained by mixing Ar gas, $O_2$ gas, and Xe gas to the fluorocarbon-based gas in an amount of 50% or less of the entire gas flow rate. A mixed gas is used containing at least one among chlorine-based gases capable of performing reactive etching on the inorganic substrate 21 hard to undergo reactive etching by the fluorocarbon-based gas. As the chlorine-based gases, examples thereof are $Cl_2$ $BCl_3$, $CCl_4$, $PCl_3$, $SiCl_4$, HCl, $CCl_2F_2$ and $CCl_3F$. Further, in order to improve the etching rate of the inorganic substrate 21, the oxygen gas, argon gas or mixed gas of oxygen gas and argon gas may be added to the chlorine-based gas.

From the viewpoints of increasing ion incident energy contributing to reactive etching and improving the etching rate of the inorganic substrate 21, the pressure in etching preferably ranges from 0.1 Pa to 20 Pa, and more preferably ranges from 0.1 Pa to 10 Pa.

Further, by mixing two kinds of fluorocarbon gases with different ratios (y/x) of C and F (CxHzFy: x=1 to 4, y=1 to 8, and z=0 to 3 of integers in this ranges) to increase or decrease the accumulation amount of the fluorocarbon film to protect the side walls of the nanostructure of the inorganic substrate 21 processed by dry etching, it is possible to independently create the angle of the taper shape of the nanostructure to undergo dry etching treatment. In the case of controlling the mask shape (shape of the first to (n-1)th resist layer 22) of the inorganic substrate 21 with higher accuracy by dry etching, in the case of assuming that the total flow rate is 100 sccm, the ratio between the flow rate of fluorocarbon gas with $F/C \geq 3$ and the flow rate of fluorocarbon gas with $F/C<3$ is preferably 95 sccm:5 sccm to 60 sccm:40 sccm, and more preferably 70 sccm:30 sccm to 60 sccm:40 sccm.

Furthermore, as the mixed gas of fluorocarbon-based gas and Ar gas and mixed gas of $O_2$ gas or Xe gas, when the reactive etching component and ion incident component are proper amounts, from the viewpoint of improving the etching rate of the inorganic substrate 21, the ratio of gas flow rates is preferably 99 sccm:1 sccm to 50 sccm: 50 sccm, more preferably 95 sccm: 5 sccm to 60 sccm:40 sccm, and further preferably 90 sccm:10 sccm to 70 sccm:30 sccm. Further, as the mixed gas of chlorine-based gas and Ar gas and mixed gas of $O_2$ gas or Xe gas, when the reactive etching component and ion incident component are proper amounts, from the viewpoint of improving the etching rate of the inorganic substrate 21, the ratio of gas flow rates is preferably 99 sccm:1 sccm to 50 sccm:50 sccm, more preferably 99 sccm:1 sccm to 80 sccm:20 sccm, and further preferably 99 sccm:1 sccm to 90 sccm:10 sccm.

Still furthermore, for etching of the inorganic substrate 21 using the chlorine-based gas, it is preferable to use only $BCl_3$ gas, mixed gas of $BCl_3$ and Cl gas or mixed gas of these mixed gases and Ar gas or Xe gas. In these mixed gases, when the reactive etching component and ion incident component are proper amounts, from the viewpoint of improving the etching rate of the inorganic substrate 21, in the case of assuming that the total gas flow rate is 100 sccm, the ratio of gas flow rates is preferably in the range of 99 sccm:1 sccm to 50 sccm:50 sccm, more preferably in the range of 99 sccm:1 sccm to 70 sccm:30 sccm, and most preferably in the range of 99 sccm:1 sccm to 90 sccm:10 sccm. Also in the case where the total flow rate of gas is changed, the above-mentioned flow rate ratios are not changed.

The plasma etching is performed using capacity coupling type RIE, inductive coupling type RIE or RIE using

ion drawing-in voltage. For example, in the case of using the fluorocarbon-based gas, there are etching method of using only CHF=gas or a gas obtained by mixing $CF_4$ and $C_4F_8$ in the ratio of gas flow rates of 90 sccm:10 sccm to 60 sccm:40 sccm, setting the processing pressure in the range of 0.1 Pa to 5 Pa, and using capacity coupling type RIE, conductive coupling type RIE or RIE using ion drawing-in voltage, and the like.

Further, for example, in the case of using the chlorine-based gas, there are etching method of using only $BCl_3$ gas, or a gas obtained by mixing $BCl_3$ and $Cl_2$ gas or Ar gas in the gas flow rate ratio of 95 sccm:5 sccm to 70 sccm:30 sccm, setting the processing pressure in the range of 0. 1 Pa to 10 Pa, and using capacity coupling type RIE, conductive coupling type RIE or RIE using ion drawing-in voltage, and the like. Furthermore, also in the case where the total gas flow rate of the mixed gas is changed, the above-mentioned flow rate ratio is not changed.

Furthermore, a fourth etching step to remove the nth resist layer 23 by dry etching may be added to between the second etching step and the third etching step.

Still furthermore, a step of cleaning the concavo-convex structure product 31 may be added after the third etching step. As the cleaning, there are cleaning using analkali solution typified by aqueous sodium hydroxide and aqueous potassium hydroxide, acid cleaning using a Piranha solution and aqua regia, and the like.

Each component of the resist layered product 30 will be described subsequently. In addition, in the Description, the chemical composition is sometimes represented by -A-B-. The description is an expression to explain a bond between an element A and an element B, and for example, also in the case where an element has three or more bonding functions, the same expression is used. In other words, the description of -A-B- at least represents that the element A chemically reacts with the element B, and includes that the element A forms a chemical bond with an element other than the element B.

<nth resist layer 23>

In the case of a multilayer resist where the layered number n of resist layers is two or more, materials forming the nth resist layer 23 are different from materials forming the first to (n-1) th resist layer 22. Hereinafter, the multilayer resist is described. In addition, in the case of a single layer where the layered number n is one, it is possible to select materials forming the first to (n-1) th resist layer 22 and materials forming the nth resist layer 23 in the case of multilayer where the layered number n is two or more as described below.

The materials forming the nth resist layer 23 are not limited particularly, as long as the materials contain a predetermined metal element and meet a selection ratio (etching rate) as described later. Particularly, it is preferable to contain a predetermined metalloxane bond portion. As the materials forming the nth resist layer 23, it is possible to use publicly-known resins (for example, thermoplastic resin, thermosetting resin, photocurable resin, etc.) which are able to be diluted by a solvent, inorganic precursors, inorganic condensation products, plating solutions (chromium plating solution and the like), metal oxide fillers, metal oxide fine particles, metal fine particles, spin-on glass (SOG), organic spin-on glass (O-SOG), hydrogen silsesquioxane (HSQ) and the like.

The materials forming the nth resist layer 23 preferably contain at least one or more metal elements selected from the group consisting of Si, Ti, Zr, Zn, Mg, In, Al, W, Cr, B, Sn, Ta, Au and Ag. By containing these metal elements, improved is the processing selection ratio between the nth resist layer 23 and the first to (n-1)th resist layer 22, and it is thereby possible to further decrease the aspect ratio of the fine pattern 12 of the mold 10. Therefore, transfer accuracy of the nth resist layer 23 is improved. Further, in the second etching step, the protection effect is enhanced on the side walls of the first to (n-1)th resist layer 22, and it is thereby possible to enhance transfer accuracy of the fine mask pattern 25. From the viewpoint of more exerting these effects, as the metal element, the nth resist layer 23 preferably contains at least one or more metal elements selected from the group consisting of Si, Ti, Zr, Zn, Al, B and Sn, and more preferably contains at least one or more metal elements selected from the group consisting of Si, Ti, Zr and Zn. Further, in the case of containing two or more metal elements, containing at least Si improves transfer accuracy of the concavo-convex structure 23a of the nth resist layer 23 and is preferable. In addition, in the case of containing two or more metal elements as described above, by containing at least Si, improved are dispersion properties of the metal elements inside the nth resist layer, and it is possible to improve processing accuracy of the inorganic substrate. For example, there are Si and Ti, Si and Zr, Si and B, Si, Ti and Zr, Si, Ti and B, and the like.

When the nth resist layer 23 contains a metal element except Si element, it is preferable that a metal element M1 except Si is at least one kind of metal element selected from the group consisting of Ti, Zr, Zn, Sn, B, In and Al, and that the ratio ($C_{pM1}/C_{psi}$) between the Si element concentration ($C_{pSi}$) and the element concentration ($C_{pM1}$) of the metal element M1 except Si ranges from 0.02 to 20. By this means, improved are the filling properties of the nth resist layer 23 to the fine pattern 12 of the mold, transfer accuracy, and processing accuracy of the first to (n-1) th resist layer 22. Further, the ratio ($C_{pM1}/C_{pSi}$) of 0.1 or more improves dry etching properties of the nth resist layer 23, and side wall protection properties in etching the first to (n-1)th resist layer 22, and is preferable, the ratio of 0.3 or more is more preferable, and the ratio of 0.5 or more is the most preferable. Further, from the viewpoint of improving transfer accuracy of the nth resist layer 23, the ratio ($C_{pM1}/C_{pSi}$) is preferably 15 or less, more preferably 10 or less, and most preferably 5 or less.

In the case where Si and metal element except Si are described as Me, when Me-OR (in addition, R is a chemical structure being an alcohol when described as HOR) is contained, the shape hold effect is improved in the nth resist layer 23 filled into the fine pattern 12 of the mold. In other words, by peeling off the mold 10, it is possible to obtain the concavo-convex structure 23a with high shape stability. This is because of utilizing the chemical reaction by polycondensation by containing such a portion. As R in the case of describing as Me-OR, examples thereof an ethoxy group, methoxy group, propyl group, and isopropyl group.

As the materials forming the nth resist layer 23, it is preferable to contain a metalloxane bond described in following general formula(10). In this case, the metalloxane bond preferably contains at least Si, Ti, and Zr.

General formula (10) -O-Me1-O-Me2-

(In general formula (10), each of Me1 and Me2 is one of Si, Ti, Zr, Zn, Mg, In, Al, W, Cr, B, and Sn, Me1 and Me2 may be the same element or may be different. "O" means an oxygen element.)

Containing the above-mentioned metalloxane bond improves the processing selection ratio between the nth resist layer 23 and the first to (n-1)th resist layer 22, and it is thereby possible to decrease the aspect ratio of the concavo-convex structure of the fine pattern 12 of the mold 10. Therefore, transfer accuracy of the nth resist layer 23 is improved.

The means for containing the above-mentioned metalloxane bond in the nth resist layer 23 is not limited particularly, and it is possible to introduce by hydrogen silsesquioxane (HSQ), spin-on glass (SOG), organic spin-on glass (O-SOG), silicone, these substances modified with functional groups, sol-gel materials typified by metal alkoxide, Si-based UV curable resins (for example, TPIR series made by TOKYO OHKA KOGYO CO. , LTD. , and the like) and the like. By introducing the metalloxane bond by using these materials, the processing selection ratio between the nth resist layer 23 and the first to (n-1) th resist layer 22 is held excellent, it is also possible to protect side walls of the first to (n-1) th resist layer 22, in processing the first to (n-1) th resist layer 22 by dry etching using the nth resist layer 23 as a mask, and it is thereby possible to process the thick first to (n-1) th resist layer 22 with ease.

In addition, in the case of containing photocurable groups using a silane coupling agent, it is preferable to mix the silane coupling agent and metal alkoxide having a metal species except Si. Further, hydrolysis·polycondensation of the mixture may be promoted to prepare a partial condensation product (prepolymer).

When the metalloxane bond contains a metal element except Si element, it is preferable that a metal element M1 except Si is at least one kind of metal element selected from the group consisting of Ti, Zr, Zn, Sn, B, In and Al, and that an element concentration ($C_{pM1}/C_{pSi}$) between the Si element concentration ($C_{pSi}$) and the element concentration ($C_{pM1}$) of the metal element M1 except Si ranges from 0.02 to 20. By this means, improved are the filling properties of the nth resist layer 23 to the fine pattern 12 of the mold, transfer accuracy, and processing accuracy of the first to (n-1) th resist layer 22. Further, since improved are dry etching properties of the nth resist layer 23, and side wall protection properties in etching the first to (n-1) th resist layer 22, the ratio ($C_{pM1}/C_{pSi}$) is preferably 0.1 or more, more preferably 0.3 or more, and most preferably 0.5 or more. Further, from the viewpoint of improving transfer accuracy of the nth resist layer 23, the ratio ($C_{pM1}/C_{pSi}$) is preferably 15 or less, more preferably 10 or less, and most preferably 5 or less.

In addition, the case where the metalloxane bond contains a metal elemental except Si element is classified into three cases. The first case is a case of containing the siloxane bond where the Me1 and Me2 of above-mentioned general formula (10) are both Si elements, and the metalloxane bond where the Me1 and Me2 of above-mentioned formula are metal elements except the Si element. The second case is a case of containing the metalloxane bond (Si-O-M1-) where Si element and metal element M1 except Si element are bound via oxygen. The third case is a case where the first case and the second coexist. In any of the cases, from the above-mentioned mechanism, it is possible to improve transfer accuracy of the nth resist layer 23 and improve processing accuracy of the first to (n-1)th resist layer 22.

Further, since the metal element M1 except Si is selected from the group consisting of Ti, Zr, Zn, Sn, B, In and A1, stability of the metalloxane bond is improved. As a result, it is possible to improve the filling properties of the nth resist layer 23 to the fine pattern 12 of the mold 10, and it is also possible to improve uniformity inside the surface of the concavo-convex structure 23a. From the viewpoint of more exerting the effects, the metal element M1 except Si is preferably selected from the group consisting of Ti, Zr, Zn, and B, and is more preferably selected from Ti and Zr.

In addition, the above-mentioned metalloxane bond (-Me1-O-M2-O) is defined as a state in which at least four or more metal elements are coupled through oxygen atoms i.e. a state in which metal elements are condensed more than -O-Ma-O-Mb-O-Mc-O-Md-O- (in addition, Ma, Mb, Mc and Md are Si, Ti, Zr, Zn, Mg, In, Al, W, Cr, B, or Sn.) For example, when the metal element except Si is Ti, the metalloxane bond comprised of -O-Ti-Si-O- is contained, and ina general formula of $[-Ti-O-Si-O-]_n$, the metalloxane bond is defined in the range of $n \geq 2$. In addition, the bond is not always alternately arranged mutually as -O-Ti-O-Si-. Therefore, the general formula of -O-Ma-O-Mb-O-Mc-O-Md-O- is defined as the metalloxane bond. In the case where the metalloxane bond is the general formula $[-Me-O-]_n$ (in addition, Me is Si, Ti, Zr, Zn, Mg, In, Al, W, Cr, B, Sn), when n is 10 or more, it is possible to improve dry etching properties, side wall protection properties, and transfer accuracy. From the same effects, n is preferably 15 or more.

Particularly, from the viewpoint of improving transfer accuracy of the nth resist layer 23 and processing accuracy

of the first to (n-1) th resist layer 22, it is preferable to contain at least one metalloxane bond among the metalloxane bond (siloxane bond) formed of Si element and oxygen element, metalloxane bond made of Ti element and oxygen element, and metalloxane bond made of Zr element and oxygen element.

Further, the above-mentioned siloxane bond is defined as $[\text{-Si-O-}]_n$ (in addition, n≥10). By n≥10, flexibility specific to the siloxane bond develops, and transfer accuracy of the concavo-convex structure 23a is improved. Further, by containing the siloxane bond, since it is possible to increase the distance between the metal elements M1, improved are uniformity of surface physical properties inside the surface of the concavo-convex structure 23a and dry etching properties of the nth resist layer 23. From the viewpoint of more exerting these effects, n≥30 is preferable, n≥50 is more preferable, and n≥100 is the most preferable. Further, from the viewpoint of improving flowability of the nth resist layer 23 and improving the filling properties to the fine pattern 12 of the mold 10, n≥200 is preferable, and n≥500 is more preferable. Furthermore, from the viewpoints of preventing breakage due to a bend and fall of the concavo-convex structure 23a and obtaining excellent dry etching properties, n≤100,000 is preferable, n≤10,000 is more preferable, and n≤8,000 is the most preferable. Still furthermore, from the viewpoint of more improving flowability of the nth resist layer 23 to improve the filling properties, n≤5,000 is preferable, and n≤3,000 is more preferable.

Furthermore, in the above-mentioned metalloxane bond and the above-mentioned siloxane bond, by containing an aryl group to bind to Si, it is possible to improve uniformity of surface physical properties of the concavo-convex structure 23a, and it is also possible to dry etching properties of the nth resist layer 23.

Still furthermore, when the nth resist layer 23 contains one of an acrylic group, methacrylic group, acryloyl group, methacryloyl group, acryloxy group, methacryloxy group, vinyl group, epoxy group and oxetane group, and a photopolymerization initiator, by applying an energy ray to the nth resist layer 23 filled in the fine pattern 12 of the mold 10, it is possible to generate organic bonds. In such a case, inorganic segments due to the metalloxane bonds and organic segments due to the organic bonds coexist in the nth resist layer 23. As a result, since the nth resist layer 23 has both rigidity as the inorganic substance and flexibility as the organic substance, the transfer accuracy is improved in the concavo-convex structure 23a, and dry etching properties are also improved in the nth resist layer 23.

In this case, it is preferable that the ratio ($C_{pM1}/C_{pSi}$) meets the range of 0.1 to 4.5. By meeting this range, in addition to the above-mentioned effects, it is possible to improve the filling properties of the nth resist layer 23 to the fine pattern 12 of the mold 10 and surface accuracy of the nth resist layer 23. Particularly, when the ratio ($C_{pM1}/C_{pSi}$) is 3.5 or less, it is possible tomore improve the fillingproperties. Further, from the viewpoint of uniforming surface physical properties of the concavo-convex structure 23a over within the surface, the ratio ($C_{pM1}/C_{pSi}$) is preferably 3 or less, and more preferably 2.5 or less. Furthermore, when the ratio ($C_{pM1}/C_{pSi}$) is 0.05 or more, it is possible to improve dry etching properties of the nth resist layer 23. Still furthermore, from the viewpoint of more improving dry etching properties and improving processing accuracy of the first to (n-1) th resist layer 22, the ratio ($C_{pM1}/C_{pSi}$) is preferably 0.1 or more, more preferably 0.3 or more, and most preferably 0.5 or more.

The nth resist layer 23 is obtained by diluting the materials forming the nth resist layer 23 with a solvent, applying the diluent onto the first to (n-1) th resist layer, and depositing the film. Herein, from the viewpoint of film depositing properties of the nth resist layer 23 , the viscosity of the materials of the nth resist layer 23 at 25°C preferably ranges from 30 cp to 10,000 cP, and from the viewpoint of keeping dry etching properties excellent, is more preferably 50 cP or more. Further, from the viewpoint of improving in-plane uniformity of the nth resist layer 23, the viscosity is more preferably 100 cP or more, and most preferably 150 cP or more. From the viewpoint of improving the filling properties of the nth resist layer 23 to the fine pattern 12 of the mold 10, the viscosity is more preferably 8,000 cP or less, and most preferably 5,000 cP or less. In addition, the viscosity is a value measured in the case where the solvent content is 5% or less.

From the viewpoints of stability of the nth resist layer 23 in film depositing and shape accuracy in performing dry etching processing on the first to (n-1) th resist layer 22 using the nth resist layer 23 as a mask, the solvent to dilute the materials of the nth resist layer 23 preferably meets the following conditions. When the materials of the nth resist layer 23 are diluted with the solvent, the radius of inertia is preferably 50 nm or less. By meeting this range, it is possible to reduce surface roughness of the nth resist layer 23, and improve the filling properties of the nth resist layer 23 to the fine pattern 12 of the mold 10. Further, when the radius of inertia is 35 nm or less, it is possible to improve processing accuracy of the first to (n-1)th resist layer 22 in performing dry etching on the first to (n-1) th resist layer 22 using the nth resist layer 23 as a mask. Furthermore, when the radius of inertia is 20 nm or less, since it is possible to improve stability as a coating solution of the solution with the nth resist layer diluted, it is possible to more decrease surface roughness of the deposited nth resist layer 23. Still furthermore, when the radius of inertia is 10 nm or less, since stabilization of the nth resist layer 23 uniformly proceeds in performing heating, energy ray irradiation and the like on the nth resist layer 23 filled in the fine pattern 12 of the mold 10, it is possible to improve transfer accuracy of the nth resist layer 23. Moreover, from the viewpoints of obtaining the above-mentioned effects, reducing collision establishment between the materials of the nth resist layer 23, and suppressing an increase in the radius of inertia, the radius is preferably 5 nmor less, and more preferably 3 nmor less. Moreover, in the case where the radius of the inertia is 1.5 nm or less, even when the film thickness of the nth resist layer 23 is made a thin film with a film thickness of about 100 nm or less, it is possible to

reduce surface roughness of the nth resist layer 23, and such a case is preferable. From this viewpoint, it is the most preferable that the radius is 1 nm or less. Herein, the radius of inertia is assumed to be a radius calculated by applying Gunier plot on the measurement result obtained from measurement by small angle X-ray scattering using X-ray with a wavelength of 0.154 nm.

Further, in the above-mentioned metalloxane bond or the above-mentioned siloxane bond, in the case where Si and metal element M1 except Si are described as Me, when Me-OR (in addition, R is a chemical structure being an alcohol when described as HOR) is contained, the shape hold effect is improved in the nth resist layer 23 filled into the fine pattern 12 of the mold. In other words, by peeling off the mold 10, it is possible to obtain the concave-convex structure 23a with high shape stability. This is because of utilizing the chemical reaction due to polycondensation by containing such a portion. As R in the case of describing as Me-OR, examples thereof an ethoxy group, methoxy group, propyl group, and isopropyl group.

In addition, as the materials forming the nth resist layer 23 having the above-mentioned metalloxane bond or siloxane bond, there are materials containing at least one kind selected from the group consisting of hydrogen silsesquioxane (HSQ), spin-on glass (SOG), organic spin-on glass (O-SOG), hydrogensilsesquioxane (HSQ) modified with photopolymerizable groups, spin-on glass (P-SOG) modified with photopolymerizable groups, metal alkoxide, and silane coupling agent with photopolymerizable group-terminals. Among the materials, by containing silsesquioxane (HSQ), spin-on glass (SOG), organic spin-on glass (O-SOG), Si-based UV curable resins (for example, TPIR series made by TOKYO OHKA KOGYO CO., LTD and the like) or metal alkoxide, since it is possible to actualize a thin residual film thickness at low pressure and low temperature, it is possible to suppress making of excessive facilities and improve repetition use characteristics of the mold 10.

The metalloxane bond that does not contain Si element is obtained by polycondensation of metal alkoxide where the metal species is the metal element M1. Further, the metalloxane bond formed of Si element and metal element M1 except Si is obtained by polycondensation of metal alkoxide where the metal species is the metal element M1 and metal alkoxide where the metal species is Si element, polycondensation of metal alkoxide where the metal species is the metal element M1 and HSQ, SOG, O-SOG, HSQ or P-SOG, and polycondensation of metal alkoxide where the metal species is the metal element M1, metal alkoxide where the metal species is Si element and HSQ, SOG, O-SOG, HSQ or P-SOG. The method of polycondensation is not limitedparticularly, and from the viewpoint of improving stability of the metalloxane bond, preferable is at least polycondensation including the dealcoholization reaction and/or dehydration reaction.

On the other hand, by containing hydrogen silsesquioxane (HSQ) modified with photocurable groups, spin-on glass (P-SOG) modified with photocurable groups, organic spin-on glass (P-SOG) modified with photocurable groups, or silane coupling agent with photocurable group-terminals, it is possible to use photopolymerization (energy ray irradiation step) together, and improved are transfer velocity and transfer accuracy. In addition, as the photocurable groups, examples thereof are an acryloyl group, methacryloyl group, acryloxy group, methacryloxy group, acrylic group, methacrylic group, vinyl group, epoxy group, allyl group, oxetanyl group, dioxetane group, cyano group, and isocyanate group. Particularly, from the viewpoint of polymerization velocity, it is preferable to contain at least vinyl groups, acrylic groups and methacrylic groups.

From the viewpoint of transfer accuracy of the concavo-convex structure 23a of the nth resist layer 23 after the mold release step, it is preferable that in the nth resist layer 23 and the (n-1)th resist layer 22, the chemical bond is formed in the interface. In this case, even when the residual film RF of the nth resist layer 23 is extremely thin, since (F) improved is resistance to peeling energy with respect to the residual film RF in the mold release step, it is possible to prevent the nth resist layer 23 from peeling off from the interface with the (n-1) th resist layer 22.

It is possible to form the chemical bond in the interface between the (n-1)th resist layer 22 and the nth resist layer 23 by providing both the (n-1)th resist layer 22 and the nth resist layer 23 with materials containing photopolymerizable functional groups, thermopolymerizable functional groups, or Me-OR (for example, groups developing the condensation reaction typified by the sol-gel material). Among the methods, it is preferable to provide both the (n-1) th resist layer 22 and the nth resist layer 23 with materials containing thermopolymerizable functional groups or photopolymerizable functional groups.

As the materials containing photopolymerizable functional groups or thermopolymerizable functional groups for the nth resist layer 23, examples thereof are hydrogen silsesquioxane (HSQ), spin-on glass (SOG), organic spin-on glass (O-SOG), materials such as silicone modified with photopolymerizable groups or thermopolymerizable groups,Si-based UV curable resins (for example, TPIR series made by TOKYO OHKA KOGYO CO. , LTD, and the like) silane coupling agent with photopolymerizable functional group-terminals or thermopolymerizable functional group-terminals, and materials provided with photopolymerizable resin or thermopolymerizable resin. Further, it is also possible to adopt organic-inorganic hybrid molecules containing an organic portion and an inorganic portion in the same molecule.

Further, in the nth resist layer 23 and the (n-1) th resist layer 22, in order to enhance compatibility between the layers and improving adhesion, it is preferable that the contact angle is smaller than 90 degrees in depositing the film of the nth resist layer 23 on the (n-1)th resist layer 22. Furthermore, from the viewpoint of more exerting the effects, the

contact angle in film depositing is preferably 70 degrees or less, more preferably 60 degrees or less, and most preferably 40 degrees or less.

Moreover, in order to improve the filling properties of the nth resist layer 23 to the fine pattern 12, a surfactant and leveling agent maybe added to the nth resist layer 23. It is possible to use publicly-known commercial available materials, and preferable are materials having an olefin structure in the same molecule. From the viewpoint of the filling properties, relative to 100 parts by weight of the nth resist layer 23, the addition concentration is preferably 30 parts by weight or more, and more preferably 60 parts by weight or more. Further, from the viewpoint of improving transfer accuracy, the addition concentration is preferably 500 parts by weight or less, more preferably 300 parts by weight or less, and further preferably 150 parts by weight or less. From the viewpoint of improving transfer accuracy of the nth resist layer 23, in using a surfactant and leveling material, relative to 100 parts by weight of the nth resist layer 23, the addition concentration is preferably 20 parts by weight or less, more preferably 15 parts by weight or less, and most preferably 10 parts by weight or less.

It is possible to use the surfactant and leveling material together with a surface modifier(s) having abrasion resistance, scratch resistance, fingerprint adhesion prevention, antifouling property, leveling properties, water repellency, oil repellency or the like together. As the surface modifiers, examples thereof are FTERGENT made by NEOS Company Limited (for example, M series: FTERGENT 251, FTERGENT 215M, FTERGENT 250, FTX-245M, FTX-290M; S series: FTX-207S, FTX-211S, FTX-220S, FTX-230S; Fseries: FTX-209F, FTX-213F, FTERGENT 222F, FTX-233F, FTERGENT 245F; G series:FTERGENT 208G, FTX-218G, FTX-230G, FTS-240G; Oligomer series: FTERGENT 730FM, FTERGENT730LM, FTERGENT P series: FTERGENT710FL, FTX-710HL, etc.), "MEGAFAC" made by DIC Corporation (for example, F-114, F-410, F-493, F-494, F-443, F-444, F-445, F-470, F-471, F-474, F-475, F-477, F-479, F-480SF, F-482, F-483, F-489, F-172D, F-178K, F-178RM, MCF-350SF, etc.), "OPTOOL (RegisteredTrademark) " (for example, DSX, DAC, AES), "EFTONE (Registered Trademark)" (for example, AT-100), "ZEFFLETM (Registered Trademark)" (for example, GH-701), "UNIDYNE (Registered Trademark)", "DAIFREE (Registered Trademark)" and "OPTOACE (Registered Trademark) " made by Daikin Industries, Ltd., "Novec(Registered Trademark) EGC-1720" made by Sumitomo 3M Limited, and "Fluoro Surf (Registered Trademark)" made by Fluoro Technology.

Further, as the surface modifier, from the viewpoint of improving solubility with the surfactant and leveling material, it is preferable to contain at least one selecting from the group consisting of a carboxyl group, urethane group, and functional groups having isocyanuric acid derivative. In addition, the isocyanuric acid derivative includes structures having the isocyanuric acid skeleton where at least one hydrogen atom bound to a nitrogen atom is replaced with another substituent group. As the derivative meeting these conditions, for example, there is OPTOOL DAC (made by Daikin Industries, Ltd.).

In addition, in association with the curing reaction of the nth resist layer 23, when a by-product occurs by the nth resist layer 23, it is preferable to use a resin mold typified by PDMS. This is because the resin mold absorbs or transmits the by-product occurring in association with curing of the nth resist layer, and it is possible to suppress a decrease in the reaction rate according to the Le Chatelier’s law. Among the by-products are alcohol and water arising in association with the hydrolysis reaction condensation. Further, as the resin mold, preferable are cycloolefin-based resin, acetylcellulose-based resin, and polydimethylsiloxane. In the case of manufacturing the resin mold as a cured material of photocurable resin, when the number of average functional groups of the photocurable resin that is the raw material forming the resinmold ranges from 1. 2 to 3 , transmittance properties or absorption properties of the by-product are improved, being preferable. From the same effects, the number of average functional groups more preferably ranges from 1.2 to 2.5, and most preferably ranges from 1.2 to 2.2.

<First to (n-1)th resist layer 22>

The materials forming the first to (n-1) th resist layer 22 are not limited particularly, as long as the materials meet a predetermined selection ratio (etching rate ratio) described later. Among the materials, from the viewpoint of suppressing peeling of the residual film RF in the interface between the nth resist layer 23 and the (n-1)th resist layer 22, the (n-1)th resist layer is preferably of materials that form chemical bonds with the materials of the nth resist layer 23. As such materials, examples thereof are materials having photopolymerizable functional groups, thermopolymerizable functional groups, or substituent groups capable of developing the condensation reaction such as the sol-gel reaction. Among the materials, from the viewpoint of more improving transfer accuracy, it is preferable to form with materials containing thermopolymerizable functional groups.

Further, as materials forming the first resist layer 22, from the viewpoint of improving transfer accuracy as a result of improving adhesion between the first resist layer 22 and the inorganic substrate 21, it is preferable to contain materials having polar groups such as an carboxyl group, carbonyl group and epoxy group.

Furthermore, from the viewpoint of improving the filling properties of the nth resist layer 23 to the fine pattern 12, the first to (n-1) th resist layer 22 is preferably formed of materials with the Young’s modulus (longitudinal modulus) ranging from 1 MPa to 10 GPa, more preferably formed of materials with the Young’s modulus ranging from 5 MPa to

10 GPa, and further preferably formed of materials with the Young's modulus ranging from 10 MPa to 3 GPa.

In this case, since it is possible to more (1) improve the stress concentration relaxation effect of the first to (n-1)th resist layer 22, it is possible to improve uniformity of the residual film thickness of the nth resist layer 23. Further, since flowability of the nth resist layer 23 is in a moderate range, a part of the nth resist layer 23 sandwiched between the fine pattern 12 of the mold 10 and the (n-1) th resist layer 22 is ease to enter into the concavo portions 12b of the fine pattern 12 of the mold 10, and it is thereby possible to easily thin the residual film RF of the nth resist layer 23.

In addition, the Young's modulus is measured by either of the following methods. (1) Measurement is performed on the stabilized first to (n-1) the resist layer 22 provided on the inorganic substrate 21. For example, when the first to (n-1) the resist layer 22 is photocurable, measurement is performed on the thin film (the first to (n-1) the resist layer 22) after photo-curing the first to (n-1) the resist layer 22. In this case, measurement of the Young's modulus is capable of being measured by the Nano Indentation method or Surface Acoustic Wave (SAW) method on the first to (n-1) the resist layer 22. (2) Abulk thin film is prepared so that the stabilized first to (n-1) the resist layer 22 is capable of being self-support. It is possible to measure by applying the tensile test method (JIS G0567J) to the obtained first resist layer bulk thin film.

Further, from the viewpoint of improving processing accuracy of the inorganic substrate 21 in the above-mentioned third etching step, the glass transition temperature (Tg) of the stabilized first to (n-1) resist layer 22 is preferably 50°C or more. Particularly, from the viewpoint of decreasing a difference between apparatuses in the third etching step, Tg is preferably 65°C or more, more preferably 80°C or more, and most preferably 100°C or more. Further, from the viewpoint of increasing the processing capable range of the fine concavo-convex structure 31a provided on the inorganic substrate 21, Tg is preferably 120°C or more, more preferably 140°C or more, and most preferably 150°C or more. In addition, as the stabilized first to (n-1) th resist layer 22, for example, when the first to (n-1)th resist layer 22 is photocurable, the stabilized first to (n-1) th resist layer 22 means the thin film (first to (n-1)th resist layer 22) subsequent to photo-curing of the first to (n-1) th resist layer 22. In the case of heat-curable, the stabilized first to (n-1)th resist layer 22 means the thin film (first to (n-1) th resist layer 22) subsequent to heat-curing of the first to (n-1)th resist layer 22.

<Selection ratio (etching rate ratio)>

The selection ratio (etching rate ratio) is the ratio (Va/Vb) of the dry etching rate (Va) of the thin film formed of a substance A to the etching rate (Vb) of the thin film formed of a substance B to which the dry etching conditions are applied. Since the ratio (Vo1/Vm1) between the etching rate (Vm1) of the nth resist layer 23 in the second etching step and the etching rate (Vo1) of the first to (n-1)th resist layer 22 affects processing accuracy in etching the first to (n-1) th resist layer 22 using the nth resist layer 23 as a mask, the range of 1<(Vol/Vm1)≤150 is preferable. From the viewpoint of making the nth resist layer 23 easier to etch than the first to (n-1) th resist layer 22, the ratio (Vol/Vm1) is preferably 1< (Vol/Vm1), and from the viewpoint of transfer accuracy of the concavo-convex structure of the nth resist layer 23, is preferably (Vol/Vm1)≤150. From the viewpoint of etching resistance, the ratio (Vol/Vm1) is preferably 3≤(Vol/Vm1), more preferably 10≤(Vol/Vm1), and further preferably 15≤ (Vol/Vm1). Further, the ratio (Vol/Vm1) is more preferably (Vol/Vm1)≤100.

In addition, the above-mentioned selection ratio (Vol/Vm1) is applied to each layer of the first to (n-1) th resist layer 22.

By the ratio (Vol/Vm1) meeting the above-mentioned ranges, it is possible to easily process the first to (n-1) th resist layer 22 meeting above-mentioned equation (11) by dry etching using the nth resist layer 23 as a mask. By this means, it is possible to form the fine mask pattern 25 made of the nth resist layer 23 and the first to (n-1)th resist layer 22 on the inorganic substrate 21 by dry etching. By using such a fine mask pattern 25, it is possible to perform dry etching on the inorganic substrate 21 with ease.

The ratio ($Vo\perp/Vo_{//}$) between the etching rate ($Vo_{//}$) in the cross direction and the etching rate ($Vo\perp$) in the longitudinal direction that is etching anisotropy in etching the first to (n-1) th resist layer 22 in the second etching step preferably meets (Vo ⊥/Vo//) >1. In this case, the larger ratio (Vo ⊥/Vo//) is more preferable. While being dependent on the ratio between the etching rate of the first to (n-1) th resist layer 22 and the etching rate of the inorganic substrate 21, it is preferable to meet (Vo⊥/Vo//) >2, it is more preferable to meet (Vo ⊥/Vo//)>3.5, and it is further preferable to meet (Vo ⊥/Vo//)>10.

In addition, the longitudinal direction means the film thickness direction of the first to (n-1)th resist layer 22, and the cross direction means the surface direction of the first to (n-1) th resist layer 22. In the region where the pitch of the mask is sub-micro or less, as distinct from the micro-scale, etching efficiency by dry etching degrades. This is because the loading effect and shadowing effect appear corresponding to a narrow gap between masks. In other words, in the case of forming the nano-structure by dry etching, the etching rate is apparently decreases. From such a viewpoint, in dry etching processing on the inorganic substrate 21 using the fine mask pattern 25 as a mask, it is necessary to form the high first to (n-1) th resist layer 22 with stability and keep the width of the first to (n-1)th resist layer 22 large. By meeting the above-mentioned ranges, it is possible to keep the width (width of the backbone) of the first to (n-1)th resist

layer 22 large, and therefore, such ranges are preferable.

As the ratio (Vo2/Vi2) between the etching rate (Vi2) of the inorganic substrate 21 and the etching rate (Vo2) of the first to (n-1) th resist layer 22 in the third etching step, the smaller ratio is preferable. By meeting (Vo2/Vi2)<1, since the etching rate of the first to (n-1) th resist layer 22 is smaller than the etching rate (Vi2) of the inorganic substrate 21, it is possible to easily process the inorganic substrate 21. From the viewpoint of coating properties and etching accuracy of the first to (n-1) th resist layer 22, it is preferable to meet (Vo2/Vi2)≤3, and it is more preferable to meet (Vo2/Vi2)≤2.5. Further, from the viewpoint of thinning the first to (n-1) th resist layer 22, it is preferable to meet (Vo2/Vi2)≤2, and it is more preferable to meet (Vo2/Vi2)≤1.

In addition, in the above-mentioned selection ratio (Vo2/Vi2), at least the first resist layer meets the above-mentioned range. By the first resist layer meeting the selection ratio (Vo2/Vi2), it is possible to improve processability of the inorganic substrate 21. Particularly, by each of the first to (n-1) th resist layer 22 meeting the above-mentioned selection ratio (Vo2/Vi2), it is possible to more improve processability of the inorganic substrate 21.

It is possible to easily actualize the first to (n-1)th resist layer 22 having high dry etching resistance to the inorganic substrate 21 so as to meet (Vo2/Vi2) <1, by utilizing a difference in the reaction mechanism of dry etching. For example, it is possible to easily process a sapphire substrate that is a processing hard substrate by dry etching using a gas containing a chlorine-based gas (for example, $BCl_3$ gas). On the other hand, an organic substance having n electros, particularly the skeleton of a benzene ring traps chlorine, and the rate of dry etching using the gas containing the chlorine-based gas decreases. In other words, it is possible to easily actualize (Vo2/Vi2)<1.

In addition, the above-mentioned etching rate is defined as an etching rate of dry etching on the surface of the flat material without the concavo-convex structure being formed. Further, the ratio (VA/VB) of the etching rate of the material A to the etching rate of the material B is defined as a ratio of the rate (VA) obtained from the etching conditions on the flat film of the material A to the rate (VB) obtained on the flat film of the material B on the same conditions.

<Inorganic substrate 21>

The materials of the inorganic substrate 21 are capable of being selected as appropriate correspond to a use, and therefore, are not limited particularly. As the materials of the inorganic substrate 21, examples thereof are transparent conductive substrates typified by sapphire, silicon and tin-doped indium oxide (ITO), semiconductor substrates such as ZnO, SiC, Cu-W, and nitride semiconductor typified by gallium nitride and the like, quarts and the like. As the semiconductor substrates, for example, it is also possible to use a substrate formed of GaAsP, GaP, AlGaAs, InGaN, GaN, AlGaN, ZnSe, AlHaInP, ZnO, or SiC. As the inorganic substrate 21 using quartz, examples thereof are a glass plate and glass film.

As the inorganic substrate 21, for example, in the case of a use for meeting concurrently improvements in internal quantum efficiency and light extraction efficiency of an LED, it is preferable to use a sapphire substrate, and in the case of a use for improving light extraction efficiency, it is preferable to use a GaN substrate or SiC substrate. In these cases, processing is performed, from the side on which the concavo-convex structure 23a is formed, on the layered product of nth resist layer 23 with the concavo-convex structure 23a provided on the surface/the first to (n-1) resist layer 22/sapphire substrate, GaN substrate or SiC substrate as the inorganic substrate 21. Further, in order to improve light extraction efficiency of an LED, it is possible to regard the transparent conductive layer surface of the LED as the inorganic substrate 21. Furthermore, as the inorganic substrate 21, for example, for a use to prepare non-reflection surface glass, it is preferable to use a glass plate and glass film, and for a solar battery use, from the viewpoints of improving light absorption efficiency, transform efficiency and the like, it is preferable to use a silicon substrate. In this case, in the case of making the inorganic substrate 21 a complete black body, carbon black may be blended in the inorganic substrate 21 to use, or the surface of the inorganic substrate 21 may be coated with carbon black.

Further, a hard mask layer may be provided between the inorganic substrate 21 and the first to (n-1) th resist layer 22. In this case, since the first to (n-1) th resist layer 22 is layered on one surface of the hard mask layer, the fine mask pattern 25 comprised of the nth resist layer 23 and the first to (n-1) th resist layer 22 after the second etching step is formed on the hard mask layer with a high aspect ratio. By using the fine mask pattern 25 with a high aspect ratio as a mask, it is possible to easily etch the hard mask layer. Then, by etching the inorganic substrate 21 using the processed hard mask layer as a mask, it is possible to increase a condition margin of the third etching step. For example, it is possible to cause the processing at high temperatures in dry etching and wet etching to act suitably, and it is possible to widen options for processing of the inorganic substrate 21.

Materials of the hard mask layer are not limited particularly, as long as the materials enable the inorganic substrate 21 to undergo etching processing. As the materials of the hard mask layer, for example, it is possible to use Si, Ti, Zn, Zr, Mo, W, Cu, Fe, Al, In, Sn, Hf, Rf, Sr, Rb, Cs, V, Ta, Mn, Ru, Os, Co, Ni, Pd, Pt, Ag, Au, Ir, Ga, Ge, Pb, As, Sb, Se, Te, oxides thereof, spin-on glass (SOG) and spin-on carbon (SOC). Further, from the viewpoint of processability in etching, the thickness of the hard mask layer preferably ranges from 5 nm to 500 nm, more preferably ranges from 5 nm to 300 nm, and further preferably ranges from 5 nm to 150 nm.

In addition, the hard mask layer may be a multilayer structure. Herein, the multilayer means lamination of the hard mask layer in the film thickness direction. For example, a first hard mask layer (1) may be provided on the main surface of the inorganic substrate 21, and a second hard mask layer (2) may be provided on the first hard mask layer (1). Similarly, an N+1th hard mask layer (N+1) may be provided on an Nth hard mask (N). From the viewpoint of processability of the hard mask layer and processing accuracy of the inorganic substrate 21, the layered number of hard mask layers is preferably 10 or less, more preferably 5 or less, and further preferably 3 or less.

The thickness of each layer in the case where the hard mask layer is the multilayer structure preferably ranges from 5 nm to 150 nm. Further, with the case of the single layer included, the total film thickness of all hard mask layers is preferably 500 nm or less, more preferably 300 nm or less, and further preferably 150 nm or less.

As a configuration of two-layer hard mask layer, for example, there is a configuration in which a film of $SiO_2$ is formed on the main surface of the inorganic substrate 21, and a film of Cr is formed on the $SiO_2$. Further, as a configuration of three-layer hard mask layer, examples thereof are a configuration in which a film of $SiO_2$ is formed on the main surface of the inorganic substrate 21, a film of Cr is formed on the $SiO_2$, and a film of $SiO_2$ is formed on Cr, a configuration in which a film of $SiO_2$ is formed on the main surface of the inorganic substrate 21, a film of SOG is formed on the $SiO_2$, and a film of SOC is formed on the SOG, and a conf iguration in which a film of $SiO_2$ is formed on the main surface of the inorganic substrate 21, a film of SOC is formed on the $SiO_2$, and a film of SOG is formed on the SOC.

From the viewpoints of processability, the ratio (etching rate of the inorganic substrate 21/etching rate of the hard mask layer) of the etching rate of the inorganic substrate 21 to the etching rate of the hard mask layer is preferably 1 or more, and more preferably 3 or more. From the viewpoint of processing the inorganic substrate 21 with a high aspect ratio, the above-mentioned ratio is preferably 5 or more, and more preferably 10 or more. From the viewpoint of thinning the hard mask layer, the selection ratio is further preferably 15 or more.

A semiconductor light emitting device provided with the concavo-convex structure product 31 according to the above-mentioned Embodiment will be described next with reference to FIG. 42. FIG. 42 is a cross-sectional schematic diagram of a semiconductor light emitting device according to this Embodiment. Described herein is an LED device as a semiconductor light emitting device. In the LED device 40, a sapphire substrate is used as the inorganic substrate 21 of the concavo-convex structure product 31. As the sapphire substrate, for example, it is possible to use a 2-inch Φ sapphire substrate, 4-inch Φ sapphire substrate, 6-inch Φ sapphire substrate, 8-inch Φ sapphire substrate and the like.

As shown in FIG. 42, the LED device 40 is comprised of an n-type semiconductor layer 42, light emitting semiconductor layer 43, p-type semiconductor layer 44, anode electrode 45 formed on the p-type semiconductor layer 44, and cathode electrode 46 formed on the n-type semiconductor layer 42 that are successively layered on the concavo-convex structure 31a of the concavo-convex structure 31 manufactured using the sapphire substrate as the inorganic substrate 21. The LED device 40 has a double-hetero structure, but the layered structure of the light emitting semiconductor layer 43 is not limited particularly. Further, it is also possible to provide a buffer layer, not shown, between the concavo-convex structure product 31 and the n-type semiconductor layer 42.

The concavo-convex structure product 31 used in the LED device 40 is manufactured using the resist layered product 30 according to the above-mentioned Embodiment, as details are described with reference to FIGs. 3A to 3E. First, the etching (oxygen ashing) processing using $O_2$ gas is performed from the concavo-convex structure 23a surface side to remove the residual film RF (first etching step). Next, the conditions of the first etching step are continuously applied to partially remove the first to (n-1)th resist layer 22, and the surface of the sapphire substrate as the inorganic substrate 21 is partially exposed (second etching step). Next, using the fine mask pattern 25 comprised of the nth resist layer 23 and the first to (n-1) resist layer 22 formed on the sapphire substrate as a mask, for example, by reactive ion etching using $BCl_3$ gas, the concavo-convex structure 31a is formed on the sapphire substrate surface to manufacture the concave-convex structure product 31 (third etching step). Finally, the surface of the obtained concavo-convex structure product 31 is washed and cleaned, for example, using a mixed solution of sulfuric acid and hydrogen peroxide solution.

By thus manufacturing the LED device 40 using the concavo-convex structure product 31 according to the above-mentioned Embodiment, it is possible to actualize improvements in external quantum efficiency based on the concavo-convex structure 31a, and efficiency of the LED element 40 is thereby improved. The efficiency (external quantum efficiency) of the LED device is determined by current injection efficiency, light extraction efficiency, and internal quantum efficiency, and particularly, it is important to improve light extraction efficiency and internal quantum efficiency to manufacture the LED device with high efficiency. By using the concavo-convex structure product 31 where the concavo-convex structure is provided on the inorganic substrate 21 to manufacture the LED device, it is possible to control light extraction efficiency and internal quantum efficiency. In the case of shortening the time required to manufacture the concavo-convex structure product 31 of nano-structure, decreasing a use amount of the semiconductor crystal layer and improving light extraction efficiency, as the shape of the concavo-convex structure of the concavo-convex structure product 31, it is preferable that the pitch ranges from 400 nm to 1250 nm, and that the height ranges from 0.5 time to 1.5 time the pitch. Particularly, when the pitch ranges from 450 nm to 950 nm, and the height ranges from 0.5 time to 1.2 time the pitch, it is possible to more exert the above-mentioned effects. From the viewpoint of actualizing improvements in light extraction efficiency by light diffraction, as the arrangement, it is possible to adopt a hexagonal arrangement and

tetragonal arrangement. Herein, by adopting a quasi-hexagonal arrangement or quasi-tetragonal arrangement provided with disorder, arrangement changing from the hexagonal arrangement to tetragonal arrangement, and like, it is possible to obtain both effects of light diffraction properties and light scattering properties, and it is possible to more improve light extraction efficiency. On the other hand, in the case of improving both internal quantum efficiency and light extraction efficiency at the same time, it is preferable that the pitch ranges from 200 nm to 350 nm, and that the height ranges from 0.5 time to 1.5 time the pitch. In this case, since the density of concavo-convex structure is improved, dislocations occurring in the semiconductor crystal layer are dispersed, it is possible to decrease local and macroscopic dislocation densities, and internal quantum efficiency is thereby improved. However, in the case of high-density concavo-convex structure, the degree of improvements of light extraction efficiency is sometimes decreased, and in this case, by providing the arrangement with disorder, it is possible to improve light extraction efficiency. The disorder of the arrangement is achieved by quasi-hexagonal arrangement, quasi-tetragonal arrangement and arrangement changing from the hexagonal arrangement to tetragonal arrangement and the like. Moreover, it is possible to adopt an arrangement forming a hexagonal arrangement on a nano-scale with large periodicity on a micro-scale. For example, there is a quasi-hexagonal arrangement in which the pitch varies between 270 nm to 330 nm according to the sine curve, and the wavelength of the sine curve ranges from 1200 nm to 4200 nm.

Particularly, by using the mold 10 provided with the fine pattern 12 meeting the area e shown by oblique lines in FIG. 6, it is possible to make the moderate ratio between the size of the convex portion of the concavo-convex structure 31a of the concavo-convex structure product 31 and the flat surface of the concave-portion bottom portion. Therefore, in depositing the semiconductor crystal layer on the concavo-convex structure 31a, it is possible to disturb the growth mode of the semiconductor crystal layer, it is thereby possible to reduce the density of dislocations occurring inside the semiconductor crystal layer, and it is possible to improve internal quantum efficiency. In FIG. 6, as described previously, the curve a represents $(lcv/lcc)=\sqrt{(1.1/(Sh/Scm))}-1$. The curve b represents $(lcv/lcc)=\sqrt{(0.5/(Sh/Scm))}-1$. Further, the straight line c represents $(Sh/Scm)=0.23$, the straight line d represents $(Sh/Scm)=0.99$, the straight line f represents $(lcv/lcc)=1.0$, and the straight line g represents $(lcv/lcc)=0.01$.

Further, from the viewpoint of more improving light extraction efficiency while maintaining improvements in internal quantum efficiency of the LED, particularly, it is preferable that the fine pattern 12 meets the area e as shown in FIG. 10. In this case, it is possible to increase the size of the convex portion of the concavo-convex structure product 31, it is thereby possible to increase the number of modes of light diffraction of the emitted light of the LED, and light extraction efficiency is improved. In FIG. 10, as described already, the area e is the area concurrently meeting $(lcv/lcc) \geq\sqrt{(0.76/(Sh/Scm))}-1$ (curve b4 or more in FIG. 10), $(lcv/lcc)\leq\sqrt{(0.93/(Sh/Scm))}-1$ (curve a4 or less in FIG. 10), $(lcv/lcc)\geq 0.01$ (straight line g or more in FIG. 10), $(lcv/lcc)\leq 0.50$ (straight line f or less in FIG. 10), $(Sh/Scm)\geq 0.40$ (straight line c2 or more in the horizontal-axis direction in FIG. 10), and $(Sh/Scm)\leq 0.95$ (straight line d or less in the horizontal-axis direction in FIG. 10).

From the viewpoint of more exerting the above-mentioned effects, it is preferable that the fine pattern 12 of the mold 10 meets the area e as shown in FIG. 11. In FIG. 11, as described already, the area e is the area concurrently meeting $(lcv/lcc)\geq\sqrt{(0.76/(Sh/Scm))}-1$ (curve b4 or more in FIG. 11), $(lcv/lcc)\leq\sqrt{(0.93/(Sh/Scm))}-1$ (curve a4 or less in FIG. 11), $(lcv/lcc) \geq 0.01$ (straight line g or more in FIG. 11), $(lcv/lcc) \leq 0.28$ (straight line f or less in FIG. 11), $(Sh/Scm) \geq 0.60$ (straight line c4 or more in the horizontal-axis direction in FIG. 11), and $(Sh/Scm)\leq 0.95$ (straight line d or less in the horizontal-axis direction in FIG. 11).

Further, from the viewpoint of more improving internal quantum efficiency and light extraction efficiency i.e. making the moderate ratio between the size of the convex portion of the concavo-convex structure 31a of the concavo-convex structure product 31 and the flat surface of the concave-portionbottom portion, it is preferable that the fine pattern 12 of the mold 10 meets the area e as shown in FIG. 13. In the graph in FIG. 13, the horizontal axis represents the ratio (Sh/Scm), and the vertical axis represents the ratio (lcv/lcc). The area e is the area concurrently meeting $(lcv/lcc)\geq\sqrt{(0.76/(Sh/Scm))}-1$ (curve b4 or more in FIG. 13), $(lcv/lcc)\leq\sqrt{(0.93/(Sh/Scm))}-1$ (curve a4 or less in FIG. 13), $(lcv/lcc) \geq 0.01$ (straight line g or more in FIG. 13), $(lcv/lcc)\leq 0.20$ (straight line f or less in FIG. 13), $(Sh/Scm) \geq 0.65$ (straight line c5 or more in the horizontal-axis direction in FIG. 13), and $(Sh/Scm)\leq 0.93$ (straight line d or less in the horizontal-axis direction in FIG. 13).

Further, in adjacent convex portions of the concavo-convex structure product 31 that is processed using the above-mentioned mold, the nearest distance in the convex-portion bottom preferably exceeds 0 nm. By meeting this range, since it is possible to excellently proceed core generation and growth of the semiconductor crystal layer, it is possible to improve internal quantum efficiency. From the same viewpoints, the distance is preferably 50 nm or more, more preferably 80 nm or more, and most preferably 100 nm or more. On the other hand, the upper limit value is preferably 300 nm or less. In this case, it is possible to more improve processing accuracy using the above-mentioned mold. Further, from the viewpoints of maintaining improvements in internal quantum efficiency and more improving light extractionefficiency, the value is more preferably 150 nm or less, and most preferably 100 nm or less.

Further, although not shown, it is also possible to process by regarding the surface on the side opposite to the light emitting semiconductor layer 43 of the concavo-convex structure product 31 as a main surface of the inorganic

substrate 21 according to the present invention. In this case, it is possible to extract emitted light reflected from the surface opposite to the light emitting semiconductor layer 43 of the inorganic substrate 21 of the LED device. In this case, as the concavo-convex structure to provide, it is preferable that the pitch ranges from 400 nm to 800 nm, and that the height ranges from 0.5 time to 1.5 time the pitch.

Furthermore, although not shown, it is possible to process by using the transparent conductive layer surface of the LED device as a main surface of the inorganic substrate. In this case, it is possible to extract emitted light reflected from the surface of the inorganic substrate 21 of the LED device. In this case, as the concavo-convex structure 23a to provide, it is preferable that the pitch ranges from 500 nm to 1500 nm, and that the height ranges from 0.5 time to 1.5 time the pitch.

[Examples]

The present invention will specifically be described below based on Examples performed to clarify the effects of the invention. In addition, materials, use compositors, processing steps and the like in the following Embodiment are illustrative, and are capable of being carried into practice with modifications thereof. Moreover, the invention is capable of being carried into practice with modifications thereof as appropriate without departing from the scope of the invention. Therefore, the present invention is not limited at all by the following Examples.

The following materials were used in the Examples.

- DACHP···Fluorine-containing additive (made by Daikin Industries, Ltd., OPTOOL DAC HP)
- M350···Trimethylolpropane (EO-modified) triacrylate (made by TOAGOSEI Co., Ltd., M350)
- M309···Trimethylolpropane triacrylate (made by TOAGOSEI Co., Ltd., M309)
- I.184···1-Hydroxy-cyclohexyl-phenyl-ketone (made by BASF Company, Irgacure (Registered Trademark) 184)
- I.369···2-Benzyl-2-dimethylamino-1-(4-morpholino phenyl)-butanone-1 (made by BASF Company Irgacure (Registered Trademark) 369)
- M211B···Bisphenol A EO-modified diacrylate (made by TOAGOSEI Co., Ltd. ARONIX M211B)
- PGME···Propylene glycol monomethyl ether
- MEK···Methyl ethyl ketone
- MIBK···Methyl isobutyl ketone
- TTB···Titanium (IV) tetrabutoxide monomer (made by Wako Pure Chemical Industries, Ltd.)
- DEDFS···Diethoxy diphenyl silane (made by Shin-Etsu silicone corporation, LS-5990)
- SH710···Phenyl-modified silicone (made by Dow Corning Toray Co., Ltd., SH710 Fluid)
- 3APTMS···3-Acryloxypropyl trimethoxysilane (made by Shin-Etsu silicone corporation, KBM-5103)
- PO-A···Phenoxyethyl acrylate (made by KYOEISHA CHEMICAL Co., Ltd., Light acrylate PO-A)

(Preparation of a mold)

(a) Preparation of a cylindrical master stamper (preparation of a mold for resin mold preparation)

Quartz glass was used as a substrate of a cylindrical master stamper, and a concave-convex structure was formed on the quartz glass surface by a direct-write lithography method using a semiconductor laser. First, an inorganic resist layer is deposited on the quartz glass surface by a sputtering method. The sputtering method was performed with power of RF 100W using CuO of 3-inch Φ (8 atm%Si contained) as a target (resist layer) to deposit an inorganic resist layer of 20 nm.

Next, while rotating the cylindrical quartz glass substrate, exposure was performed using a semiconductor laser with a wavelength of 405 nm. Subsequently, exposure was further performed on the once exposed inorganic resist layer using the semiconductor laser with a wavelength of 405 nm. Next, the exposed inorganic resist layer was developed. Development of the inorganic resist layer was performed for 240 seconds using 0.03 wt% glycine aqueous solution. Next, using the developed inorganic resist layer as a mask, etching was performed on the etching layer (quartz glass) by dry etching. Dry etching was performed using $SF_6$ as an etching gas on the conditions that the processing gas pressure was 1 Pa, processing power was 300 W, and that the processing time was 5 minutes. Next, only the inorganic resist layer residual was peeled off from the cylindrical quartz glass substrate provided with the concavo-convex structure on the surface, using hydrochloric acid of pH1. The peeling time was 6 minutes.

The fine pattern of the obtained cylindrical master stamper was coated with Durasurf HD-1101Z (made by Daikin Industries, Ltd.) that is a fluorine-based mold release agent, heated at 60°C for 1 hour, and then, allowed to stand at room temperature for 24 hours to fix. Then, cleaning was performed three times using Durasurf HD-ZV (made by Daikin Industries, Ltd.), and demolding treatment was performed.

In addition, the shape and arrangement of the fine pattern provided on the cylindrical master stamper surface

were controlled by output of the semiconductor laser, operation pattern and operation velocity.

Next, the fine pattern of resin was formed on a film from the cylindrical master stamper successively by the photo nanoimprint method.

(b) Preparation of a reel-shaped resin mold A

The following materials 1 were used as a transfer material used in photo nanoimprint.

- Materials 1··· DACHP: M350: I.184: I.369 = 17.5 g: 100 g: 5.5 g: 2.0 g were mixed.

The materials 1 were applied onto an easy adhesion surface of a PET film: A-4100 (made by Toyobo Co., Ltd.: width 300 mm, thickness 100 μm) by Micro Gravure coating (made by Yasui Seiki Co., Ltd.) so that the coating film thickness was 6 μm. Next, the PET film coated with the materials 1 was pressed against the cylindrical master stamper with a nip roll (0.1 MPa), and was irradiated with ultraviolet rays at a temperature of 25°C and moisture of 60% under atmospheric pressure using a UV exposure apparatus (made by Fusion UV Systems Japan Co., Ltd., H bulb) so that the integral amount of exposure below the center of the lamp was 1000 $mJ/cm^2$, photo-curing was performed successively, and obtained was a reel-shaped resin mold (A) (length 200 m, width 300 mm) with the fine pattern transferred to the surface.

Next, selecting the reel-shaped resin mold A as a template, a resin mold B was prepared by a UV continuous transfer method.

(C) Preparation of a mold B

In the step of preparing the resin mold B, the reel-shaped mold A was used to function as a template, and transfer was performed on the materials 1.

The materials 1 were applied onto the easy adhesion surface of the PET film: A-4100 (made by Toyobo Co., Ltd.: width 300 mm, thickness 100 μm) by Micro Gravure coating (made by Yasui Seiki Co., Ltd.) so that the coating film thickness was 6 μm. Next, the PET film coated with the materials 1 was pressed against the fine pattern surface of the resin mold A with the nip roll (0.1 MPa), and was irradiated with ultraviolet rays at a temperature of 25°C and moisture of 60% under atmospheric pressure using the UV exposure apparatus (made by Fusion UV Systems Japan Co., Ltd., H bulb) so that the integral amount of exposure below the center of the lamp was 1000 $mJ/cm^2$, photo-curing was performed successively, and obtained was a plurality of reel-shaped resin molds B (length 200 m, width 300 mm) with the fine pattern transferred to the surface provided with the same fine pattern as in the cylindrical master stamper.

(d) Preparation of a plate-shaped master stamper

Quartz glass was used as a substrate of a plate-shaped master stamper, and a fine pattern was formed on the quartz glass surface by the direct-write lithography method using a semiconductor laser. First, an inorganic resist layer is deposited on the quartz glass surface by a sputtering method. Next, while rotating the plate-shaped quartz glass, exposure was performed using the semiconductor laser with a wavelength of 405 nm. Subsequently, exposure was further performed on the once exposed inorganic resist layer using the semiconductor laser with a wavelength of 405 nm. Next, the exposed inorganic layer was developed. Development of the inorganic resist layer was performed for 240 seconds using 0.03 wt% glycine aqueous solution. Next, using the developed inorganic resist layer as a mask, etching was performed on the etching layer (quartz glass) by dry etching. Dry etching was performed using $SF_6$ as an etching gas on the conditions that the processing gas pressure was 1 Pa, processing power was 300 W, and that the processing time was 5 minutes. Next, only the inorganic resist layer residual was peeled off from the plate-shaped quartz glass provided with the fine pattern on the surface, using hydrochloric acid of pH1. The peeling time was 6 minutes.

On the fine pattern of the obtained plate-shaped master stamper, Cr was deposited in 10 nm by a sputtering method, and then, the resultant was coated with Durasurf HD-1101Z (made by Daikin Industries, Ltd.), heated at 60°C for 1 hour, and then, allowed to stand at room temperature for 24 hours to fix. Then, cleaning was performed three times using Durasurf HD-ZV (made by Daikin Industries, Ltd.), and demolding treatment was performed.

Further, polydimethyl polysiloxane (PDMS) was casted on the fine pattern surface of the plate-shaped master stamper, the resultant was subjected to heat treatment at 200°C, and then, PDMS was peeled off to prepare plate-shaped resin molds No. 1 to No. 8. The resin molds No. 1 to No. 8 prepared as described above are shown in following Table 1.

[Example 1]

<Preparation of layered product 20>

Next, prepared was the layered product 20 comprised of second resist layer 23/first resist layer 22/inorganic substrate 21, where the second resist layer 23 contained the metalloxane bonds. The following materials 2 to 7 described later were used for preparation of the layered product 20.

As the inorganic substrate 21, used was a C-surface sapphire substrate of 2-inchΦ. UV-$O_3$ treatment was performed on the sapphire substrate for 10 minutes. Next, a film of the materials 2 diluted with a mixed solvent of PGME and MEK was deposited on the sapphire substrate by a spin coat method, the resultant was allowed to stand at a temperature of 80°C and moisture of 50% for 5 minutes in a light shield environment, and the layered product comprised of the first resist layer 22/inorganic substrate 21 (sapphire substrate) was prepared.

Subsequently, a film of one of the materials 3 to 7 diluted with PGME was deposited on the first resist layer 22 by the spin coat method, and was allowed to stand in an atmosphere of temperature of 25°C and moisture of 50% for 3 minutes to prepare eight layered products 20 comprised of the second resist layer 23/first resist layer 22/inorganic substrate 21 (sapphire substrate).

In layered products 20 prepared using the materials 3 and 4, the second resist layer 23 contained the metalloxane bonds of Si-O-Si, and metal elements of Ti and Si. On the other hand, layered products 20 prepared using the materials 5 and 7 contained the metalloxane bonds of Si-O-Si and Si element.

<Preparation of resist layered product 30>

Next, using the resin molds No. 1 to NO. 8, eight prepared layered products 20 underwent the pressing step, energy ray irradiation step and mold release step to prepare eight kinds of resist layered products 30. In the pressing step and energy ray irradiation step, a nanoimprint apparatus (EUN-4200, made by Engineering System Co., Ltd.) was used.

(Pressing step)

In the pressing step, using a film laminating apparatus (TMS-S2, made by SUN-TEC CO., LTD.), the mold 10 and the layered product 20 were laminated with a laminating nip force of 90 N at a laminating velocity of 1.5 m/s.

In the case using resin molds No. 1 to No. 6, pressing was performed after preparing a mold layered product 24 of silicone rubber 1 (elastic material 28: t 10 mm, hardness 20)/two-side polished 4-inch Φ sapphire substrate/mold 10/second resist layer 23/first resist layer 22/inorganic substrate 21 (sapphire substrate)/silicone rubber 2 (t 20mm, hardness 20). Pressing was performed from above the silicone rubber 1 at 0.1 MPa for 5 minutes.

Further, in the case of using resin molds No. 7 and No. 8, the pressing step was performed without preparing the mold layered product 24. More specifically, the mold 10 surf ace side of a layered product comprised of pressing mechanism/silicone rubber (t 10 mm, hardness 20)/two-side polished 4-inch Φ sapphire/mold 10 was laminated and pressed to/against the surface side with the nth resist layer 23 formed of the layered product 20 comprised of second resist layer 23/first resist layer 22/inorganic substrate 21 (sapphire substrate)/silicone rubber (t 20mm, hardness 20) in a vacuum while maintaining a parallel state. Pressing was performed at 0.2 MPa for 5 minutes using the mold 10 heated to 105°C.

(Energy ray irradiation step)

Used as a light source was a UV-LED light source with a main wavelength of 365 nm. In the case of using resin molds No. 1 to No. 4, UV light was applied with the integral light amount of 2500 mJ/cm$^2$ while keeping the pressure of 0.1MPa for 10 minutes. Further, after the mold release step as described later, light rays were applied again with the integral light amount of 1500 mJ/cm$^2$ from a high-pressure mercury-vapor lamp from the surface side with the second resist layer 23 formed. In the case of using resin molds No. 5 and No. 6, UV light was applied while heating at 105°C for 1 minute.

(Mold release step)

The step was performed by peeling off the mold 10 from the second resist layer 23. The layered product 20 was heated at 105°C for 3 minutes. In the case of using resin molds No.7 and No. 8, the layered product 20 was heated at 105°C for 3 minutes afterpeeling.

<Preparation of concavo-convex structure product 31>

The concavo-convex structure product 31 was next prepared using the prepared resist layered product 30.

(First etching step and second etching step)

The first etching step and second etching step were performed by dry etching using oxygen gas (processing pressure: 1Pa, Power: 300W). Dry etching was performed from the surface side with the second resist layer 23 formed of the prepared resist layered product 30, and the residual film RF of the second resist layer 23 was removed to form the fine mask pattern 25. Next, the first resist layer 22 was removed via the fine mask pattern 25 to form the concavo-convex structure product 31.

(Third etching step)

The third etching step was performed by using a reactive ion etching apparatus (RIE-101iPH, made by SAMCO Inc.). Used as an etching gas was $BCl_3$ gas as a chlorine-based gas. On the conditions that ICP: 150 W, BIAS: 50 W, and pressure 0.2 Pa, the inorganic substrate 21 (sapphire substrate) was etched from the surface side with the nth resist layer 23 formed via the fine mask pattern 25, and the concavo-convex structure 31a was formed on the surface of the inorganic substrate 21 to form the concavo-convex structure product 31.

After the third etching step, using a solution obtained by mixing sulfuric acid and hydrogen peroxide solution in a weight ratio of 2:1, the surface of the prepared concavo-convex structure product 31 (sapphire substrate) was cleaned. The obtained concavo-convex structure product 31 provided with the concavo-convex structure 31a was observed with a scanning electron microscope image. By observation of the electron microscope photograph, it was confirmed that a plurality of convex portions corresponding to intervals (pitches) of the fine pattern 12 of the mold 10 was formed on the concavo-convex structure product 31. In the case of using resin mold No. 1, the bottom-portion diameter of the convex portion was about 100 nm, and the height was 130 nm. Further, the side surface of the convex portion was drawn in the curve of a convexity upward, and a flat portion (table top) was not seen on the top of convex-portion. The above-mentioned results are shown in following Table 2.

[Example 2]

[Preparation of layered product 20]

The layered product 20 was prepared as in Example 1 except that the first resist layer 22 was formed using the following materials 2, and that the second resist layer 23 was formed using the following materials 10. In Example 2, seven layered product 20 were prepared.

<Preparation of resist layered product 30>

Used as the mold 10 were resin molds No. 1 to No. 7 prepared in Example 1. Seven resist layered products 30 were prepared using prepared seven layered products 20.

(Pressing step)

The pressing step was performed using the same laminating apparatus as in Example 1. In the case of using resin molds No. 1 to No. 6, the pressing step was performed on the same conditions as in the case of resin molds No. 1 to No. 6 of Example 1 except that after laminating, pressing was performed from above the silicone rubber 1 at 0.05 MPa for 5 minutes. In the case of using resin mold No. 7, the pressing step was performed on the same conditions as in the case of resin molds No. 7 and No. 8 of Example 1 except the pressing conditions of 0.05 MPa for 5 minutes.

(Energy ray irradiation step)

UV light was applied with the integral light amount of 2500 $mJ/cm^2$ for 10 minutes while keeping the pressure of 0.05 MPa after pressing. Further, after the mold release step as described later, UV light was applied again with the integral light amount of 1500 $mJ/cm^2$ from the surface side with the second resist layer 23 formed.

(Mold release step)

The mold release step was performed as in Example 1.

<Preparation of resist layered product 30>

(First etching step to third etching step)

Next, as in Example 1, the first etching step to third etching step were performed. After etching, using a solution obtained by mixing sulfuric acid and hydrogen peroxide solution in a weight ratio of 2:1, the surface of the concavo-convex structure product 31 was cleaned.

The obtained concavo-convex structure product 31 was observed with a scanning electron microscope image. By observation of the electron microscope photograph, it was confirmed that a plurality of convex portions corresponding to intervals (pitches) of the fine pattern 12 of the mold 10 was formed on the surface of the convex-concave structure product 31. In the case of using resin mold No. 3, the bottom-portion diameter of the convex portion was about 250 nm, and the height was 280 nm. Further, the side surface of the convex portion was drawn in the curve of a convexity upward, and the side surface having two-stage inclination angles was formed from the top of convex-portion to the convex-portion bottom portion. A flat portion (table top) was not seen on the top of convex-portion. The above-mentioned results are shown in following Table 2.

[Example 3]

<Preparation of layered product 20>

Eight layered products 20 were prepared as in Example 2.

<Preparation of resist layered product 30>

Used as the mold 10 were resin molds No. 1 to No. 8 prepared in Example 1. Eight resist layered products 30 were prepared using prepared eight layered products 20.

(Pressing step)

In the case of using resin molds No. 1 to No. 6, and resin mold No. 8, the pressing step was performed as in the case of resin molds No. 1 to No. 6 of Example 1 except that the pressing pressure was 0.05 MPa. In the case of using resin mold No. 7, the pressing step was performed as in the case of resin molds No. 7 and No. 8 of Example 1 except that the pressing pressure was 0.05 MPa and the time was 5 minutes.

(Energy ray irradiation step)

UV light was applied with the integral light amount of 2500 mJ/cm$^2$ for 10 minutes while keeping the pressure of 0.05 MPa and a vacuum state. Further, after the mold release step as described later, UV light was applied again with the integral light amount of 1500 mJ/cm$^2$ from the surface side with the second resist layer 23 formed.

The mold release step was performed as in Example 1. The above-mentioned results were shown in following Table 2.

<Preparation of concavo-convex structure product 31>

Next, the concavo-convex structure product 31 was performed using the obtained resist layered product 30.

(First etching step to third etching step)

The first etching step to third etching step were performed on the same conditions as in the third etching step of Example 1. Subsequently, as in Example 1, the concavo-convex structure product 31 was cleaned, and the obtained concavo-convex structure product 31 provided with the concavo-convex structure 31a was examined with a scanning electron microscope image. As a result, it was conf irmed that a plurality of convex portions corresponding to intervals (pitches) of the fine pattern 12 of the mold 10 was formed on the surface of the concavo-convex structure product 31. In the case of using resin mold No. 5, the bottom-portion diameter of the convex portion was about 400 nm, and the height was 500 nm. Further, the side surface of the convex portion was drawn in the curve of a convexity upward, and

on the convex-portion side surface, line-shaped roughness was formed in the direction from the top of convex-portion to the convex-portion bottom portion. Further, a flat portion (table top) was not seen on the top of convex-portion.

[Comparative Example 1]

As in Example 1, three kinds of resin molds No. 9 to No. 11 and three layered products 20 were prepared, and resist layered products 30 and concavo-convex structure products 31 were prepared using prepared the mold 10 and layered products 20. Preparation conditions and results are shown in Tables 3 and 4. In addition, abbreviations in Table 3 are the same as in Tables 1 and 2.

[Comparative Example 2]

Resin mold 12 and layeredproduct 20 where metalloxane bonds were omitted from the material forming the resist layer 23. Using the following materials 8 and 9, the nth resist layers 23 were formed, and two layered products 20 were prepared. The preparation conditions and results are shown in following Tables 3 and 4.

[Comparative Example 3]

Preparation of resist layered products 30 and preparation of concavo-convex structure products were performed as in Example 2, except that resin molds No. 9 to No. 11 were used. As a result, resist layered products 30 prepared using resin molds No. 9 and No. 11 included many defects, and therefore, the concavo-convex structure product 31 was not prepared.

[Comparative Example 4]

Resist layered products 30 were prepared as in Example 2 except that resin molds Nos. 1, 3, 5 and 7 were used and that the energy ray irradiation step was omitted. The results were all the same. In peeling off the mold 10, the nth resist layer 23 was attached to both the surface side of the fine pattern 12 of the mold 10 and the surface side of the first to (n-1)th resist layer 22, and it was not possible to transfer the concavo-convex structure 23a.

[Comparative Example 5]

Resist layered products 30 were prepared as in Example 3 except that resin molds No. 9 to No. 11 were used and that the pressing step was performed under general atmospheric pressure containing oxygen. The preparation conditions and results are shown in following Tables 3 and 4.

[Comparative Example 6]

Resist layered products 30 were prepared as in Example 3 except that resin molds Nos. 1, 3, 5 and 7 were used and that the energy ray irradiation step was omitted. The results were all the same. In peeling off the mold 10, the second resist layer 22 was attached to both the surface side of the fine pattern 12 of the mold and the surface side of the first resist layer 22, and it was not possible to transfer the concavo-convex structure.

In addition, terms and materials 2 to 10 described in following Tables 1 to 4 are shown below.

- No. ··· The management number of the mold
- Pave···means a pitch of the fine pattern, and the dimension was nanometer.
- H···means a height (depth) of the fine pattern, and the dimension was nanometer.
- (lcv/lcc)···means the ratio of the distance (lcv) of the top of convex-portion to the opening width of concave-portion (lcc) of the fine pattern.
- (Sh/Scm)···Dimensionless value that means the ratio of voids in a plan view of the fine pattern
- Aspect ratio···The ratio of depth/opening width in the fine pattern of a dimensionless value
- (Vr2/Vcm)···means the ratio of the volume (Vr2) of the nth resist layer 23 to the volume (Vcm) of the concave portion of the concavo-convex structure 23a.
- (lr1/Pave)···means the ratio of the film thickness (lrl) of the first to (n-1)th resist layer 22 to the average pitch (Pave) of the concavo-convex structure 23a.
- Film thickness of the residual film···means the thickness of the residual film RF of the nth resist layer 23. The dimension is nanometer.
- Etching···Evaluation (○) represents the case where it was possible to etch the first to (n-1)th resist layer 22 up to

the interface with the sapphire substrate, and a reduction in the height of the etched first to (n-1) th resist layer 22 was within 5% of the deposited film thickness, and evaluation (X) represents the case of the reduction of 5 % or more.

- Materials 2···Materials obtained by mixing benzyl-based acrylic monomer: M211B: PO-A: M350: I.184: I.369=150g: 40g: 40g: 20g: 11g: 4g.

Used as the benzyl-based acrylic monomer was a methyl ethyl ketone solution of two-dimension copolymers of 80 mass% of benzyl methacrylate and 20 mass% of methacrylic acid (solid 50%, weight average molecular weight 56,000, acid equivalent 430, degree of dispersion 2.7). In addition, the above-mentioned mass is described as the solid mass.

- Materials 3··Materials obtained by adding 150 parts by weight of the above-mentioned benzyl-based acrylic polymer to 100 parts by weight of a mixture obtained by mixing TTB: DEDFS: SF710=170 g: 50 g: 40 g, and causing partial condensation in an atmosphere of 80°C. Condensation was carried out until the viscosity at 25°C was 550 cP. The materials 3 were materials where metalloxane bonds of Ti-O-Ti and Si-O-Si were introduced to the second resist layer.
- Materials 4···A mixture of TTB: 3APTMS=65 g: 35 g was subjected topartial condensation (preparationof prepolymer) inanatmosphere of 80°C. Partial condensation was carried out until the viscosity at 25°C was 360 cP. Materials obtained by adding 2.0 g of I.184 and 0.8 g of I.369 to 100 parts by weight of the partially condensed materials. In the case of using the materials 4, metalloxane bonds of Ti-O-Ti and Si-O-Si were introduced to the nth resist layer 23.
- Materials 5···Materials obtained by adding 2.2 g of I.184 and 0.8 g of I.369 to 100 parts by weight of materials obtained by mixing hydrogen silsesquioxane (HSQ/made by Dow Corning Corporation, FOX) : 3APTMS=60g: 40g and partially condensing in an environment of 80°C. In the case of using the materials 5, metalloxane bonds of Si-O-Si were introduced to the nth resist layer 23.
- Materials 6··Materials obtained by mixing TTB: DEDFS: TEOS (tetraethoxy silane) =170 g: 50 g: 40 g, and partially condensing (preparation of prepolymer) in an atmosphere of 80°C.
- Materials 7··· Hydrogen silsesquioxane (HSQ/made by Dow Corning Corporation, FOX). In the case of using the materials 7, metalloxane bonds of Si-O-Si were introduced to the nth resist layer 23.
- Materials 8···Materials obtained by mixing M211B: PO-A: M350: I.184: I.369=40g: 40g: 20g: 11g: 4g.
- Materials 9···Materials obtained by mixing DACHP: M350: I.184: I.369=17.5g: 100g: 5.5 g: 2.0g
- Materials 10···Materials obtained by mixing TTB: DEDFS: SH710: 3APTMS: M211B: PO-A: M350: I.184: I.369=170 g: 50 g: 40 g: 60 g: 40g: 40g: 20g: 11g: 4g.

[Table 1]

| No. | Pave | H | Icv/Icc | Sh/Scm | Aspect ratio | Mold substrate | Fine pattern | Mold release layer |
|---|---|---|---|---|---|---|---|---|
| 1 | 200 | 200 | 0.11 | 0.73 | 1.1 | PET | Materials 1 | - |
| 2 | 200 | 150 | 0.38 | 0.48 | 1.0 | PET | Materials 1 | - |
| 3 | 460 | 460 | 0.07 | 0.79 | 1.1 | PET | Materials 1 | - |
| 4 | 460 | 350 | 0.39 | 0.47 | 1.1 | PET | Materials 1 | - |
| 5 | 700 | 700 | 0.03 | 0.86 | 1.0 | PET | Materials 1 | - |
| 6 | 700 | 550 | 0.40 | 0.46 | 1.1 | PET | Materials 1 | - |
| 7 | 460 | 460 | 0.07 | 0.79 | 1.1 | $SiO_2$ | $SiO_2$ | Cr/Fluorine-containing mold release agent |
| 8 | 460 | 460 | 0.07 | 0.79 | 1.1 | PDMS | PDMS | - |

[Table 2]

| | No. | Vr2/Vcm | Ir1/Pave | First resist layer | Second resist layer | Film thickness of residual film (RF) | Etching |
|---|---|---|---|---|---|---|---|
| Example 1 | 1 | 1.11 | 1.90 | Materials 2 | Materials 4 | 10 | ○ |
| | 2 | 1.40 | 3.40 | Materials 2 | Materials 4 | 25 | ○ |
| | 3 | 1.03 | 1.48 | Materials 2 | Materials 5 | 10 | ○ |
| | 4 | 1.15 | 0.83 | Materials 2 | Materials 5 | 20 | ○ |
| | 5 | 0.42 | 0.97 | Materials 3 | Materials 6 | 10 | ○ |
| | 6 | 1.08 | 0.54 | Materials 3 | Materials 6 | 16 | ○ |
| | 7 | 1.06 | 0.83 | Materials 3 | Materials 7 | 20 | ○ |
| | 8 | 0.69 | 0.97 | Materials 3 | Materials 7 | 10 | ○ |
| Example 2 | 1 | 1.11 | 1.90 | Materials 2 | Materials 10 | 10 | ○ |
| | 2 | 1.40 | 3.40 | Materials 2 | Materials 10 | 25 | ○ |
| | 3 | 1.03 | 1.48 | Materials 2 | Materials 10 | 10 | ○ |
| | 4 | 1.15 | 0.83 | Materials 2 | Materials 10 | 20 | ○ |
| | 5 | 1.02 | 0.97 | Materials 2 | Materials 10 | 10 | ○ |
| | 6 | 1.08 | 0.54 | Materials 2 | Materials 10 | 16 | ○ |
| | 7 | 1.06 | 0.83 | Materials 2 | Materials 10 | 20 | ○ |

(continued)

| | No. | Vr2/Vcm | Ir1/Pave | First resist layer | Second resist layer | Film thickness of residual film (RF) | Etching |
|---|---|---|---|---|---|---|---|
| Example 3 | 1 | 0.85 | 1.90 | Materials 2 | Materials 10 | <10 | ○ |
| | 2 | 0.87 | 3.40 | Materials 2 | Materials 10 | <10 | ○ |
| | 3 | 0.69 | 1.48 | Materials 2 | Materials 10 | <10 | ○ |
| | 4 | 0.61 | 0.83 | Materials 2 | Materials 10 | <10 | ○ |
| | 5 | 0.42 | 0.97 | Materials 2 | Materials 10 | <10 | ○ |
| | 6 | 0.39 | 0.54 | Materials 2 | Materials 10 | <10 | ○ |
| | 7 | 0.69 | 0.83 | Materials 2 | Materials 10 | <10 | ○ |
| | 8 | 0.91 | 0.97 | Materials 2 | Materials 10 | <10 | ○ |

[Table 3]

| No. | Pave | H | Icv/Icc | Sh/Scm | Aspect ratio | Mold substrate | Fine pattern |
|---|---|---|---|---|---|---|---|
| 9 | 460 | 150 | 2.07 | 0.10 | 1.0 | PET | Materials 1 |
| 10 | 460 | 460 | 0.07 | 0.79 | 1.1 | PET | Materials 1 |
| 11 | 460 | 150 | 2.07 | 0.10 | 1.0 | PET | Materials 1 |
| 12 | 200 | 200 | 0.11 | 0.73 | 1.1 | PET | Materials 1 |

[Table 4]

| | No. | Vr2/Vcm | Ir1/Pave | First resist layer | Second resist layer | Etching |
|---|---|---|---|---|---|---|
| Comparative Example 1 | 9 | 1.3 | 1.48 | Materials 2 | Materials 4 | - |
| | 10 | 1.7 | 1.48 | Materials 2 | Materials 4 | × |
| | 11 | 1.7 | 1.48 | Materials 2 | Materials 4 | - |
| Comparative Example 2 | 12 | 1.11 | 1.90 | Materials 2 | Materials 8 | × |
| | 12 | 1.11 | 1.90 | Materials 2 | Materials 9 | × |
| Comparative Example 3 | 9 | 1.3 | 1.48 | Materials 2 | Materials 10 | - |
| | 10 | 1.7 | 1.48 | Materials 2 | Materials 10 | × |
| | 11 | 1.7 | 1.48 | Materials 2 | Materials 10 | - |
| Comparative Example 5 | 9 | 0.9 | 1.48 | Materials 2 | Materials 10 | - |
| | 10 | 0.7 | 1.48 | Materials 2 | Materials 10 | - |
| | 11 | 0.9 | 1.48 | Materials 2 | Materials 10 | - |

As can be seen from Table 2, in Examples 1 to 3 where (lcv/lcc) and (Vr2/Vcm) meet the predetermined ranges, it was possible to easily thin the residual film RF, and to easily form the fine mask pattern 25 on the sapphire substrate that is a processed object, and therefore, processing accuracy of the inorganic substrate was high. This is conceivable due to the following factors.

1. Since the contact angle of a water droplet with respect to the fine pattern surface 12 surface of the used mold all exceeds 90 degrees, and therefore, it was possible to reduce adhesionbetween the fine pattern 12 of the mold and the nth resist layer 23.
2. The relationship between the ratio (lcv/lcc) and the ratio (Sh/Scm), the ratio (lcv/lcc), the ratio (Sh/Scm) and height H meet the predetermined ranges, and therefore, the flow of the nth resist layer 23 to the fine pattern 12 of the mold 10 was promoted even in a state of above-mentioned 1.
3. The relationship between the ratio (lcv/lcc) and the ratio (Sh/Scm), the ratio (lcv/lcc), the ratio (Sh/Scm) and height H meet the predetermined ranges, and therefore, peeling energy applied to the convex-portion outer edge portion of the nth resist layer 23 was reduced in peeling off the mold 10.

Moreover, in Example 1, further, 4. it is conceivable that since the nth resist layer 23 contained metalloxane bonds, the side wall protection effect was exerted in etching the first to (n-1)th resist layer 22 using the nth resist layer 23 as a mask, and that the above-mentioned effects were more improved. Actually, the side wall protection effect as described in above-mentioned 4. was confirmed by mapping Ti contained in the materials 4 and 6, using the transmission electron microscope and energy dispersive X-ray spectroscopy.

Further, as can be seen from Table 4 , in Comparative Examples 1 and 3, in the case of using resin molds No. 9 and No. 11, concurrently with peeling of the mold 10, breakage of the concavo-convex structure 23a, peeling from the interface between the nth resist layer 23 and the first to (n-1)th resist layer 22 and the like occurred frequently. Therefore, subsequent processing of the inorganic substrate was not performed, and the evaluation is described as "-". This is because the relationship between the ratio (lcv/lcc) and the ratio (Sh/Scm), and the ranges of the ratio (lcv/lcc) and the ratio (Sh/Scm) are not suitable, and therefore, the causes are considered the fact that flowability of the nth resist layer 23 to the fine pattern 12 of the mold 10 was inhibited, cure of the materials 4 was not sufficient, peeling energy applied to the convex-portion lower-portion edge portion of the nth resist layer 23 was large, and that mold release failure occurred. Further, from the results of the case of using resin mold No. 10 of Comparative Examples 1 and 3, it is understood that there is a suitable range in the relationship between the volume of the fine pattern 12 of the mold 10 and the volume of the nth resist layer 23.

Furthermore, in Comparative Example 2, since predetermined metalloxane bonds were not contained, the height of the processed first to (n-1) th resist layer 22 was significantly decreased. The reason is conceivable that in processing the first to (n-1) th resist layer 22 using the nth resist layer 23 as a mask, 1. the side wall protection effect is not obtained sufficiently, and that 2. the selection ratio between the nth resist layer 23 and the first to (n-1)th resist layer 22 is insufficient. Therefore, when processing of the sapphire substrate was tried as in Example 1, the concavo-convex structure was hardly formed on the sapphire substrate.

Still furthermore, in Comparative Example 5, the pressing step was performed under general atmospheric pressure containing oxygen without using a vacuum environment. As a result, it is understood that when the second resist layer contains a photocurable substance in $(Vr2/Vcm) \leq 1$, unless an atmosphere of low oxygen such as a vacuum environment is used in pressing, it is not possible to achieve a thin residual film. As compared with the result of Example 3 in which pressing was performed in an atmosphere of low oxygen, it is understood that atmosphere of low oxygen is required in pressing in the case where the second resist layer contains a photocurable substance.

[Example 4]

<Preparation of layered product 20>

Prepared was the layered product 20 comprised of first resist layer 23 made of the above-mentioned materials 3/inorganic resist layer 21. In addition, the layered product 20 was a single-layer resist.

As the inorganic substrate 21, used was a C-surface sapphire substrate of 2-ince Φ. First, the sapphire substrate was treated with UV-O3 for 10 minutes. Next, particles were removed by air blow. Subsequently, a film of the above-mentioned materials 3 was deposited by the spin coat method at a maximum rotation speed of 3000 rpm. In this case, the above-mentioned materials 3 were diluted with a mixed solvent of PGME and MEK and used. In addition, the film thickness was adjusted so that Vr2/Vcm was 1.15.

The metalloxane bonds of Si-O-Si were confirmed in the first resist layer 23 made of the materials 3.

<Preparation of resist layered product 30>

Next, using a resin mold made of PDMS, the layered product 20 underwent the pressing step, energy ray irradiation step and mold release step to prepare the single-layer resist layered product 30. In the pressing step and energy ray irradiation step, the nanoimprint apparatus (EUN-4200, made by Engineering System Co., Ltd.) was used.

(Pressing step)

First, the mold 10 made of PDMS was laminated on the materials 3 with a hand roller. Next, pressing was performed after preparing a mold layered product 24 of silicone rubber 1 (elastic material 28: t 10 mm, hardness 20)/two-side polished 2-inch Φ sapphire substrate/mold 10/first resist layer 23/inorganic substrate 21 (sapphire substrate)/silicone rubber 2 (t 20mm, hardness 20). Pressing was performed from above the silicone rubber 1 at 0.12 MPa for 5 minutes.

(Energy ray irradiation step)

Used as a light source was the UV-LED light source with a main wavelength of 365 nm. UV light was applied with the integral light amount of 2500 $mJ/cm^2$ for 10 minutes while keeping the pressure of 0.12 MPa.

(Mold release step)

The step was performed by peeling off the mold 10 from the first resist layer 23.

<Preparation of concavo-convex structure product 31>

The concavo-convex structure product 31 was next prepared using the prepared resist layered product 30.

(First etching step)

The first etching step was performed by dry etching using oxygen gas (processing pressure: 1Pa, Power: 300W). Dry etching was performed from the surface side with the first resist layer 23 formed of the prepared resist layered product 30, and the residual film RF of the first resist layer 23 was removed to form the fine mask pattern 25.

(Third etching step)

The third etching step was performed by using the reactive ion etching apparatus (RIE-101iPH, made by SAMCO Inc.). Used as an etching gas was a mixed gas of $BCl_3$ gas as a chlorine-based gas and Ar gas. On the conditions that ICP: 150 W, BIAS: 50 W, and pressure 0.2 Pa, the inorganic substrate 21 (sapphire substrate) was etched via the fine mask pattern 25, and the concavo-convex structure 31a was formed on the surface of the inorganic substrate 21 to prepare the concavo-convex structure product 31.

After the third etching step, using a solution obtained by mixing sulfuric acid and hydrogen peroxide solution in a weight ratio of 2:1, the surface of the prepared concavo-convex structure product 31 (sapphire substrate) was cleaned.

By the above-mentioned operation, evaluations were made to the residual film thickness and uniformity of the resist layered product 30, convex-portion shape of the first resist layer 23 left after the first etching step, shape accuracy of the concavo-convex structure 31a obtained after the third etching step by using a scanning electron microscope. Evaluation indicators are as described below.

The resist layered product 30 was cut, and scanning electron microscope observation was performed on the cross section. Five observation sample pieces were prepared, and ten points were observed in each sample. A good evaluation represents the case that the maximum value of the residual film thickness was 50 nm or less, accuracy was average residual film thickness ± 10% or less, and that the breakage rate of the convex portion was 5% or less. A poor evaluation represents the case that the maximum value of the residual film thickness exceeded 50 nm or the case that accuracy was average residual film thickness ± more than 10%. Further, in the mold release step, a poor evaluation was also made in the case where the area of an existing portion of the residual film peeled off from the inorganic substrate exceeded 3% relative to the inorganic substrate.

A change in the shape of the convex portion before and after the first etching step was observed with the scanning electron microscope. As the evaluation, the case where the distributions of the convex-portion height and the convex-portion bottom-portion diameter before the first etching step increased by 5% or more by the first etching step was represented as a poor evaluation, and the case of 5% or less was represented as a good evaluation.

The case where the distributions of the convex-portion height and the convex-portion bottom-portion diameter

of the concavo-convex structure 31a obtained after the third etching step increased by 10% or more was represented as a poor evaluation, and the case of 10% or less was represented as a good evaluation.

The results were shown in FIG. 43. FIG. 43 is a graph showing the results of Example 4. In the graph in FIG. 43, the horizontal axis represents the ratio (Sh/Scm) with respect to the fine pattern 12 of the mold 10, and the vertical axis represents the ratio (lcv/lcc) with respect to the fine pattern 12 of the mold 10. In FIG. 43, circular signs and triangular sings represent the cases that the above-mentioned evaluation results were all good evaluations, and it is shown that the circle sign is a higher evaluation than the triangular sign, the solid line is a higher evaluation than the dashed line, and that the shaded portion is a higher evaluation than the solid line. Further, in FIG. 43, X signs represent that the case where the above-mentioned evaluation results had at least one poor evaluation.

<Triangular sign>

- Triangular sign of dashed line
  · · · The case where the maximum value of the residual film thickness was 50 nm or less, accuracy was average residual film thickness ± 10% or less, the loss rate of the convex portions of the concavo-convex structure was 5% or less, changes in the distributions of the convex-portion height and the convex-portion bottom-portion diameter due to the first etching step were 5% or less, and the distributions of the convex-portion height and the convex-portion bottom-portion diameter of the concavo-convex structure 31a were 10% or less.
- Triangular sign of solid line
  · · · The case where the maximum value of the residual film thickness was 50 nm or less, accuracy was average residual film thickness ± 10% or less, the loss rate of the convex portions of the concavo-convex structure was 3% or less, changes in the distributions of the convex-portion height and the convex-portion bottom-portion diameter due to the first etching step was 4% or less, and the distributions of the convex-portion height and the convex-portion bottom-portion diameter of the concavo-convex structure 31a were 10% or less.

<Circular sign>

· White circular sign of dashed line
· · · The case where the maximum value of the residual film thickness was 50 nm or less, accuracy was average residual film thickness ± 8% or less, the loss rate of the convex portions of the concavo-convex structure was 5% or less, changes in the distributions of the convex-portion height and the convex-portion bottom-portion diameter due to the first etching step were 3% or less, and the distributions of the convex-portion height and the convex-portion bottom-portion diameter of the concavo-convex structure 31a were 8% or less.
· White circular sign of solid line
· · · The case where the maximum value of the residual film thickness was 50 nm or less, accuracy was average residual film thickness ± 8% or less, the loss rate of the convex portions of the concavo-convex structure was 3% or less, changes in the distributions of the convex-portion height and the convex-portion bottom-portion diameter due to the first etching step were 2% or less, and the distributions of the convex-portion height and the convex-portion bottom-portion diameter of the concavo-convex structure 31a were 6% or less.
· Black-shaded circular sign
· · · The case where the maximum value of the residual film thickness was 50 nm or less, accuracy was average residual film thickness ± 6% or less, the loss rate of the convex portions of the concavo-convex structure was 3% or less, changes in the distributions of the convex-portion height and the convex-portion bottom-portion diameter due to the first etching step were 1% or less, and the distributions of the convex-portion height and the convex-portion bottom-portion diameter of the concavo-convex structure 31a were 4% or less.

The curve A1 represents (lcv/lcc)=√(1.1/(Sh/Scm))-1. The curve A2 represents (lcv/lcc)=√(0.93/(Sh/Scm))-1. The curve B1 represents (lcv/lcc)=√(0.5/(Sh/Scm))-1. The curve B2 represents (lcv/lcc)=√(0.76/(Sh/Scm))-1. The straight line C1 represents (Sh/Scm)=0.23. The straight line C2 represents (Sh/Scm)=0.4. The straight line C3 represents (Sh/Scm)=0.6. The straight line D1 represents (Sh/Scm)=0.99. The straight line F1 represents lcv/lcc=1. Then, the straight line G1 represents lcv/lcc=0.01.

From the above-mentioned results, by concurrently meeting √(0.5/(Sh/Scm))-1≤(lcv/lcc)≤√(1.1/(Sh/Scm))-1, 0.23<(Sh/Scm)≤0.99, and 0.01≤lcv/lcc<1.0, it is understood that improvements are concurrently made in (1) the filling properties of the first resist layer 23 to the fine pattern 12, (2) transfer accuracy of the first resist layer 23, and (3)

processing accuracy of the inorganic substrate. This is because flowability of the first resist layer 23 is improved in the case of meeting the above-mentioned ranges. More specifically, the reason is conceivable that since improved are the inflow properties to the fine pattern 12 of the first resist layer 23 disposed in the lower portion of the concave portion 12b of the fine pattern 23 and the outflow properties of the first resist layer 23 disposed in the portion under the convex portion 12a of the fine pattern 12, (1) the filling properties of the first resist layer 23 were improved. Next, in the case of meeting the above-mentioned ranges, it is conceivable that since it is possible to reduce peeling stress applied to the convex-portion outer edge portion of the concavo-convex structure of the first resist layer 23 in peeling off the mold 10 from the first resist layer 23, the peeling force applied to the residual film RF decreased, and that (2) the transfer properties were improved. Further, it is conceivable that since it is possible to obtain the uniform thin residual film RF with high accuracy by (1, 2), it possible to increase the height of the convex portion 23c of the first resist layer 23 after undergoing the first etching layer and to decrease the distribution, and that (3) processing accuracy of the inorganic substrate was improved.

Further, by concurrently meeting $\sqrt{(0.76/(Sh/Scm))}-1 \leq (lcv/lcc) \leq \sqrt{(0.93/(Sh/Scm))}-1$, $0.23<(Sh/Scm)\leq 0.99$, and $0.01\leq lcv/lcc<1.0$, it is understood that more improvements are made in transfer accuracy of the concavo-convex structure 23a and accuracy of the residual film, while maintaining the effect of thinning the residual film of the concavo-convex structure 23a of the first resist layer 23. In association therewith, it is understood that accuracy of the concavo-convex structure product 31 is improved. The reason is presumed that in the case of meeting the above-mentioned ranges, disturbance of the first resist layer 23 is reduced in the outer edge portion of the bottom of the convex portion 12a of the fine pattern 12 where the disturbance occurs when the first resist layer 23 disposed in the lower portion of the convex portion 12a of the fine pattern 12 flows into the concave portion 12b of the fine pattern 12.

Furthermore, by concurrently meeting $\sqrt{(0.76/(Sh/Scm))}-1 \leq (lcv/lcc) \leq \sqrt{(0.93/(Sh/Scm))}-1$, $0.4\leq(Sh/Scm)\leq 0.99$, and $0.01\leq lcv/lcc<1.0$, it is understood that more improvements are made in transfer accuracy of the concavo-convex structure 23a and accuracy of the residual film, while maintaining the effect of thinning the residual film of the concavo-convex structure 23a of the first resist layer 23. In association therewith, it is understood that accuracy of the concavo-convex structure product 31 is improved. The reason is presumed that in the case of meeting the above-mentioned ranges, the flow path is shortened when the first resist layer 23 disposed in the convex-portion lower portion of the fine pattern 12 flows into the concave portion 12b of the fine pattern 12, and that it is possible to more reduce peeling stress applied to the outer edge 23d of the bottom of the convex portion 23c of the concavo-convex structure 23a in peeling off the mold. Further, it is understood that these effects are more remarkable in concurrently meeting $\sqrt{(0.76/(Sh/Scm))}-1 \leq (lcv/lcc) \leq \sqrt{(0.93/(Sh/Scm))}-1$, $0.6\leq(Sh/Scm)\leq 0.99$, and $0.01\leq lcv/lcc<1.0$.

[Example 5]

<Preparation of layered product 20>

Prepared was the layered product 20 comprised of the second resist layer 23 made of the following materials 11/first resist layer 22 made of the above-mentioned materials 2/inorganic substrate 21.

As the inorganic substrate 21, used was a C-surface sapphire substrate of 2-ince Φ. First, the sapphire substrate was treated with UV-O3 for 10 minutes. Next, particles were removed by air blow. Subsequently, a film of the above-mentioned materials 2 was deposited by the spin coat method at a maximum rotation speed of 5500 rpm. In this case, the above-mentioned materials 2 were diluted with a mixed solvent of PGME and acetone and used. In addition, the film thickness was adjusted so that lrl/P was 1.2. Further, after the spin coat, the layered product 20 comprised of the first resist layer 22/inorganic substrate 21 was dried at 95°C for 10 minutes, and further, was irradiated with UV light with the integral light amount of 500 $mJ/cm^2$ using a high-pressure mercury-vapor lamp.

Next, a film of the following materials 11 diluted with a mixed solvent obtained by mixing PGME and 2propanol in a volume ratio of 8:2 was deposited on the first resist layer 22 by the spin coat method at a maximum rotation speed of 5000 rpm, and was allowed to stand in an atmosphere of temperature of 25°C and moisture of 50% for 3 minutes to obtain the layered product 20 comprised of the second resist layer 23/first resist layer 22/inorganic substrate 21. In addition, the film thickness was adjusted so that Vr2/Vcm was 1.13.

Materials 11···TTB: 3APTMS: SH710: I.184: I.369=80 g: 20 g: 5.5 g: 1.1 g: 0.4 g

In the layered product 20, the second resist layer 23 contained Ti and Si as metal elements, and the metalloxane bonds of Si-O-Si were confirmed.

<Preparation of resist layered product 30>

Next, using a resin mold, the layered product 20 underwent the pressing step, energy ray irradiation step and mold release step to prepare the resist layered product 30. In the pressing step and energy ray irradiation step, the nanoimprint apparatus (EUN-4200, made by Engineering System Co., Ltd.) was used.

(Pressing step)

First, the resin mold was laminated on the materials 3 with a hand roller. Next, pressing was performed after preparing a mold layered product 24 of silicone rubber 1 (elastic material 28: t 10 mm, hardness 20)/two-side polished 2-inch Φ sapphire substrate/mold 10/first resist layer 23/inorganic substrate 21 (sapphire substrate)/silicone rubber 2 (t 20mm, hardness 20). Pressing was performed from above the silicone rubber 1 at 0.12 MPa for 5 minutes.

(Energy ray irradiation step)

Used as a light source was the UV-LED light source with a main wavelength of 365 nm. UV light was applied with the integral light amount of 2500 mJ/cm$^2$ for 10 minutes while keeping the pressure of 0.08 MPa.

(Mold release step)

The step was performed by peeling off the mold 10 from the first resist layer 23.

By the above-mentioned operation, evaluations were made to transfer accuracy of the resist layered product 30, thinning of the residual film thickness, and uniformity of the residual film thickness by using the scanning electron microscope. Evaluation indicators are as described below.

The resist layered product 30 was cut, and energy dispersive X-ray spectroscopy and scanning electron microscope observation was performed on the cross section. Five observation sample pieces were prepared, and ten points were observed in each sample. A good evaluation represents the case that the rate that the convex portions of the concavo-convex structure were broken ranges from 0% to 5%, the maximum value of the residual film thickness was 50 nm or less, and that accuracy was average residual film thickness ± 10% or less. A poor evaluation represents the case where the breakage rate of the convex portions of the concavo-convex structure exceeded 5%, the case where the maximum value of the residual film thickness exceeded 50 nm or the case where accuracy was average residual film thickness ± more than 10%. Further, in the mold release step, a poor evaluation was also made in the case where the area of an existing portion of the residual film peeled off from the inorganic substrate exceeded 3% relative to the inorganic substrate.

The results were shown inFIG. 44. FIG. 44 is a graph showing the evaluation results of the resist layered products of Example 5. In the graph in FIG. 44, the horizontal axis represents the ratio (Sh/Scm) with respect to the fine pattern 12 of the mold 10, and the vertical axis represents the ratio (lcv/lcc) with respect to the fine pattern 12 of the mold 10. In FIG. 44, circular signs and triangular sings represent the cases that the above-mentioned evaluation results were good evaluations, and it is shown that the circle sign is a higher evaluation than the triangular sign, the solid line is a higher evaluation than the dashed line, and that the shaded portion is a higher evaluation than the solid line. Further, in FIG. 44, X signs represent that the case where the above-mentioned evaluation results were poor evaluations.

<Triangular sign>

- Triangular sign of dashed line
  · · · The case where the rate that the convex portions of the concavo-convex structure were broken was 5% or less, the maximum value of the residual film thickness was 50 nm or less, and accuracy was average residual film thickness ± 10% or less.
- Triangular sign of solid line
  · · · The case where the rate that the convex portions of the concavo-convex structure were broken was 3% or less, the maximum value of the residual film thickness was 50 nm or less, and accuracy was average residual film thickness ± 10% or less.

<Circular sign>

· White circular sign of dashed line
· · · The case where the rate that the convex portions of the concavo-convex structure were broken was 5% or less, the maximum value of the residual film thickness was 50 nm or less, and accuracy was average residual film thickness ± 8% or less.
· White circular sign of solid line

· · · The case where the rate that the convex portions of the concavo-convex structure were broken was 3% or less, the maximum value of the residual film thickness was 50 nm or less, and accuracy was average residual film thickness ± 8% or less.

· Black-shaded circular sign

· · · The case where the rate that the convex portions of the concavo-convex structure were broken was 3% or less, the maximum value of the residual film thickness was 50 nm or less, and accuracy was average residual film thickness ± 6% or less.

The curve A1 represents (lcv/lcc)=√(1.1/(Sh/Scm))-1. The curve A2 represents (lcv/lcc)=√(0.93/(Sh/Scm))-1. The curve B1 represents (lcv/lcc)=√(0.5/(Sh/Scm)) -1. The curve B2 represents (lcv/lcc)=√(0.76/(Sh/Scm))-1. The straight line C1 represents (Sh/Scm)=0.23. The straight line C2 represents (Sh/Scm)=0.4. The straight line C3 represents (Sh/Scm)=0.6. The straight line D1 represents (Sh/Scm)=0.99. The straight line F1 represents lcv/lcc=1. Then, the straight line G1 represents lcv/lcc=0.01.

From the above-mentioned results, by concurrently meeting √(0.5/(Sh/Scm))-1≤(lcv/lcc)≤√(1.1/(Sh/Scm))-1, 0.23<(Sh/Scm)≤0.99, and 0.01≤cv/lcc<1.0, it is understood that it is possible to obtain the concavo-convex structure having the uniform residual film of 50 nm or less with less transfer losses. It is conceivable that since improvements are made in flowability of the second resist layer 23, more specifically, the inflow properties to the fine pattern 12 of the second resist layer 23 disposed in the lower portion of the concave portion 12b of the fine pattern 12 and the outflow properties of the second resist layer 23 disposed in the portion under the convex portion 12a of the fine pattern 12, (1) the filling properties of the second resist layer 23 were improved. Next, in the case of meeting the above-mentioned ranges, it is conceivable that since it is possible to reduce peeling stress applied to the outer edge 23d of the bottom of the convex portion 23c of the concavo-convex structure 23 of the second resist layer 23 in peeling off the mold 10 from the second resist layer 23, the peeling force applied to the residual film RF decreased, and that (2) the transfer properties were improved.

Further, by concurrently meeting √(0.76/(Sh/Scm))-1≤(lcv/lcc)≤√(0.93/(Sh/Scm))-1, 0.23<(Sh/Scm)≤0.99, and 0.01≤lcv/lcc<1.0, it is understood that improvements are made in transfer accuracy of the concavo-convex structure 23a and accuracy of the residual film, while maintaining the effect of thinning the residual film of the concavo-convex structure 23a of the second resist layer 23. The reason is presumed that in the case of meeting the above-mentioned ranges, disturbance of the second resist layer 23 is reduced in the outer edge of the bottom of the convex portion 12a of the fine pattern 12 where the disturbance occurs when the second resist layer 23 disposed in the convex-portion lower portion of the fine pattern 12 flows into the concave portion of the fine pattern 12.

Furthermore, by concurrently meeting √(0.76/(Sh/Scm))-1≤(lcv/lcc)≤√(0.93/(Sh/Scm))-1, 0.4≤(Sh/Scm)≤0.99, and 0.01≤lcv/lcc<1.0, it is understood that more improvements are made in transfer accuracy of the concavo-convex structure 23a and accuracy of the residual film, while maintaining the effect of thinning the residual film of the concavo-convex structure 23a of the first resist layer 23. The reason is presumed that in the case of meeting the above-mentioned ranges, the flow path is shortened when the second resist layer 23 disposed in the lower portion of the convex portion 12a of the fine pattern 12 flows into the concave portion 12b of the fine pattern 12, and that it is possible to more reduce peeling stress applied to the outer edge 23d of the bottom of the convex portion 23c of the concavo-convex structure 23a in peeling off the mold. Further, it is understood that these effects are more remarkable in concurrently meeting √(0.76/(Sh/Scm))-1≤(lcv/lcc)≤√(0.93/(Sh/Scm))-1, 0.6≤(Sh/Scm)≤0.99, and 0.01≤lcv/lcc<1.0.

In addition, the fine pattern 12 of the resin mold used as described above was the hole structure in which concave portions were spaced by continuous convex portions, and it was observed that the area of the hole opening portion was larger than the area of the hole bottom portion.

In addition, repetition transfer properties (durability) of the mold were examined, and it was confirmed that in the range of (Sh/Scm)≤0.99, as Sh/Scm decreased to 0.95, 0.93, and 0.91, the repetition transfer properties were made more excellent. More specifically, the number of repetitions was 3 in the case of Sh/Scm=0.99, and as Sh/Scm decreased to 0.95, 0.93 and 0.91, the number of repetitions increased to 5, 10, and 20. The reason is presumed that the physical strength of the convex portion surrounding the concave portion of the fine pattern 12 of the mold 10 was increased. In view of the foregoing, it is understood that when Sh/Scm is 0.95 or less, it is possible to manufacture the second resist layer 23 having the uniform residual film many times using one mold. Particularly, when Sh/Scm is 0.93 and further 0.91, the above-mentioned effects are more remarkable.

Apart of the above-mentioned effects are described in Table 5. In Table 5, properties of the fine pattern are described in the columns of the mold composition requirements. αmin./αmax means the range (lower limit and upper limit values) of α when (lcv/lcc)=√(α/(Sh/Scm))-1 is described, and means that the fine pattern was included in the range of √(αmin. /(Sh/Scm))-1≤(lcv/lcc)≤√(αmax /(Sh/Scm))-1. Further, αmax>value means (lcv/lcc)≥√(αmax/(Sh/Scm))-1, and αmin<value means (lcv/lcc)≤√(αmin/(Sh/Scm))-1. "H" in the mold composition requirements means the depth of the mold. The dimension is "nm". The sign RF in the effect column is an average value of the residual film thickness of the second resist layer 23. Further, the sings in the total columns are the same as in the above-mentioned evaluation results.

In Table 5, "MB" means mold breakage.

[Table 5]

| Mold composition requirements | | | | Effect | |
|---|---|---|---|---|---|
| $\alpha$min./$\alpha$max | Sh/Scm | Icv/Icc | H | RF | Total |
| 0.76/0.93 | 0.21 | 0.95 | 400 | 125 | × |
| 0.76/0.93 | 0.18 | 1.25 | 400 | 130 | × |
| 0.5/1.1 | 0.2 | 1.25 | 400 | 145 | × |
| $\alpha$min<0.5 | 0.22 | 0.46 | 700 | 105 | × |
| $\alpha$max>1.0 | 0.74 | 1.05 | 400 | 45 | × |
| 0.5/1.1 | 0.71 | 0.18 | 350 | 50 | Δ |
| 0.5/1.1 | 0.32 | 0.47 | 300 | 49 | Δ |
| 0.76/0.93 | 0.37 | 0.53 | 450 | 50 | ◌ |
| 0.76/0.93 | 0.47 | 0.4 | 500 | 43 | ○ |
| 0.76/0.93 | 0.43 | 0.42 | 600 | 45 | ○ |
| 0.76/0.93 | 0.6 | 0.13 | 350 | 45 | ○ |
| 0.76/0.93 | 0.63 | 0.2 | 450 | 40 | ● |
| 0.76/0.93 | 0.72 | 0.05 | 400 | 35 | ● |
| 0.76/0.93 | 0.81 | 0.06 | 700 | 46 | ● |
| 0.76/0.93 | 0.87 | 0.02 | 800 | 48 | ● |
| 0.5/1.1 | 0.89 | 0.06 | 400 | 43 | Δ |
| $\alpha$ max>1.0 | 0.997 | 0.001 | 400 | MB | × |
| 0.76/0.93 | 0.81 | 0.06 | 40 | 25 | × |
| 0.76/0.93 | 0.81 | 0.06 | 1500 | 300 | × |

<Preparation of concavo-convex structure product 31>

The concavo-convex structure products 31 were next prepared using the prepared resist layered products 30 with the results of FIG. 44 of above-mentioned Example 5 obtained.

(First etching step and second etching step)

The first etching step and second etching step were performed by dry etching using oxygen gas (processing pressure: 1Pa, Power: 300W). Dry etching was performed from the surface side with the second resist layer 23 formed of the prepared resist layered product 30, and the residual film RF of the second resist layer 23 was removed to form the fine mask pattern 25. Next, the first resist layer 22 was removed via the fine mask pattern 25 to form the fine mask pattern 25.

(Third etching step)

The third etching step was performed by using the same apparatus as in the first and second etching steps, and was performed continuously without releasing a vacuum. The third etching step was performed using the reactive ion etching apparatus (RIE-101iPH, made by SAMCO Inc.). As an etching gas, $BCl_3$ gas as a chlorine-based gas was used with Ar added. On the conditions that ICP: 150 W, BIAS: 50 W, and pressure 0.2 Pa, the inorganic substrate 21 (sapphire substrate) was etched from the surface side with the second resist layer 23 formed via the fine mask pattern 25, and the concavo-convex structure 31a was formed on the surface of the inorganic substrate 21 to form the concavo-convex structure product 31.

After the third etching step, using a solution obtained by mixing sulfuric acid and hydrogen peroxide solution in a weight ratio of 2:1, the surface of the prepared concavo-convex structure product 31 (sapphire substrate) was cleaned.
As described above, evaluations were made to the obtained concavo-convex structure products 31, fine mask patterns 25 that were forebears to obtain the concavo-convex structure products 31, and resist layered products 31 subjected to processing of residual films that were forebears of the fine mask patterns 25. Evaluation indicators are as described below.
A change in the shape of the convex portion before and after the first etching was observed with the scanning electron microscope. As the evaluation, the case where the distributions of the convex-portion height and the convex-portion bottom-portion diameter before the first etching step increased by 5% or more by the first etching steps was represented as a poor evaluation, and the case of 5% or less was represented as a good evaluation.
The distribution with respect the width of the backbone of the fine mask pattern 25 after the second etching step 25 was calculated by scanning electron microscope observation. The case where the distribution with respect to the width of the backbone exceeded 10% was represented as a poor evaluation, and the case of 10% or less was represented as a good evaluation.
The case where the distributions of the convex-portion height and the convex-portion bottom-portion diameter of the concavo-convex structure 31a obtained after the third etching exceeded 10% was represented as a poor evaluation, and the case of 10% or less was represented as a good evaluation.
The results were shown in FIG. 45. FIG. 45 is a graph showing the evaluation results of concavo-convex structure products of Example 5. FIG. 45 indicates the samples evaluated as described above by arrows with respect to FIG. 44.
In FIG. 45, the signs that are not indicated by arrows are the same as those in FIG. 44, and signs indicated by the arrows mean the following evaluation results. Circular signs and triangular sings indicated by the arrows represent the cases that the above-mentioned evaluation results were all good evaluations, and it is shown that the circle sing is a higher evaluation than the triangular sign, the solid line is a higher evaluation than the dashed line, and that the shaded portion is a higher evaluation than the solid line. Further, X signs indicated by the arrows represent the case where the above-mentioned evaluation results had at least one poor evaluation.

<Triangular sign>

- Triangular sign of dashed line
  · · · The case where changes in the distributions of the convex-portion height and the convex-portion bottom-portion diameter before the first etching step were 5% or less, the distribution with respect to the width of the backbone of the fine mask pattern after the second etching step was 10% or less, and the distributions of the convex-portion height and the convex-portion bottom-portion diameter of the concavo-convex portion 31a obtained after the third etching step were 10% or less.
- Triangular sign of solid line
  · · · The case where changes in the distributions of the convex-portion height and the convex-portion bottom-portion diameter before the first etching step were 5% or less, the distribution with respect to the width of the backbone of the fine mask pattern after the second etching step was 8% or less, and the distributions of the convex-portion height and the convex-portion bottom-portion diameter of the concavo-convex portion 31a obtained after the third etching step were 8% or less.

<Circular sign>

- White circular sign of dashed line
  · · · The case where changes in the distributions of the convex-portion height and the convex-portion bottom-portion diameter before the first etching step were 4% or less, the distribution with respect to the width of the backbone of the fine mask pattern after the second etching step was 8% or less, and the distributions of the convex-portion height and the convex-portion bottom-portion diameter of the concavo-convex portion 31a obtained after the third etching step were 8% or less.
- White circular sign of solid line
  · · · The case where changes in the distributions of the convex-portion height and the convex-portion bottom-portion diameter before the first etching step were 3% or less, the distribution with respect to the width of the backbone of the fine mask pattern after the second etching step was 6% or less, and the distributions of the convex-portion height

and the convex-portion bottom-portion diameter of the concavo-convex portion 31a obtained after the third etching step were 6% or less.

- Black-shaded circular sign

· · · The case where changes in the distributions of the convex-portion height and the convex-portion bottom-portion diameter before the first etching step were 2% or less, the distribution with respect to the width of the backbone of the fine mask pattern after the second etching step was 5% or less, and the distributions of the convex-portion height and the convex-portion bottom-portion diameter of the concavo-convex portion 31a obtained after the third etching step were 5% or less.

The curve A1 represents (lcv/lcc)=√(1.1/(Sh/Scm))-1. The curve A2 represents (lcv/lcc)=√(0.93/(Sh/Scm))-1. The curve B1 represents (lcv/lcc)=√(0.5/(Sh/Scm))-1. The curve B2 represents (lcv/lcc)=√(0.76/(Sh/Scm))-1. The straight line C1 represents (Sh/Scm)=0.23. The straight line C2 represents (Sh/Scm) =0.4. The straight line C3 represents (Sh/Scm)=0.6. The straight line D1 represents (Sh/Scm)=0.99. The straight line F1 represents lcv/lcc=1. Then, the straight line G1 represents lcv/lcc=0.01.

From the above-mentioned results, by concurrently meeting √(0.5/(Sh/Scm))-1-≤(lcv/lcc)≤√(1.1/(Sh/Scm))-1, 0.23<(Sh/Scm)≤0.99, and 0.01≤lcv/lcc<1.0, it is understood that since it is possible to decrease the change in the shape of the convex portion 23c of the concavo-convex structure 23a by the residual film treatment, accuracy of the fine mask pattern 25 is improved and that accuracy of the concavo-convex structure product 31 is enhanced. As described already, the reason is conceivable that since flowability of the second resist layer 23 is improved by meeting the above-mentioned ranges, (1) the filling properties of the second resist layer 23 are improved, while it is possible to reduce peeling stress applied to the outer edge 23d of the bottom of the convex portion 23c of the concavo-convex structure 23a of the second resist layer in peeling off the mold 10 from the second resist layer 23, (2) the transfer properties are improved, and that it is possible to obtain the second resist layer 23 with fewer losses in the concavo-convex structure 23a provided with the uniform and thin residual film RF. By such a concavo-convex structure 23a of the second resist layer 23, it is conceivable that it is possible to increase the height of the convex portion 23c of the first resist layer 23 after undergoing the first etching step and to decrease the distribution, (4) processing accuracy of the first resist layer 23 is improved, and that it was possible to obtain the fine mask pattern 25 with small distributions. Then, by processing the inorganic substrate 21 using the fine mask pattern with high accuracy as a mask, it is conceivable that (3) processing accuracy of the inorganic substrate 21 was improved. In other words, as accuracy of the concavo-convex structure 23a of the second resist layer 23 increases, and then, uniformity of the residual film RF improves, accuracy of the concavo-convex structure product 31 is improved. Accordingly, as considered in FIG. 44, it is conceivable that accuracy of the concavo-convex structure product 31 is more improved by meeting the following ranges, and it was actually confirmed by examinations.

By concurrently meeting √(0.76/(Sh/Scm))-1≤(lcv/lcc)≤√(0.93/(Sh/Scm))-1, 0.23<(Sh/Scm)≤0.99, and 0.01≤lcv/lcc<1.0, accuracy of the concavo-convex structure product 31 was more improved. Further, by concurrently meeting √(0.76/(Sh/Scm))-1≤(lcv/lcc)≤√(0.93/(Sh/Scm))-1, 0.4≤(Sh/Scm)≤0.99, and 0.01≤lcv/lcc<1.0, accuracy of the concavo-convex structure product 31 was further improved. Furthermore, by concurrently meeting √(0.76/(Sh/Scm))-1≤(lcv/lcc)≤√(0.93/(Sh/Scm))-1, 0.6≤(Sh/Scm)≤0.99, and 0.01<lcv/lcc<1.0, it was confirmed that these effects were more remarkable.

Next, using the obtained concavo-convex structure products 31 as the substrates, LED devices were prepared, and light-emitting characteristics were evaluated.

By an organic metal chemical vapor deposition method (MOCVD), a semiconductor light emitting device was prepared by successively stacking, on the concavo-convex structure product 31, (1) AlGaN low-temperature buffer layer, (2) n-type GaN layer, (3) n-type AlGaN clad layer, (4) InGaN light emitting layer (MQW), (5) p-type AlGaN clad layer, (6) p-type GaN layer and (7) ITO layer. The asperities of the sapphire substrate were embedded on the deposition conditions in layering the (2) n-type GaN layer. Next, the semiconductor light emitting device (A) was subjected to etching processing, and electrode pads were attached. In this state, using a prober, a current of 20 mA was passed through between p-electrode pad and n-electrode pad to measure light emitting output of the semiconductor light emitting device (A).

The following two evaluations were performed. First, using a sapphire substrate without being provided with the concavo-convex structure, a semiconductor light emitting device was prepared by the above-mentionedmethod. Assuming that the light emitting output of the semiconductor light emitting device is 1, evaluations were made to the light emitting output of the semiconductor light emitting devices prepared by using the concavo-convex structure products 31. Second, the evaluation was made to the distribution of the light emitting output of the semiconductor light emitting device.

The results are shown in FIG. 46. FIG. 46 is a graph showing the evaluation results of the semiconductor light emitting devices of Example 5. FIG. 46 indicates the samples evaluated as described above by arrows with respect to FIG. 44.

In FIG. 46, the signs that are not indicated by arrows are the same as those in FIG. 44, and signs indicated by the arrows mean the following evaluation results. Circular signs and triangular sings indicated by the arrows represent the cases that the evaluation result of the output distribution of the semiconductor light emitting device as described above was good, and it is shown that the circle sign is a higher evaluation than the triangular sign, the solid line is a higher evaluation than the dashed line, and that the shaded portion is a higher evaluation than the solid line. Further, X signs indicated by the arrows represent the case where the evaluation result of the output distribution of the semiconductor light emitting device as described above was not suitable. Further, the value in FIG. 46 means the light emitting output ratio.

<X sign>

· · · The case where the distribution of light emitting output exceeded ±20%.

<Triangular sign>

- Triangular sign of dashed line
  · · · The case where the distribution of light emitting output was ±20% or less.
- Triangular sign of solid line
  · · · The case where the distribution of light emitting output was ±15% or less.

<Circular sign>

- White circular sign of dashed line
  · · · The case where the distribution of light emitting output was ±10% or less.
- White circular sign of solid line
  · · · The case where the distribution of light emitting output was ±8% or less.
- Black-shaded circular sign
  · · · The case where the distribution of light emitting output was ±5% or less.

The curve A1 represents $(Icv/Icc)=\sqrt{(1.1/(Sh/Scm))}-1$. The curve A2 represents $(Icv/Icc)=\sqrt{(0.93/(Sh/Scm))}-1$. The curve B1 represents $(Icv/Icc)=\sqrt{(0.5/(Sh/Scm))}-1$. The curve B2 represents $(Icv/Icc)=\sqrt{(0.76/(Sh/Scm))}-1$. The straight line C1 represents $(Sh/Scm)=0.23$. The straight line C2 represents $(Sh/Scm)=0.4$. The straight line C3 represents $(Sh/Scm)=0.6$. The straight line D1 represents $(Sh/Scm)=0.99$. The straight line F1 represents $Icv/Icc=1$. Then, the straight line G1 represents $Icv/Icc=0.01$.

From the above-mentioned results, by concurrently meeting $\sqrt{(0.5/(Sh/Scm))}-1\leq(Icv/Icc)\leq\sqrt{(1.1/(Sh/Scm))}-1$, $0.23<(Sh/Scm)\leq0.99$, and $0.01\leq Icv/Icc<1.0$, it is understood that it is possible to manufacture semiconductor light emitting devices with high light emitting intensity and small light emitting output distribution. As described above, this is because it is possible to uniform and thin the residual film of the second resist layer 23 by meeting these ranges. In other words, accuracy is improved in the concavo-convex structure of the concavo-convex structure product 31. By using the sapphire substrate provided with such a concavo-convex structure, it is presumed that first, the distribution of the effect of disturbing the growth mode of the semiconductor crystal layer inside the surface is decreased, and that internal quantum efficiency is improved inside the surface. Further, by the effect of optical scattering properties due to the concavo-convex structure, light extraction efficiency is improved. In view of the foregoing, it is presumed that since external quantum efficiency of the semiconductor light emitting device is improved, the light emitting output was increased, and that the distribution was further decreased.

Further, by concurrently meeting $\sqrt{(0.76/(Sh/Scm))}-1\leq(Icv/Icc)\leq\sqrt{(0.93/(Sh/Scm))}-1$, $0.23<(Sh/Scm)\leq0.99$, and $0.01\leq Icv/Icc<1.0$, it was confirmed that the light emitting output and the distribution of light emitting output was both improved. The reason is presumed that it is possible to manufacture the concavo-convex structure product 31 with high accuracy from the already described mechanism, and that by meeting the above-mentioned ranges, since accuracy of the flat surface of the concave-portion bottom portion of the concavo-convex structure product 31 is improved, internal quantum efficiency was more improved.

Furthermore, by concurrently meeting $\sqrt{(0.76/(Sh/Scm))}-1\leq(Icv/Icc)\leq\sqrt{(0.93/(Sh/Scm))}-1$, $0.4\leq(Sh/Scm)\leq0.99$, and $0.01(Icv/Icc)<1.0$, it was confirmed that the light emitting output and the distribution of light emitting output was both further improved. This is because it is possible to manufacture the concavo-convex structure product 31 with high accuracy from the already described mechanism, and it is considerable due to the result of improvement in light extraction

efficiency caused by the fact that it is possible to increase the volume of the convex portion of the concavo-convex structure product 31. Still furthermore, by concurrently meeting $\sqrt{(0.76/(Sh/Scm))}-1 \leq (lcv/lcc) \leq \sqrt{(0.93/(Sh/Scm))}-1$, $0.6 \leq (Sh/Scm) \leq 0.99$, and $0.01 \leq lcv/lcc < 1.0$, it was confirmed that these effects were more remarkable.

The light emitting output slightly decreased near Sh/Scm being 0.85. The reason is conceivable that the area of the concave-portion bottom portion of the concavo-convex structure product 31 was too small. With respect thereto, it was confirmed that it is possible to resolve by applying over etching in the first etching step and the second etching step.

[Example 6]

Optimization of the film thickness (lr1) of the first resist layer 22 was performed, using the resin mold with lcv/lcc of 0.022 and Sh/Scm of 0.87 evaluated as the black-shaded circle sign in Example 5.

As in Example 5, the concavo-convex structure product 31 was prepared. A change point is only the thickness (lr1) of the first resist layer as described below.

The thickness (lr1) of the first resist layer was varied in the range of 0.15 time to 6.00 times the average pitch Pave of the fine pattern 12 of the mold 10.

Evaluations were the distributions of the diameter and height of the convex portion of the concavo-convex structure product 31, and the height of the concavo-convex structure product 31. The results are shown in Table 6.

[Table 6]

| lr1 /Pave | Inorganic substrate processability |
|---|---|
| 0.15 | × |
| 0.29 | Δ |
| 0.36 | Δ |
| 0.50 | ○ |
| 0.71 | ◎ |
| 1.00 | ◎ |
| 1.71 | ◎ |
| 2.14 | ◎ |
| 2.57 | ○ |
| 4.29 | ○ |
| 5.00 | Δ |
| 6.00 | × |

The meaning of sings in Table 6 is as described below.

X· · · · · · The case where the distributions of the diameter and height of the convex portion of the concavo-convex structure product 31 exceeded 10%, and the height of the concavo-convex structure product 31 was less than 0.3P.
Δ · · · The case where the distributions of the diameter and height of the convex portion of the concavo-convex structure product 31 were 10% or less, and the height of the concavo-convex structure product 31 was 0.3P or more.
○ · · · The case where the distributions of the diameter and height of the convex portion of the concavo-convex structure product 31 was 7% or less, and the height of the concavo-convex structure product 31 was 0.4P or more.
◎ · · · The case where the distributions of the diameter and height of the convex portion of the concavo-convex structure product 31 was 5% or less, and the height of the concavo-convex structure product 31 was 0.5P or more.

In addition, these evaluation indicators were determined from light extraction efficiency in the case of using the concavo-convex structure product 31 in the semiconductor light emitting device.

As can be seen from Table 6, it is understood that the ratio (lr1/Pave) of the thickness of the first resist layer 22 to the pitch of the fine pattern is in a suitable range. The reason why the evaluation was X in the case of the ratio (lr1/Pave) of 0.15 or less derives from the fact that the first resist layer 22 disappears fast in the third etching step because the thickness of the first resist layer is thin relative to the pitch of the fine pattern 12, and that the width distribution of the backbone of the fine mask pattern 25 of the first resist layer 22 is increased in the second etching step.

On the other hand, the reason why the evaluation was X in the case of the ratio (lr1/Pave) of 6 or more is presumed that since the film thickness of the first resist layer 22 is too thick relative to resolution of the fine pattern 12, variations are large in the width of the backbone of the fine mask pattern 25 in the second etching step, and that the effect of thermal vibration is easy to undergo in the third etching step. In the ratio (lr1/Pave) ranging from 0.29 to 0. 36, the valuation was improved to Δ. As the reason, it is conceivable that since the thickness of the first resist layer 22 is moderate relative to the pitch of the fine pattern 12, it was possible to suppress loss of the first resist layer 22 in the third etching step, and that it was possible to maintain resistance to thermal vibration of the fine mask pattern 25.

In the case of the ratio (lr1/Pave) of 5.00, the valuation was improved to Δ. The reason is conceivable that the effect of thermal vibration in the third etching step was relaxed. In the case of the ratio (lr1/Pave) of 0.50, the valuation was improved to ○. The reason is conceivable that since the pitch of the fine pattern 12 and the film thickness of the first resist layer 22 meet the predetermined relationship, it was possible to relax the influence of the loading effect in the third etching step by variations in the height of the fine mask pattern 24 i.e. in the thickness of the first resist layer 22. In the range in which the ratio (lr1/Pave) ranges from 2.57 to 4.29, the valuation was improved to ○. The reason is conceivable that since as the width of the backbone of the fine mask pattern 25 decreases in the third etching step, the loading effect is weakened, the processing velocity of the inorganic substrate 21 is improved. In the case of the range in which the ratio (lr1/Pave) ranges from 0. 71 to 2.14, the evaluations were the highest. It is presumed that the above-mentioned effects all appear. In other words, it is conceivable that since the film thickness of the first resist layer 22 is made suitable for resolution of the fine pattern, it is possible to suppress variations in the fine mask pattern 25 in the second etching step, it is thereby possible to increase the volume of the fine mask pattern 25 at the time of third etching, and that it is possible to relax the influence of the loading effect and shadow effect due to the width of the backbone and height of the fine mask pattern 25.

In addition, the present invention is not limited to the above-mentioned Embodiment, and is capable of being carried into practice with various modifications thereof. For example, the size, shape and the like shown in the accompanying drawings are not limited thereto, and are capable of being carried into practice with modifications thereof as appropriate within the scope of exhibiting the effects of the present invention. Moreover, the invention is capable of being carried into practice with modifications thereof as appropriate without departing from the scope of the object of the invention.

Industrial Applicability

The present invention is useful in forming a fine concavo-convex structure in an inorganic substrate, and particularly, is capable of being suitably used in manufacturing of large scale integrated circuits (LSI), semiconductor light emitting devices or solar batteries.

The present application is based on Japanese Patent ApplicationNo. 2012-054943 filed on March 12, 2012, Japanese Patent ApplicationNo. 2012-054944 filed on March 12, 2012, Japanese Patent Application No. 2012-054945 filed on March 12, 2012, and Japanese PatentApplicationNo. 2012-186551filedonAugust27, 2012, entire contents of which are expressly incorporated by reference herein.

## Claims

**1.** A mold comprising:

a fine pattern on a part or whole of a surface thereof,
wherein in the fine pattern, a ratio (lcv/lcc) of a top width of convex-portion (lcv) to an opening width of concave-portion (lcc) and a ratio (Sh/Scm) of an opening portion area (Sh) existing under a region of a unit area (Scm) of the fine pattern to the unit area (Scm) meet following equation (1),
the ratio (Sh/Scm) meets following equation (2),the ratio (lcv/lcc) meets following equation (3), and a height (H) of the fine pattern meets following equation (4).
[Mathematical Expression 1]

Eq. (1)

$$\sqrt{0.5/(Sh/Scm)} - 1 \leqq lcv/lcc \leqq \sqrt{1.1/(Sh/Scm)} - 1$$

Eq. (2)

$$0.23 < (Sh/Scm) \leq 0.99$$

Eq. (3)

$$0.01 \leq (lcv/lcc) < 1.0$$

Eq. (4)

$$50nm \leq H \leq 1500nm$$

2. The mold according to claim 1, wherein in each of concave portions forming the fine pattern, a diameter increases from a bottom portion toward the opening portion.

3. The mold according to claim 1 or 2, wherein the fine pattern meets following equation (5).
[Mathematical Expression 2]

Eq. (5)

$$\sqrt{0.76/(Sh/Scm)} - 1 \leqq lcv/lcc \leqq \sqrt{0.93/(Sh/Scm)} - 1$$

4. The mold according to claim 3, wherein the fine pattern meets following equation (6).
[Mathematical Expression 3]

Eq. (6)

$$\sqrt{0.78/(Sh/Scm)} - 1 \leqq lcv/lcc \leqq \sqrt{0.91/(Sh/Scm)} - 1$$

5. The mold according to any one of claims 2 to 4, wherein the fine pattern meets following equation (7).

Eq. (7)

$$0.4 \leq (Sh/Scm) \leq 0.95$$

6. The mold according to claim 5, wherein the fine pattern meets following equation (8).

Eq. (8)

$$0.6 \leq (Sh/Scm) \leq 0.93$$

7. The mold according to any one of claims 1 to 6, wherein a water contact angle on the fine pattern is 90 degrees or more.

8. The mold according to any one of claims 1 to 6, wherein the fine pattern contains at least one or more components selected from the group constituting of a methyl group, a fluorine element and a silicon element.

9. The mold according to any one of claims 1 to 8, wherein a bending modulus of elasticity of the mold ranges from 5 Mpa to 10Gpa.

**10.** The mold according to any one of claims 1 to 9, wherein the mold is used for processing of a substrate for an LED.

**11.** A resist layered product comprising:

an inorganic substrate; and
a resist layer comprised of n layer (s) ($n \geq 1$) provided on one main surface of the inorganic substrate,
wherein a surface of an nth resist layer that is an uppermost layer of the resist layer comprised of n layers (s) has a concavo-convex structure on a part or whole of the surface,
the concavo-convex structure is provided by transfer of a fine pattern of a mold, a thickness of a residual film after the transfer is 50 nm or less,
a ratio (lcv/lcc) of a top width of convex-portion (lcv) to an opening width of concave-portion (lcc) of the fine pattern of the mold meets following equation (3), and
a ratio (Vr2/Vcm) between a concave-portion volume (Vcm) of the fine pattern existing under a region of a unit area (Scm) of the surface with the fine pattern formed of the mold and a volume (Vr2) of the nth resist layer existing under a region of a unit area (Scr2) in the plane in the nth resist layer formed inside a surface parallel to the one main surface of the inorganic substrate meets following equation (9).

Eq. (3)

$$0.01 \leq (lcv/lcc) < 1.0$$

Eq. (9)

$$0.1 \leq (Vr2/Vcm) \leq 1.5$$

**12.** The resist layered product according to claim 11, wherein the mold is the mold according to any one of claims 1 to 10.

**13.** The resist layered product according to claim 11 or 12, wherein the layered number n of the resist layer comprised of n layers is two or more.

**14.** The resist layered product according to any one of claims 11 to 13, wherein the nth resist layer contains at least one or more metal elements selected from the group consisting of Si, Ti, Zr, Zn, Mg, In, Al, W, Cr, B, Sn, Ta, Au and Ag.

**15.** The resist layered product according to claim 14, wherein the nth resist layer contains a metalloxane bond portion indicated by following general formula (10).

General formula (10) -Me1-O-Me2-

(In general formula (10), each of Me1 and Me2 is one of Si, Ti, Zr, Zn, Mg, In, Al, W, Cr, B, and Sn, Me1 and Me2 may be the same element or may be different. "○" means an oxygen element.)

**16.** The resist layered product according to claim 14 or 15, wherein a ratio (lr1/Pave) of a total film thickness (lr1) of a first resist layer to an (n-1)th resist layer to an average pitch (Pave) of the fine pattern meets following equation (11).

Eq. (11)

$$0.01 \leq (lr1/Pave) \leq 5$$

**17.** The resist layered product according to any one of claims 11 to 16, wherein in the fine pattern, the average pitch (Pave) meets following equation (12).

Eq. (12)

$$50\ nm \leq Pave \leq 1500\ nm$$

**18.** The resist layered product according to claim 17, wherein Young' s modulus (longitudinal modulus) of a layered resist comprised of (n-1) layers of from a first resist layer to an (n-1)th resist layer ranges from 1 MPa to 10 GPa.

**19.** The resist layered product according to claim 17 or 18, wherein the nth resist layer contains at least one material selected from the group consisting of hydrogen silsesquioxane (HSQ), spin-onglass (SOG), organic spin-on glass (O-SOG), hydrogen silsesquioxane (HSQ) modified with a photopolymerizable group, spin-on glass (SOG) modified with a photopolymerizable group, metal alkoxide, and a silane coupling agent with a photopolymerizable group-terminal.

**20.** The resist layered product according to any one of claims 17 to 19, wherein the fine pattern meets following formula (13).

Eq. (13)

$$0.01 \leq (lcv/lcc) < 0.8$$

**21.** The resist layered product according to any one of claims 17 to 20, wherein the fine pattern meets following formula (14).

Eq. (14)

$$0.5 \leq (Vr2/Vcm) \leq 1.4$$

**22.** The resist layered product according to claim 20 or 21, wherein the fine pattern has a dot structure comprised of a plurality of convex portions, a length (lx) of a longest segment on a surface to form a vertex portion of a single convex portion in the dot structure is 500 nm or less, and an area of the vertex portion is smaller than an area of a bottom portion of the convex portion.

**23.** The resist layered product according to claim 20 or 21, wherein the fine pattern has a hole structure comprised of a plurality of concave portions, a ratio (Sh/Scm) of an opening portion area (Sh) existing under a region of a unit area (Scm) of the fine pattern to the unit area (Scm) meet following equation (15), a length of a shortest segment (ly) connecting between an opening edge portion of optional one hole (A) in the hole structure and an opening edge portion of another hole (B) closest to the optional one hole (A) is 500 nm or less, and an opening width of the hole of the hole structure is larger than a width of a bottom portion.

Eq. (15)

$$0.45 < (Sh/Scm) \leq 0.99$$

**24.** The resist layeredproduct according to claim 22 or 23, wherein transfer of the concavo-convex structure of the fine pattern to the nth resist layer with the mold is performed under a reduced pressure, in a vacuum, in an environment of inert gas or in an environment of compressible gas, a temperature of the mold or the inorganic substrate is 200°C or less in the transfer, and a pressing force is 5 MPa or less.

**25.** The resist layered product according to any one of claims 22 to 24, wherein the fine pattern is made of one of polyimide, a cycloolefin resin, a fluorine-containing resin, a silicone-containing resin and polydimethylsiloxane.

**26.** The resist layered product according to any one of claims 22 to 25, further comprising:

a demolding layer provided on the fine pattern.

**27.** The resist layered product according to any one of claims 22 to 25, further comprising:

a metal layer provided on the fine pattern; and
a demolding layer provided on the metal layer.

**28.** The resist layered product according to any one of claims 22 to 27, wherein the mold is provided with a mold substrate and the fine pattern provided on a main surface of the mold substrate, the mold substrate has flexibility, and the fine pattern is one of a cured material of a fluorine-containing photocurable resin, a cured material of a methyl group-containing photocurable resin and a cured material of a fluorine and methyl group-containing photocurable resin.

**29.** The resist layered product according to any one of claims 22 to 28, wherein the inorganic substrate is a sapphire substrate, a SiC substrate, a ZnO substrate, a Si substrate or a nitride semiconductor substrate.

**30.** The resist layered product according to any one of claims 11 to 27, wherein the layered number n of the resist layer comprised of n layers is two or three.

**31.** Amethodof manufacturing the resist layeredproduct according to any one of claims 11 to 30, including:

a pressing step of pressing a fine pattern of a mold against a surface of an nth resist layer in an atmosphere of low oxygen to obtain a mold layered product;
an energy ray irradiation step of irradiating the nth resist layer of the mold layered product with an energy ray from the mold side and/or the inorganic substrate side, and transferring the fine pattern to the nth resist layer to provide the concavo-convex structure; and
a mold release step of peeling off the mold from the nth resist layer with the concavo-convex structure transferred thereto to obtain the resist layered product, wherein the resist layered product meets following equation (16).

Eq. (16)

$$0.1 \leq (Vr2/Vcm) \leq 1$$

**32.** The method of manufacturing the resist layered product according to claim 31, wherein the resist layered product meets following equation (17).

Eq. (17)

$$0.5 \leq (Vr2/Vcm) \leq 1$$

**33.** The method of manufacturing the resist layered product according to claim 31 or 32, wherein in the energy ray irradiation step, the energy ray is applied while pressing the fine pattern against the nth resist layer.

**34.** Amethodof manufacturing the resist layeredproduct according to any one of claims 11 to 30, including:

a pressing step of pressing a fine pattern of a mold against a surface of an nth resist layer to obtain a mold layered product;
an energy ray irradiation step of irradiating the nth resist layer of the mold layered product with an energy ray from the mold side and/or the inorganic substrate side, and transferring the fine pattern to the nth resist layer to provide the concavo-convex structure; and
a mold release step of peeling off the mold from the nth resist layer with the concavo-convex structure transferred thereto to obtain the resist layered product, wherein the resist layered product meets following equation (18).

Eq. (18)

$$1 < (Vr2/Vcm) \leq 1.5$$

**35.** The method of manufacturing the resist layered product according to claim 34, wherein the resist layered product meets following equation (19).

Eq. (19)

$$1<(Vr2/Vcm)\leqq 1.3$$

**36.** The method of manufacturing the resist layered product according to claim 34 or 35, wherein the pressing step is performed in an atmosphere of low oxygen.

**37.** A concavo-convex structure product manufactured by using the resist layered product according to any one of claims 11 to 30, wherein the concavo-convex structure product is manufactured by a manufacturing method including a first etching step of removing, by dry etching, a residual film of the nth resist layer existing between a bottom portion of a concave portion in the concavo-convex structure of the nth resist layer and an interface between an (n-1) th resist layer and the nth resist layer from the surface side with the nth resist layer provided,
a second etching step of etching, by dry etching, a first to the (n-1)th resist layers up to an interface between the first resist layer and the inorganic substrate after removing the residual film, and
a third etching step of etching the inorganic substrate after the second etching step.

**38.** The concavo-convex structure product according to claim 37, wherein in the third etching step, dry etching is performed until the first resist layer disappears.

**39.** The concavo-convex structure product according to claim 37 or 38, wherein a fourth etching step of removing the nth resist layer by dry etching is further included between the second etching step and the third etching step.

**40.** A method of manufacturing a resist layered product having a concavo-convex structure on a part or whole of a surface thereof, comprising:

preparing an inorganic substrate provided with a resist layer on one main surface thereof; and
pressing the mold according to any one of claims 1 to 9 against the resist layer.

**41.** The methodof manufacturing a resist layeredproduct according to claim 40, wherein the concavo-convex structure of the mold meets following requirements (i) to (iv):

(i) a ratio (Sh/Scm) between a unit area (Scm) of the concavo-convex structure and an opening portion area (Sh) existing under a region of the unit area (Scm) meets $0.4\leq(Sh/Scm)\leq0.99$;
(ii) a ratio (lcv/lcc) of a top width of convex-portion (lcv) to an opening width of concave-portion (lcc) of the concavo-convex structure meets $0.01\leq(lcv/lcc)<1.0$;
(iii) the ratio (lcv/lcc) and the ratio (Sh/Scm) meet following equation (5); and
[Mathematical Expression 4]

Eq. (5)

$$\sqrt{0.76/(Sh/Scm)}-1\leqq lcv/lcc\leqq\sqrt{0.93/(Sh/Scm)}-1$$

(iv) a height of the concavo-convex structure ranges from 50 nm to 1000 nm.

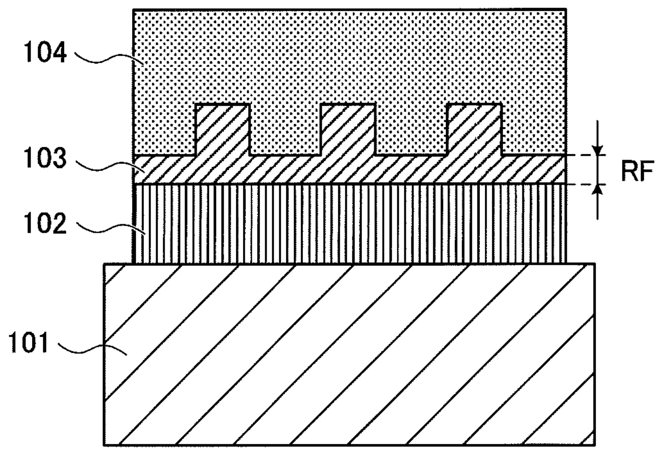


FIG.1

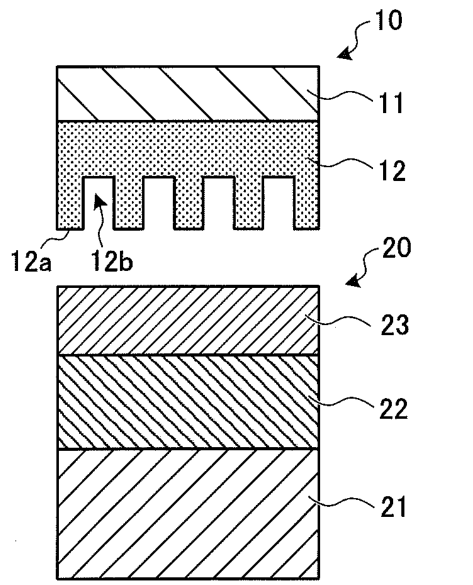


FIG.2A

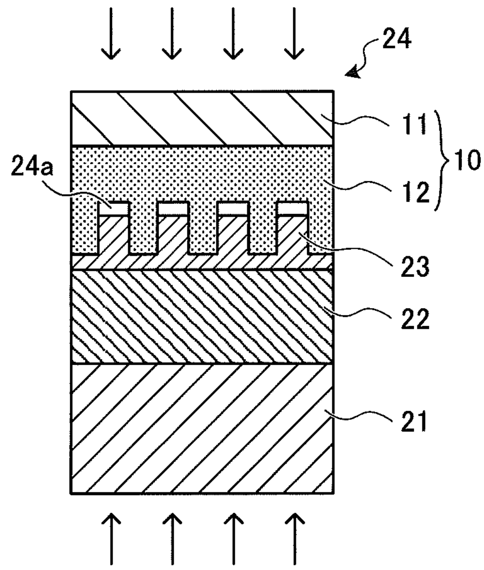


FIG.2C

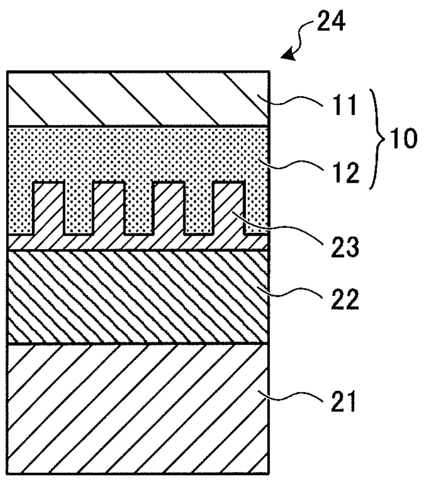


FIG.2B

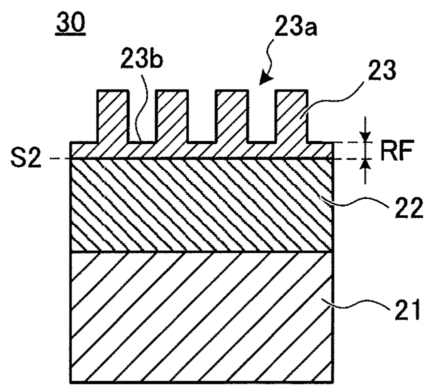


FIG.2D

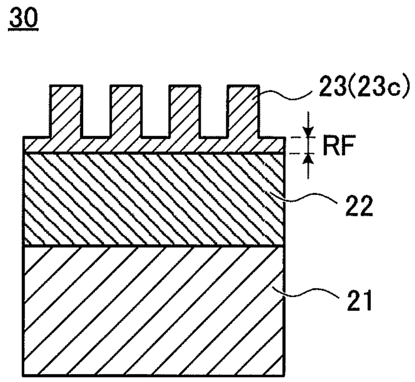


FIG.3A

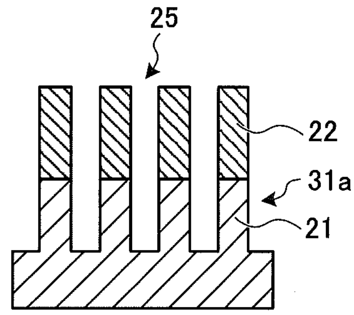


FIG.3D

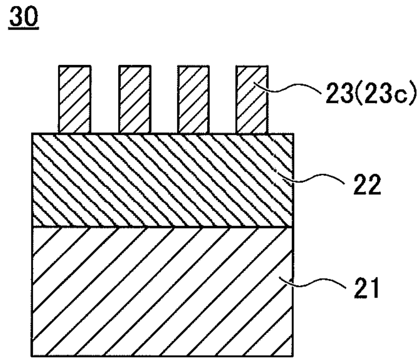


FIG.3B

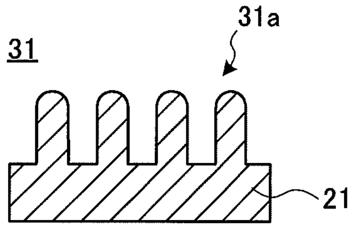


FIG.3E

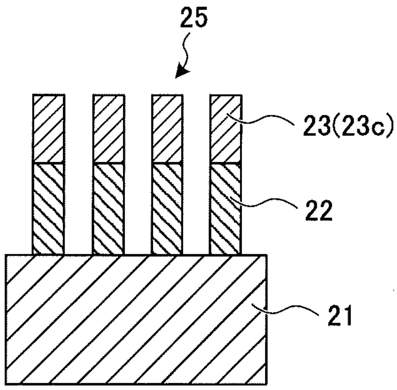


FIG.3C

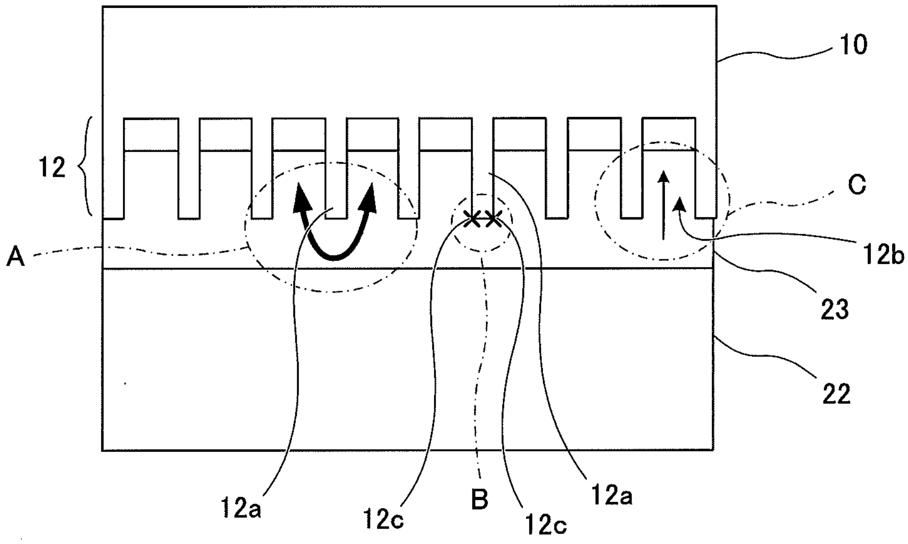


FIG.4

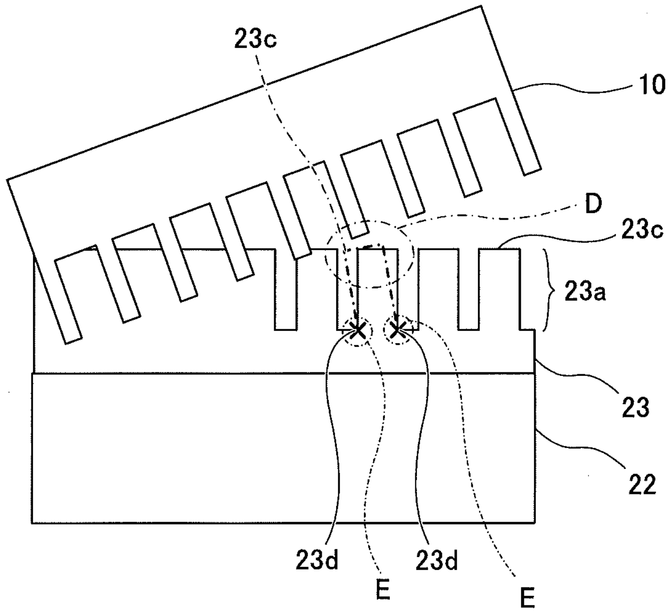


FIG.5A

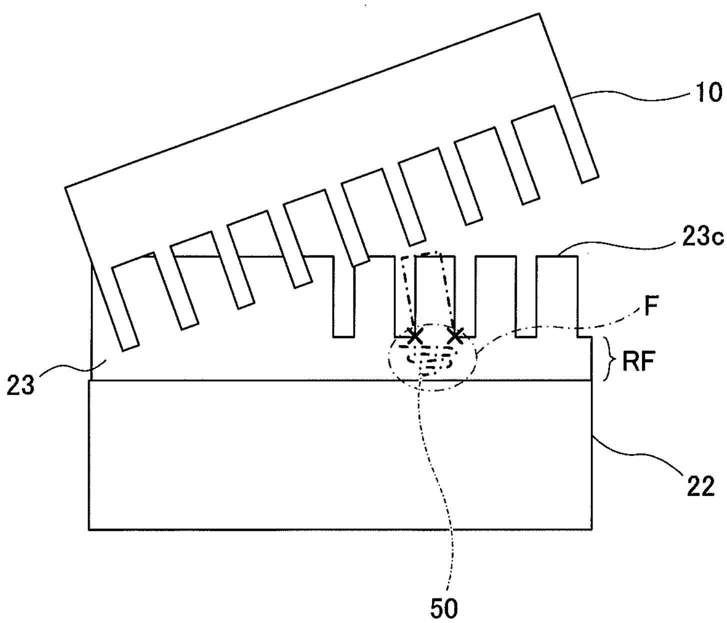


FIG.5B

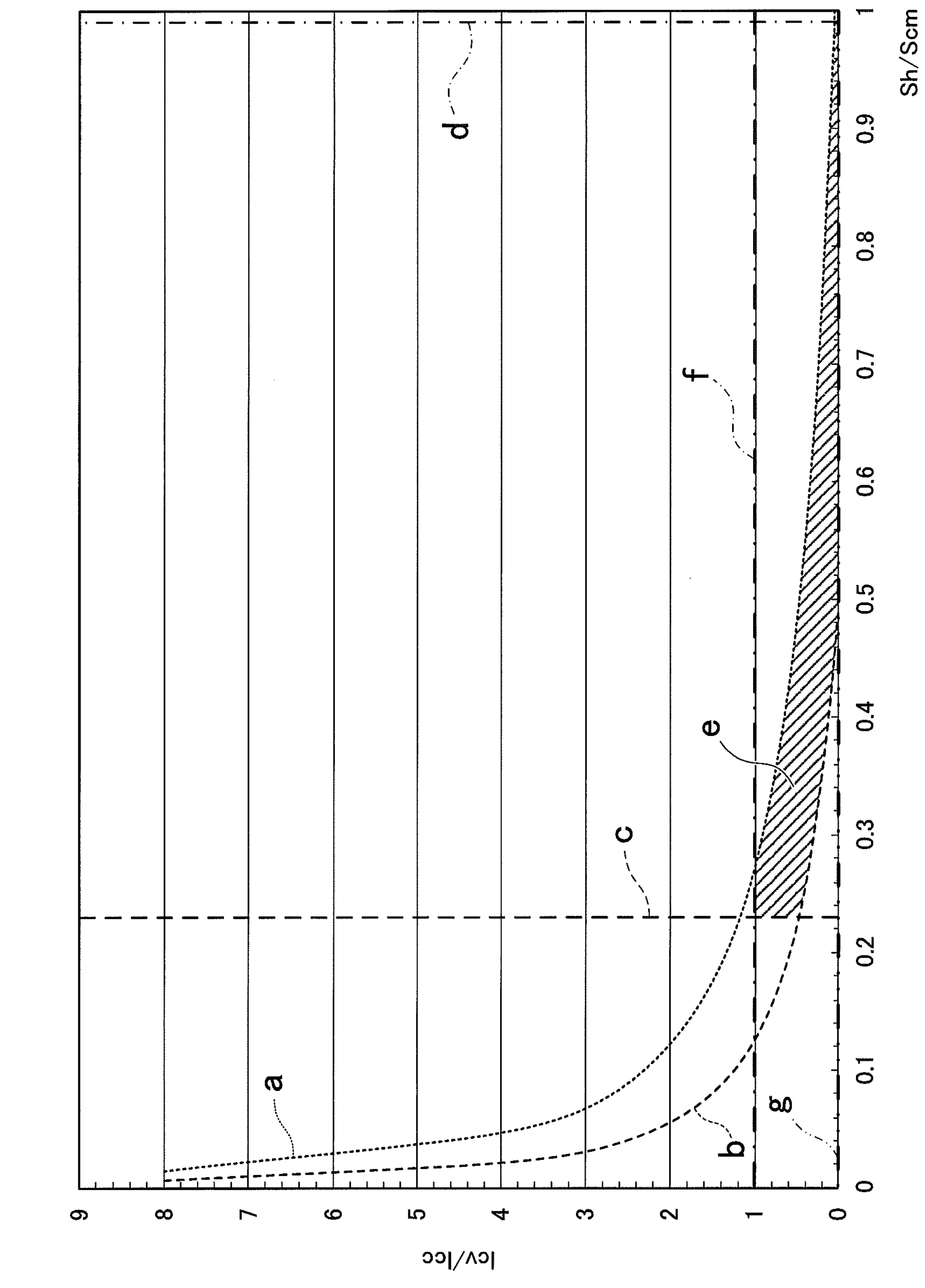


FIG.6

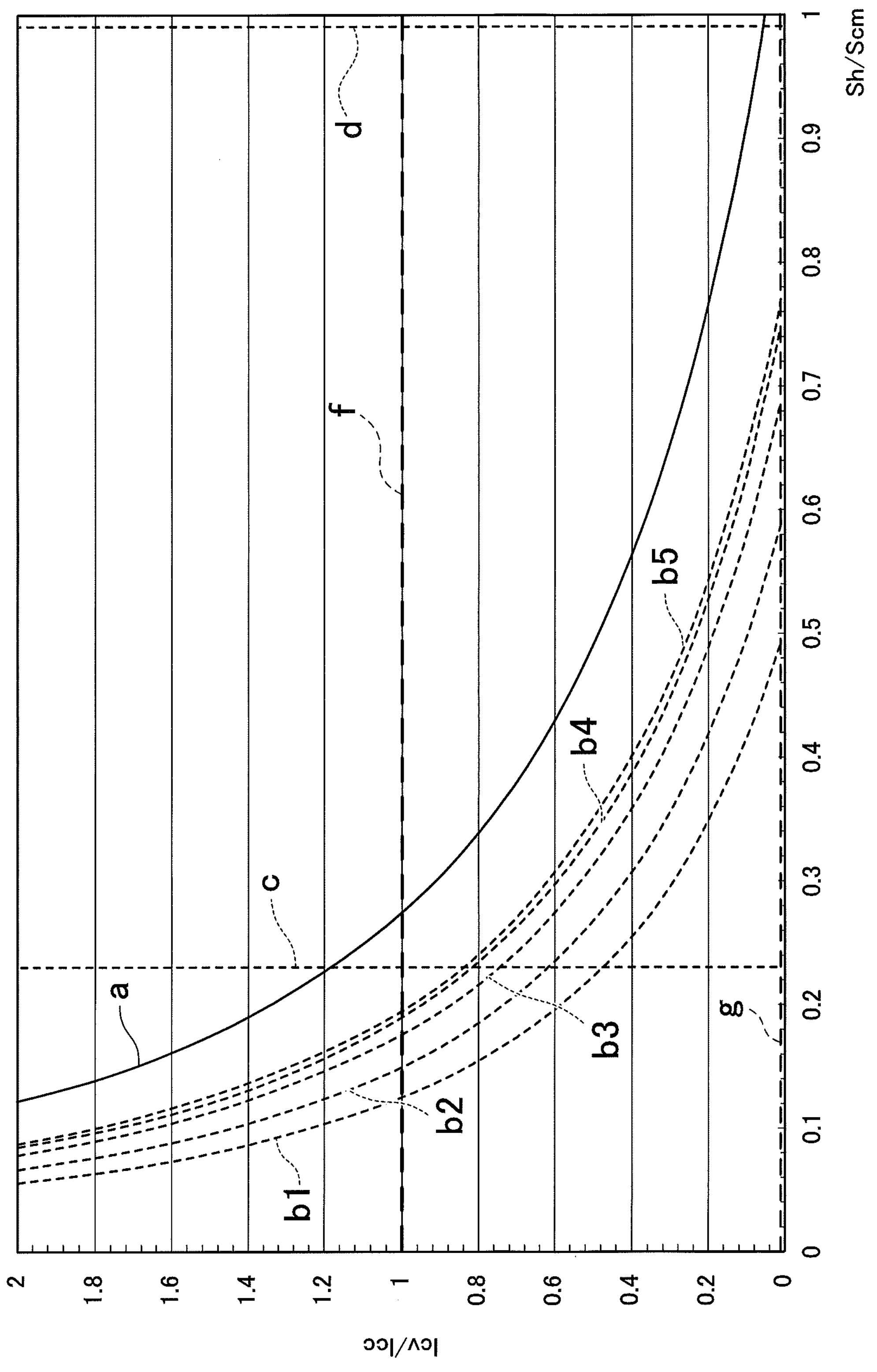
Icv/Icc
Sh/Scm
0
0.2
0.4
0.6
0.8
1
1.2
1.4
1.6
1.8
2
0.1
0.2
0.3
0.4
0.5
0.6
0.7
0.8
0.9
a
b1
b2
b3
b4
b5
c
d
f
g

FIG.7

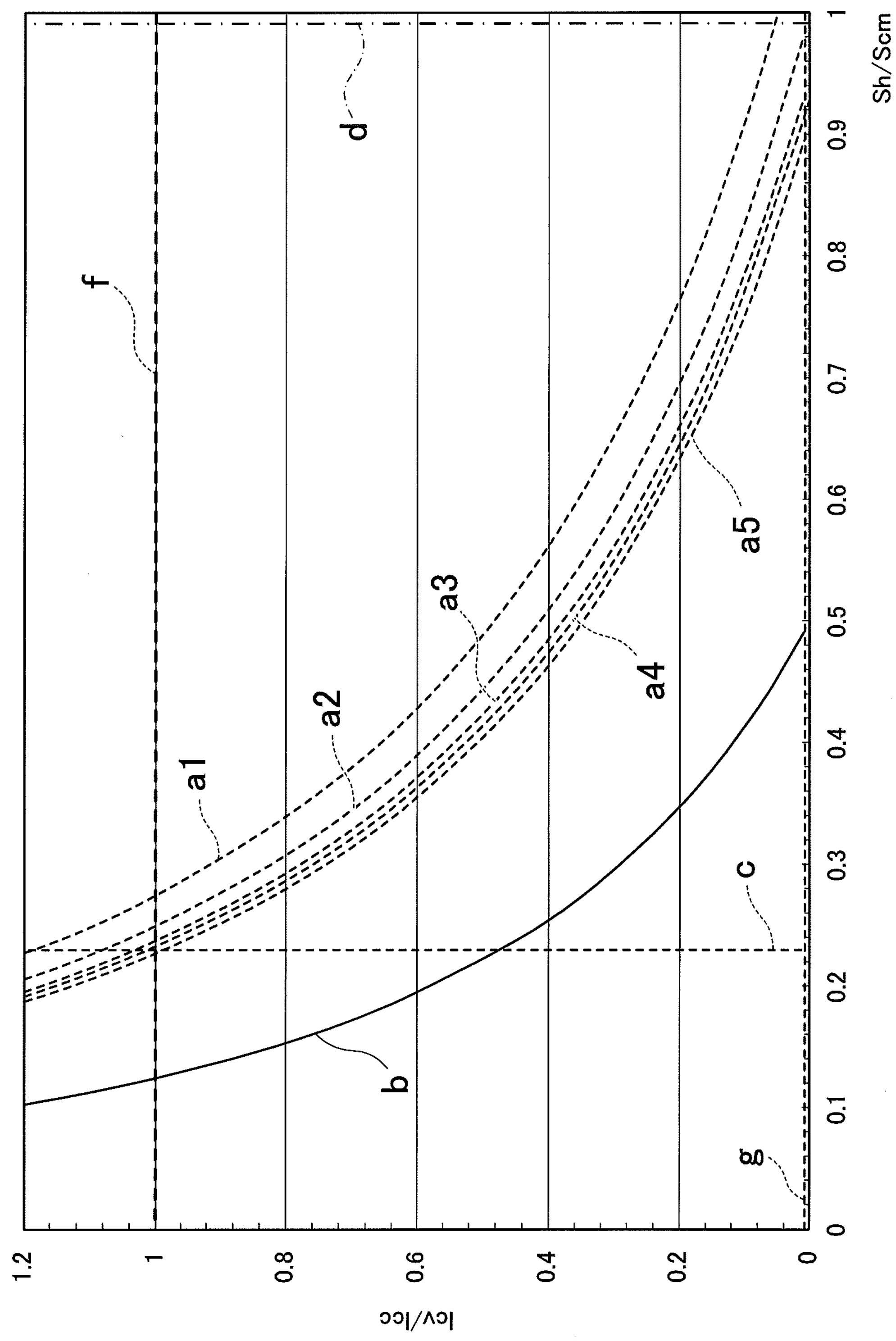
Icv/Icc
1.2
1
0.8
0.6
0.4
0.2
0
Sh/Scm
0
0.1
0.2
0.3
0.4
0.5
0.6
0.7
0.8
0.9
1
a1
a2
a3
a4
a5
b
c
d
f
g

FIG.8

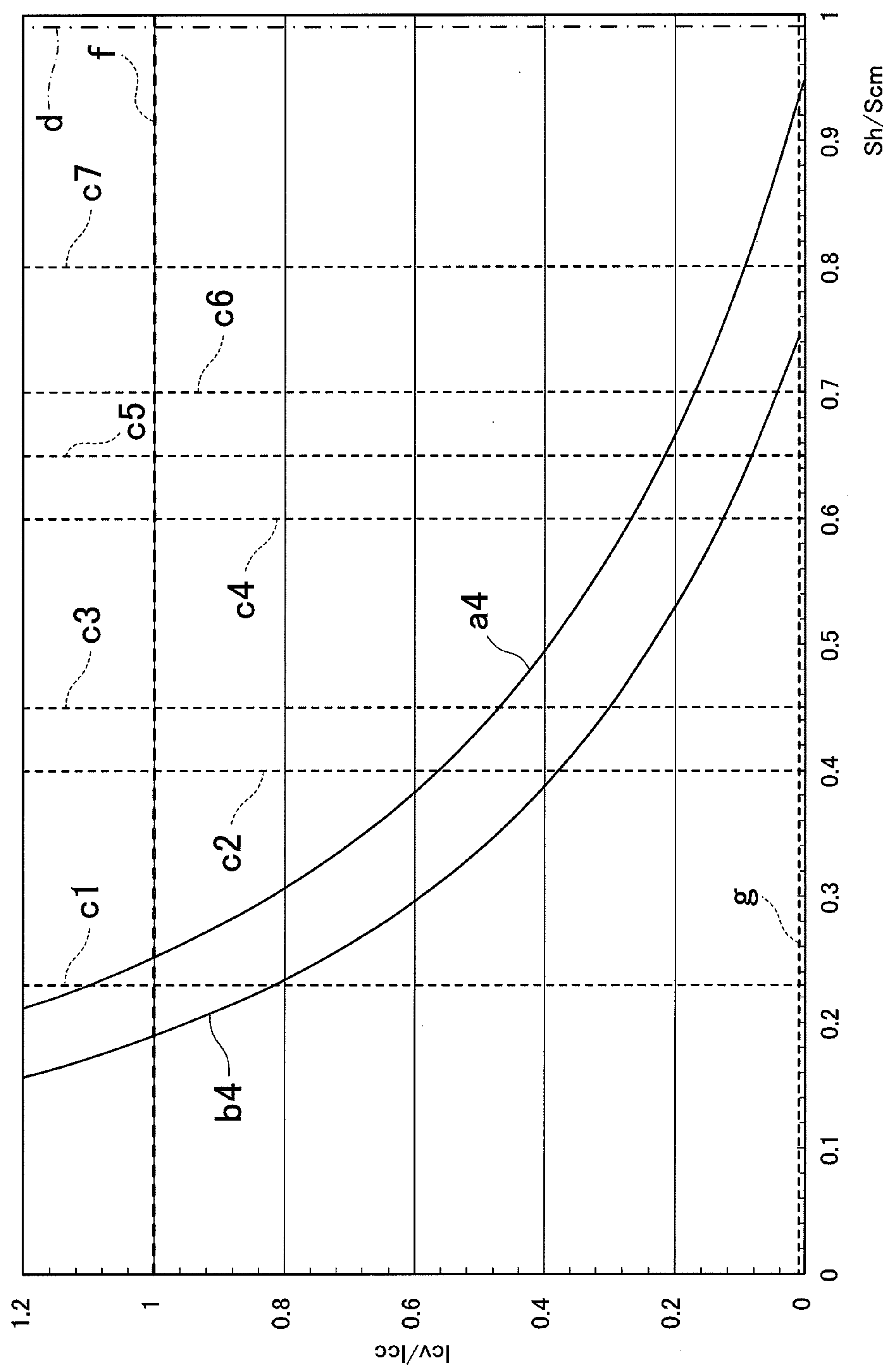
Icv/Icc
Sh/Scm
1.2
1
0.8
0.6
0.4
0.2
0
0.1
0.2
0.3
0.4
0.5
0.6
0.7
0.8
0.9
1
a4
b4
c1
c2
c3
c4
c5
c6
c7
d
f
g

FIG.9

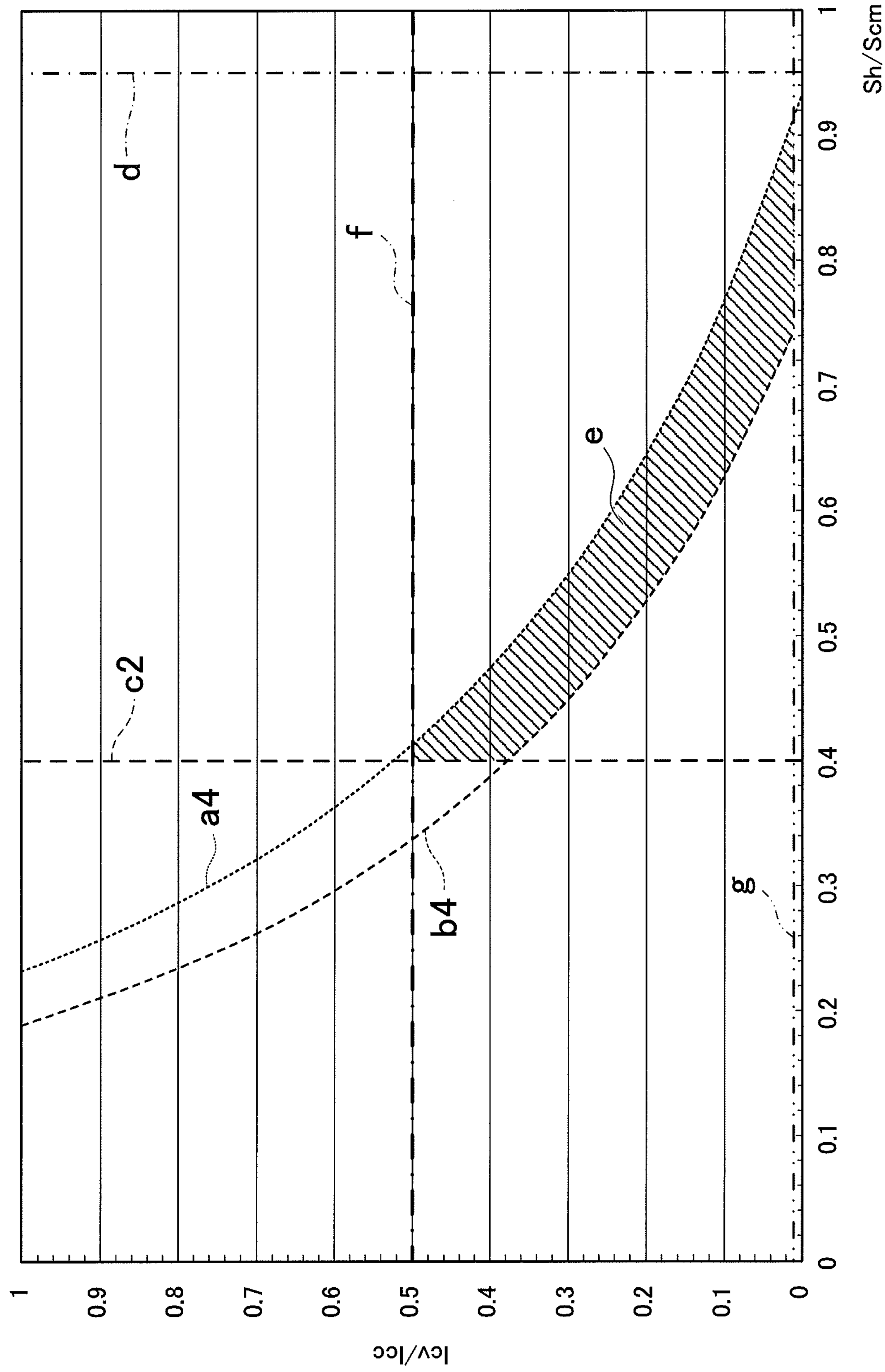


FIG.10

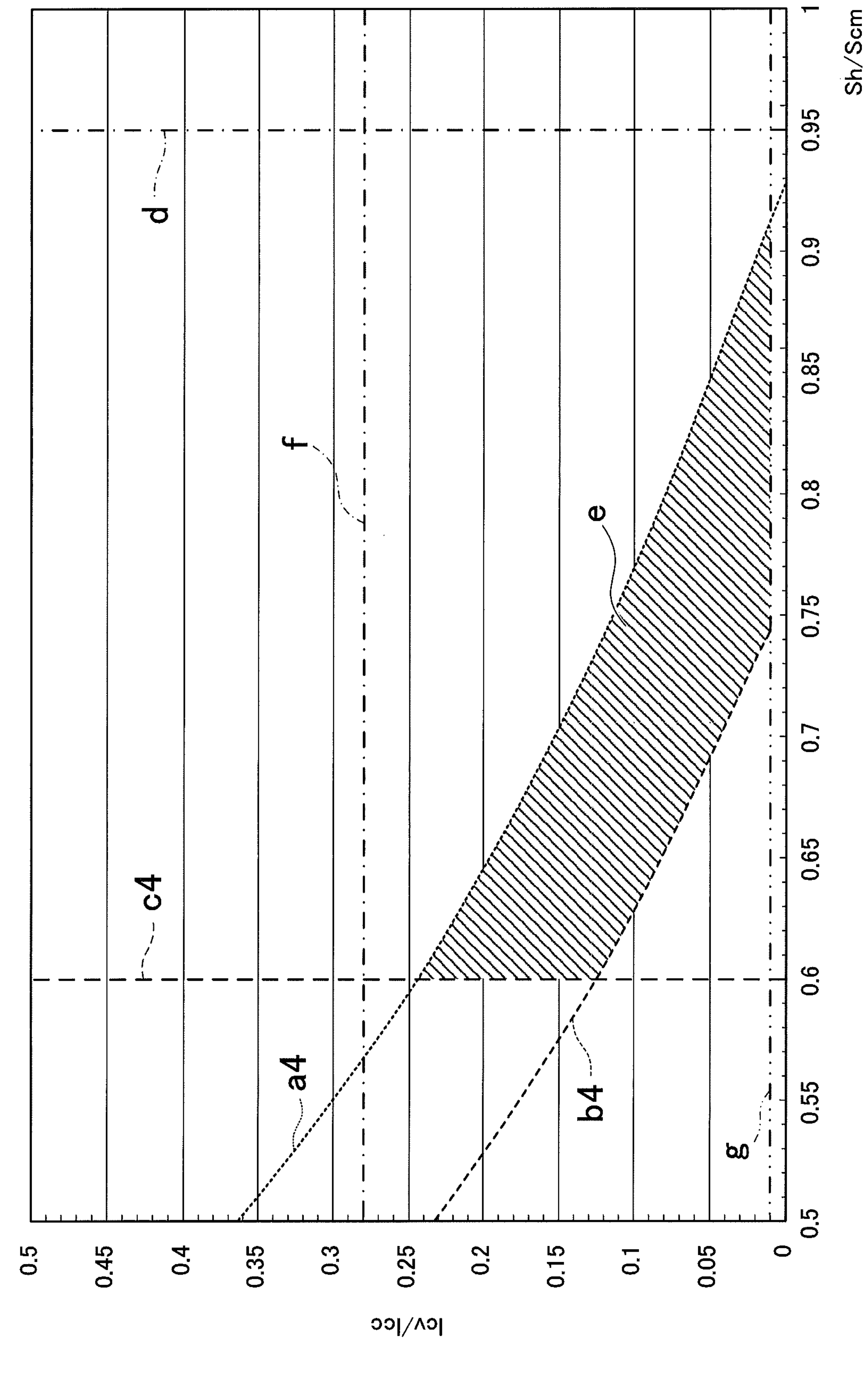
Icv/Icc
Sh/Scm
0.5
0.45
0.4
0.35
0.3
0.25
0.2
0.15
0.1
0.05
0
0.5
0.55
0.6
0.65
0.7
0.75
0.8
0.85
0.9
0.95
1
a4
b4
c4
d
e
f
g

FIG.11

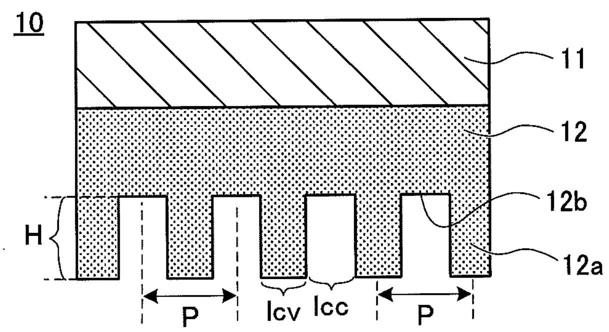


FIG.12

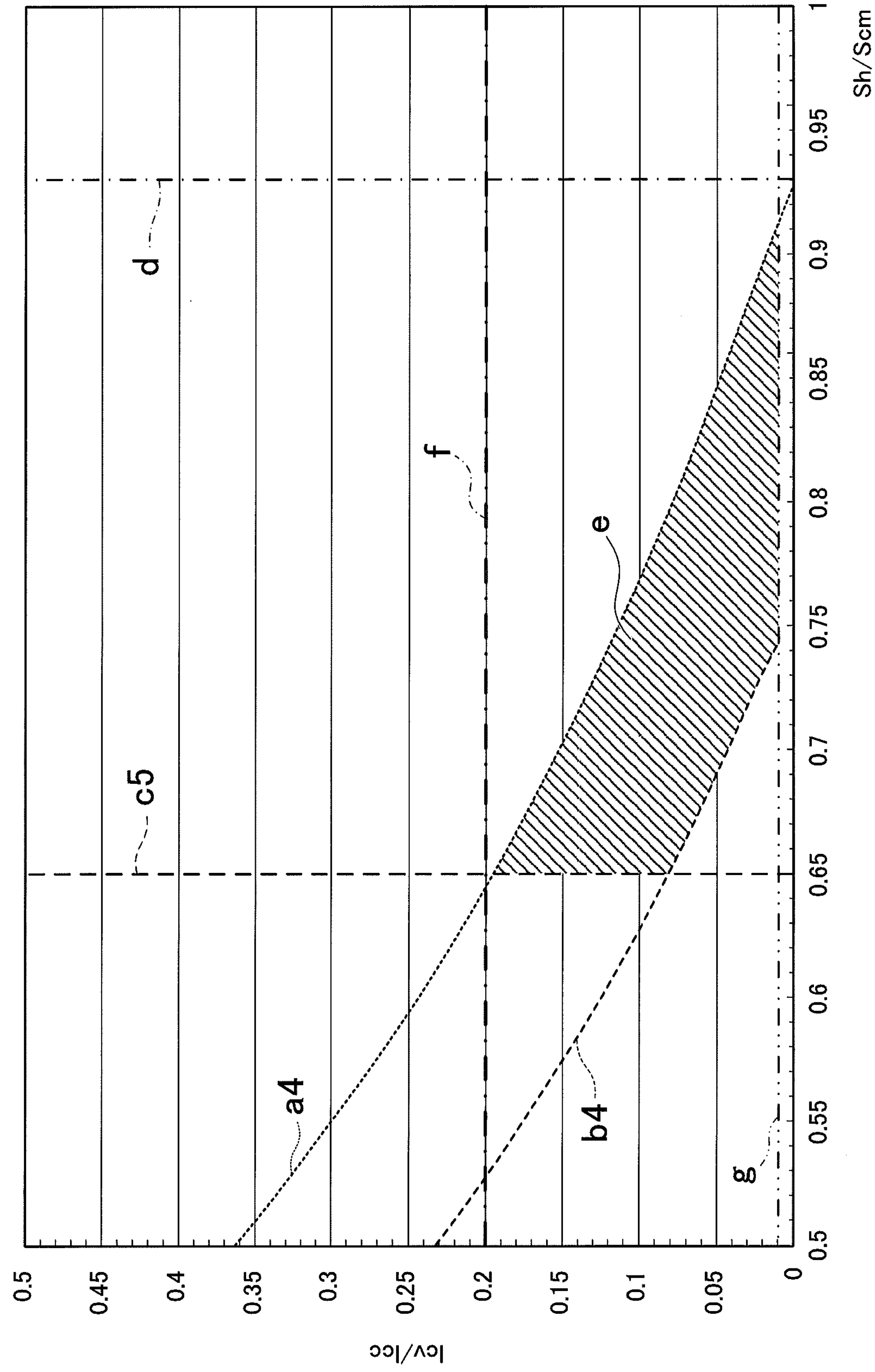
Icv/Icc
Sh/Scm
0
0.05
0.1
0.15
0.2
0.25
0.3
0.35
0.4
0.45
0.5
0.55
0.6
0.65
0.7
0.75
0.8
0.85
0.9
0.95
1
a4
b4
c5
d
e
f
g

FIG.13

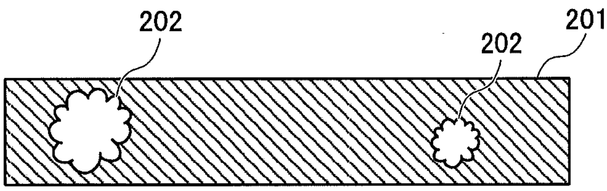


FIG.14A

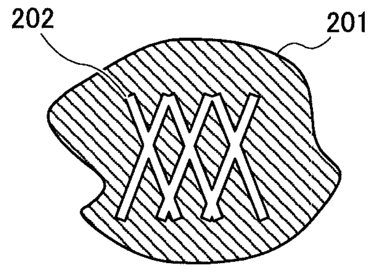


FIG.14C

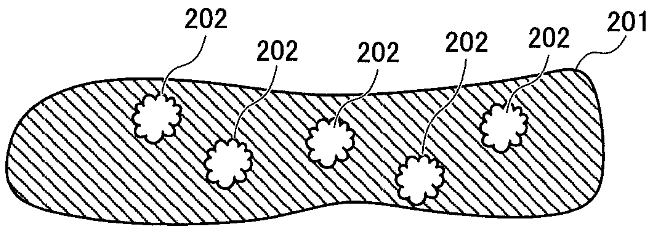


FIG.14B

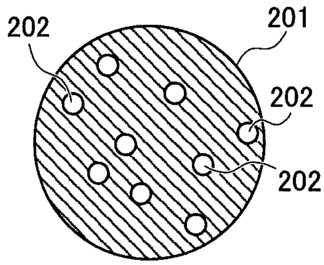


FIG.14D

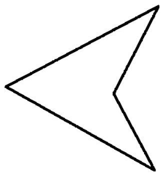

FIG.15A

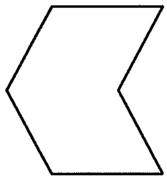

FIG.15B

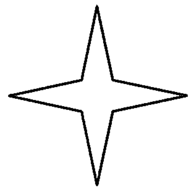

FIG.15C

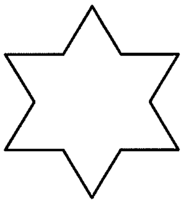

FIG.15D

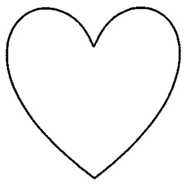

FIG.15E

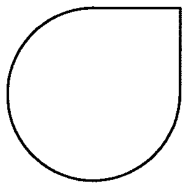

FIG.15F

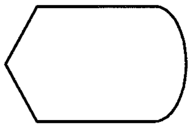

FIG.15G

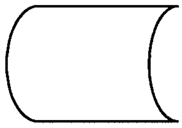

FIG.15H

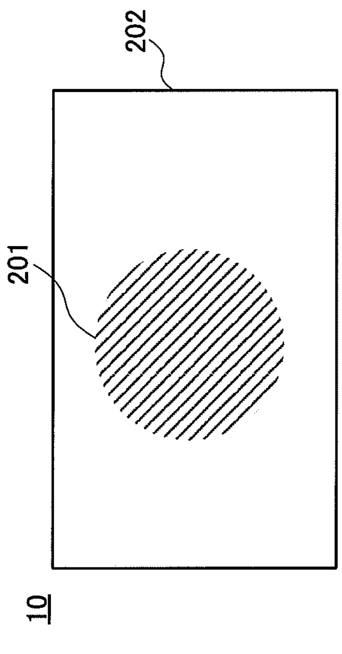


FIG.16A

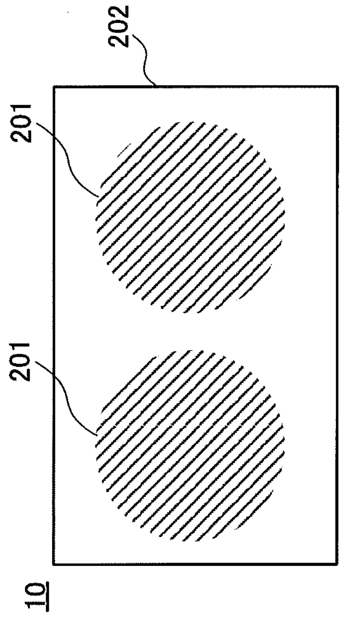


FIG.16B

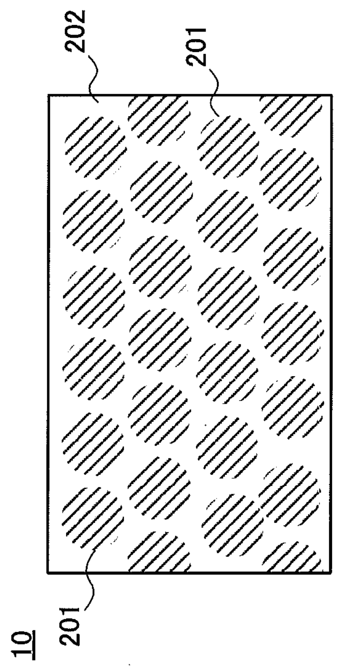


FIG.16C

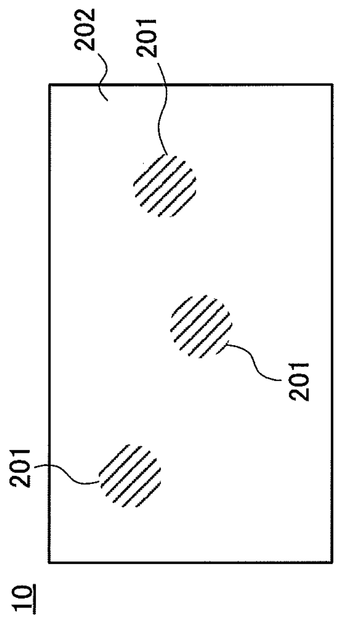


FIG.16D

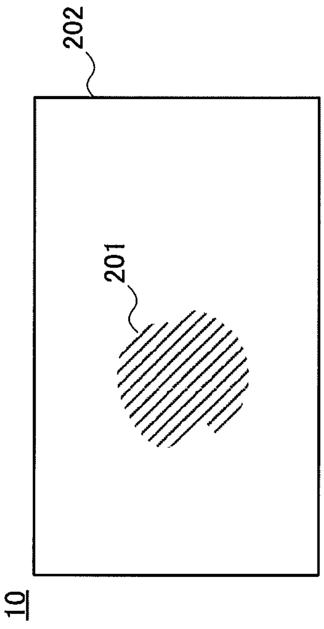


FIG.16E

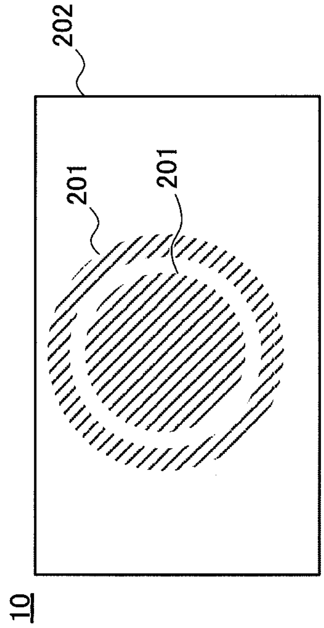


FIG.16F

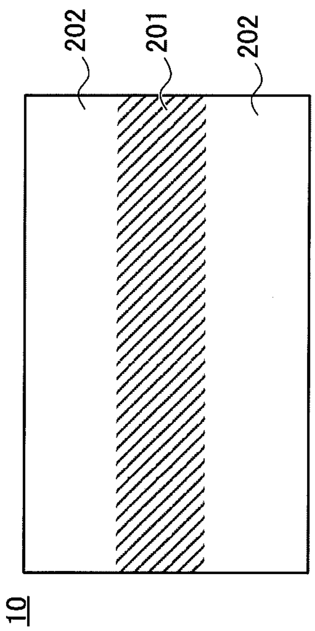

FIG.17A

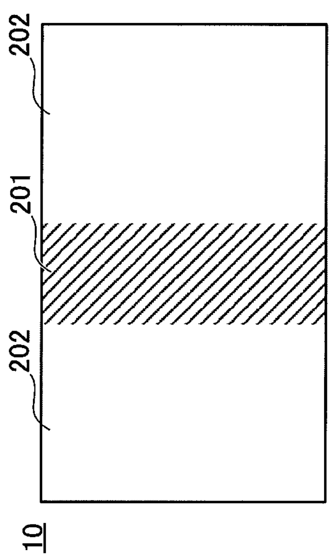

FIG.17B

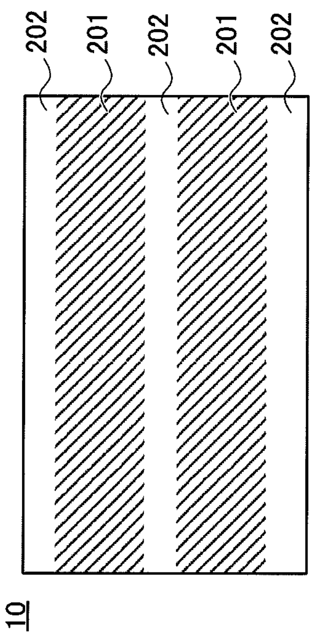

FIG.17C

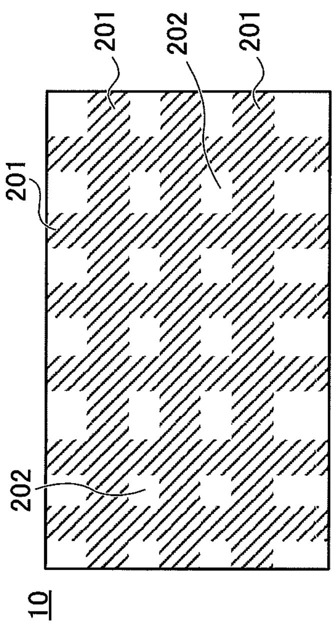

FIG.17D

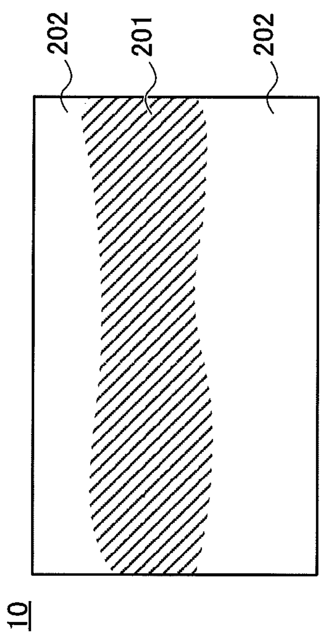

FIG.17E

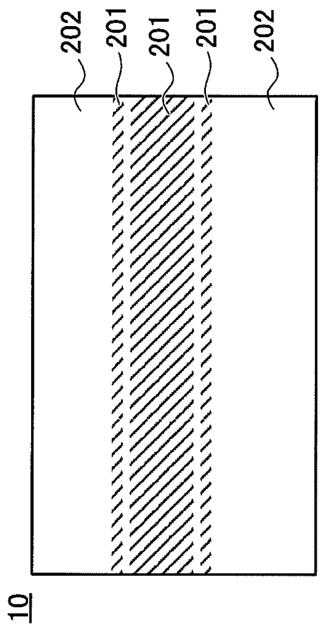

FIG.17F

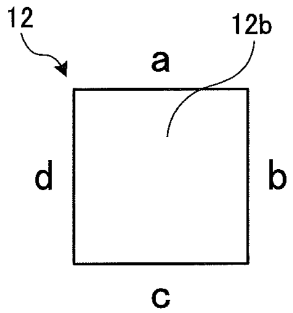


FIG.18A

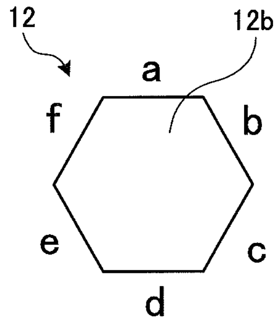


FIG.18B

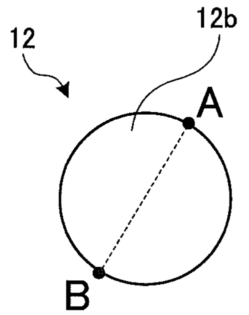


FIG.18C

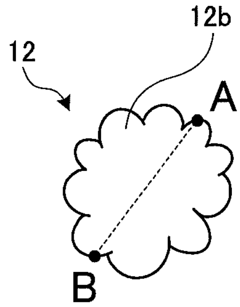


FIG.18D

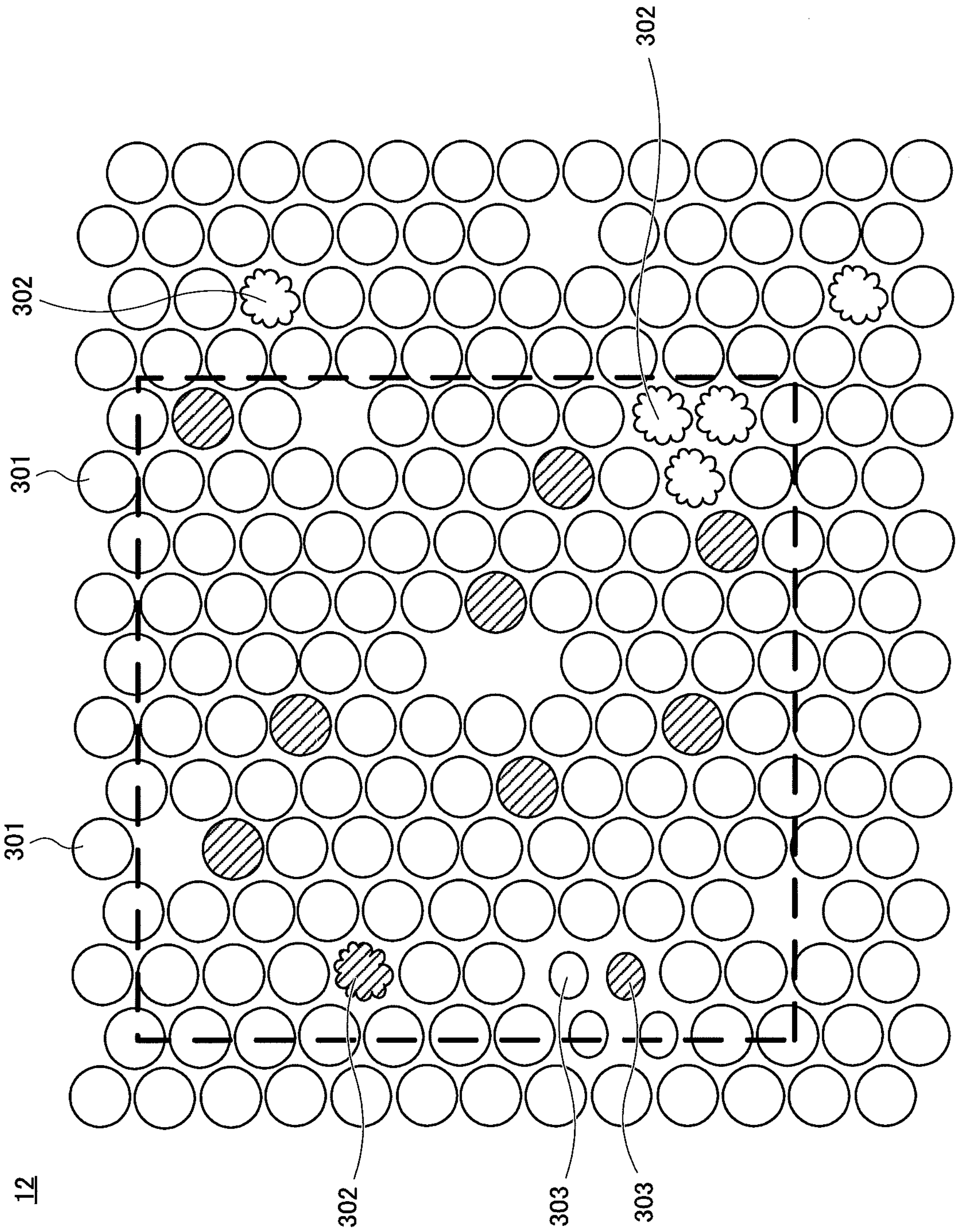


FIG.19

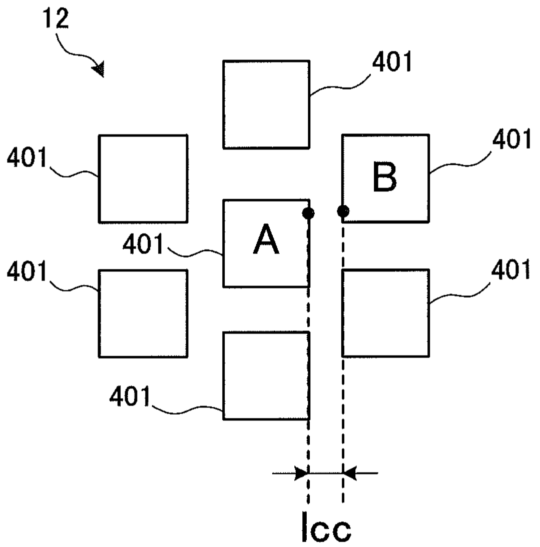


FIG.20A

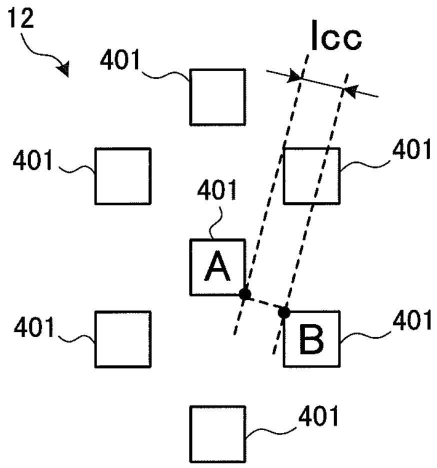


FIG.20B

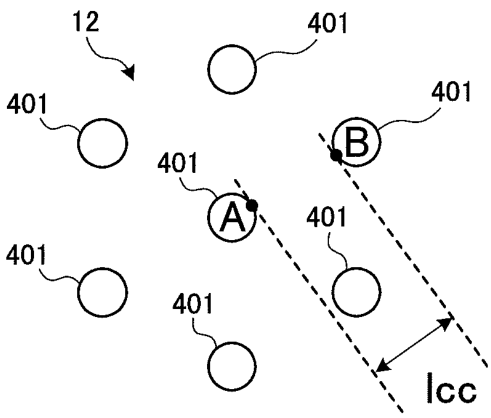


FIG.20C

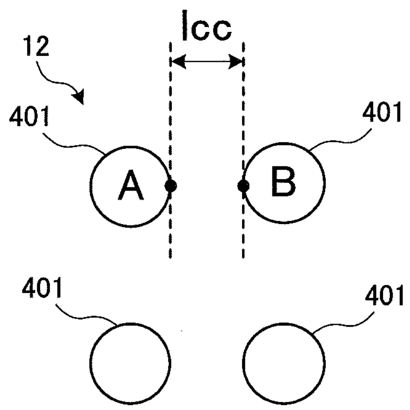


FIG.20D

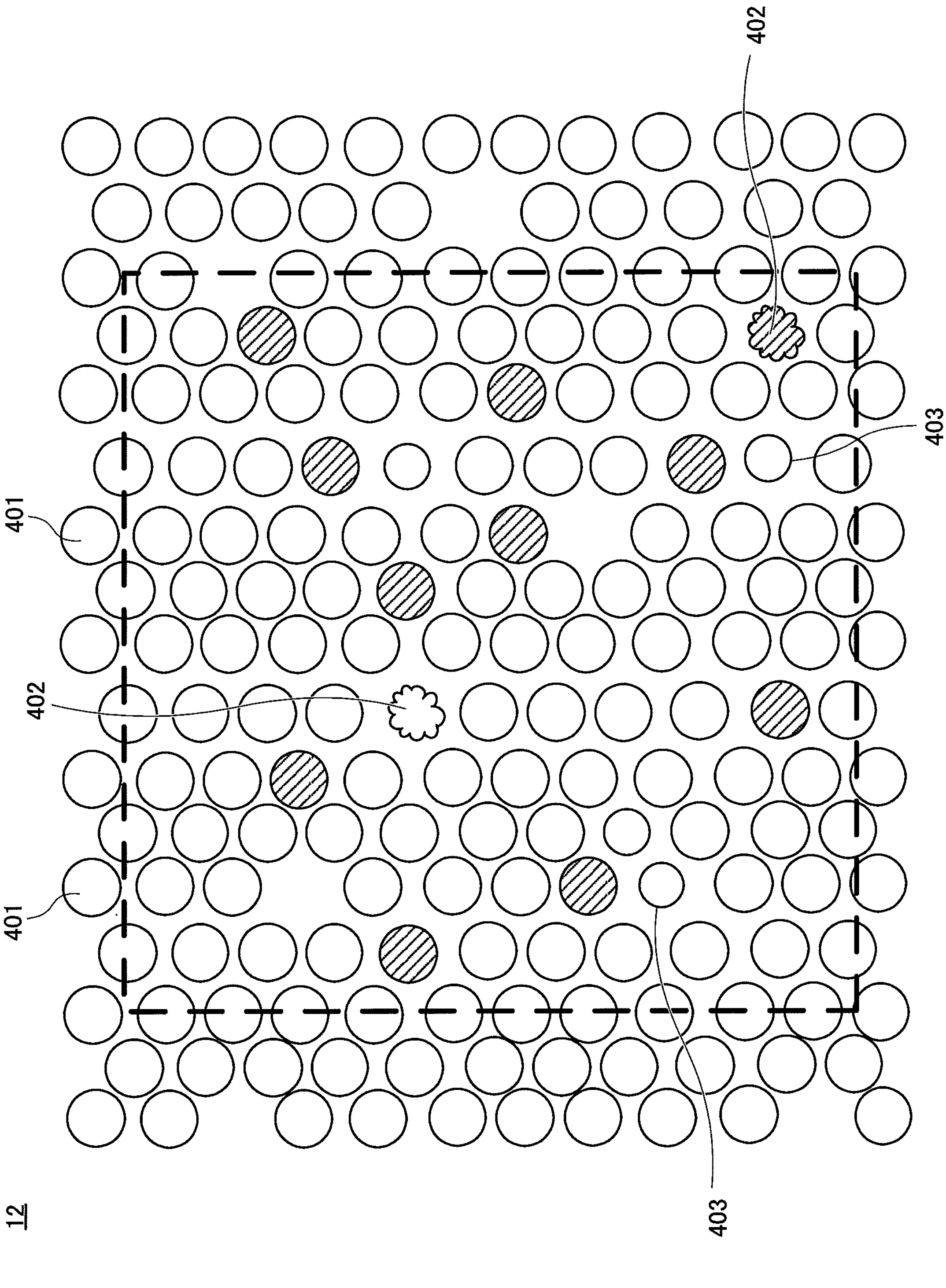


FIG.21

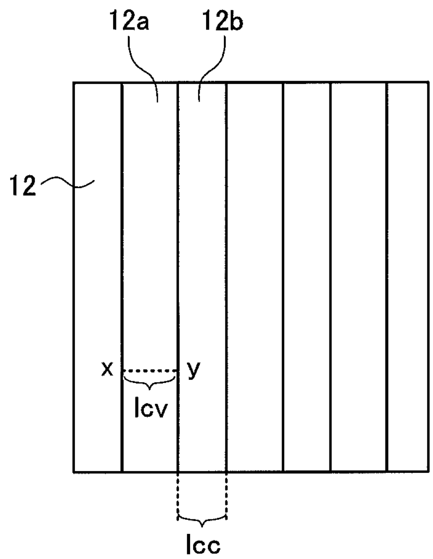


FIG.22

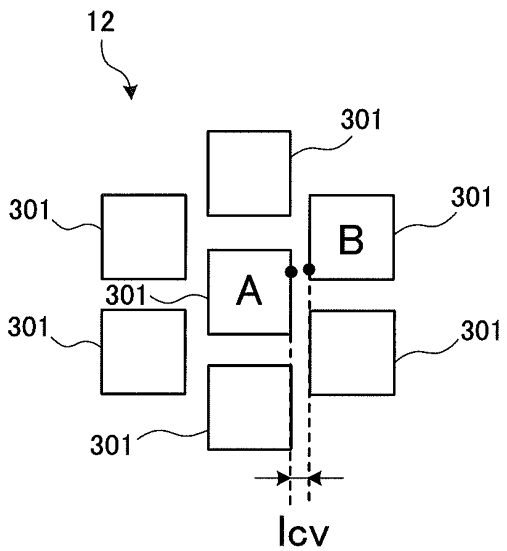


FIG.23A

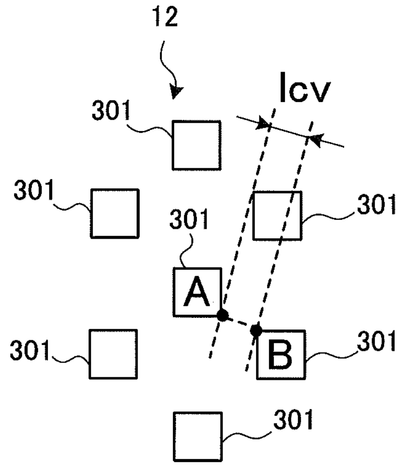


FIG.23B

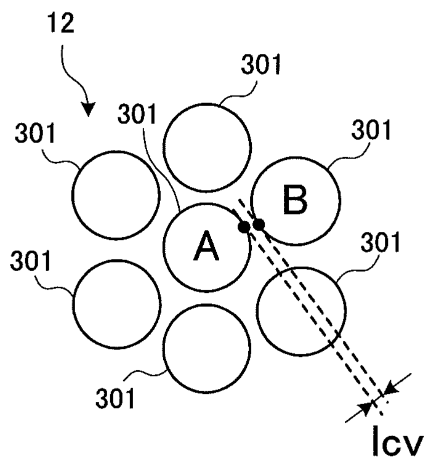


FIG.23C

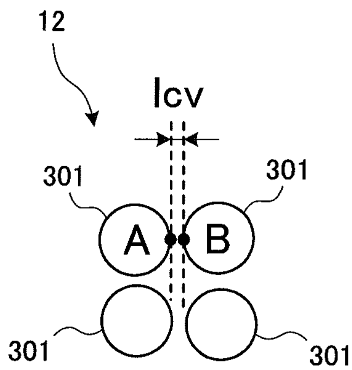


FIG.23D

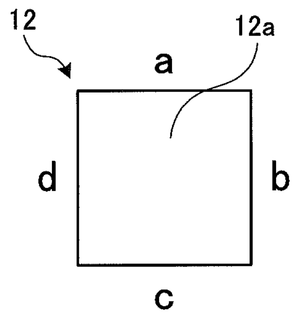


FIG.24A

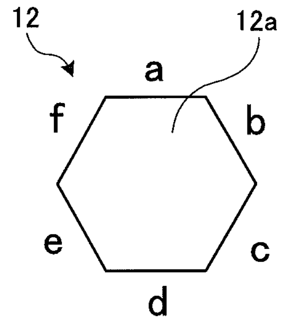


FIG.24B

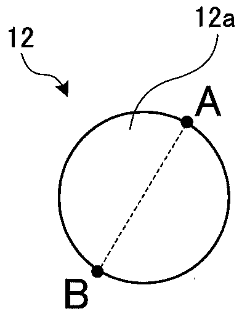


FIG.24C

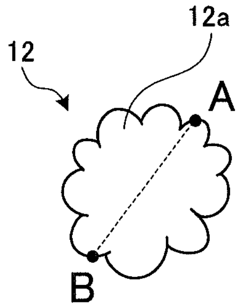


FIG.24D

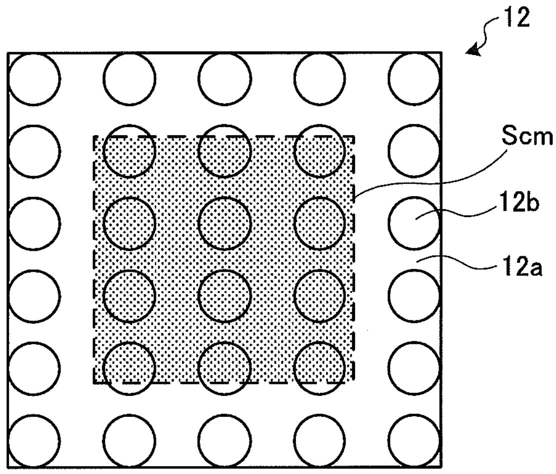


FIG.25A

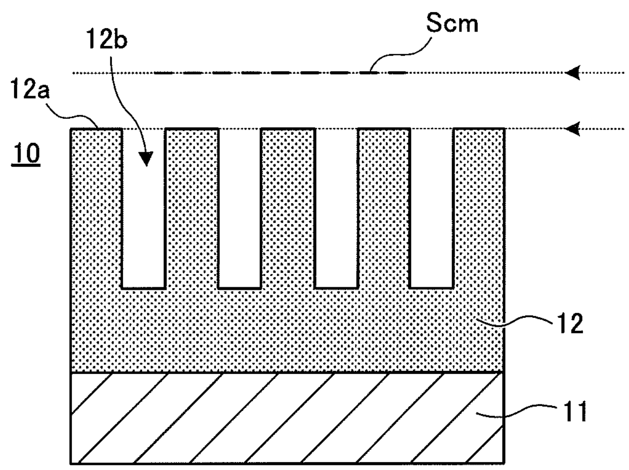


FIG.25B

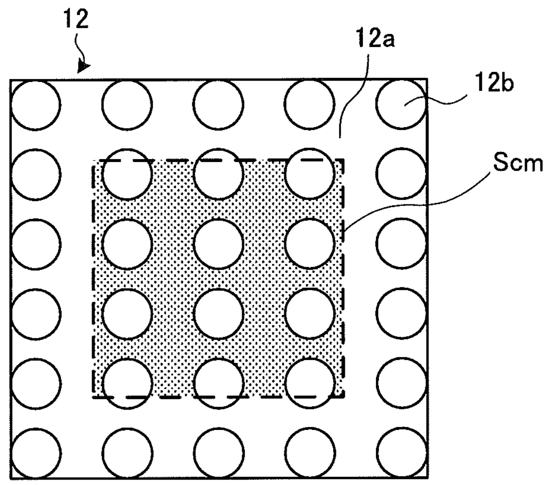


FIG.26A

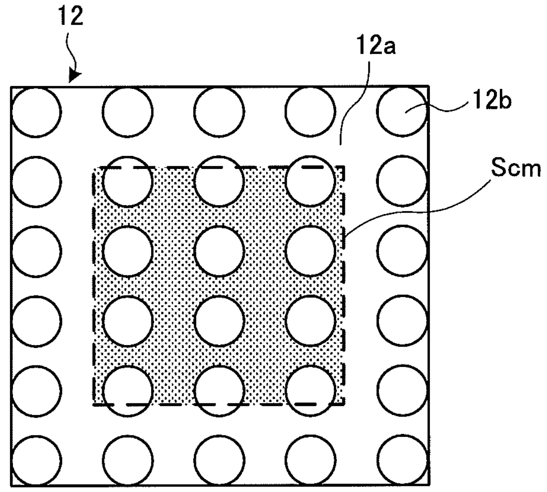


FIG.26B

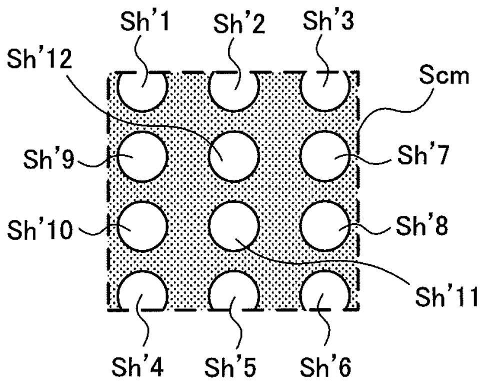


FIG.26C

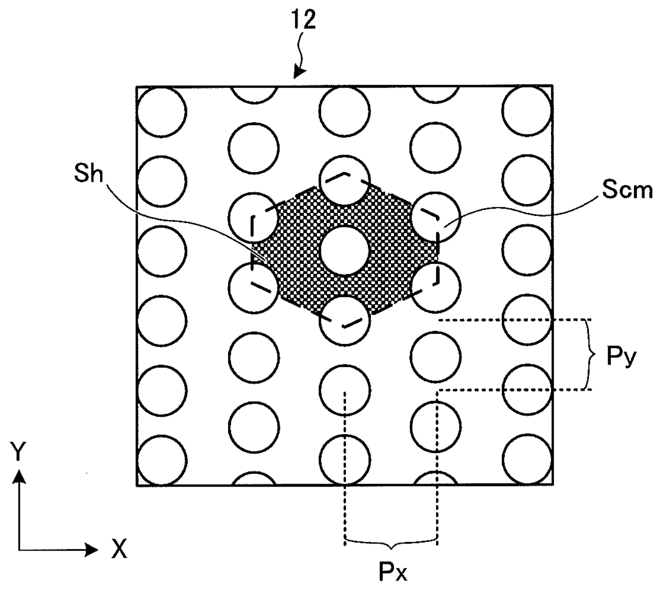


FIG.27

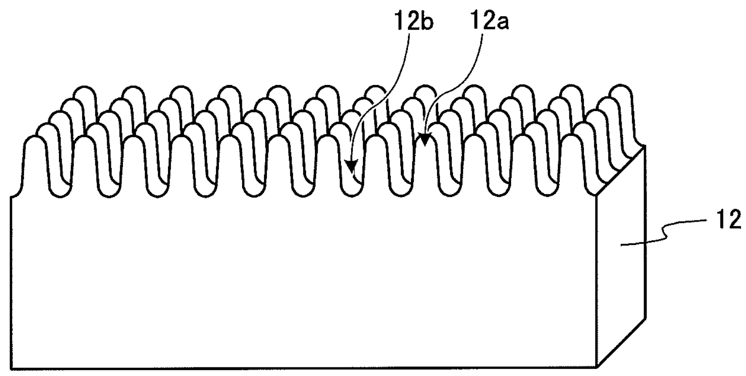


FIG.28A

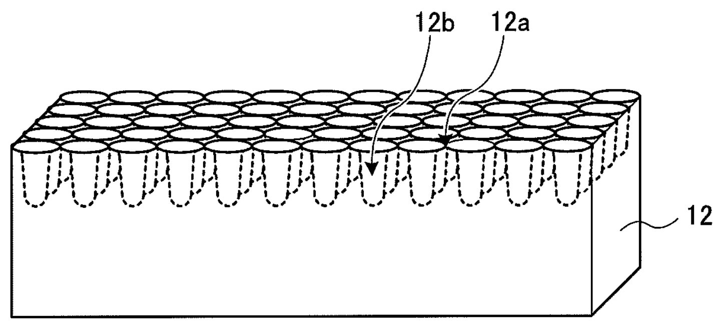


FIG.28B

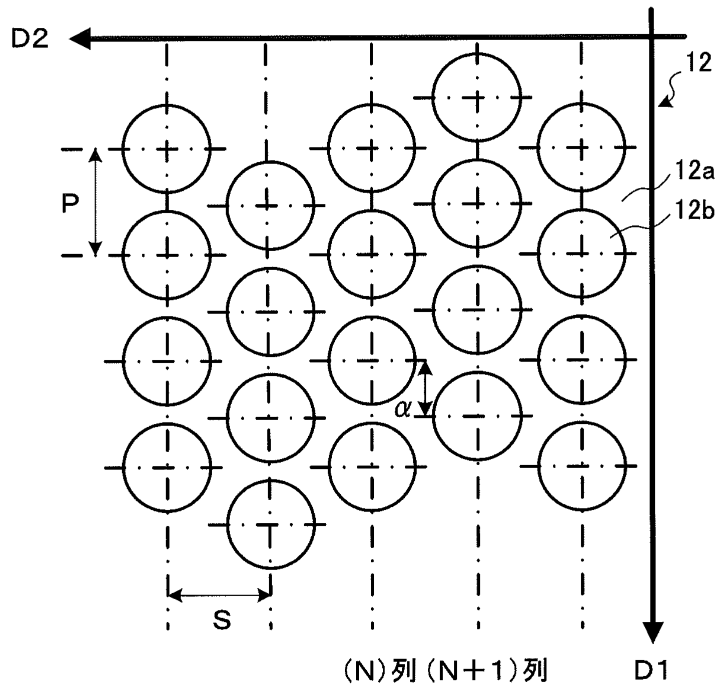


FIG.29

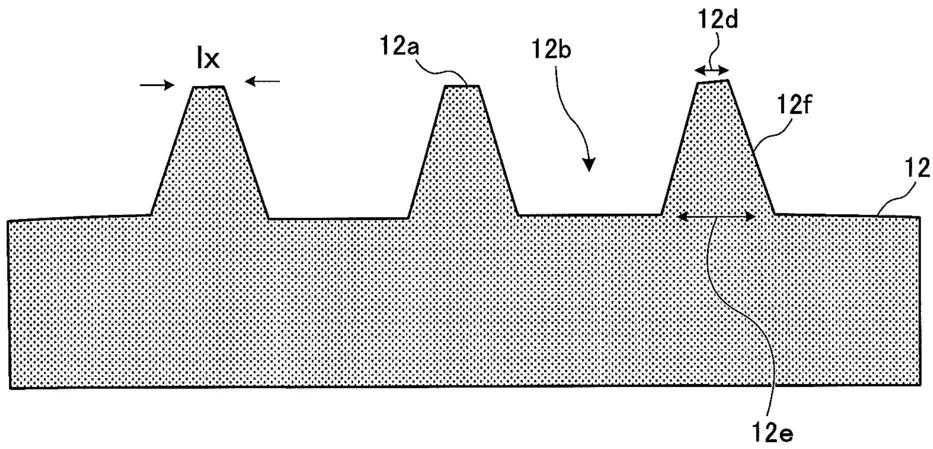


FIG.30A

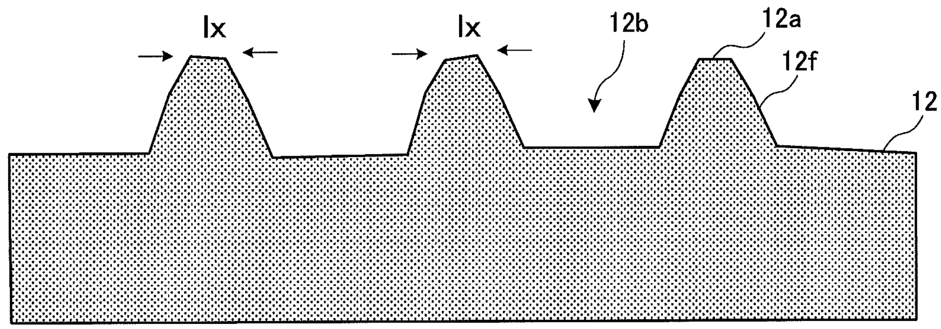


FIG.30B

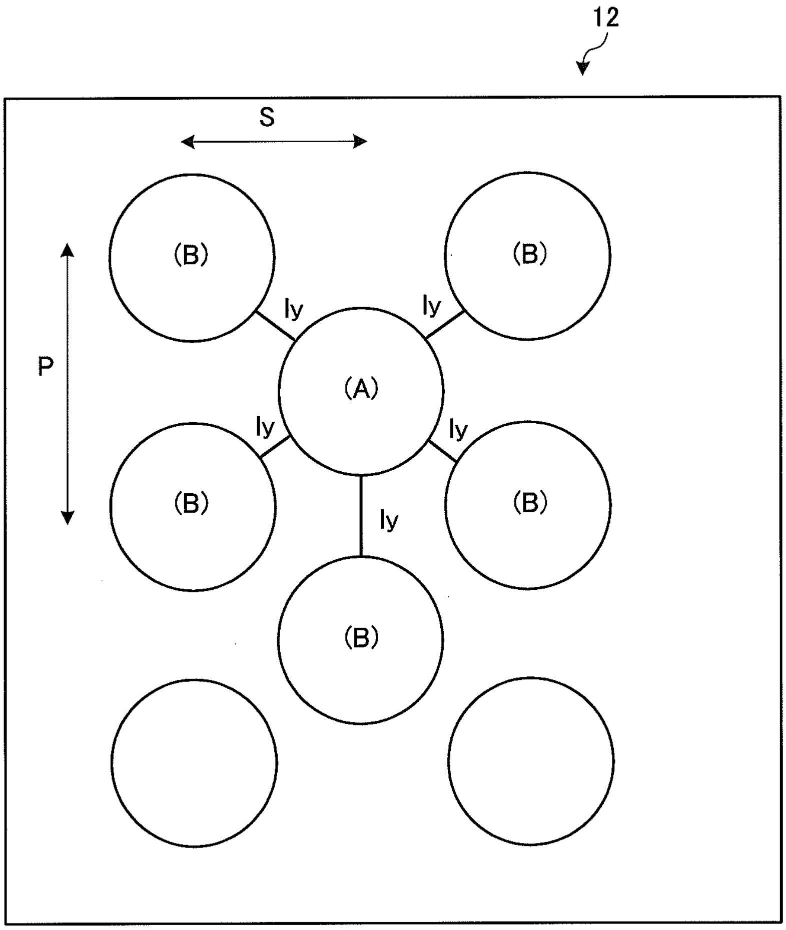


FIG.31

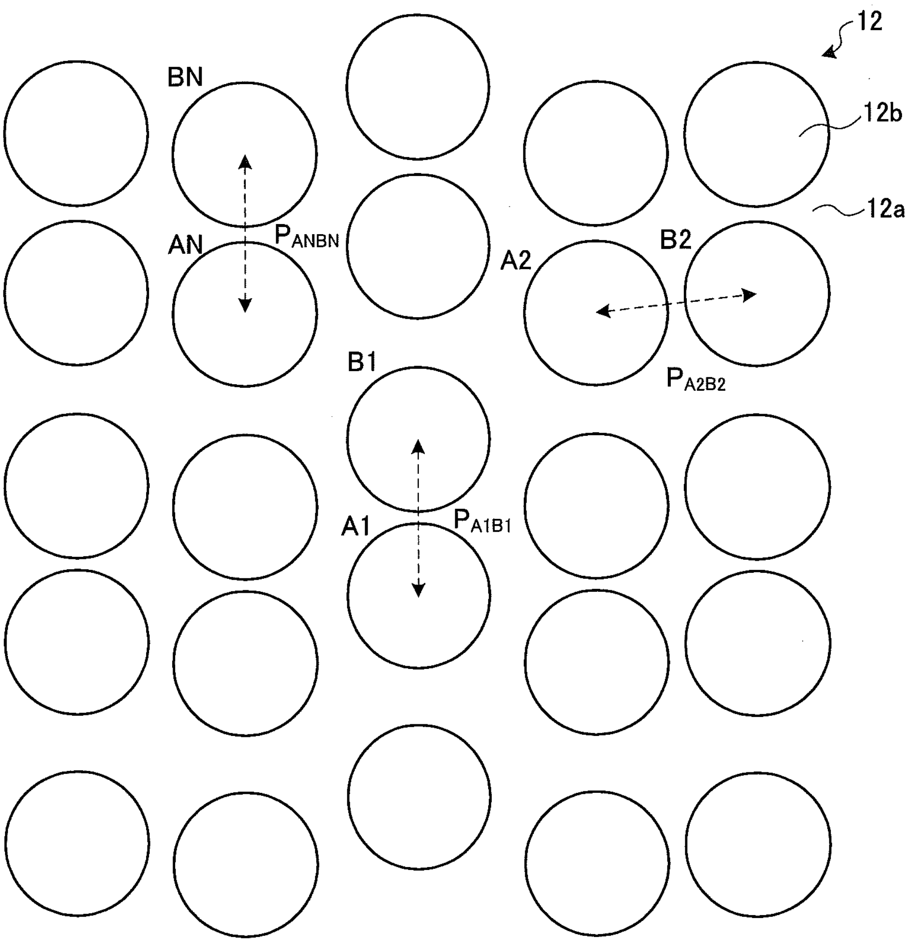


FIG.32

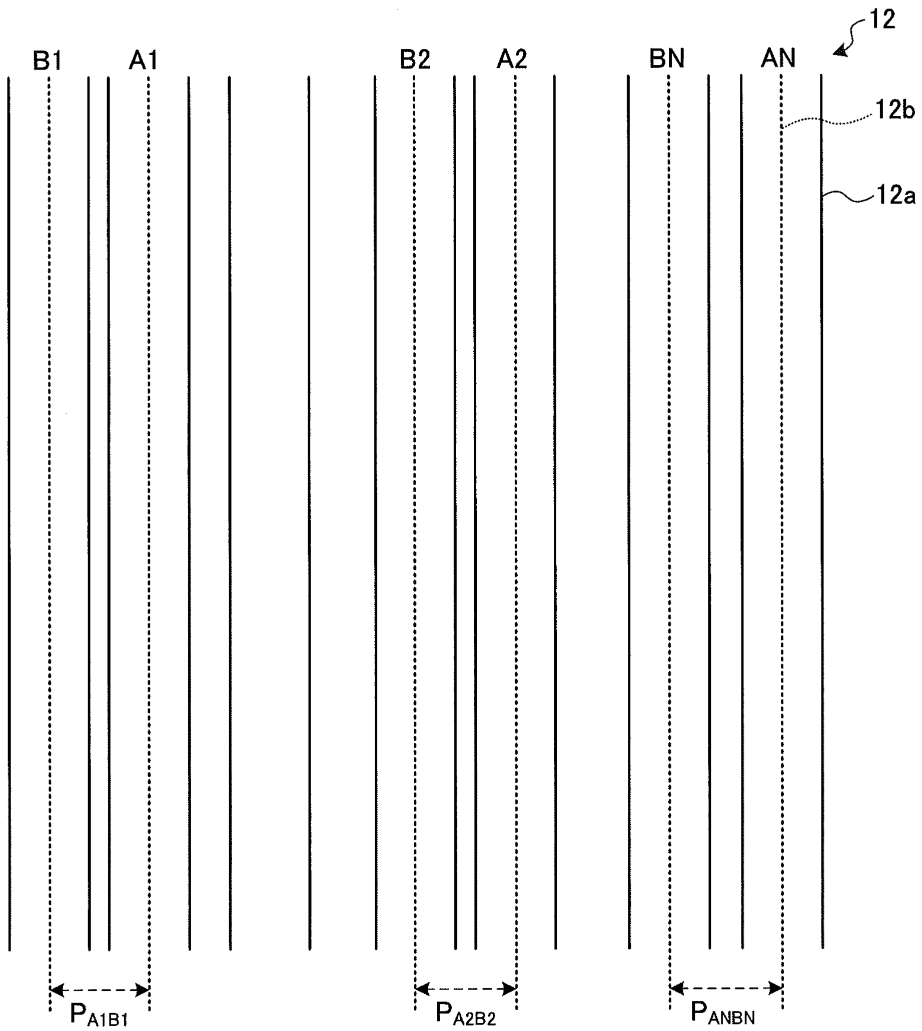


FIG.33

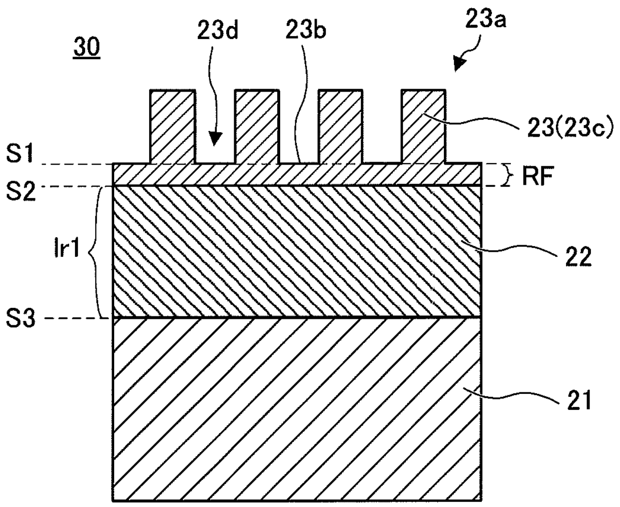


FIG.34

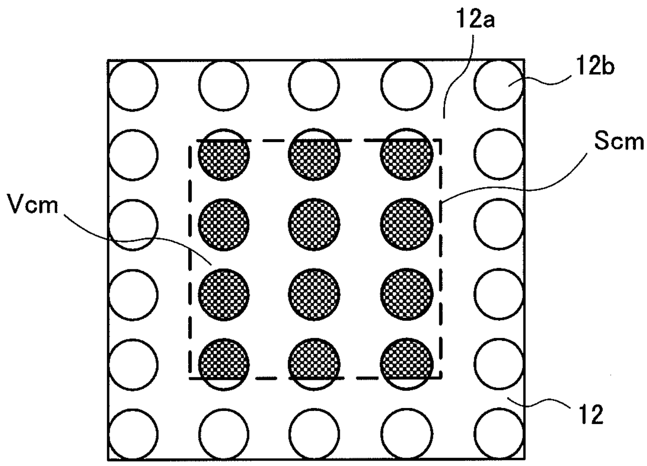


FIG.35A

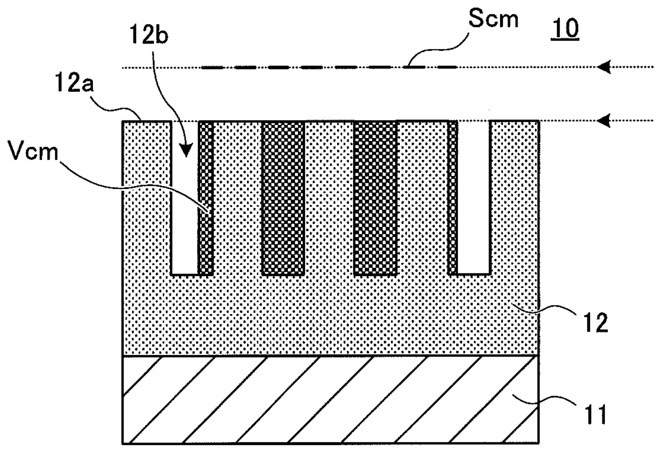


FIG.35B

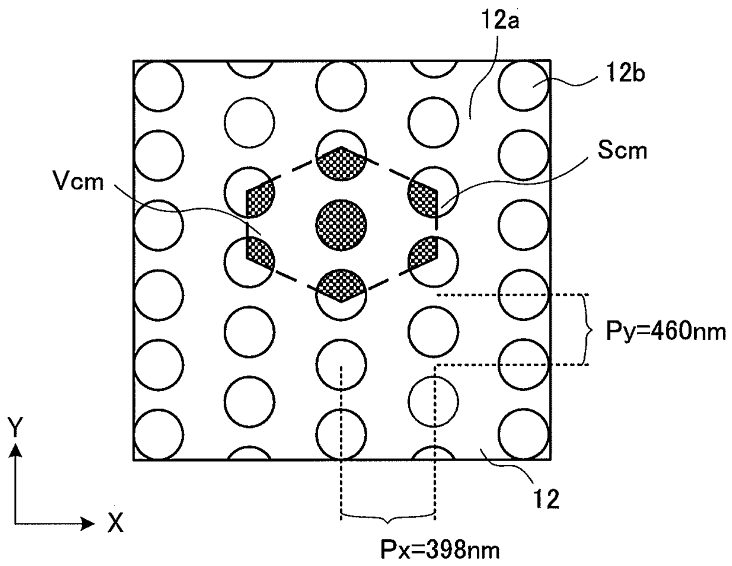


FIG.36A

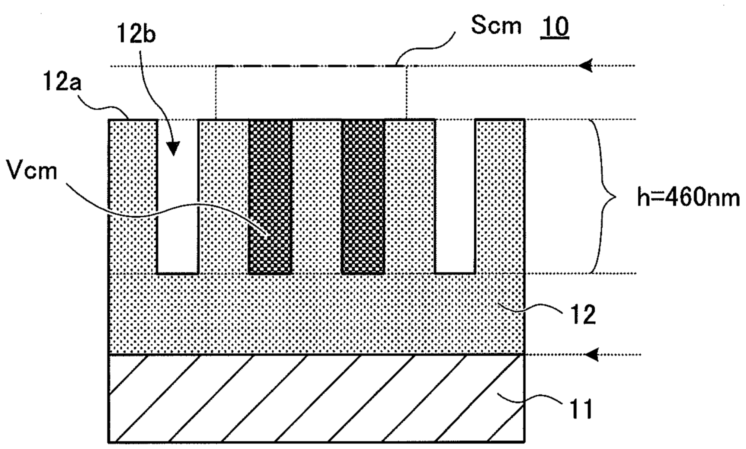


FIG.36B

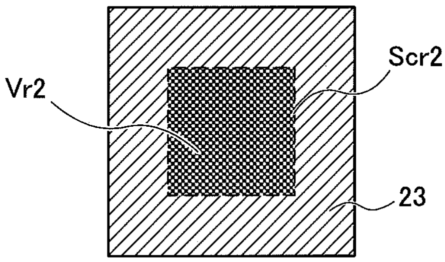


FIG.37A

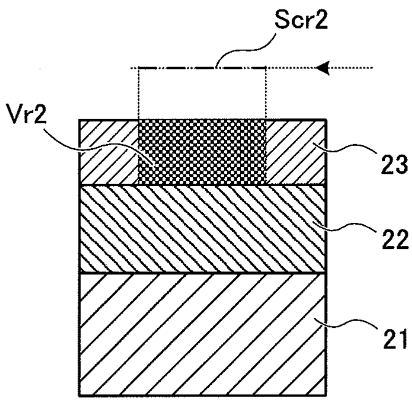


FIG.37B

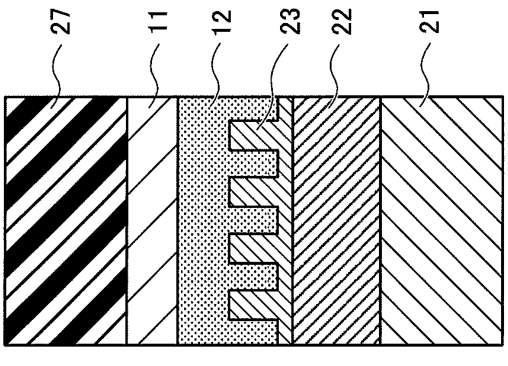


FIG.38A

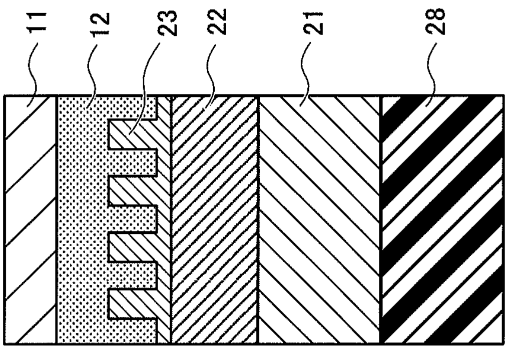


FIG.38B

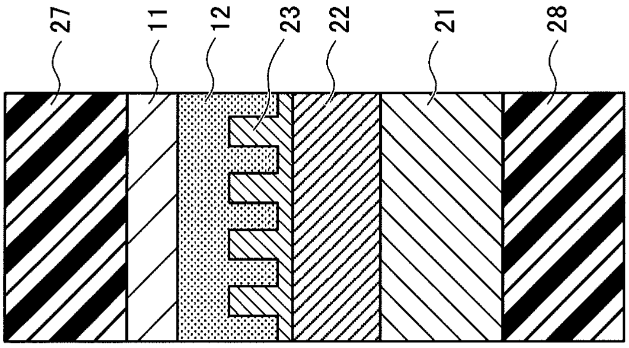


FIG.38C

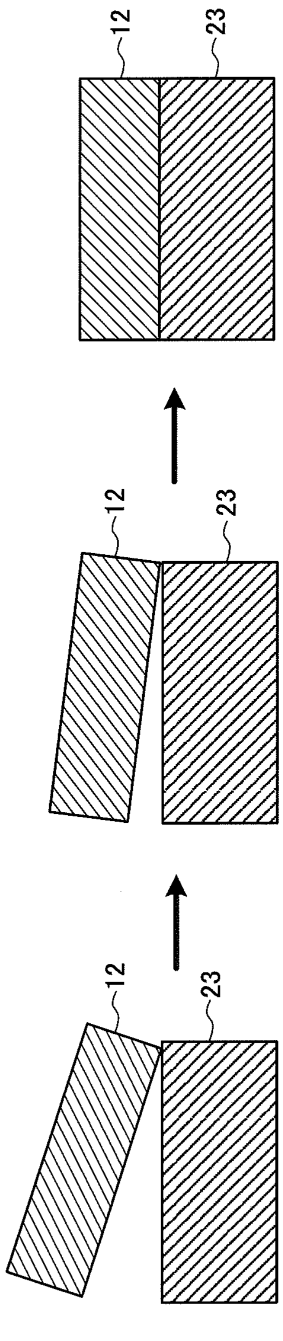


FIG.39A

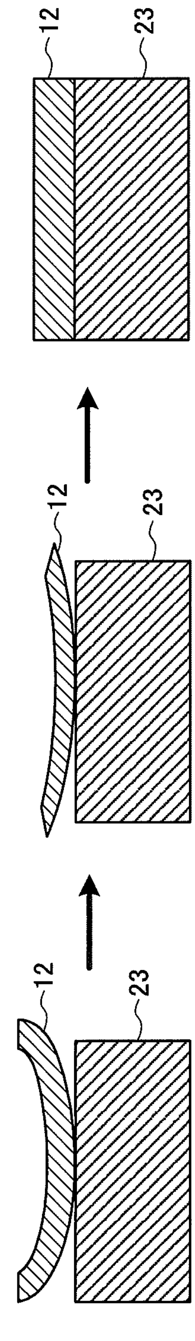


FIG.39B

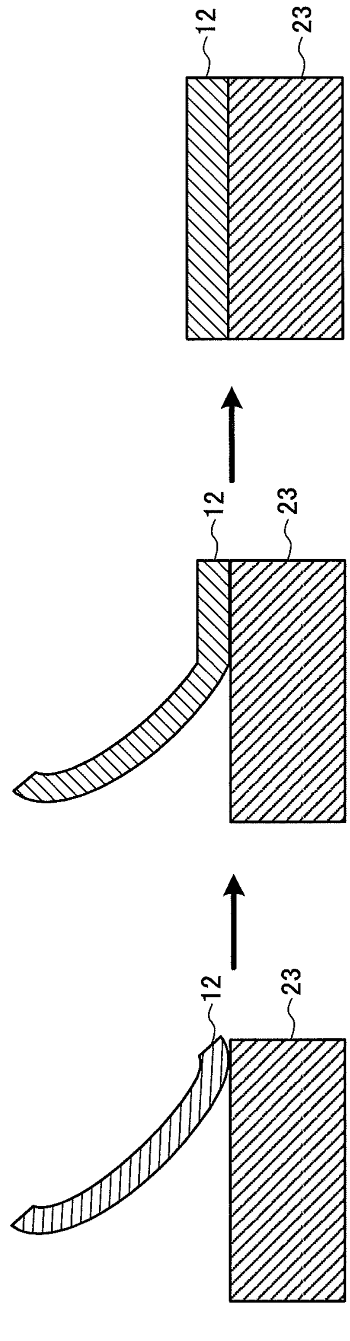


FIG.39C

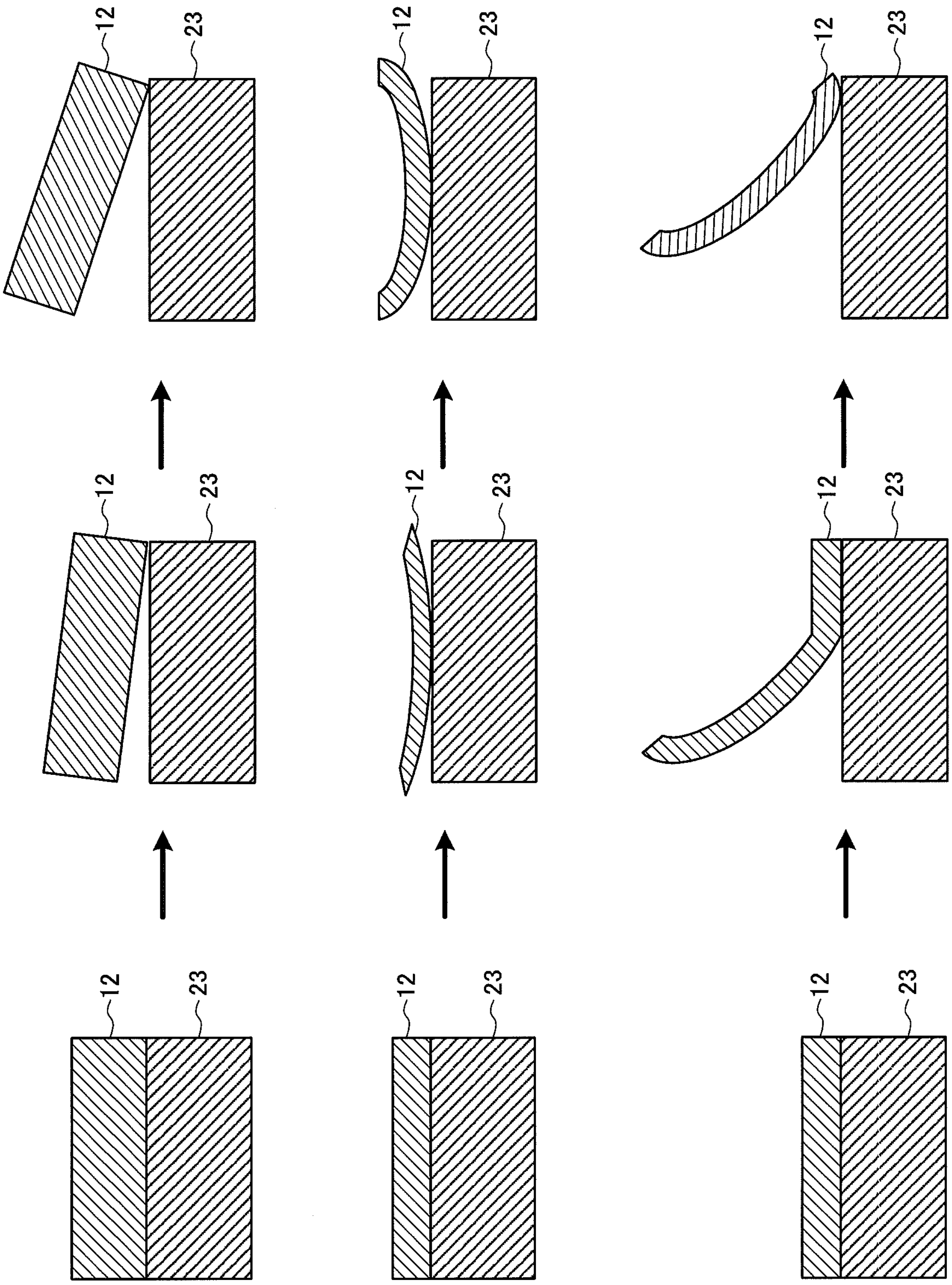


FIG.40A

FIG.40B

FIG.40C

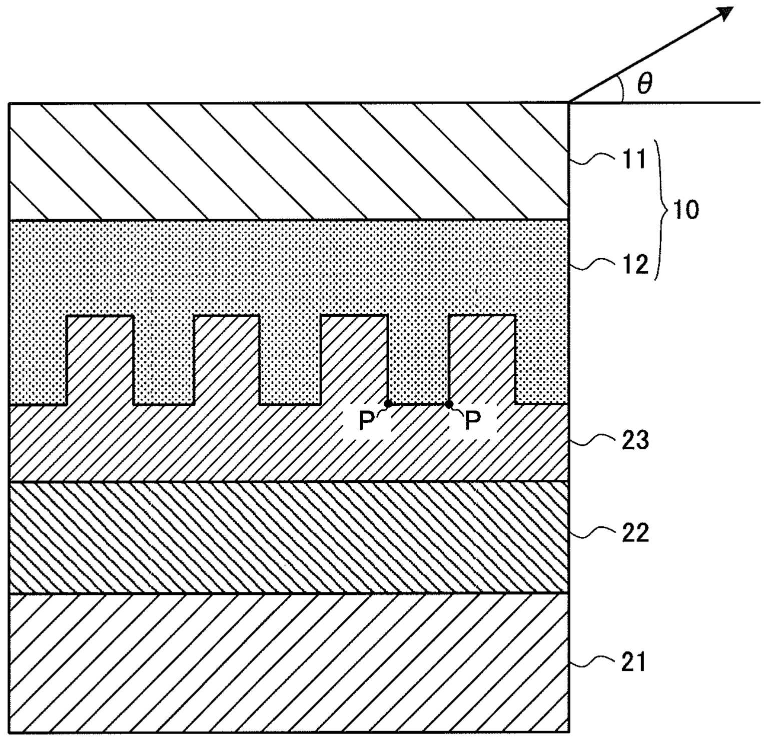


FIG.41

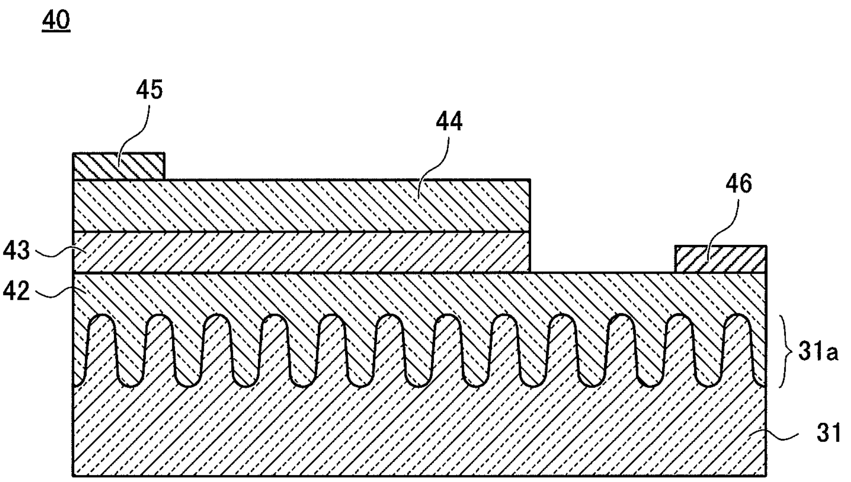


FIG.42

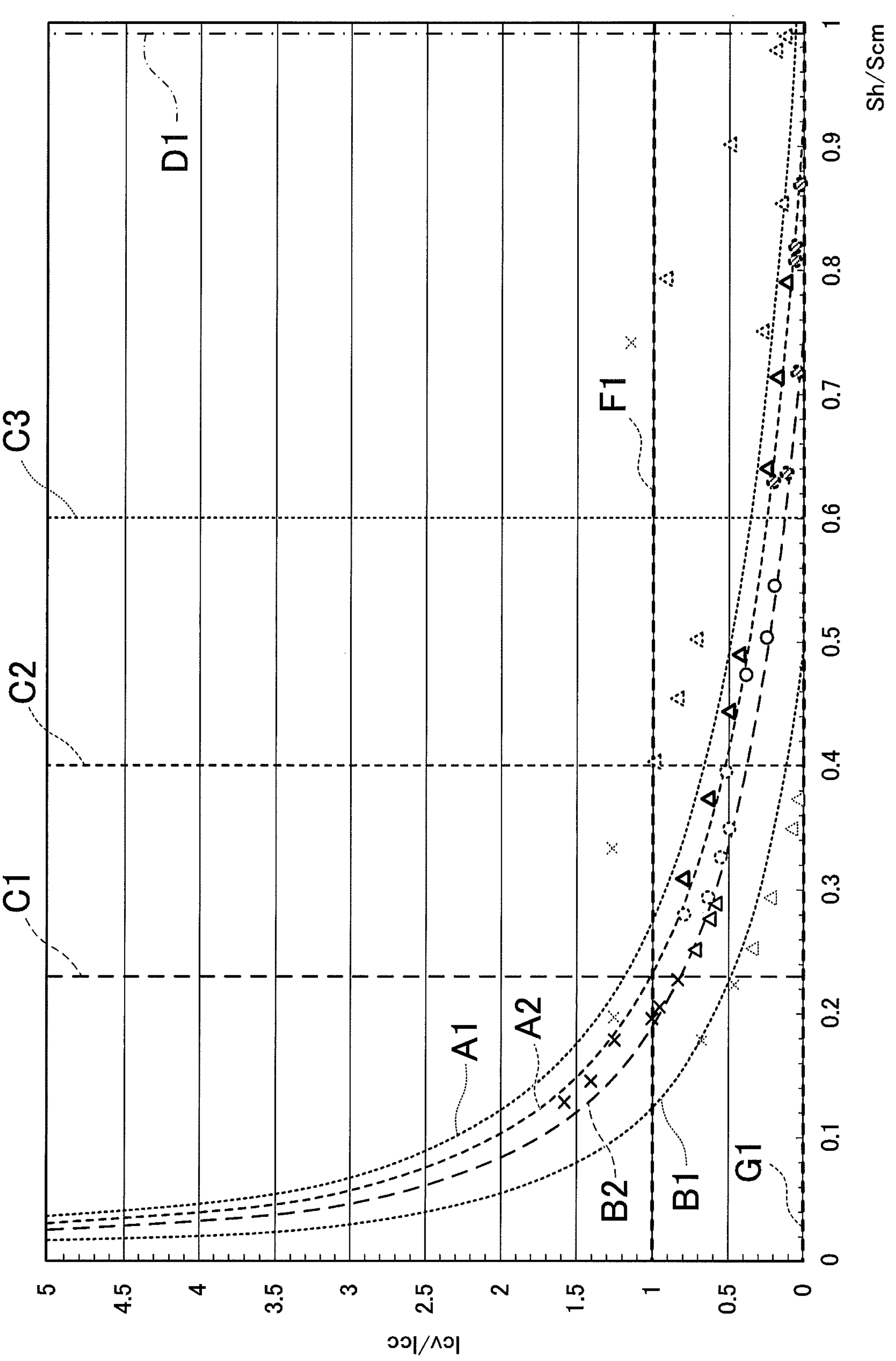
C1
C2
C3
D1
F1
A1
A2
B1
B2
G1
Icv/Icc
Sh/Scm
0
0.5
1
1.5
2
2.5
3
3.5
4
4.5
5
0
0.1
0.2
0.3
0.4
0.5
0.6
0.7
0.8
0.9
1

FIG.43

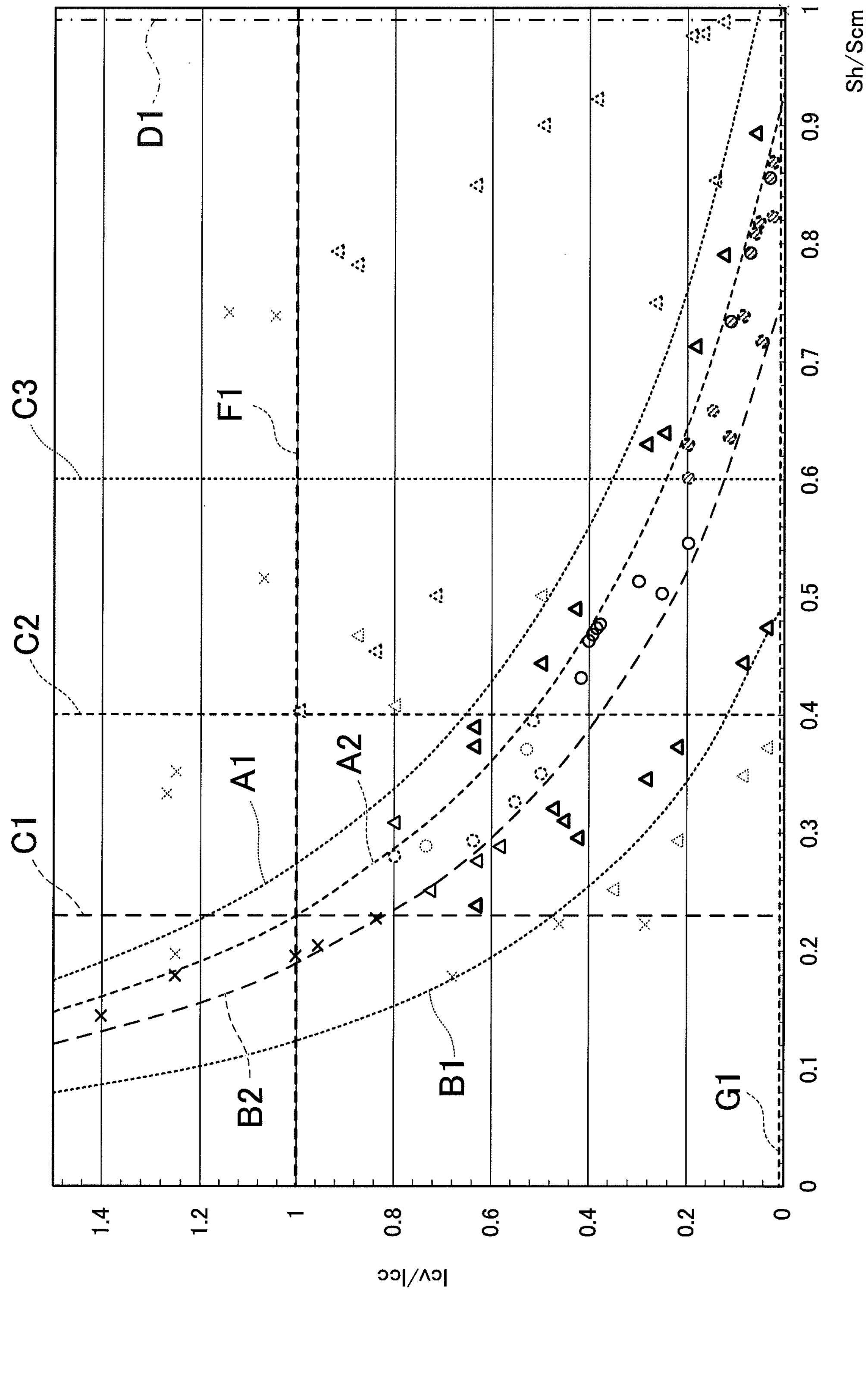
C1
C2
C3
D1
F1
A1
A2
B1
B2
G1
Icv/Icc
Sh/Scm
0
0.2
0.4
0.6
0.8
1
1.2
1.4
0
0.1
0.2
0.3
0.4
0.5
0.6
0.7
0.8
0.9
1

FIG.44

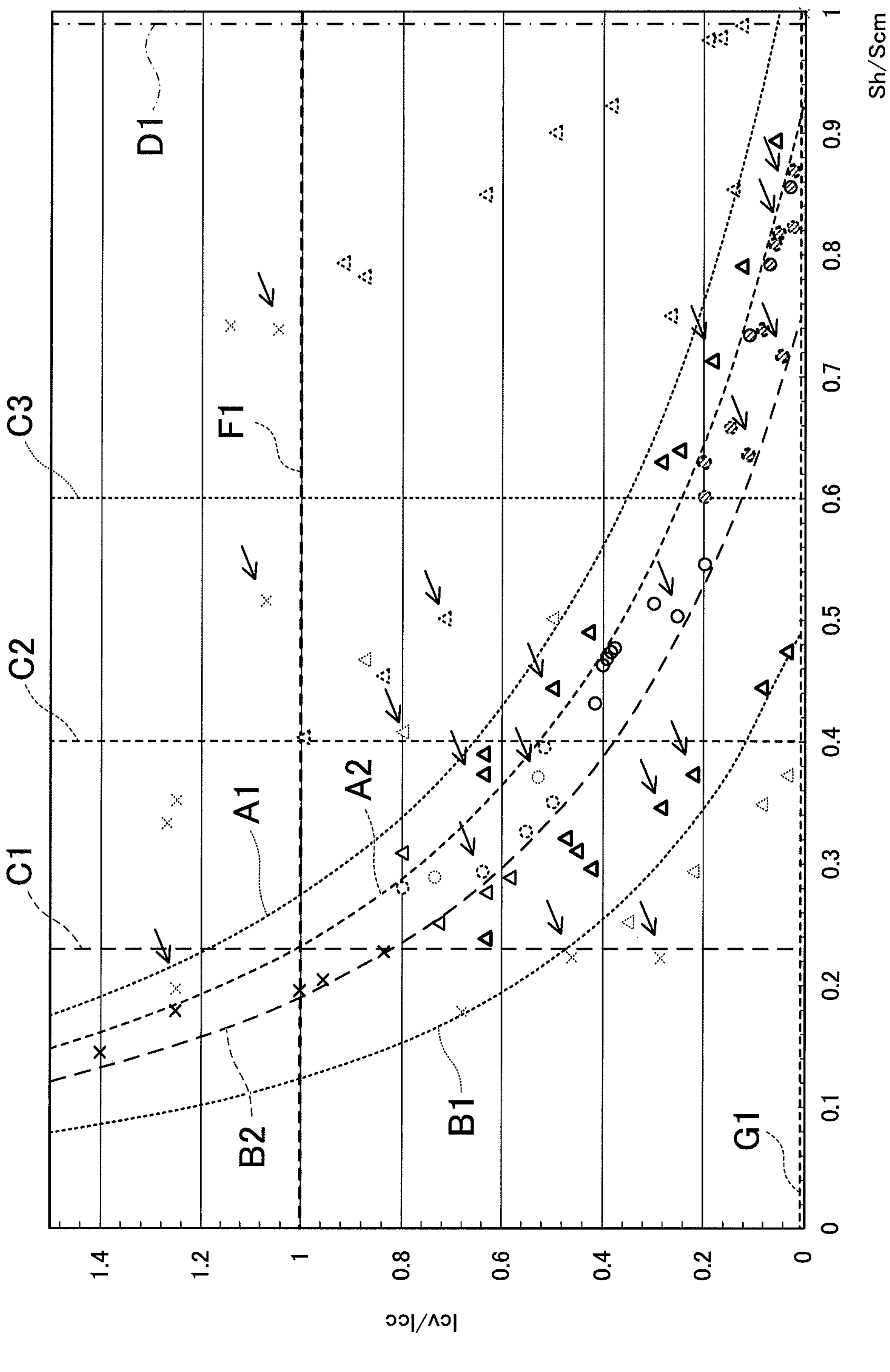
C1
C2
C3
D1
F1
A1
A2
B1
B2
G1
Icv/Icc
Sh/Scm
0
0.2
0.4
0.6
0.8
1
1.2
1.4
0
0.1
0.2
0.3
0.4
0.5
0.6
0.7
0.8
0.9
1

FIG.45

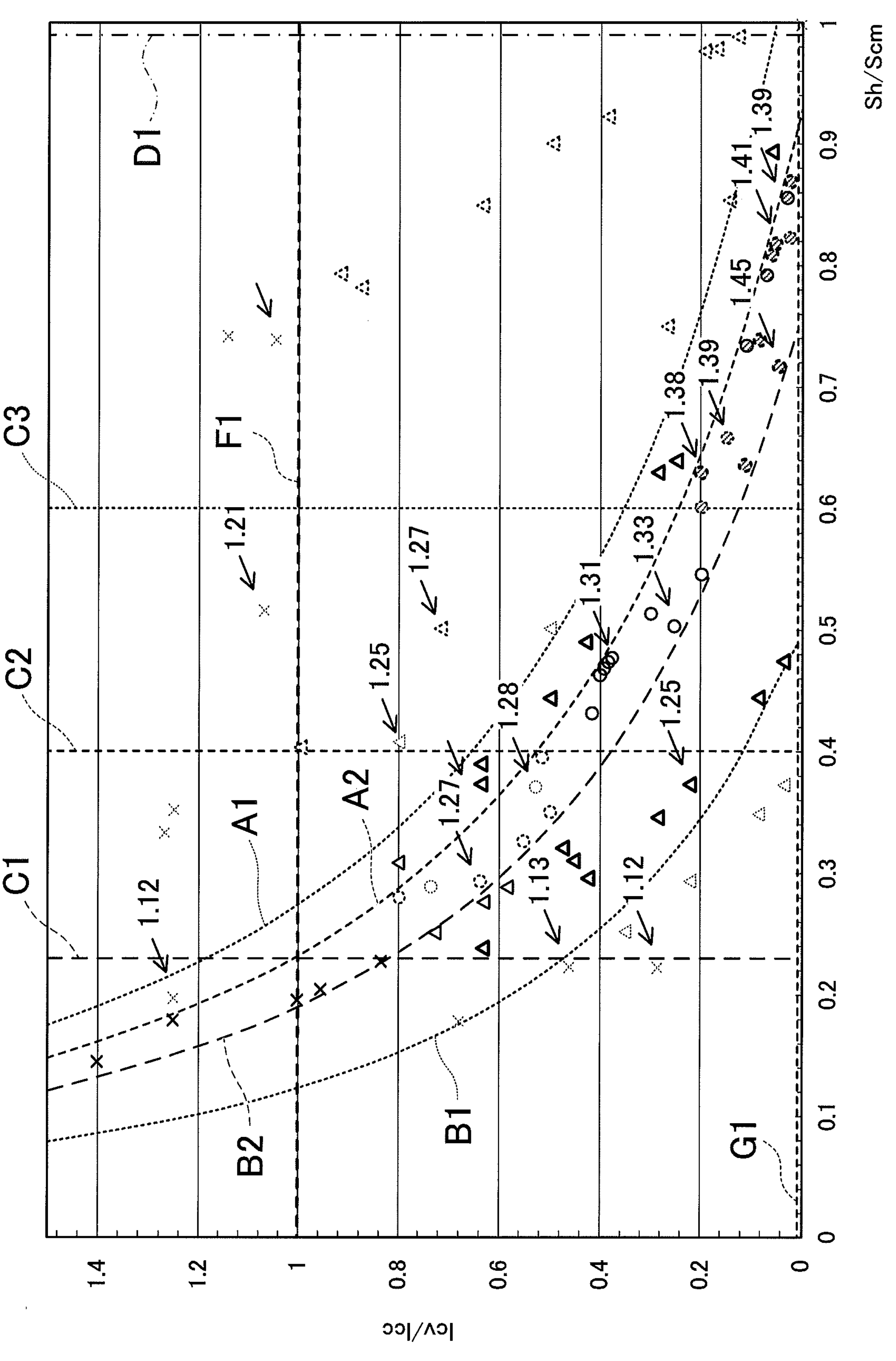
C1
C2
C3
D1
F1
A1
A2
B1
B2
G1
1.12
1.21
1.27
1.25
1.28
1.27
1.13
1.12
1.31
1.33
1.25
1.38
1.39
1.45
1.41
1.39
Icv/Icc
Sh/Scm
0
0.2
0.4
0.6
0.8
1
1.2
1.4
0.1
0.3
0.5
0.7
0.9

FIG.46

**INTERNATIONAL SEARCH REPORT**

International application No.
PCT/JP2013/056598

A. CLASSIFICATION OF SUBJECT MATTER
*H01L21/027*(2006.01)i, *B29C33/38*(2006.01)i, *B29C33/42*(2006.01)i, *B29C59/02*(2006.01)i, *B32B3/26*(2006.01)i

According to International Patent Classification (IPC) or to both national classification and IPC

B. FIELDS SEARCHED

Minimum documentation searched (classification system followed by classification symbols)
H01L21/027, B29C33/38, B29C33/42, B29C59/02, B32B3/26

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | WO 2009/148138 A1 (Asahi Glass Co., Ltd.),<br>10 December 2009 (10.12.2009),<br>paragraphs [0019] to [0021], [0051] to [0066]<br>& US 2011/0084424 A1 & US 2012/0247950 A1<br>& EP 2286980 A1 & CN 102046357 A<br>& KR 10-2011-0031275 A & TW 201008744 A | 1-8,11,12,<br>40,41<br>9,10,13-39 |
| Y<br>A | JP 2010-036514 A (Hitachi High-Technologies Corp.),<br>18 February 2010 (18.02.2010),<br>paragraphs [0035] to [0037]<br>& US 2010/0034911 A1 & EP 2281860 A1<br>& AT 510896 T & ES 2362643 T | 9,10,13-39<br>1-8,11,12,<br>40,41 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 March, 2013 (26.03.13) | 02 April, 2013 (02.04.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No. PCT/JP2013/056598

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2007-329276 A (Tokyo Ohka Kogyo Co., Ltd.), 20 December 2007 (20.12.2007), paragraphs [0008] to [0096] & US 2009/0189317 A1 & WO 2007/142088 A1 | 13-39<br>1-12,40,41 |
| A | JP 2011-066273 A (Konica Minolta Holdings, Inc.), 31 March 2011 (31.03.2011), entire text; all drawings (Family: none) | 1-41 |
| A | JP 2011-143674 A (Teijin Chemicals Ltd.), 28 July 2011 (28.07.2011), entire text; all drawings (Family: none) | 1-41 |
| A | JP 2010-016354 A (Alps Electric Co., Ltd.), 21 January 2010 (21.01.2010), entire text; all drawings (Family: none) | 1-41 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011066273 A
- JP 2012054943 A
- JP 2012054944 A
- JP 2012054945 A
- JP 2012186551 A